# EUROPEAN PATENT APPLICATION

(11) **EP 3 943 499 A2**
(43) Date of publication of application: **26.01.2022**
(21) Application number: 21186314.7
(22) Date of filing: 19.07.2021
(51) Int. Cl.: C07F 15/00, C09K 11/06

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 20.07.2020 KR 20200089868
(71) Applicant: Samsung Electronics Co., Ltd., Suwon-si, Gyeonggi-do 16677 (KR)
(72) Inventor: HWANG, Kyuyoung, 16678 Gyeonggi-do (KR); MOON, Juhee, 16678 Gyeonggi-do (KR); ARATANI, Sukekazu, 16678 Gyeonggi-do (KR); LEE, Kum Hee, 16678 Gyeonggi-do (KR); LEE, Banglin, 16678 Gyeonggi-do (KR); YI, Jeoungin, 16678 Gyeonggi-do (KR); CHOI, Byoungki, 16678 Gyeonggi-do (KR)
(74) Representative: Elkington and Fife LLP

(57) **Abstract**

An organometallic compound represented by Formula 1:

Formula 1 M(L₁)n1(L₂)n2

wherein M is a transition metal, L₁ is a ligand represented by Formula 2 as provided herein, n1 is 1, 2, or 3, wherein, when n1 is 2, two L₁ groups are identical to or different from each other, and when n1 is 3, two or more of three L₁ groups are different from each other, L₂ is a monodentate ligand, a bidentate ligand, a tridentate ligand, or a tetradentate ligand, and n2 is 0, 1, 2, 3, or 4, wherein, when n2 is 2 or greater, two or more L₂ groups are identical to or different from each other, and L₁ and L₂ are different from each other.

## Description

### BACKGROUND OF THE INVENTION

The present disclosure relates to organometallic compounds, organic light-emitting devices including the same, and electronic apparatuses including the organic light-emitting devices.

### FIELD OF THE INVENTION

Organic light-emitting devices are self-emission devices, which have improved characteristics in terms of viewing angles, response time, brightness, driving voltage, and response speed, and produce full-color images.

In an example, an organic light-emitting device includes an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

### SUMMARY OF THE INVENTION

Provided are organometallic compounds, organic light-emitting devices including the same, and electronic apparatuses including the organic light-emitting devices.

Additional aspects will be set forth in part in the description which follows and, in part, will be apparent from the description, or may be learned by practice of the presented embodiments of the disclosure.

According to one aspect of one or more embodiments, there is provided an organometallic compound represented by Formula 1:

Formula 1 M(L₁)ₙ₁(L₂)ₙ₂

wherein, in Formula 1,
M is a transition metal,
L₁ is a ligand represented by Formula 2,
n1 is 1, 2, or 3, wherein, when n1 is 2, two L₁ groups are identical to or different from each other, and when n1 is 3, two or more of three L₁ groups are different from each other,
L₂ is a monodentate ligand, a bidentate ligand, a tridentate ligand, or a tetradentate ligand,
n2 is 0, 1, 2, 3, or 4, wherein, when n2 is 2 or greater, two or more of L₂ groups are identical to or different from each other,
L₁ and L₂ are different from each other, 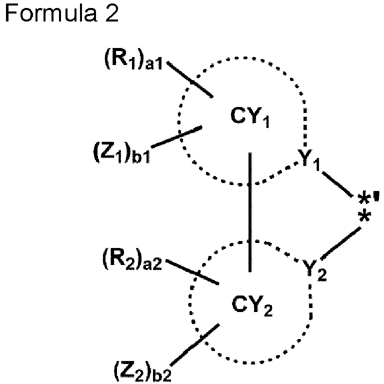 wherein, in Formula 2,
Y₁ and Y₂ are each independently N or C,
ring CY₁ and ring CY₂ are each independently a C₅-C₃₀ carbocyclic group or a C1-C30 heterocyclic group,
R₁ and R₂ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),-Ge(Q₃)(Q₄)(Q₅), -B(Q₆)(Q₇), -P(=O)(Q₈)(Q₉), or -P(Q₈)(Q₉),
a1 and a2 are each independently an integer from 0 to 20,
b1 and b2 are each independently an integer from 0 to 20, and the sum of b1 and b2 is 1 or greater,
Z₁ and Z₂ in Formula 2 are each independently a group represented by Formula 3, 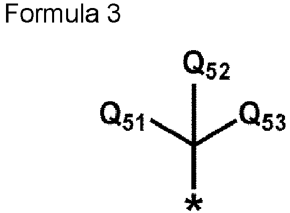 wherein, in Formula 3,
Q₅₁ and Q₅₂ are each independently hydrogen, deuterium, -F, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
Q₅₃ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
two or more of a plurality of R₁ groups are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of R₂ groups are optionally linked together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is the same as described in connection with R₁, provided that R₁₀ₐ is not hydrogen,
* and *' in Formula 2 each indicate a binding site to M in Formula 1,
* in Formula 3 indicates a binding site to a neighboring atom,
in Formula 2 and Formula 3, substituents of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group are each independently:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉),-P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₈)(Q₃₉), or -P(Q₃₈)(Q₃₉); or
a combination thereof, and
Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, -F, a cyano group, a C₁-C₆₀ alkyl group, a C₆-C₆₀ aryl group, a deuterated C₆-C₆₀ aryl group, a fluorinated C₆-C₆₀ aryl group, or a combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group or a C₁-C₆₀ heteroaryl group, each unsubstituted or substituted with deuterium, -F, a cyano group, a C₁-C₆₀ alkyl group, a deuterated C₁-C₆₀ alkyl group, a fluorinated C₁-C₆₀ alkyl group, a C₆-C₆₀ aryl group, a deuterated C₆-C₆₀ aryl group, a fluorinated C₆-C₆₀ aryl group, or a combination thereof; a C₆-C₆₀ aryloxy group; a C₆-C₆₀ arylthio group; a monovalent non-aromatic condensed polycyclic group; or a monovalent non-aromatic condensed heteropolycyclic group.

According to an aspect of another embodiment, there is provided an organic light-emitting device including: a first electrode; a second electrode; and an organic layer disposed between the first electrode and the second electrode and including an emission layer, wherein the organic layer includes at least one organometallic compound represented by Formula 1.

The at least one organometallic compound may be included in the emission layer of the organic layer, and the at least one organometallic compound included in the emission layer may function as a dopant.

According to an aspect of another embodiment, there is provided an electronic apparatus including the organic light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIGURE which shows a schematic cross-sectional view of an organic light-emitting device according to one or more embodiments.

### DETAILED DESCRIPTION OF THE EMBODIMENTS

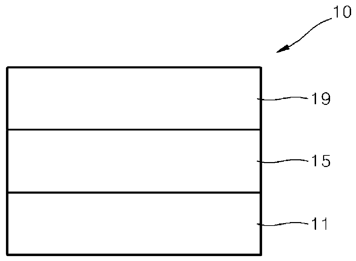

Reference will now be made in detail to exemplary embodiments, examples of which are illustrated in the accompanying drawing, wherein like reference numerals refer to like elements throughout. In this regard, the present exemplary embodiments may have different forms and should not be construed as being limited to the descriptions set forth herein. Accordingly, the exemplary embodiments are merely described below, by referring to the figure, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to a cross section illustration that is a schematic illustration of one or more idealized embodiments. As such, variations from the shapes of the illustration as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figure are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An aspect of the present disclosure provides an organometallic compound represented by Formula 1:

Formula 1 M(L₁)ₙ₁(L₂)ₙ₂

wherein M in Formula 1 is a transition metal.

In one or more embodiments, M may be a Period 1 transition metal, a Period 2 transition metal, or a Period 3 transition metal in the Periodic Table of Elements.

In one or more embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In one or more embodiments, M may be Ir, Pt, Os, or Rh.

In one or more embodiments, M may be Ir.

In Formula 1, L₁ may be a ligand represented by Formula 2: 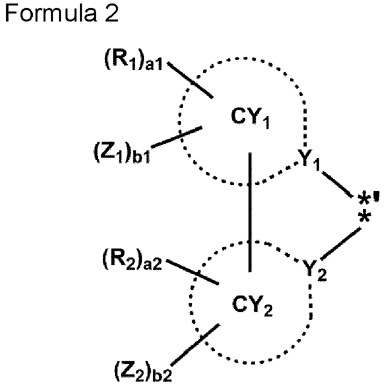 wherein Formula 2 is the same as described in the present specification.

In Formula 1, n1 indicates the number of L₁ groups, and may be 1, 2, or 3. When n1 is 2, two L₁ groups may be identical to or different from each other. When n1 is 3, two or more of three L₁ groups may be different from each other.

In Formula 1, L₂ may be a monodentate ligand, a bidentate ligand, a tridentate ligand, or a tetradentate ligand.

In Formula 1, n2 indicates the number of L₂ groups, and may be 0, 1, 2, 3, or 4. When n2 is 2 or greater, two or more of L₂ groups may be identical to or different from each other. For example, n2 may be 1 or 2.

In one or more embodiments, in Formula 1, i) M may be Ir, and the sum of n1 and n2 may be 3, for example, a) n1 may be 1 and n2 may be 2, or b) n1 may be 2 and n2 may be 1; or ii) M may be Pt, and the sum of n1 and n2 may be 2, for example, n1 and n2 each may be 1.

In Formula 1, L₁ and L₂ may be different from each other.

In Formula 1, when n1 is 3, two or more of three L₁ groups may be different from each other, and L₁ and L₂ may be different from each other. In this regard, the organometallic compound represented by Formula 1 may be a heteroleptic complex.

In Formula 2, Y₁ and Y₂ may each independently be C or N. For example, Y₁ may be N, and Y₂ may be C.

In Formula 2, ring CY₁ and ring CY₂ may each independently a C₅-C₃₀ carbocyclic group or a C₁-C₃₀ heterocyclic group.

In one or more embodiments, ring CY₁ and ring CY₂ may each independently selected from, i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
wherein the first ring may be a cyclopentane group, a cyclopentene group, a furan group, a thiophene group, a pyrrole group, a silole group, a germole group, a phosphole group, a selenophene group, a borole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaphosphole group, an azaselenophene group, or an azaborole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring CY₁ and ring CY₂ in Formula 2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, or a benzene group condensed with a norbornane group.

In one or more embodiments, ring CY₁ in Formula 2 may be a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a 5,6,7,8-tetrahydroisoquinoline group, a 5,6,7,8-tetrahydroquinoline group, an azafluorene group, an azacarbazole group, an azadibenzofuran group, an azadibenzothiophene group, or an azadibenzosilole group.

In one or more embodiments, ring CY₂ in Formula 2 may be a benzene group, a naphthalene group, an anthracene group, a phenanthrene group, a triphenylene group, a pyrene group, a chrysene group, a 1,2,3,4-tetrahydronaphthalene group, or a group represented by Formula 2B: 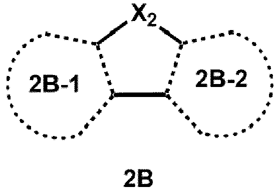 wherein, in Formula 2B,
X₂ may be O, S, Se, or a moiety including N, C, or Si, and
ring 2B-1 and ring 2B-2 may each independently be a benzene group, a naphthalene group, an anthracene group, a phenanthrene group, a triphenylene group, a pyrene group, a chrysene group, a 1,2,3,4-tetrahydronaphthalene group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a 5,6,7,8-tetrahydroisoquinoline group, a 5,6,7,8-tetrahydroquinoline group, an indene group, an indole group, a benzofuran group, a benzothiophene group, a benzosilole group, a fluorene group, a carbazole group, a dibenzofuran group, a dibenzothiophene group, a dibenzosilole group, an azaindene group, an azaindole group, an azabenzofuran group, an azabenzothiophene group, an azabenzosilole group, an azafluorene group, an azacarbazole group, an azadibenzofuran group, an azadibenzothiophene group, or an azadibenzosilole group.

In Formula 2, R₁ and R₂ may each independently be hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₈)(Q₉), and Q₁ to Q₉ may each be the same as described in the present specification.

In Formula 2, a1 and a2 indicate the number of R₁ groups and the number of R₂ groups, respectively, and may each independently be an integer from 0 to 20. When a1 is 2 or greater, two or more of R₁ groups may be identical to or different from each other, and when a2 is 2 or greater, two or more of R₂ groups may be identical to or different from each other. For example, a1 and a2 may each independently be 0, 1, 2, 3, 4, 5, or 6.

In one or more embodiments, R₁ and R₂ in Formula 2 may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, or a combination thereof;
a C₃-C₁₀ cycloalkyl group, a C₁-C₁₀ heterocycloalkyl group, a phenyl group, a biphenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)Ci-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a naphthyl group, a deuterated naphthyl group, a fluorinated naphthyl group, a (C₁-C₂₀ alkyl)naphthyl group, a pyridinyl group, a deuterated pyridinyl group, a fluorinated pyridinyl group, a (C₁-C₂₀ alkyl)pyridinyl group, or a combination thereof; or
-Si(Q₃)(Q₄)(Q₅) or -Ge(Q₃)(Q₄)(Q₅), and
Q₃ to Q₅ may each independently be:
   deuterium;
   a C₁-C₆₀ alkyl group unsubstituted or substituted with deuterium, -F, a cyano group, a C₁-C₆₀ alkyl group, a C₆-C₆₀ aryl group, a deuterated C₆-C₆₀ aryl group, a fluorinated C₆-C₆₀ aryl group, or a combination thereof; or
   a C₆-C₆₀ aryl group or a C₁-C₆₀ heteroaryl group, each unsubstituted or substituted with deuterium, -F, a cyano group, a C₁-C₆₀ alkyl group, a deuterated C₁-C₆₀ alkyl group, a fluorinated C₁-C₆₀ alkyl group, a C₆-C₆₀ aryl group, a deuterated C₆-C₆₀ aryl group, a fluorinated C₆-C₆₀ aryl group, or a combination thereof.

In one or more embodiments, at least one R₁ group in the number of a1 in Formula 2 may be: deuterium; -F; a C₁-C₂₀ alkyl group or a C₃-C₁₀ cycloalkyl group, each unsubstituted or substituted with deuterium, -F, C₁-C₁₀ alkyl group, or a combination thereof; a group represented by -Si(Q₃ₐ)(Q₄ₐ)(Q₅ₐ); or a group represented by -Ge(Q₃ₐ)(Q₄ₐ)(Q₆ₐ), wherein Q₃ₐ to Q₅ₐ are as defined herein for Q₃ to Q₅, respectively.

In one or more embodiments, at least one R₂ group in the number of a2 in Formula 2 may be: deuterium; -F; or a C₁-C₂₀ alkyl group or a C₃-C₁₀ cycloalkyl group, each unsubstituted or substituted with deuterium, -F, a C₁-C₁₀ alkyl group, or a combination thereof.

In one or more embodiments, R₁ and R₂ in Formula 2 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -CI, -Br, -I, -CD₃, -CD₂H,-CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₂-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₈)(Q₉), and
Q₁ to Q₉ may each independently be:
   deuterium, -F, a cyano group, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃,-CD₂CD₂H, -CD₂CDH₂, -CF₃, -CF₂H, -CFH₂, -CH₂CF₃, -CH₂CF₂H, -CH₂CFH₂,-CHFCH₃, -CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, or a combination thereof.

In Formula 2, Z₁ and Z₂ may each independently be a group represented by Formula 3: 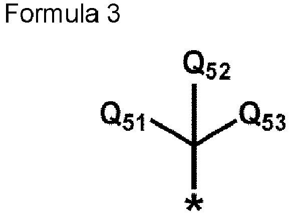 wherein Formula 3 is the same as described above.

In Formula 2, b1 and b2 indicate the number of Z₁ groups and the number of Z₂ groups, respectively, and may each independently be an integer from 0 to 20. When b1 is 2 or greater, two or more of Z₁ groups may be identical to or different from each other, and when b2 is 2 or greater, two or more of Z₂ groups may be identical to or different from each other.

In Formula 2, the sum of b1 and b2 may be 1 or greater (for example, 1, 2, 3, or 4). That is, the group represented by Formula 2 may include at least one of Z₁ and Z₂.

For example, b1 and b2 may each independently be 0, 1, 2, or 3.

In one or more embodiments, in Formula 2,
i) b1 may be 1 or 2, and b2 may be 0;
ii) b1 may be 0, and b2 may be 1 or 2; or
iii) b1 and b2 may each be 1.

In Formula 3, O₅₁ and Q₅₂ may each independently be hydrogen, deuterium, - F, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and Q₅₃ may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, at least one of Q₅₁ and Q₅₂ (for example, both Q₅₁ and Q₅₂) in Formula 3 may each independently be deuterium, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, Q₅₁ and Q₅₂ in Formula 3 may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, or a combination thereof; or
a C₃-C₁₀ cycloalkyl group, a C₁-C₁₀ heterocycloalkyl group, a phenyl group, a biphenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)Ci-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a naphthyl group, a deuterated naphthyl group, a fluorinated naphthyl group, a (C₁-C₂₀ alkyl)naphthyl group, a pyridinyl group, a deuterated pyridinyl group, a fluorinated pyridinyl group, a (C₁-C₂₀ alkyl)pyridinyl group, or a combination thereof.

In one or more embodiments, each of Q₅₁ and Q₅₂ in Formula 3 may not be hydrogen.

In one or more embodiments, at least one of Q₅₁ and Q₅₂ (for example, both Q₅₁ and Q₅₂) in Formula 3 may each independently be:
deuterium; or
a C₁-C₂₀ alkyl group unsubstituted or substituted with deuterium, -F, or a combination thereof.

In one or more embodiments, Q₅₃ in Formula 3 may be a C₃-C₁₀ cycloalkyl group, a C₁-C₁₀ heterocycloalkyl group, a phenyl group, a biphenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a naphthyl group, a deuterated naphthyl group, a fluorinated naphthyl group, a (C₁-C₂₀ alkyl)naphthyl group, a pyridinyl group, a deuterated pyridinyl group, a fluorinated pyridinyl group, a (C₁-C₂₀ alkyl)pyridinyl group, or a combination thereof.

In Formula 2, i) two or more of a plurality of R₁ groups may optionally be linked together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, or ii) two or more of a plurality of R₂ groups may optionally be linked together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

Here, R₁₀ₐ is the same as described in connection with R₁, provided that R₁₀ₐ is not hydrogen.

In Formula 2, * and *' each indicate a binding site to M in Formula 1.

In Formula 3, * indicates a binding site to a neighboring atom.

In one or more embodiments, a group represented by 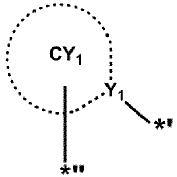 in Formula 2 may be a group represented by one of Formulae CY1-1 to CY1-42: 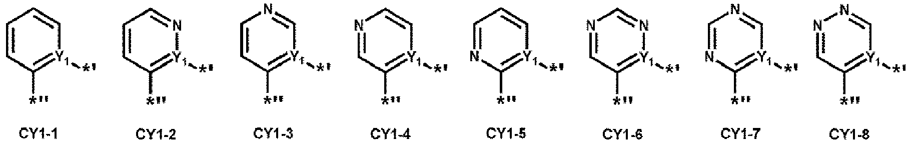 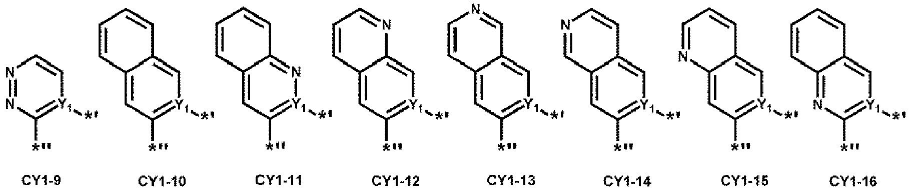 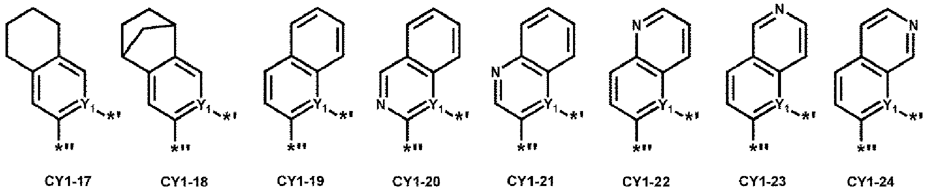 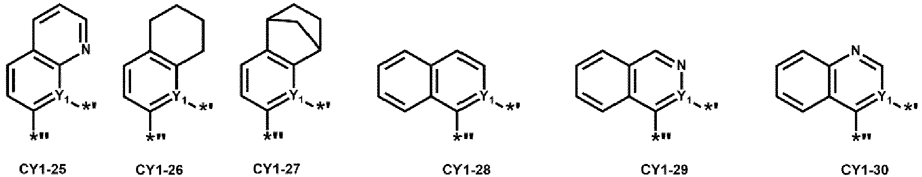 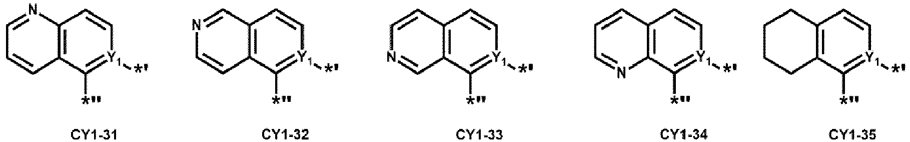 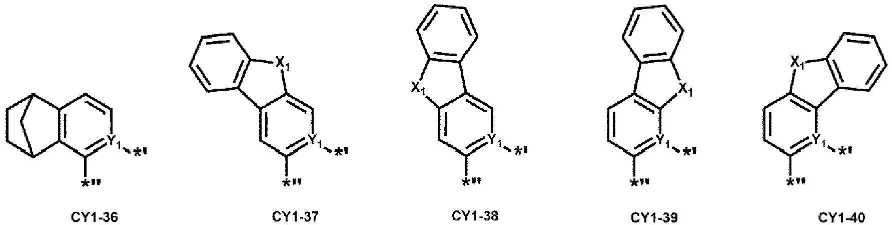 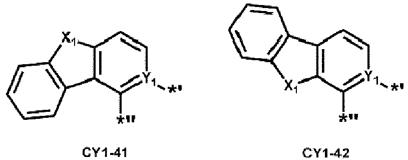 wherein, in Formulae CY1-1 to CY1-42,
Y₁ may be the same as described in the present specification,
X₁ may be O, S, Se, or a moiety including N, C, or Si,
*' indicates a binding site to M in Formula 1, and
*" indicates a binding site to ring CY₂ in Formula 2.

In one or more embodiments, a group represented by 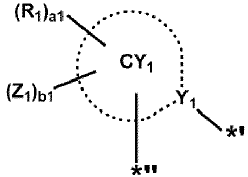 in Formula 2 may be a group represented by one of Formulae CY1-10 to CY1-42.

In one or more embodiments, a group represented by 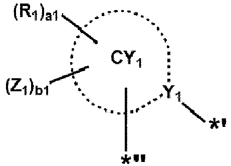 in Formula 2 may be a group represented by one of Formulae CY1(1) to CY1(16) or CY1(1)Z to CY1(38)Z: 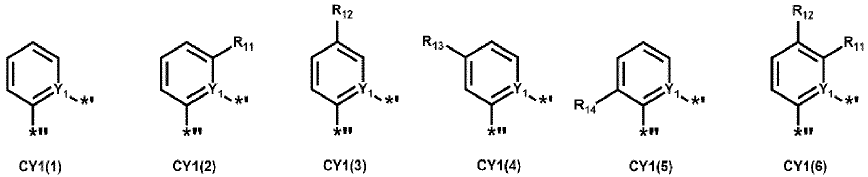 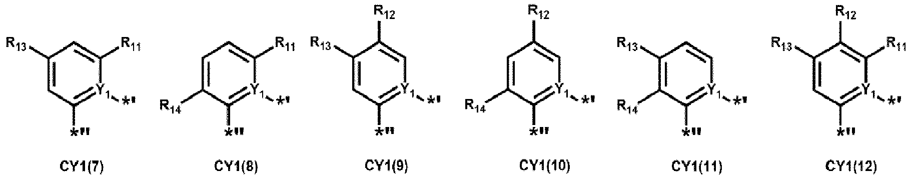 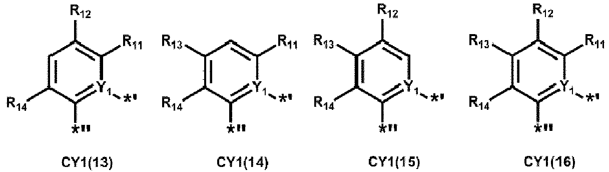 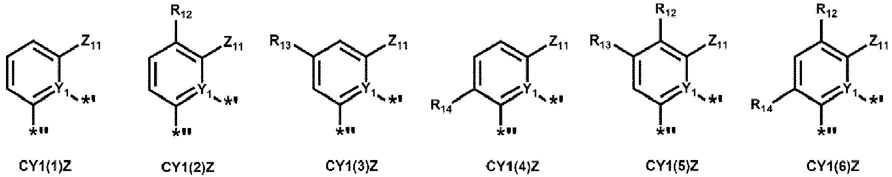 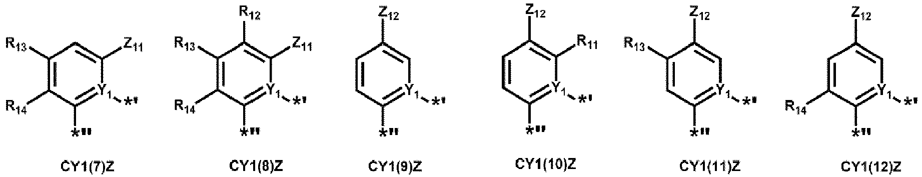 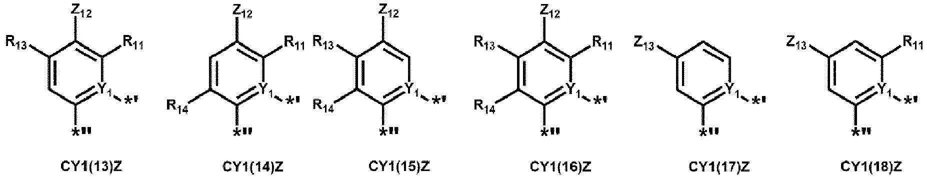 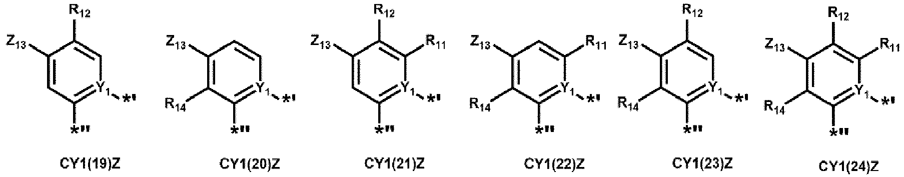 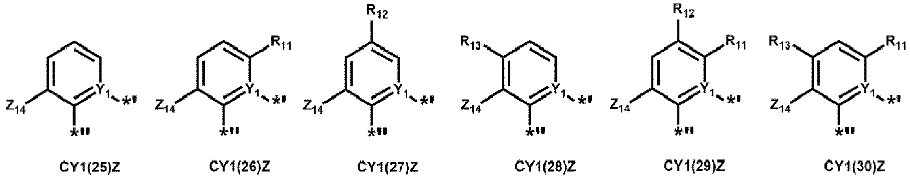 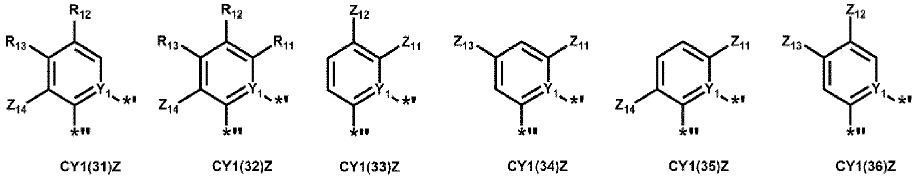 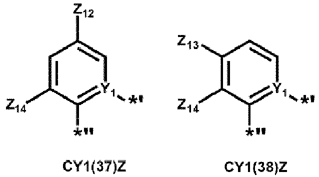 wherein, in Formulae CY1(1) to CY1(16) and CY1(1)Z to CY1(38)Z,
Y₁ may be the same as described in the present specification,
R₁₁ to R₁₄ may each be the same as described in connection with R₁, provided that each of R₁₁ to R₁₄ may not be hydrogen,
Z₁₁ to Z₁₄ may each be the same as described in connection with Z₁,
*' indicates a binding site to M in Formula 1, and
*" indicates a binding site to ring CY₂ in Formula 2.

For example, Formulae CY1(1) to CY1(16) and CY1(1)Z to CY1(38)Z may satisfy:
i) one of Condition 1-1-1 and Condition 1-1-2,
ii) Condition 1-2, or
iii) one of Condition 1-1-1 and Condition 1-1-2, and Condition 1-2:

### Condition 1-1-1

R₁₂ is hydrogen;

### Condition 1-1-2

R₁₂ is: deuterium; -F; a C₁-C₂₀ alkyl group or a C₃-C₁₀ cycloalkyl group, each unsubstituted or substituted with deuterium, -F, a C₁-C₁₀ alkyl group, or a combination thereof; a group represented by -Si(Q₃)(Q₄)(Q₅); or a group represented by-Ge(Q₃)(Q₄)(Q₅);

### Condition 1-2

R₁₃ includes two or more carbon atoms (for example, R₁₃ is a C₂-C₂₀ alkyl group, a C₃-C₁₀ cycloalkyl group, a phenyl group, or a biphenyl group, each unsubstituted or substituted with deuterium, -F, a C₁-C₁₀ alkyl group, or a combination thereof).

In one or more embodiments, a group represented by 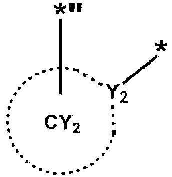 in Formula 2 may be a group represented by one of Formulae CY2-1 to CY2-64: 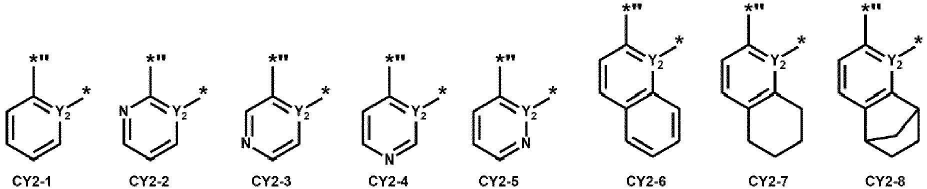 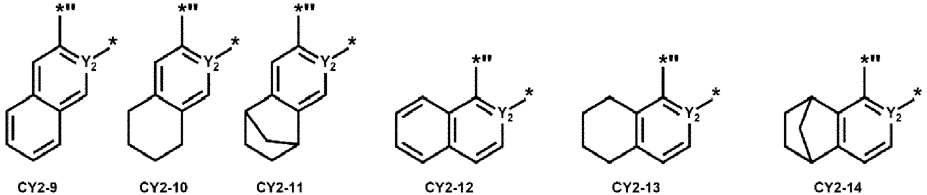 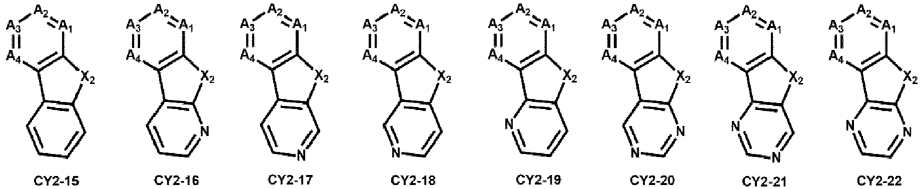 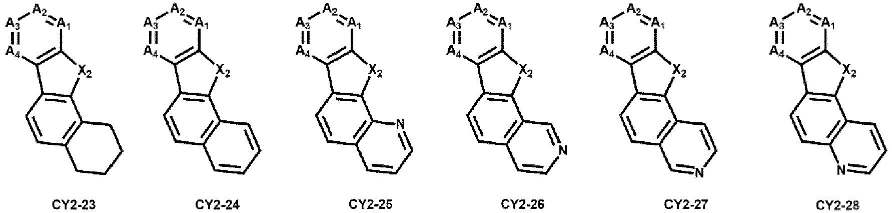 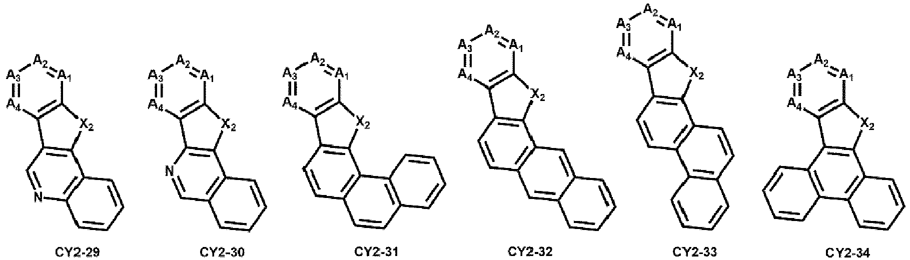 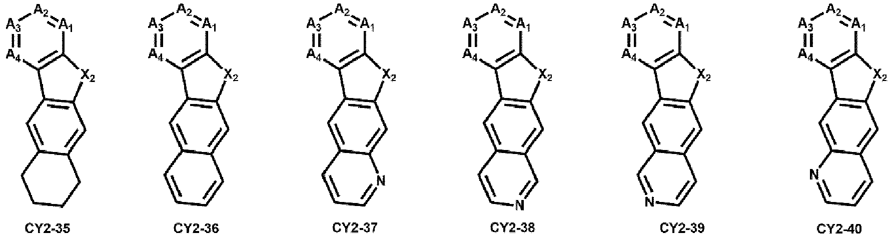 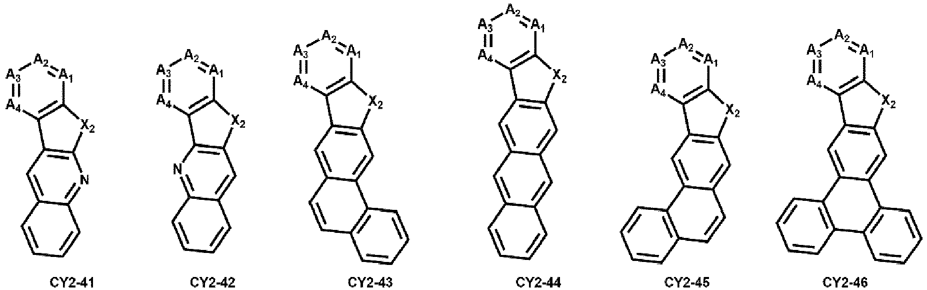 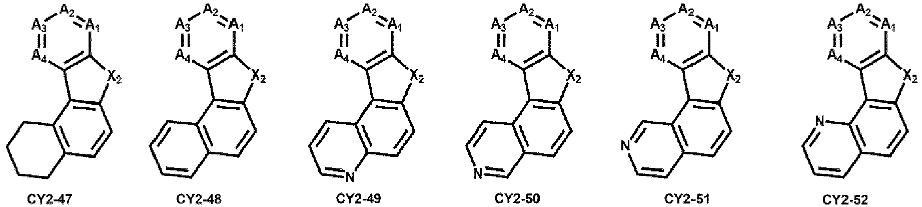 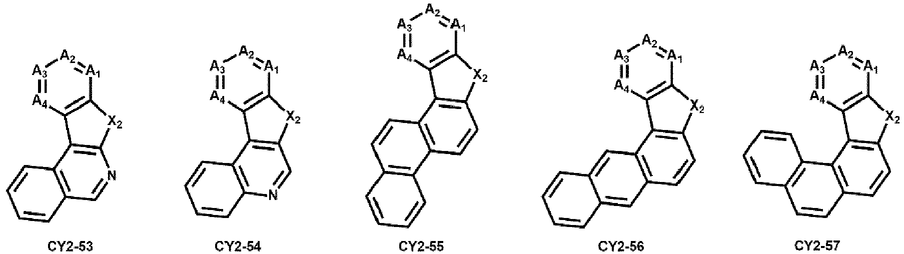 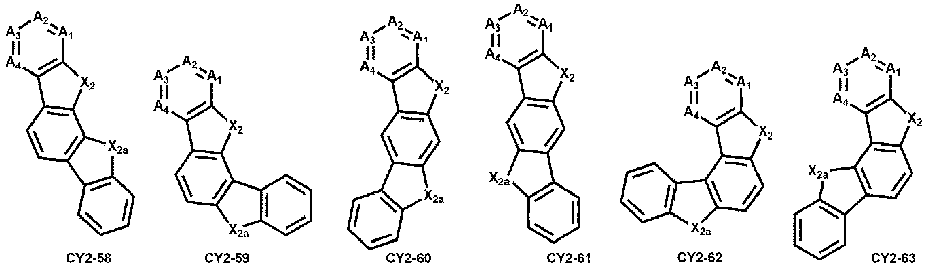 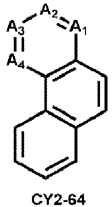 wherein, in Formulae CY2-1 to CY2-64,
Y₂ may be the same as described in the present specification,
X₂ and X₂ₐ may each independently be O, S, Se, or a moiety including N, C, or Si,
* in Formulae CY2-1 to CY2-14 indicates a binding site to M in Formula 1,
*" in Formulae CY2-1 to CY2-14 indicates a binding site to ring CY₁ in Formula 2, and
Formulae CY2-15 to CY2-64 may satisfy one of Condition 2-1 to Condition 2-6:
Condition 2-1:
   A₁ is Y₂,
   A₂ indicates a binding site to ring CY₁ in Formula 2, and
   A₃ and A₄ are each independently N or C;
Condition 2-2:
   A₂ is Y₂,
   A₃ indicates a binding site to ring CY₁ in Formula 2, and
   A₁ and A₄ are each independently N or C;
Condition 2-3:
   A₃ is Y₂,
   A₄ indicates a binding site to ring CY₁ in Formula 2, and
   A₁ and A₂ are each independently N or C;
Condition 2-4:
   A₄ is Y₂,
   A₃ indicates a binding site to ring CY₁ in Formula 2, and
   A₁ and A₂ are each independently N or C;
Condition 2-5:
   A₃ is Y₂,
   A₂ indicates a binding site to ring CY₁ in Formula 2, and
   A₁ and A₄ are each independently N or C;
Condition 2-6:
   A₂ is Y₂,
   A₁ indicates a binding site to ring CY₁ in Formula 2, and
   A₃ and A₄ are each independently N or C.

In one or more embodiments, a group represented by 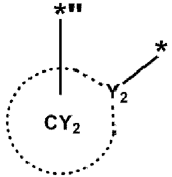 in Formula 2 may be a group represented by one of Formulae CY2-6 to CY2-14 and CY2-23 to CY2-64. For example, a group represented by 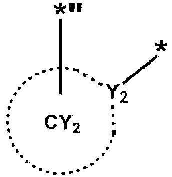 in Formula 2 may be a group represented by one of Formulae CY2-6 to CY2-14 and a2 and b2 in Formula 2 may be 0.

In one or more embodiments, a group represented by 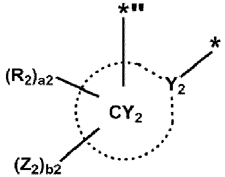 in Formula 2 may be a group represented by one of Formulae CY2(1) to CY2(96) and CY2(1)Z to CY2(54)Z: 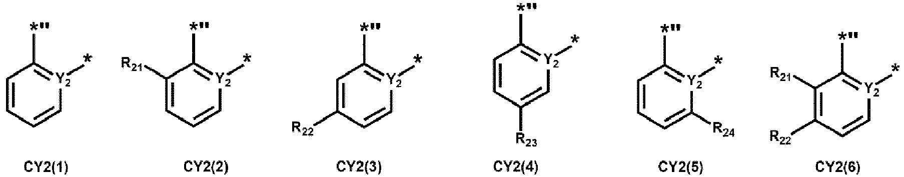 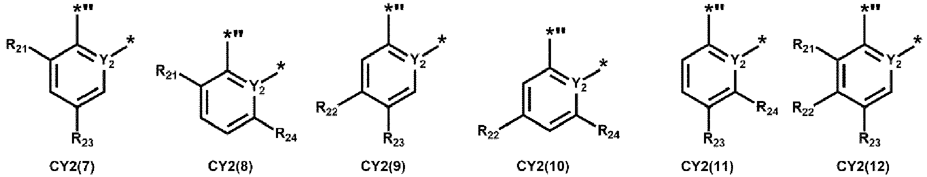 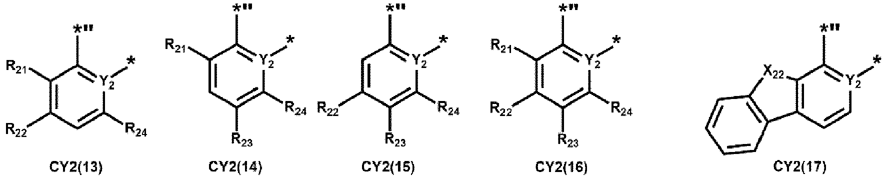 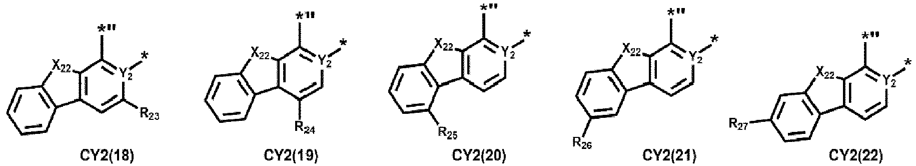 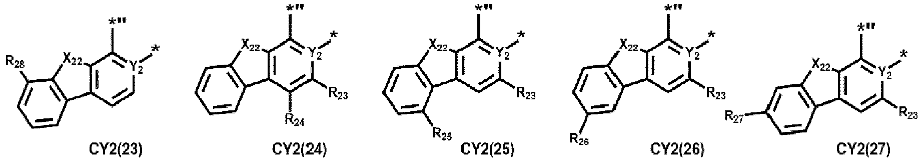 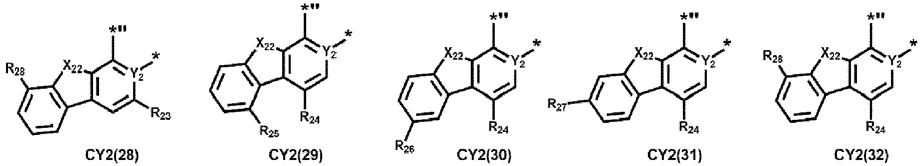 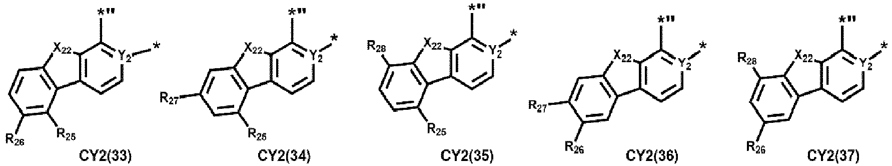 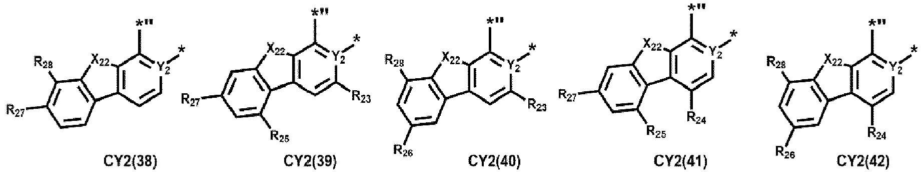 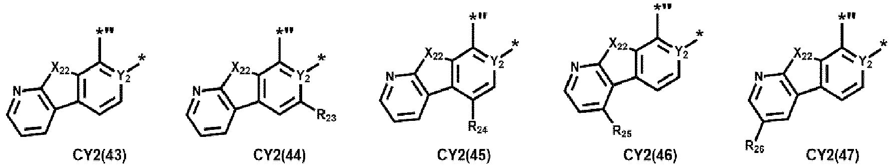 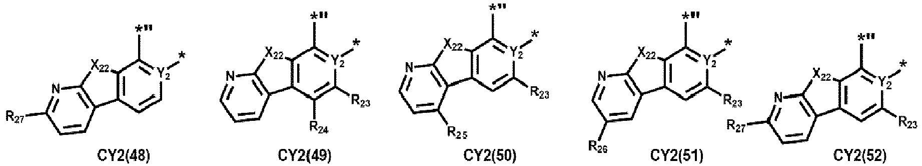 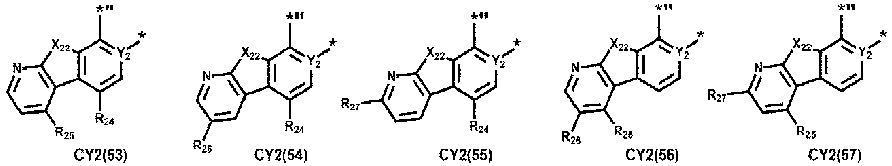 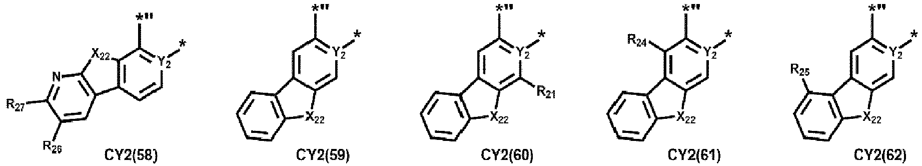 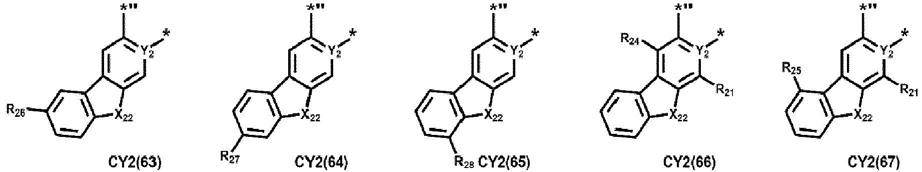 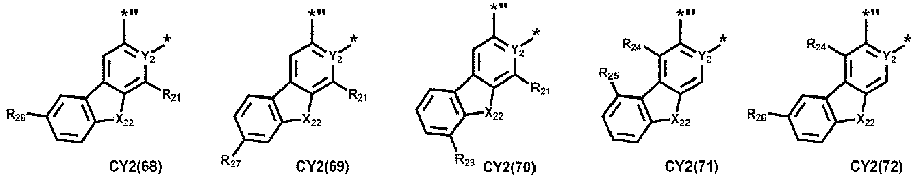 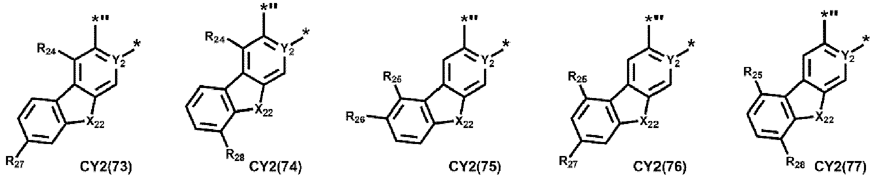 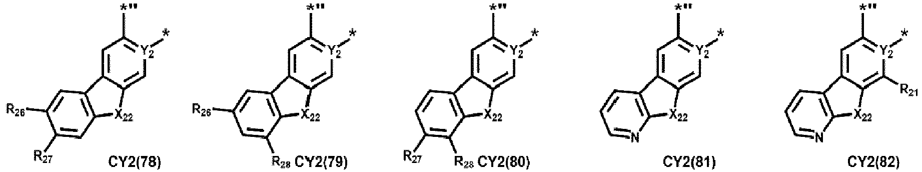 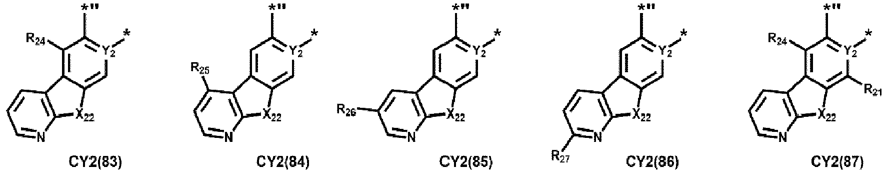 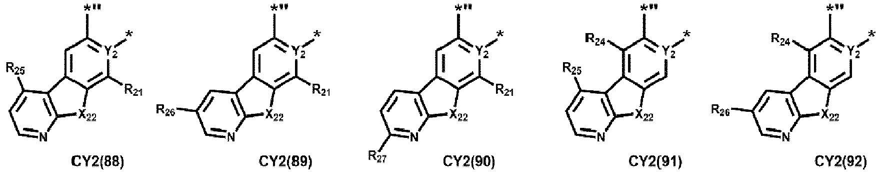 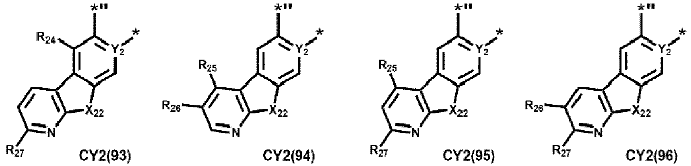 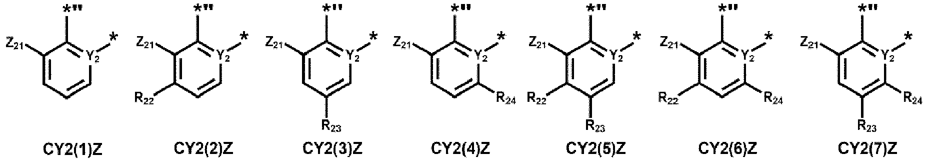 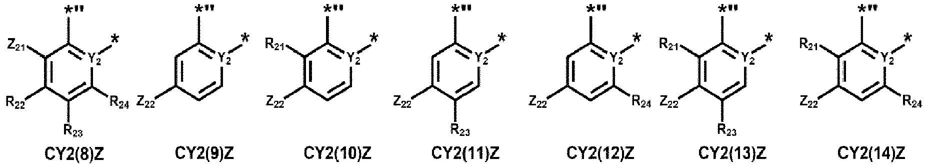 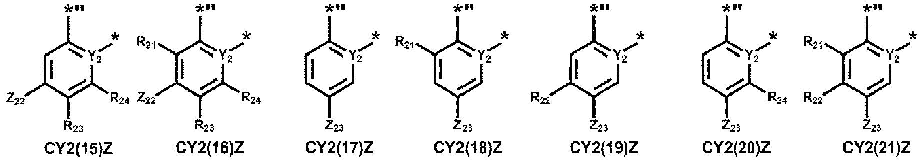 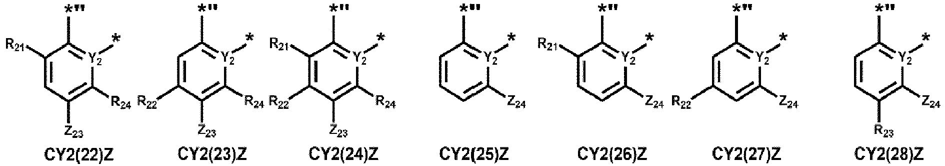 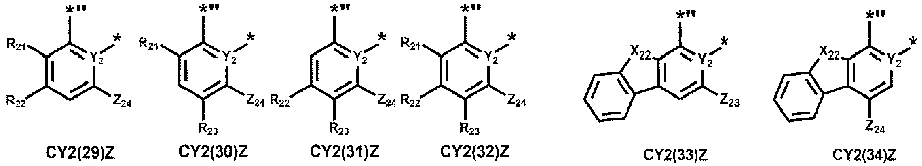 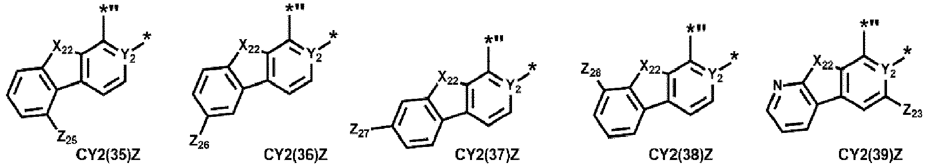 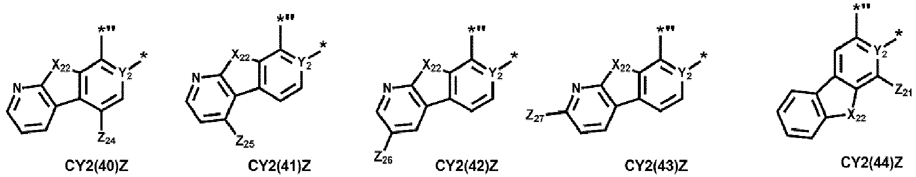 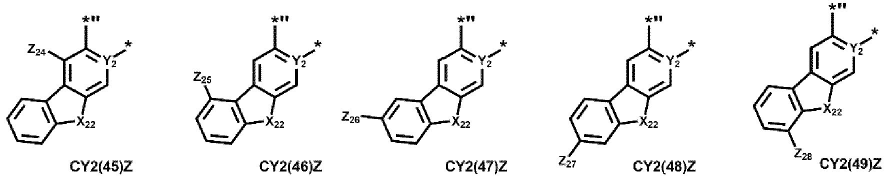 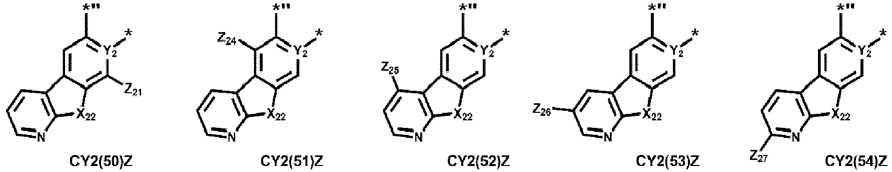 wherein, in Formulae CY2(1) to CY2(96) and CY2(1)Z to CY2(54)Z,
Y₂ may be the same as described in the present specification,
X₂₂ may be C(R₂₉ₐ)(R_{29b}), N(R₂₉ₐ), O, S, Se, or Si(R₂₉ₐ)(R_{29b}),
R₂₁ to R₂₈, R₂₉ₐ, and R_{29b} may each be the same as described in connection with R₂, and each of R₂₁ to R₂₈ may not be hydrogen,
Z₂₁ to Z₂₈ may each be the same as described in connection with Z₂,
* indicates a binding site to M in Formula 1, and
*" indicates a binding site to ring CY₁ in Formula 2.

In one or more embodiments, L₁ in Formula 1 may include deuterium, a fluoro group (-F), a group represented by Si(Q₃)(Q₄)(Q₅), a group represented by-Ge(Q₃)(Q₄)(Q₅), or a combination thereof.

In one or more embodiments, L₂ in Formula 1 may be a group represented by one of Formulae 4A to 4F: 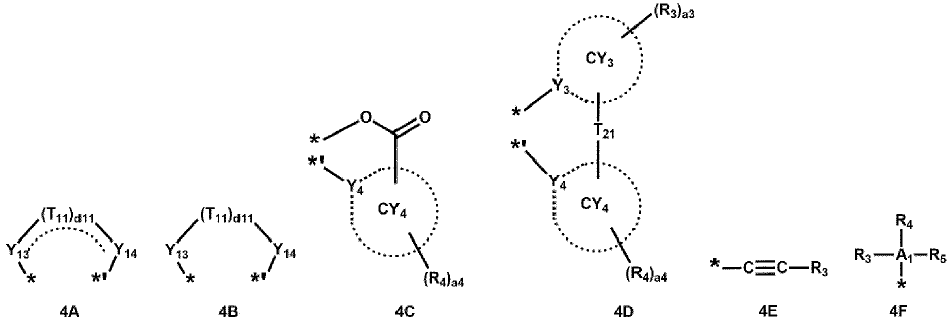 wherein, in Formulae 4A to 4F,
Y₁₃ may be O, N, N(R₃), P(R₃)(R₄), or As(R₃)(R₄),
Y₁₄ may be O, N, N(R₅), P(R₅)(R₆), or As(R₅)(R₆),
T₁₁ may be a single bond, a double bond, *-C(R₃₁)(R₃₂)-*', *-C(R₃₁)=C(R₃₂)-*', *=C(R₃₁)-*', *-C(R₃₁)=*', *=C(R₃₁)-C(R₃₂)=C(R₃₃)-*', *-C(R₃₁)=C(R₃₂)-C(R₃₃)=*', *-N(R₃₁)-*', or a C₅-C₃₀ carbocyclic group unsubstituted or substituted with at least one R₃₁,
d11 may be an integer from 1 to 10, wherein, when d11 is 2 or greater, two or more of T₁₁ groups may be identical to or different from each other,
Y₃ and Y₄ may each independently be C or N,
T₂₁ may be a single bond, a double bond, O, S, Se, C(R₅)(R₆), Si(R₅)(R₆), or N(R₅),
ring CY₃ and ring CY₄ may each independently be a C₅-C₃₀ carbocyclic group or a C₁-C₃₀ heterocyclic group,
A₁ may be P or As,
R₁, R₃ to R₆ and R₃₁ to R₃₃ may each be the same as described in connection with
a3 and a4 may each independently be an integer from 0 to 20, and
* and *' each indicate a binding site to M in Formula 1.
For example, L₂ in Formula 1 may be a group represented by Formula 4D.

In one or more embodiments, Y₃, Y₄, ring CY₃, ring CY₄, R₃, R₄, a3, and a4 in Formulae 4C and/or 4D may each be the same as described in connection with Y₁, Y₂, ring CY₁, ring CY₂, R₁, R₂, a1, and a2 in Formula 2, respectively.

In one or more embodiments, in Formula 4D, Y₃ may be N, and Y₄ may be C.

In one or more embodiments, in Formula 4D, T₂₁ may be a single bond.

In one or more embodiments, at least one of R₃ groups in the number of a3 in Formula 4D may be: deuterium; -F; a C₁-C₂₀ alkyl group or a C₃-C₁₀ cycloalkyl group, each unsubstituted or substituted with deuterium, -F, C₁-C₁₀ alkyl group, or a combination thereof; a group represented by -Si(Q₃)(Q₄)(Q₅); or a group represented by -Ge(Q₃)(Q₄)(Q₅), wherein Q₃ to Q₅ are defined the same as Q₃ to Q₅ occurred in the definition of R₁ and R₂ in Formula 2.

In one or more embodiments, at least one of R₄ groups in the number of a4 in Formulae 4C and 4D may be: deuterium; -F; or a C₁-C₂₀ alkyl group or a C₃-C₁₀ cycloalkyl group, each unsubstituted or substituted with deuterium, -F, a C₁-C₁₀ alkyl group, or a combination thereof.

In one or more embodiments, a group represented by 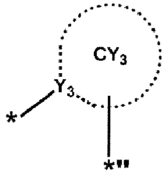 in Formula 4D may be a group represented by one of Formulae CY3-1 to CY3-42: 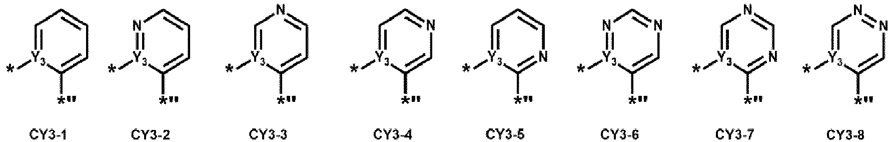 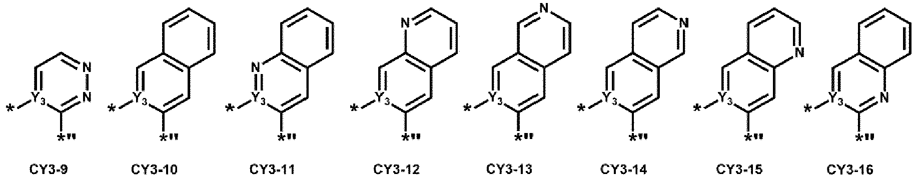 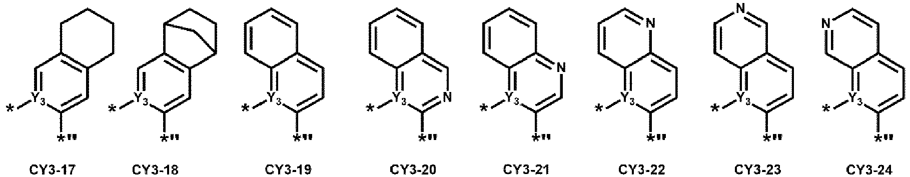 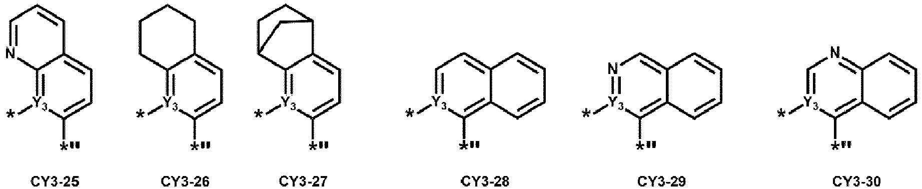 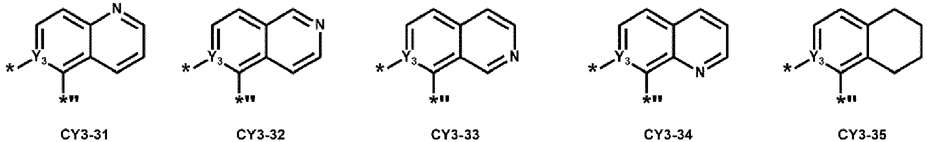 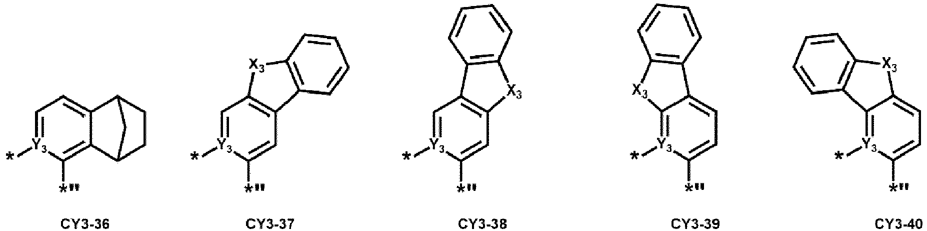 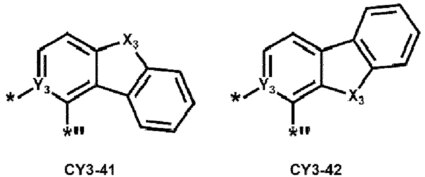 wherein, in Formulae CY3-1 to CY3-42,
Y₃ may be the same as described in the present specification,
X₃ may be O, S, Se, or a moiety including N, C, or Si,
* indicates a binding site to M in Formula 1, and
*" indicates a binding site to T₂₁ in Formula 4D.

In one or more embodiments, a group represented by 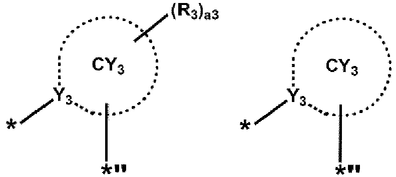 in Formula 4D may be a group represented by one of Formulae CY3-10 to CY3-42. For example, a group represented by 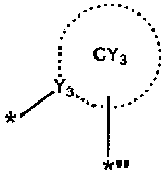 in Formula 4D may be a group represented by one of Formulae CY3-10 to CY3-42 and a3 in Formula 4D may be 0.

In one or more embodiments, a group represented by 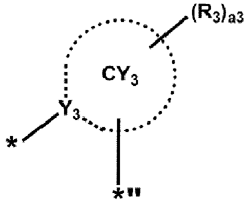 in Formula 4D may be a group represented by one of Formulae CY3(1) to CY3(16): 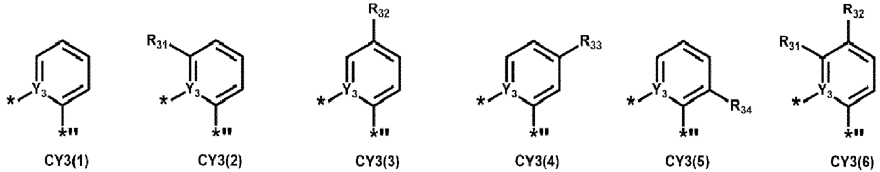 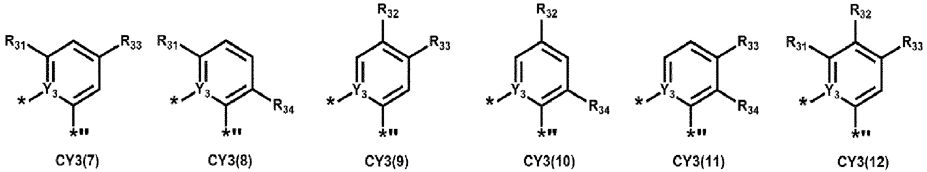 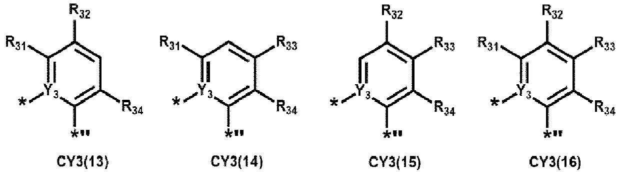 wherein, in Formulae CY3(1) to CY3(16),
Y₃ may be the same as described in the present specification,
R₃₁ to R₃₄ may each be the same as described in connection with R₃, provided that each of R₃₁ to R₃₄ may not be hydrogen,
* indicates a binding site to M in Formula 1, and
*" indicates a binding site to T₂₁ in Formula 4D.

For example, Formulae CY3(1) to CY3(16) may satisfy:
i) one of Condition 3-1-1 and Condition 3-1-2,
ii) Condition 3-2, or
iii) one of Condition 3-1-1 and Condition 3-1-2 as well as Condition 3-2:
   Condition 3-1-1:
      R₃₂ is hydrogen;
   Condition 3-1-2:
      R₃₂ is deuterium; -F; a C₁-C₂₀ alkyl group or a C₃-C₁₀ cycloalkyl group, each unsubstituted or substituted with deuterium, -F, a C₁-C₁₀ alkyl group, or a combination thereof; a group represented by -Si(Q₃)(Q₄)(Q₅); or a group represented by-Ge(Q₃)(Q₄)(Q₅), wherein Q₃ to Q₅ are defined the same as Q₃ to Q₅ occurred in the deficition of R₃;
   Condition 3-2:
      R₃₃ includes two or more carbon atoms (for example, R₃₃ is a C₂-C₂₀ alkyl group, a C₃-C₁₀ cycloalkyl group, a phenyl group, or a biphenyl group, each unsubstituted or substituted with deuterium, -F, a C₁-C₁₀ alkyl group, or a combination thereof).

In one or more embodiments, a group represented by 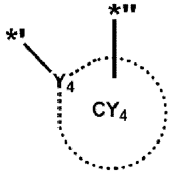 in Formulae 4C and 4D may be a group represented by one of Formulae CY4-1 to CY4-14, or may be a group represented by one of Formulae CY2-15 to CY2-64 that satisfy one of Condition 4-1 to Condition 4-6: 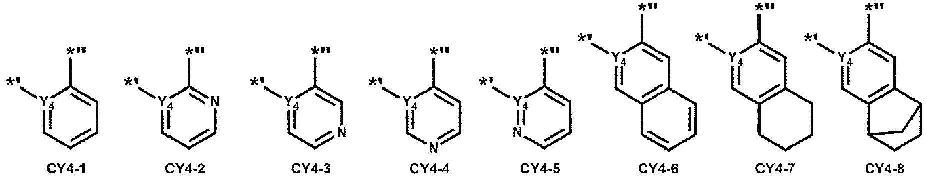 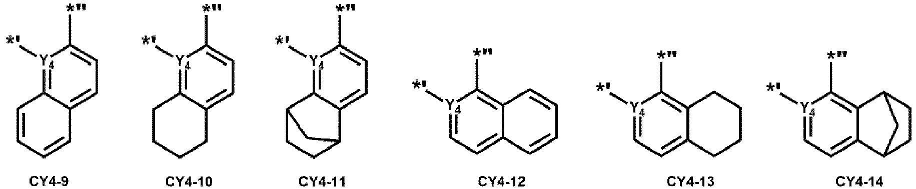 wherein, in Formulae CY4-1 to CY4-14,
Y₄ may be the same as described in the present specification,
X₂ and X₂ₐ may each independently be O, S, Se, or a moiety including N, C, or Si,
*' in Formulae CY4-1 to CY4-14 indicates a binding site to M in Formula 1,
*" in Formulae CY4-1 to CY4-14 indicates a binding site to a neighboring atom in Formula 4C or a binding site to T₂₁ in Formula 4D, and
Condition 4-1 to Condition 4-6 are as follows:
Condition 4-1:
   A₁ is Y₄,
   A₂ indicates a binding site to a neighboring atom in Formula 4C or a binding site to T₂₁ in Formula 4D, and
   A₃ and A₄ are each independently N or C;
Condition 4-2:
   A₂ is Y₄,
   A₃ indicates a binding site to a neighboring atom in Formula 4C or a binding site to T₂₁ in Formula 4D, and
   A₁ and A₄ are each independently N or C
Condition 4-3:
   A₃ is Y₄,
   A₄ indicates a binding site to a neighboring atom in Formula 4C or a binding site to T₂₁ in Formula 4D, and
   A₁ and A₂ are each independently N or C;
Condition 4-4:
   A₄ is Y₄,
   A₃ indicates a binding site to a neighboring atom in Formula 4C or a binding site to T₂₁ in Formula 4D, and
   A₁ and A₂ are each independently N or C;
Condition 4-5:
   A₃ is Y₄,
   A₂ indicates a binding site to a neighboring atom in Formula 4C or a binding site to T₂₁ in Formula 4D, and
   A₁ and A₄ are each independently N or C;
Condition 4-6:
   A₂ is Y₄,
   A₁ indicates a binding site to a neighboring atom in Formula 4C or a binding site to T₂₁ in Formula 4D, and
   A₃ and A₄ are each independently N or C.

In one or more embodiments, a group represented by 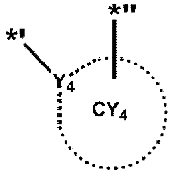 in Formulae 4C and 4D may be a group represented by one of Formulae CY4-6 to CY4-14, or may be a group represented by one of Formulae CY2-23 to CY2-64 that satisfy one of Condition 4-1 to Condition 4-6. For example, a group represented by 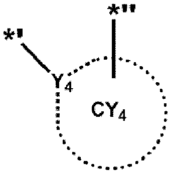 in Formulae 4C and 4D may be a group represented by one of Formulae CY4-6 to CY4-14, or may be a group represented by one of Formulae CY2-23 to CY2-64 that satisfy one of Condition 4-1 to Condition 4-6 and a4 in Formulae 4C and 4D may be 0.

In one or more embodiments, a group represented by 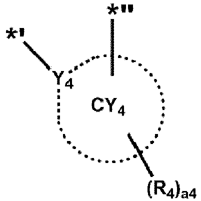 in Formula 4D may be a group represented by one of Formulae CY4(1) to CY4(96): 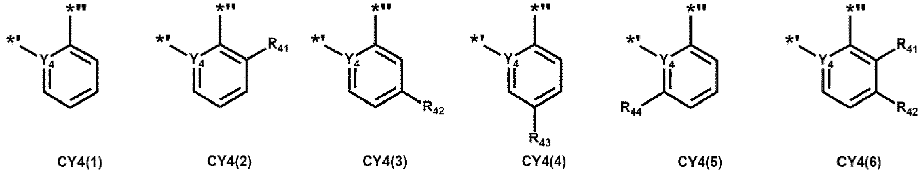 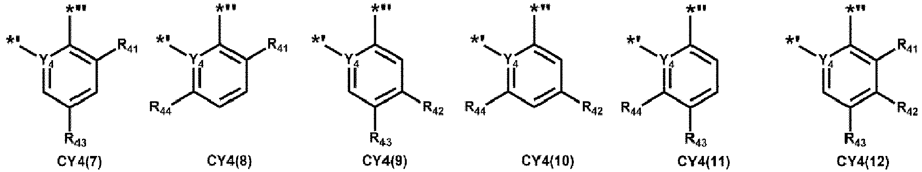 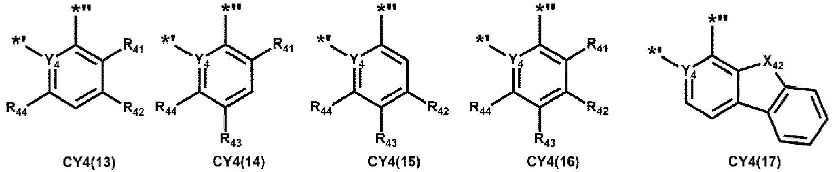 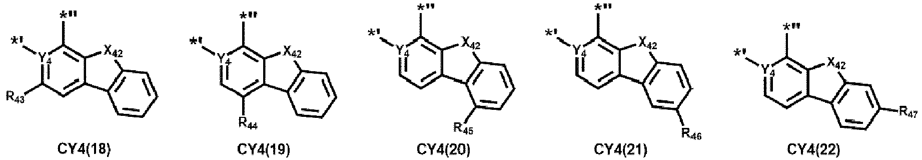 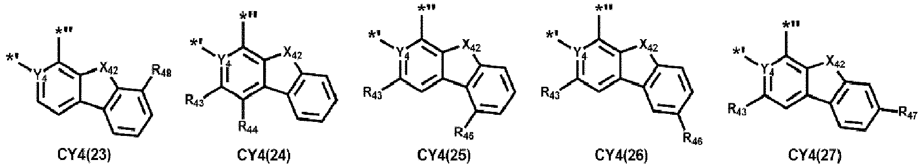 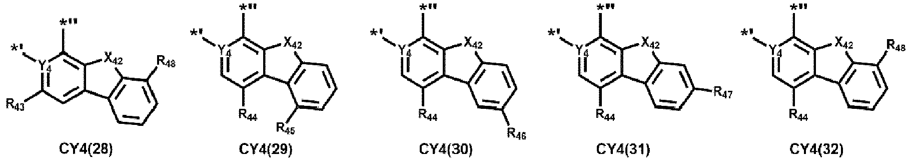 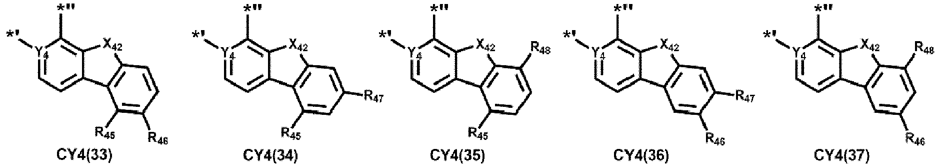 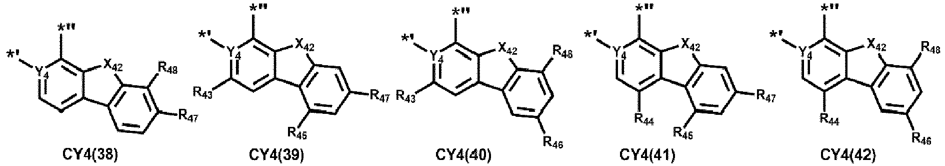 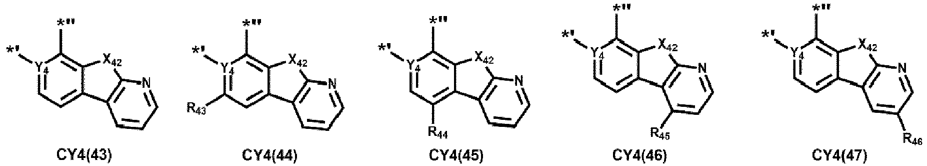 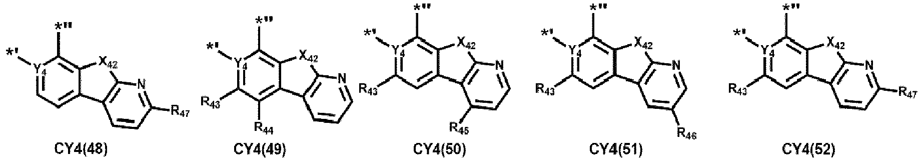 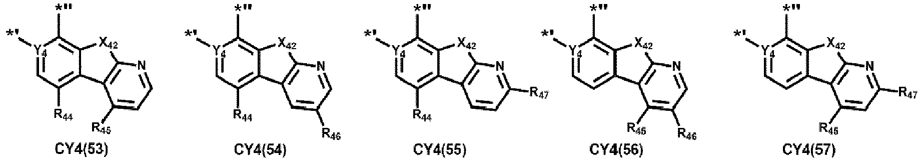 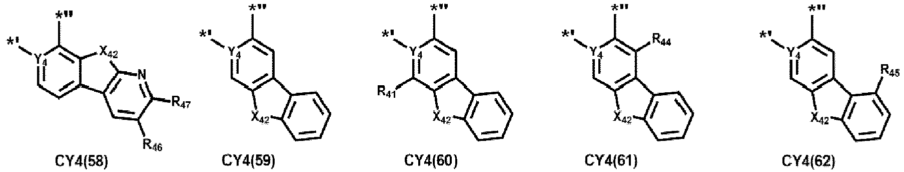 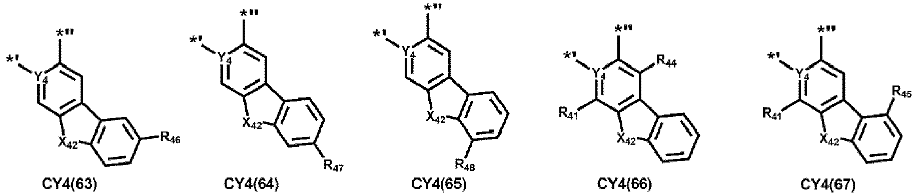 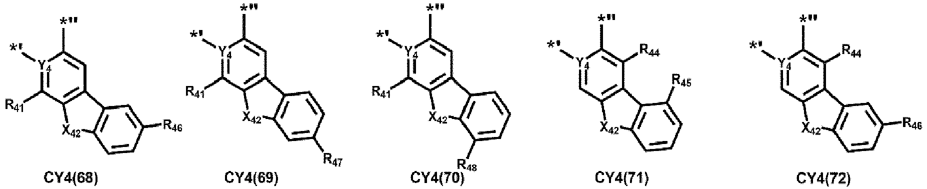 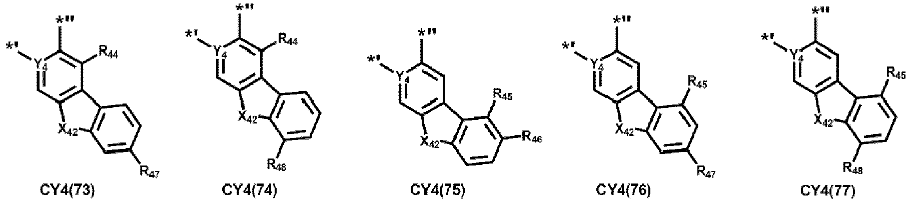 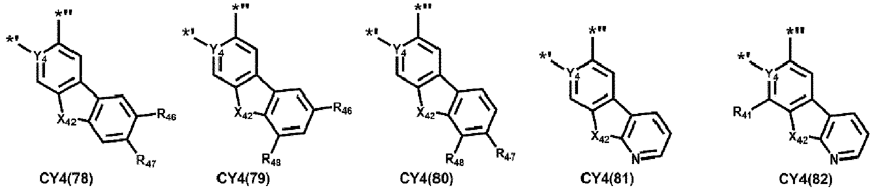 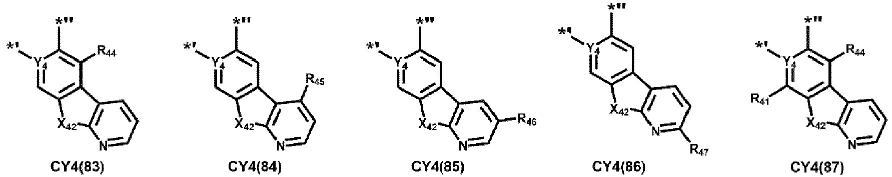 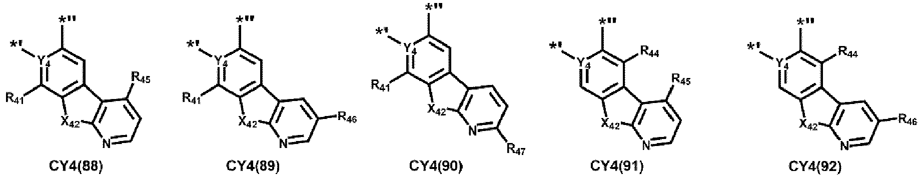 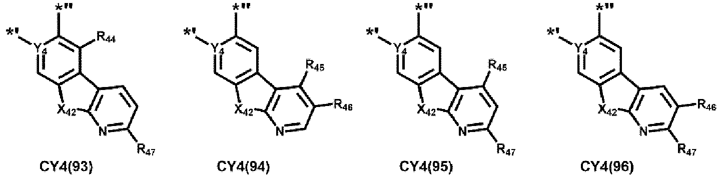 wherein, in Formulae CY4(1) to CY4(96),
Y₄ may be the same as described in the present specification,
X₄₂ may be C(R₄₉ₐ)(R_{49b}), N(R₄₉ₐ), O, S, Se, or Si(R₄₉ₐ)(R_{49b}),
R₄₁ to R₄₈, R₄₉ₐ, and R_{49b} are each the same as described in connection with R₄, and each of R₄₁ to R₄₈ may not be hydrogen,
*' indicates a binding site to M in Formula 1, and
*" indicates a binding site to a neighboring atom in Formula 4C or a binding site to T₂₁ in Formula 4D.

In one or more embodiments, L₂ in Formula 1 may include deuterium, a fluoro group (-F), a group represented by -Si(Q₃)(Q₄)(Q₅), a group represented by-Ge(Q₃)(Q₄)(Q₅), or a combination thereof.

In one or more embodiments, R₁ and R₂ in Formula 2 and R₃ to R₆ and R₃₁ to R₃₃ in Formulae 4A to 4F may each independently be hydrogen, deuterium, -F, a cyano group, a nitro group, -SF₅, -CH₃, -CD₃, -CD₂H, -CDH₂, -CF₃, -CF₂H, -CFH₂,-OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with deuterium, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with deuterium, a group represented by one of Formulae 10-201 to 10-353 in which at least one hydrogen is substituted with -F, -Si(Q₃)(Q₄)(Q₅), or -Ge(Q₃)(Q₄)(Q₅) (wherein Q₁ to Q₅ may each be the same as described in the present specification).

In one or more embodiments, Q₅₁ and Q₅₂ in Formula 3 may each independently be hydrogen, deuterium, -F-, a cyano group, -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with deuterium, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with deuterium, or a group represented by one of Formulae 10-201 to 10-353 in which at least one hydrogen is substituted with -F.

In one or more embodiments, at least one of Q₅₁ and Q₅₂ (for example, both Q₅₁ and Q₅₂) in Formula 3 may each independently be deuterium, -F-, a cyano group, -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, or a group represented by one of Formulae 9-1 to 9-39 in which at least one hydrogen is substituted with -F.

In one or more embodiments, Q₅₃ in Formula 3 may be a group represented by one of Formulae 10-12 to 10-132, a group represented by one of Formulae 10-12 to 10-132 in which at least one hydrogen is substituted with deuterium, a group represented by one of Formulae 10-12 to 10-132 in which at least one hydrogen is substituted with -F, a group represented by one of Formulae 10-201 to 10-353, a group represented by one of Formulae 10-201 to 10-353 in which at least one hydrogen is substituted with deuterium, or a group represented by one of Formulae 10-201 to 10-353 in which at least one hydrogen is substituted with -F: 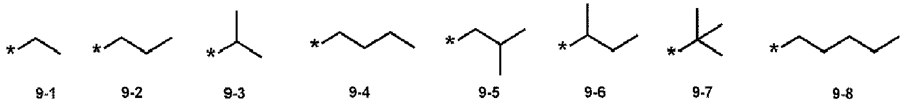 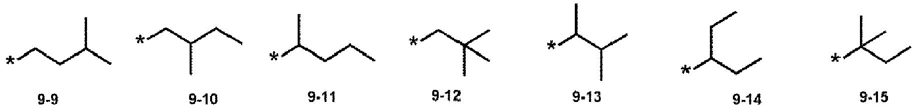 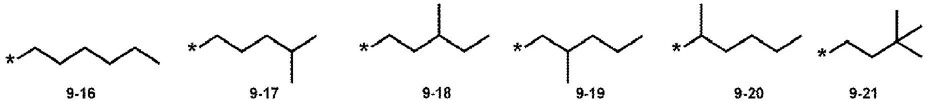 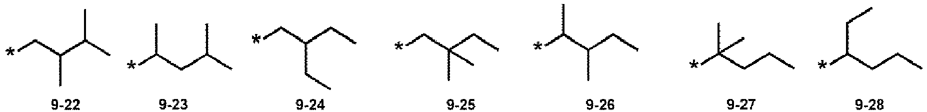 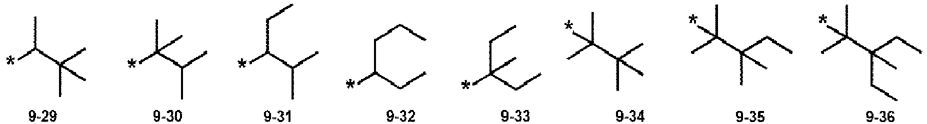 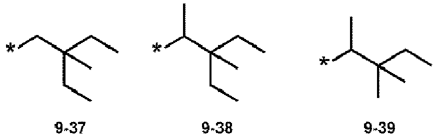 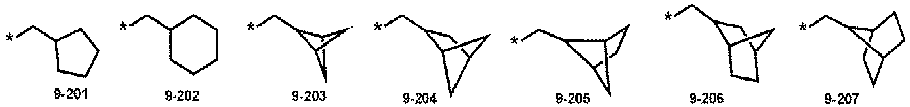 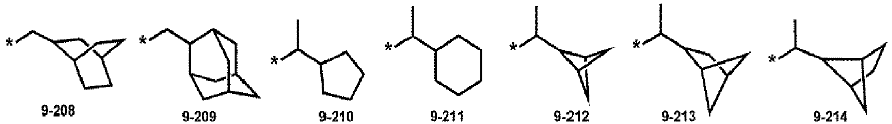 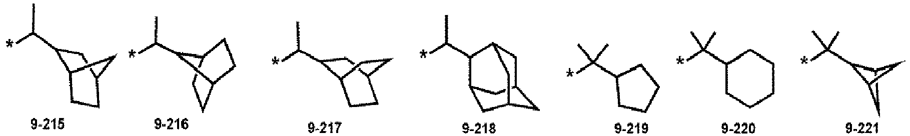 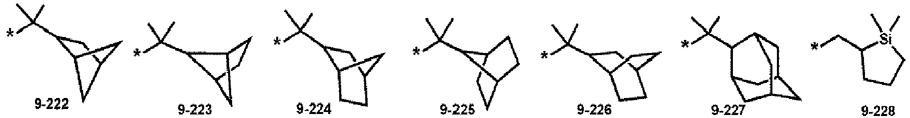 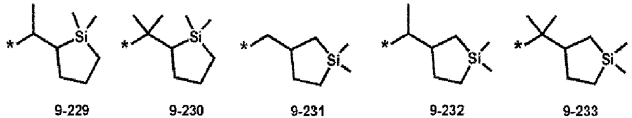 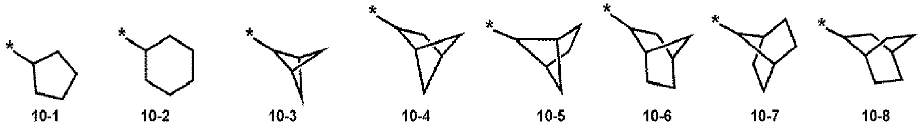 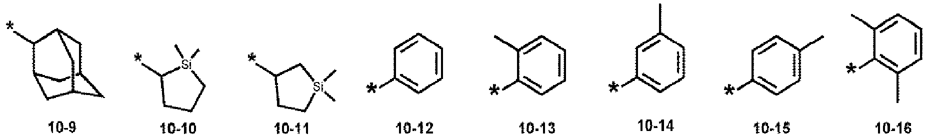 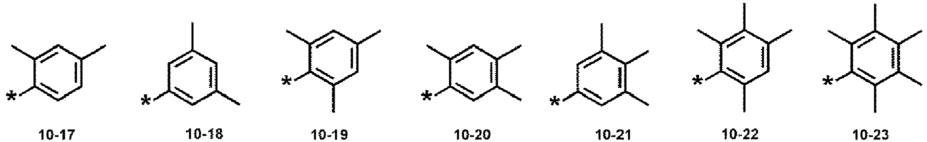 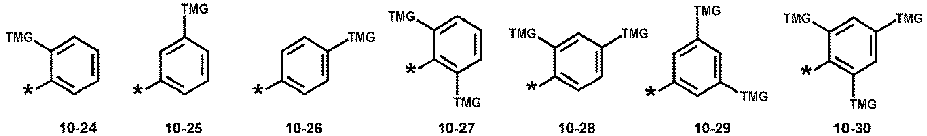 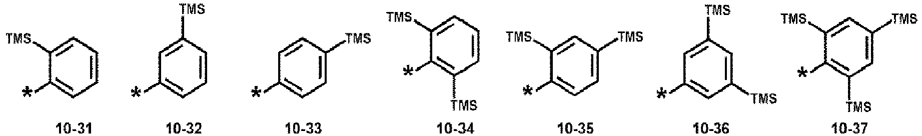 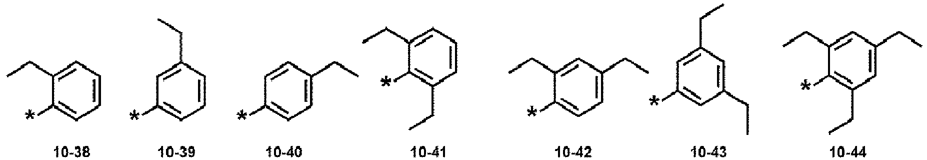 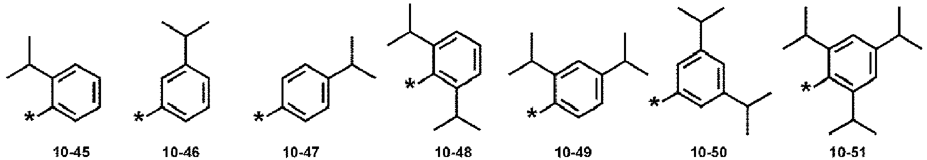 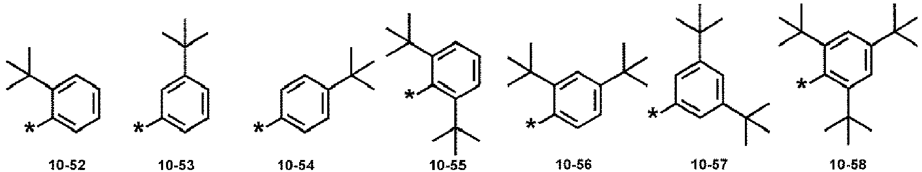 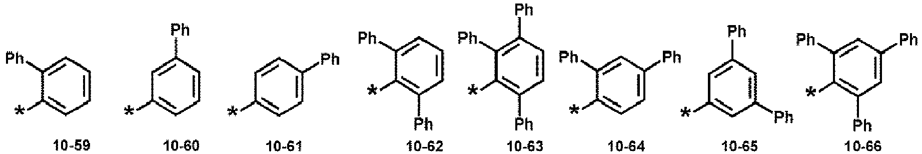 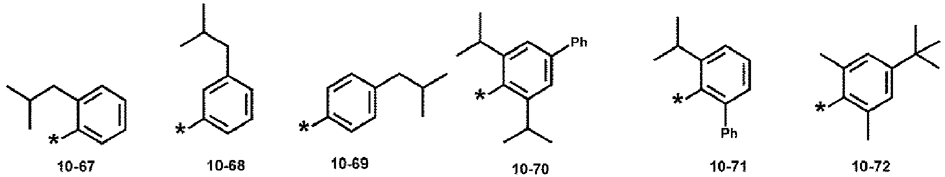 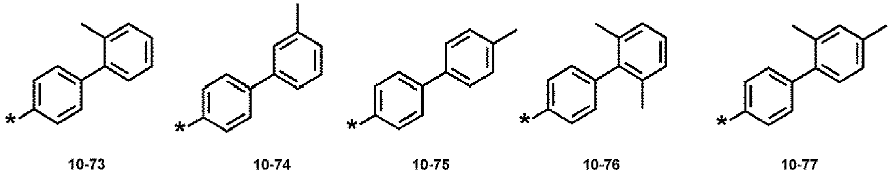 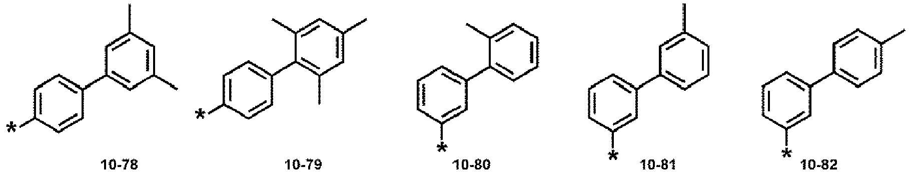 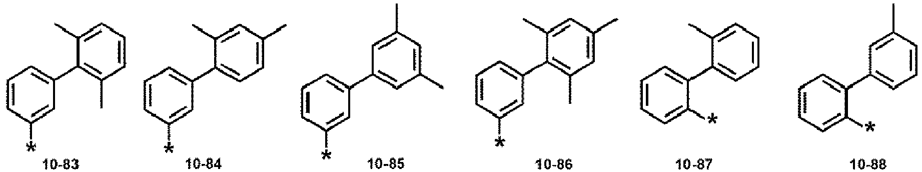 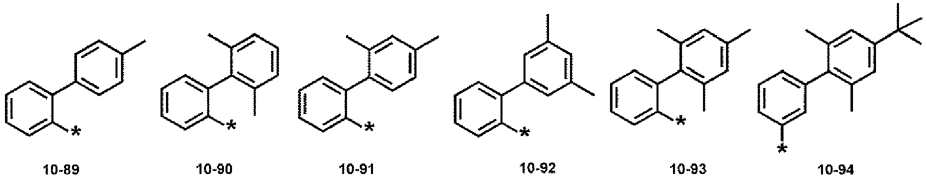 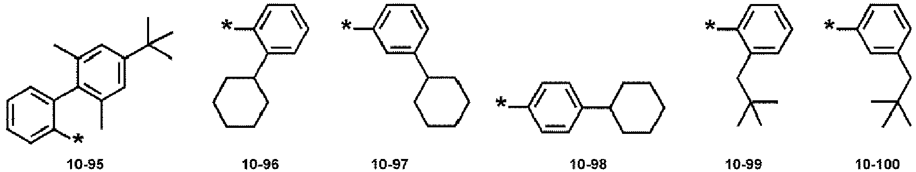 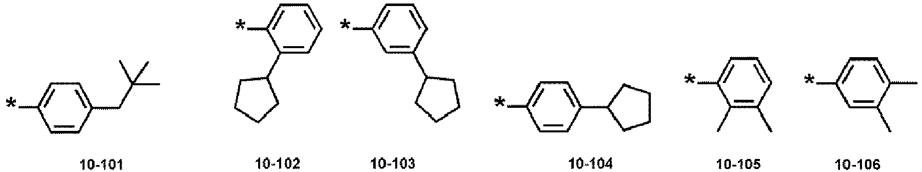 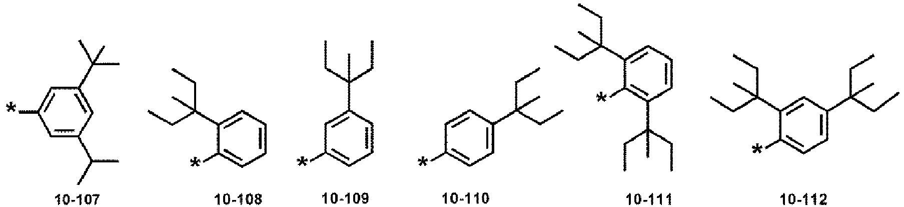 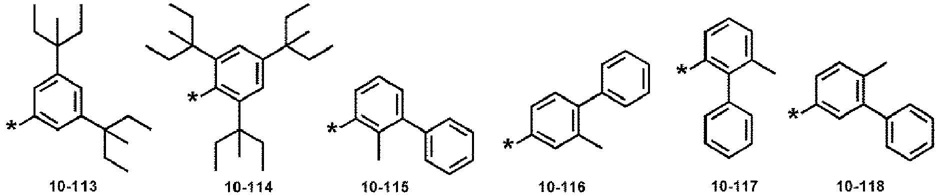 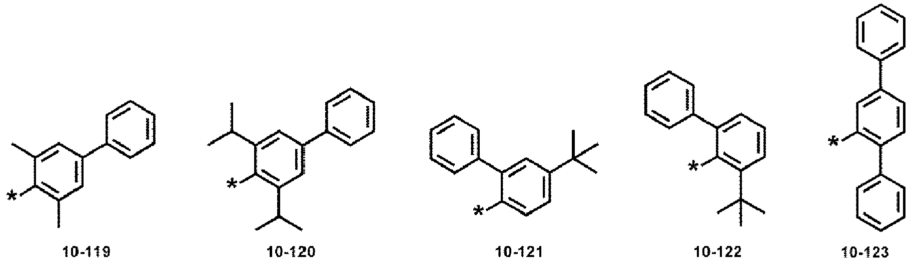 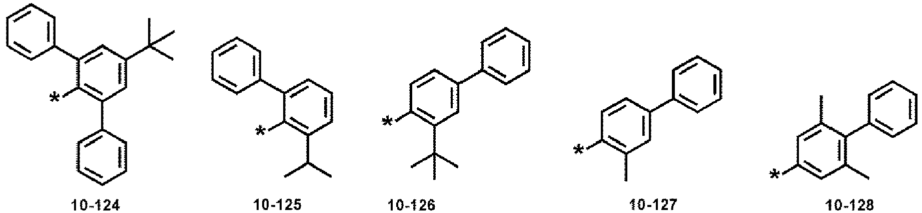 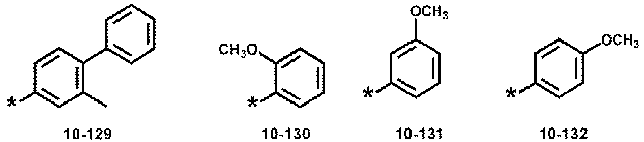 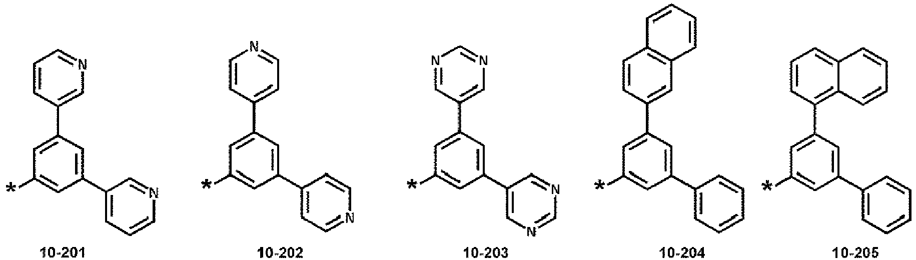 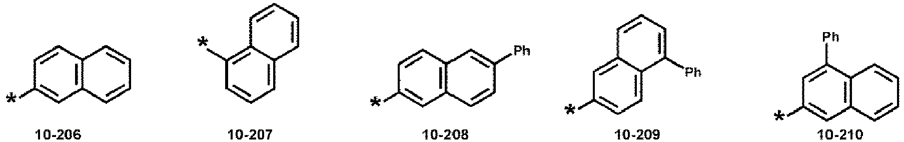 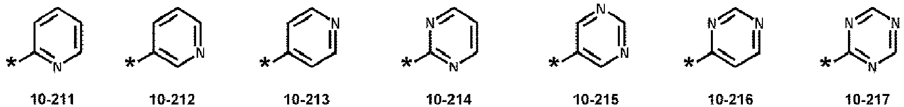 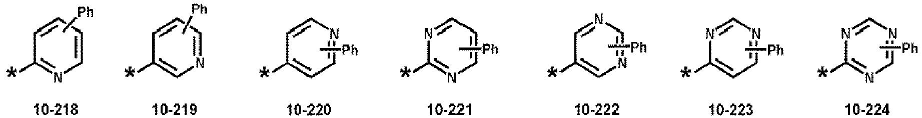 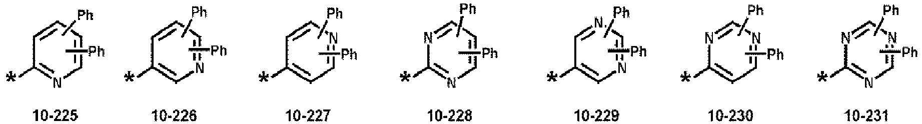 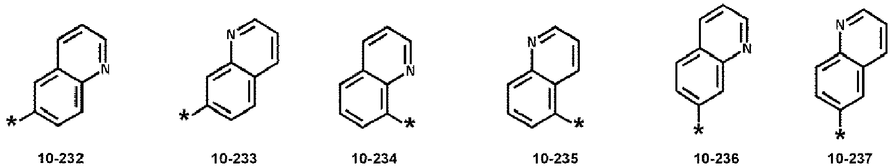 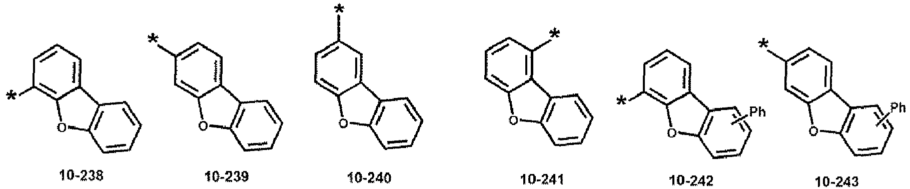 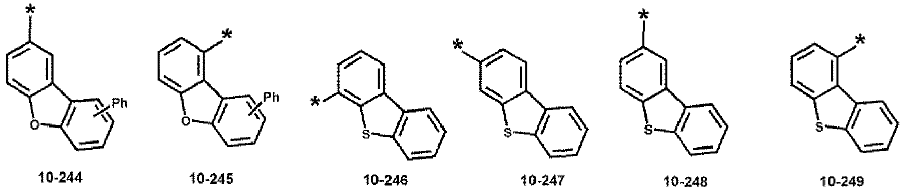 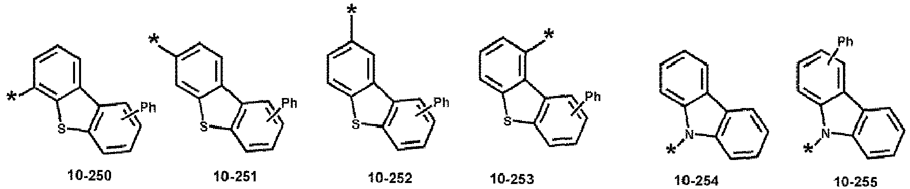 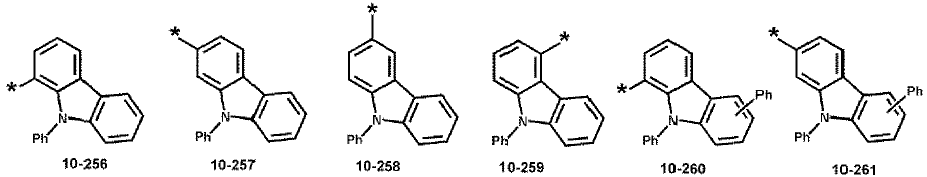 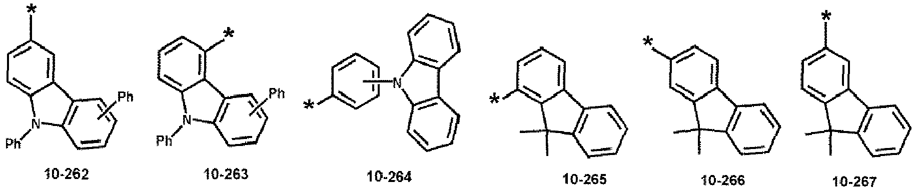 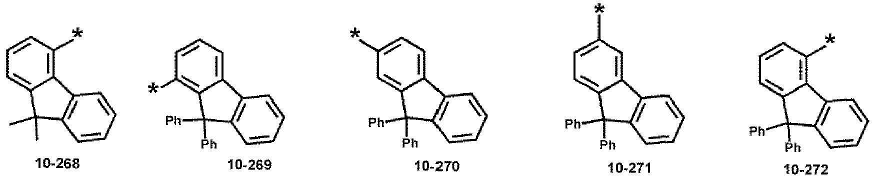 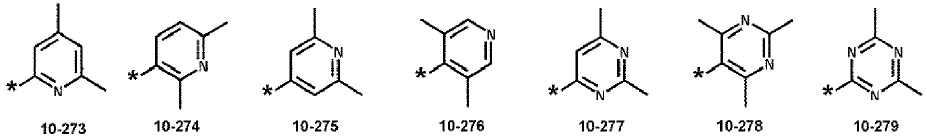 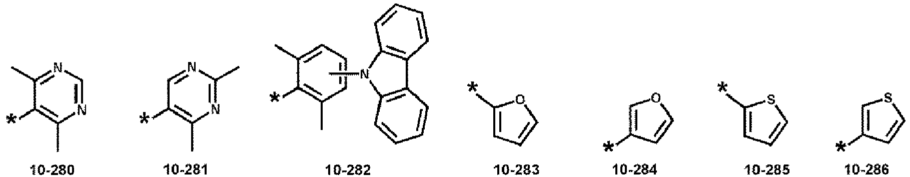 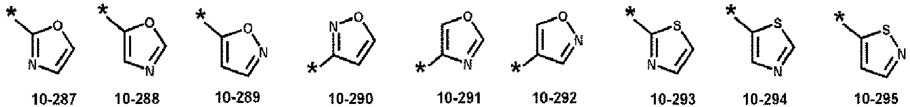 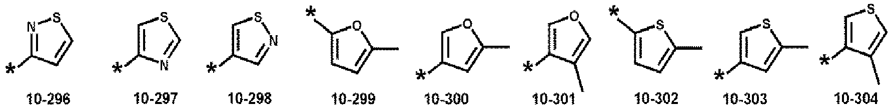 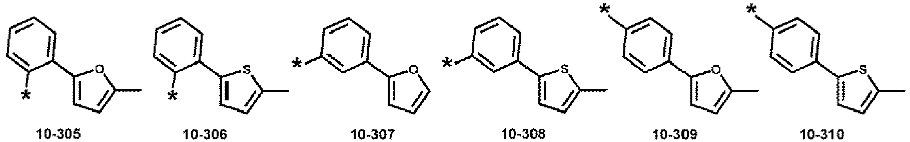 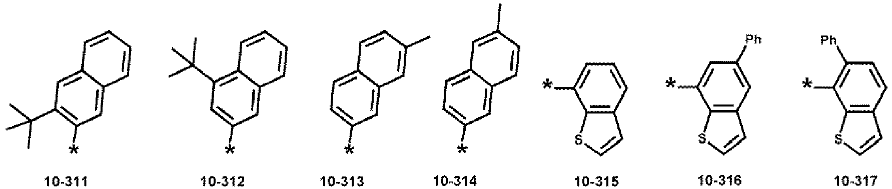 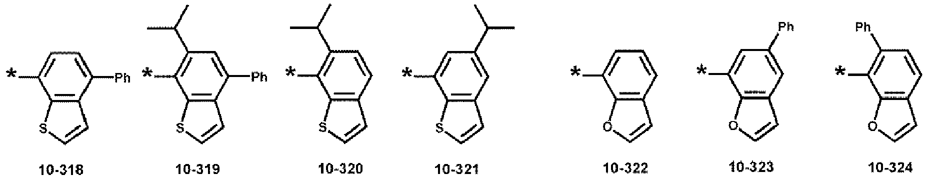 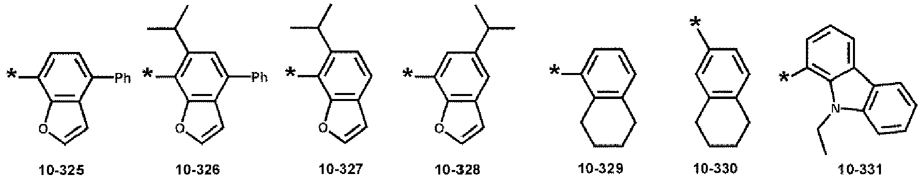 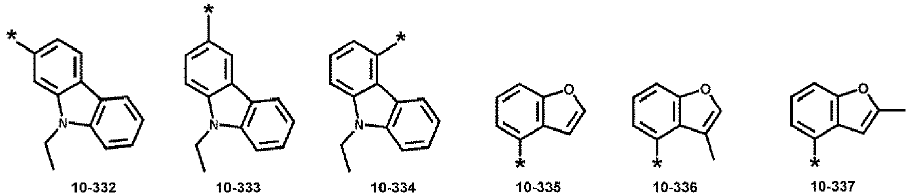 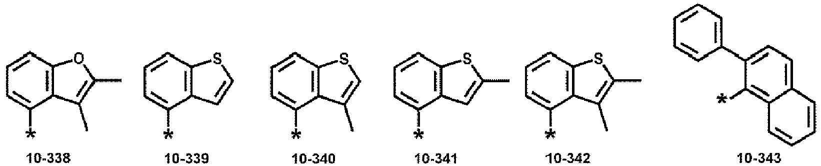 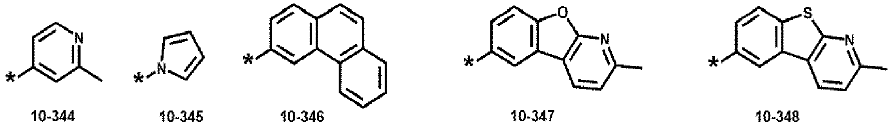 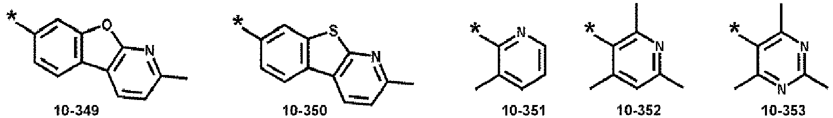 wherein, in Formulae 9-1 to 9-39, 9-201 to 9-233, 10-1 to 10-132, and 10-201 to 10-353, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-233 in which at least one hydrogen is substituted with deuterium" may be, for example, a group represented by one of Formulae 9-501 to 9-514 and 9-601 to 9-635:

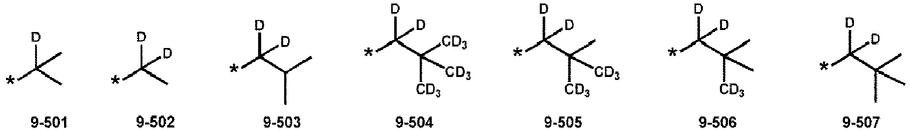

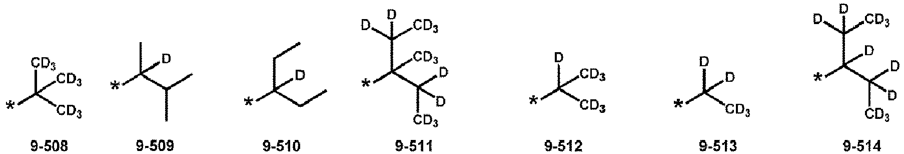

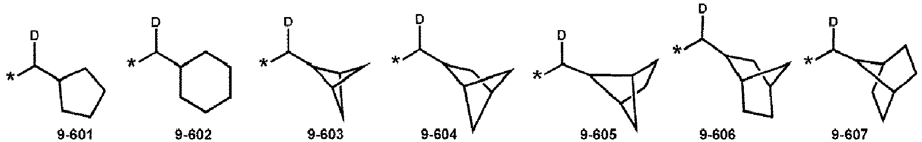

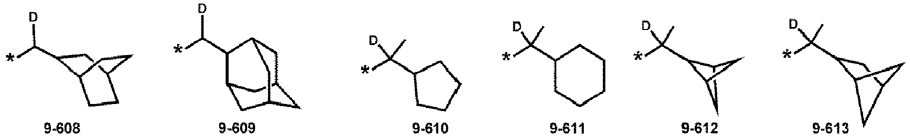

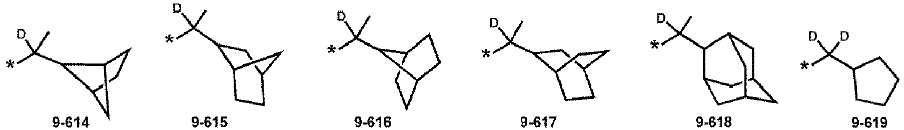

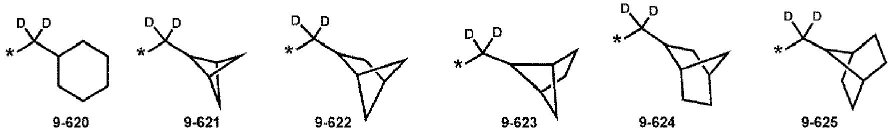

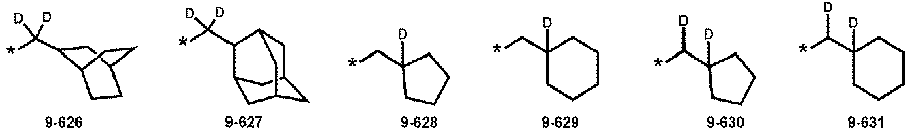

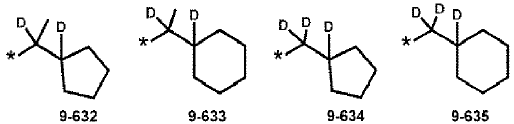

The "group represented by one of Formulae 9-1 to 9-39 in which at least one hydrogen is substituted with -F" and the "group represented by one of Formulae 9-201 to 9-233 in which at least one hydrogen is substituted with -F" may be, for example, a group represented by one of Formulae 9-701 to 9-710:

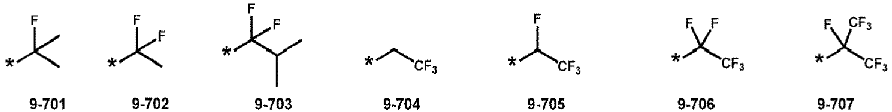

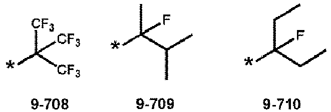

The "group represented by one of Formulae 10-1 to 10-132 in which at least one hydrogen is substituted with deuterium" and the "group represented by one of Formulae 10-201 to 10-353 in which at least one hydrogen is substituted with deuterium" may be, for example, a group represented by one of Formulae 10-501 to 10-553:

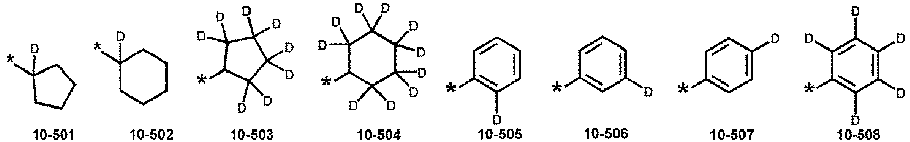

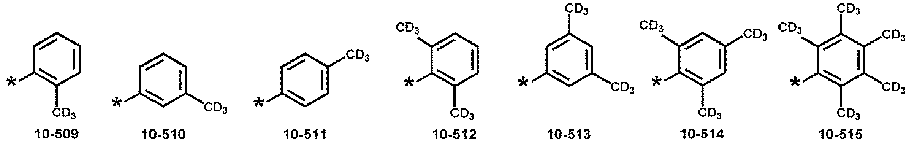

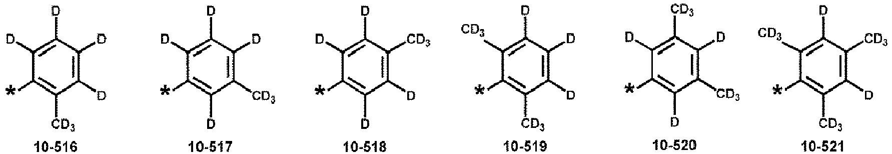

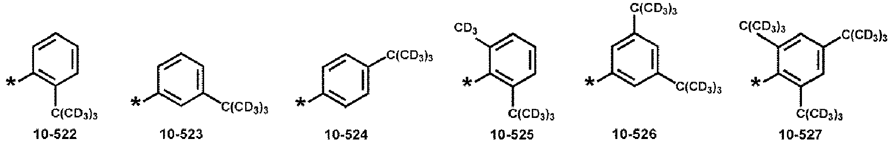

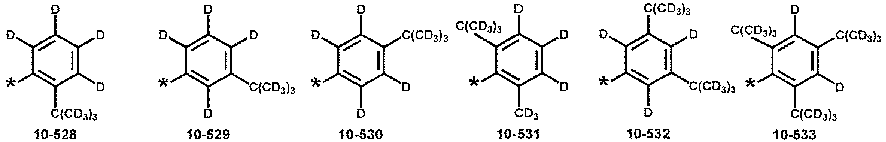

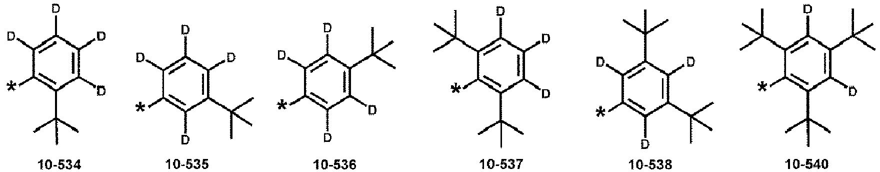

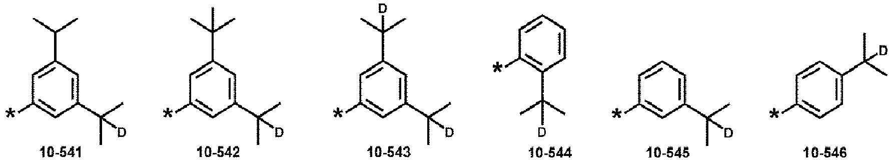

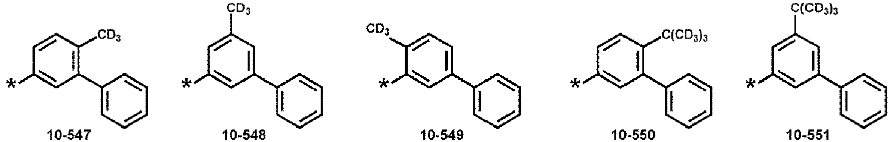

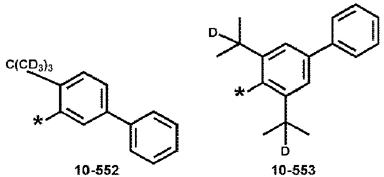

The "group represented by one of Formulae 10-1 to 10-132 in which at least one hydrogen is substituted with -F" and the "group represented by one of Formulae 10-201 to 10-353 in which at least one hydrogen is substituted with -F" may be, for example, a group represented by one of Formulae 10-601 to 10-620:

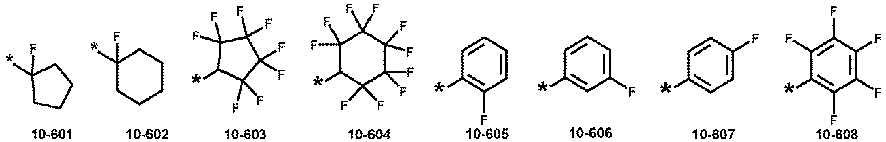

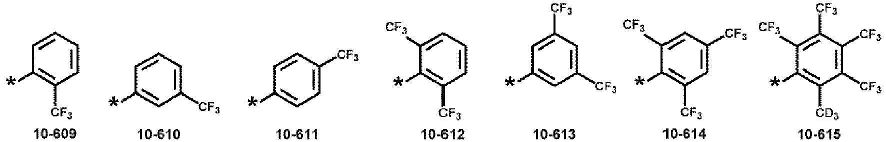

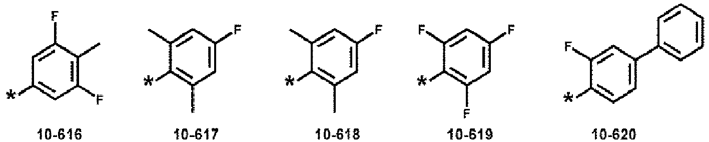

In one or more embodiments, the organometallic compound represented by Formula 1 may be one of Compounds 1 to 2560:

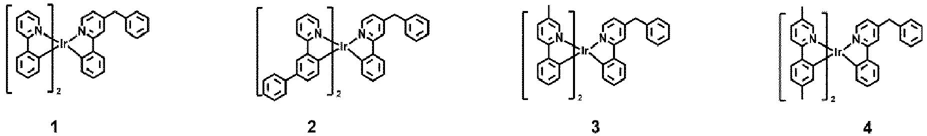

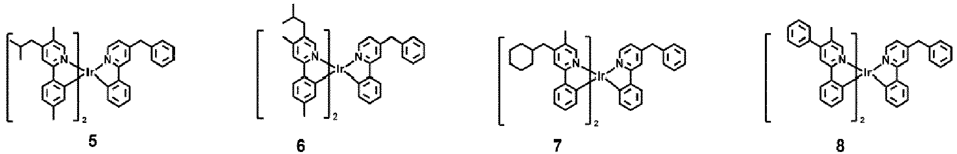

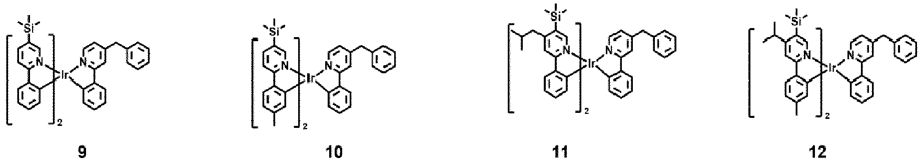

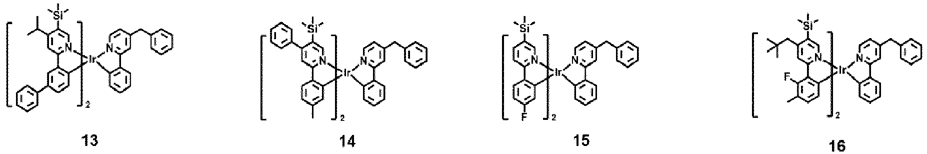

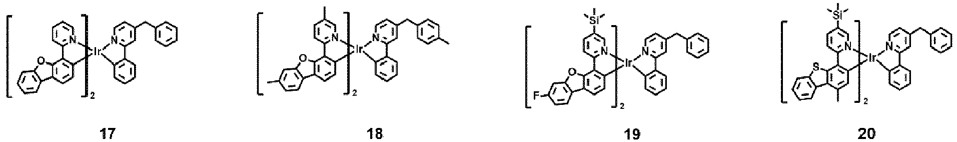

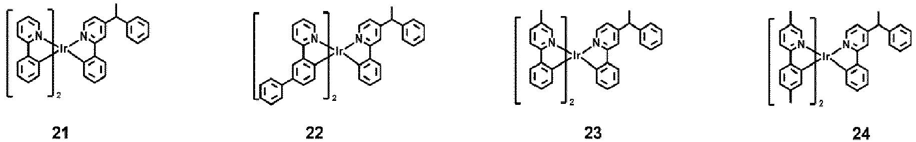

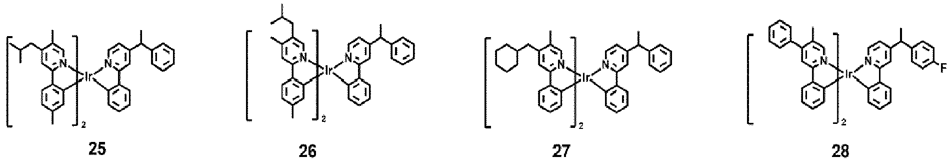

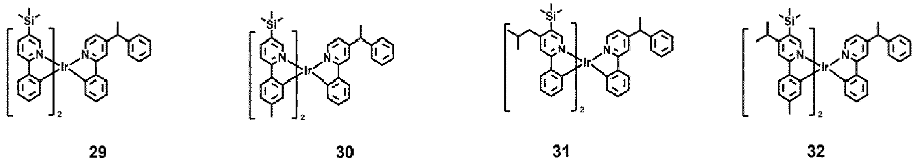

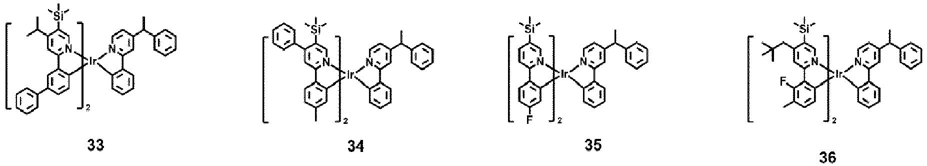

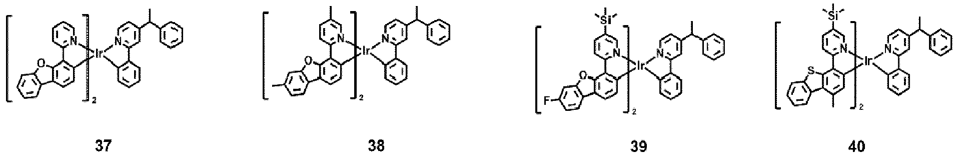

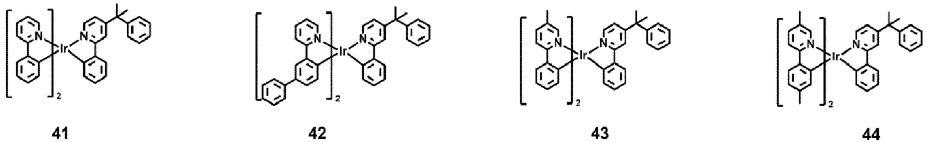

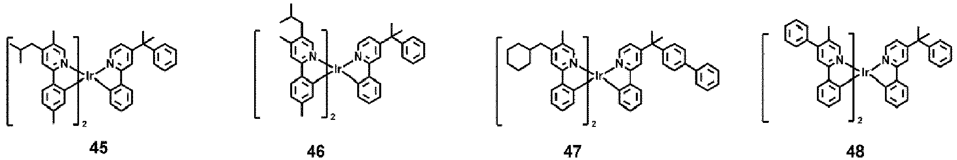

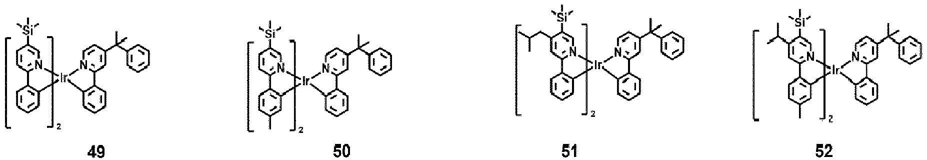

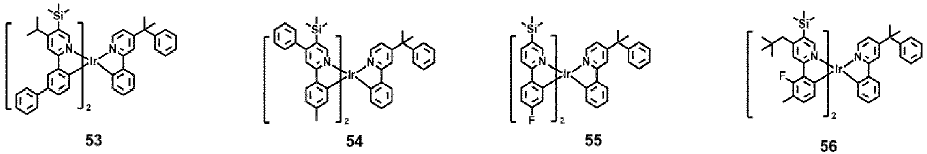

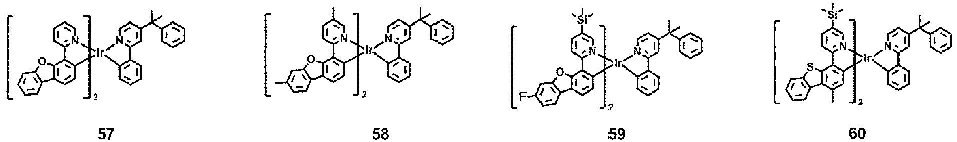

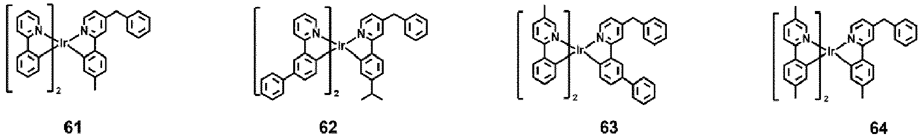

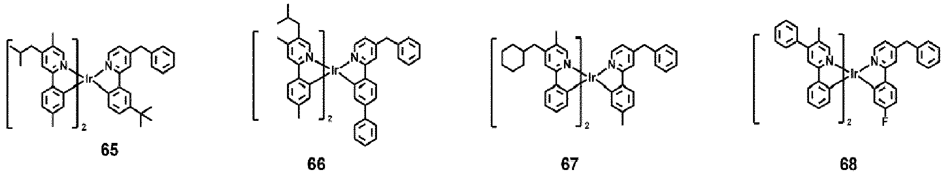

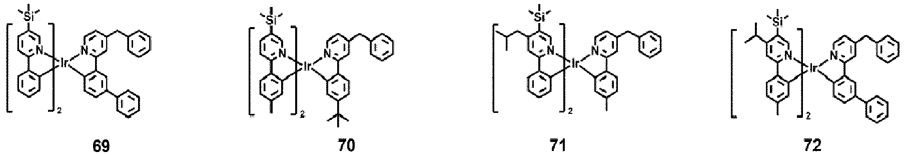

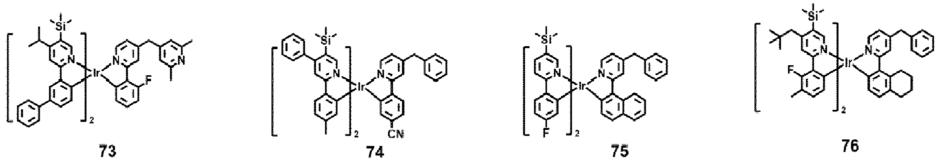

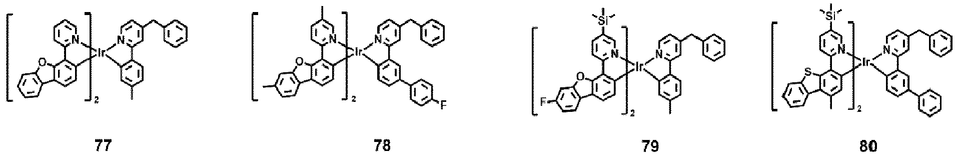

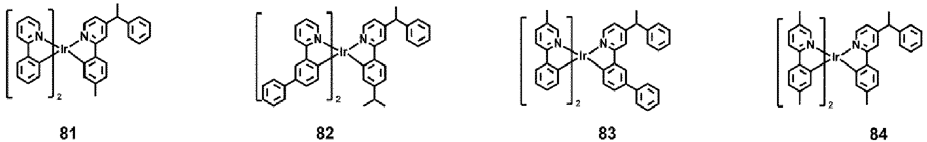

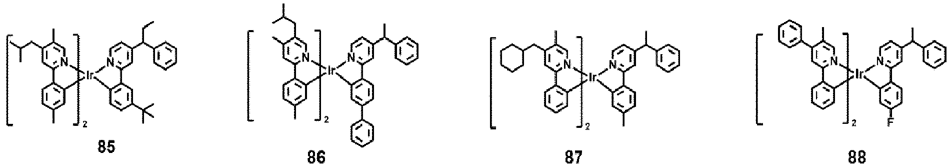

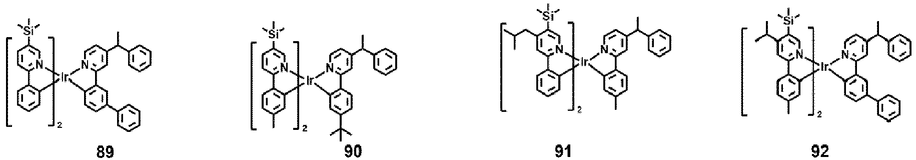

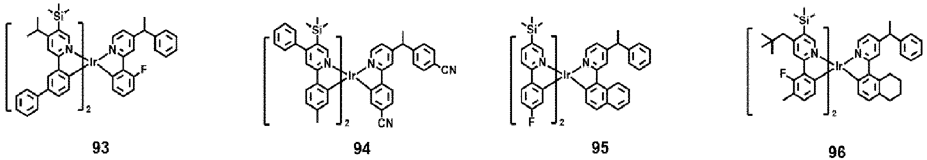

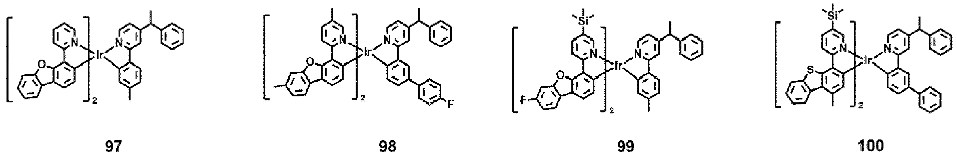

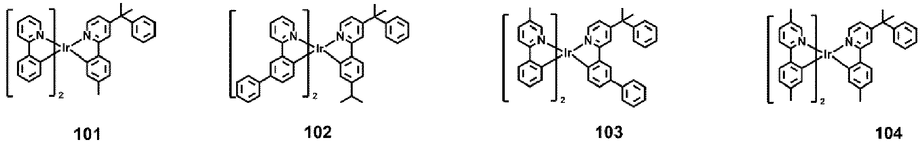

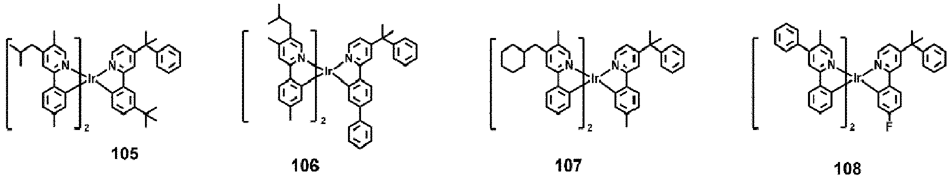

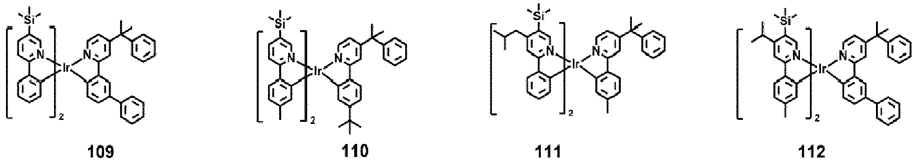

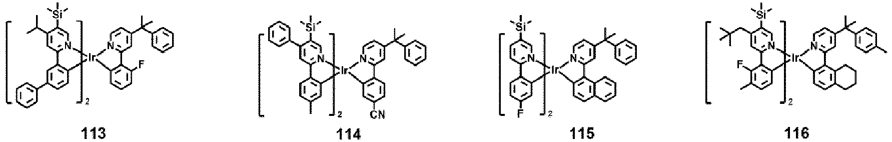

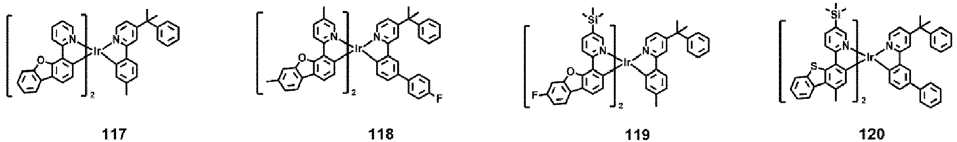

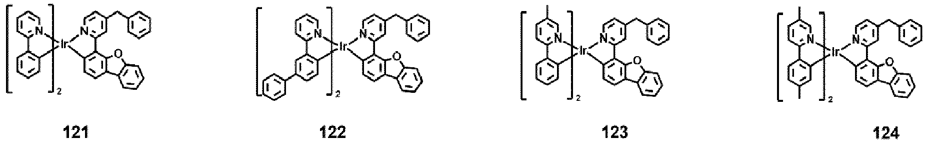

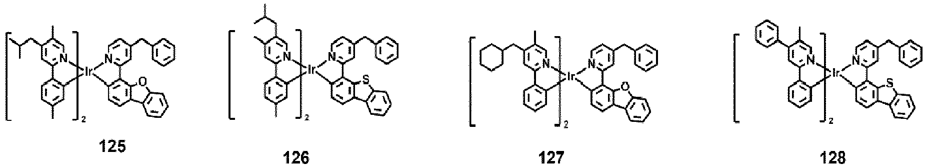

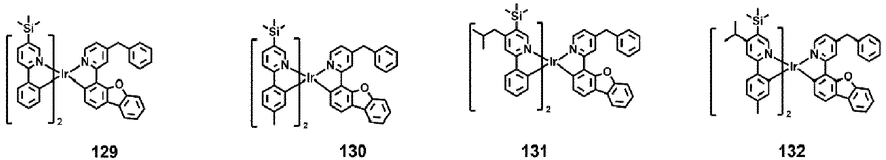

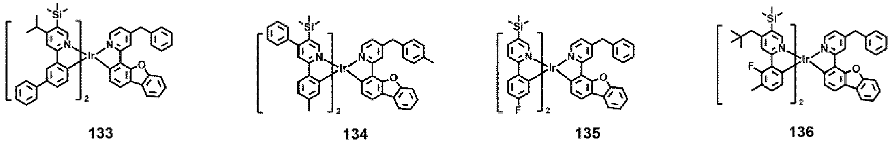

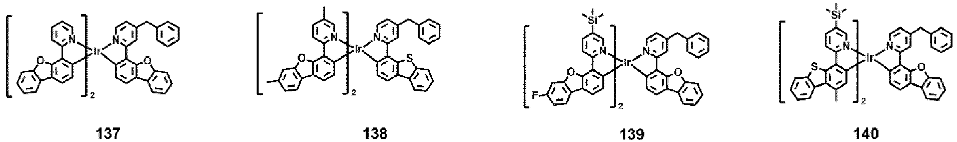

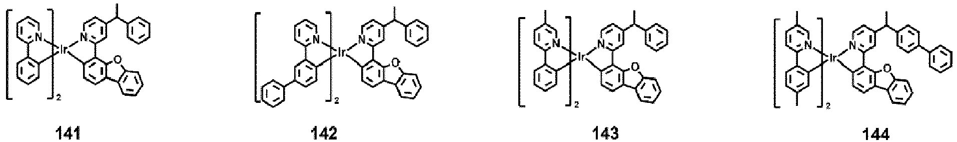

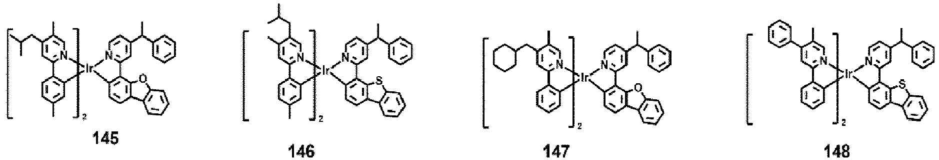

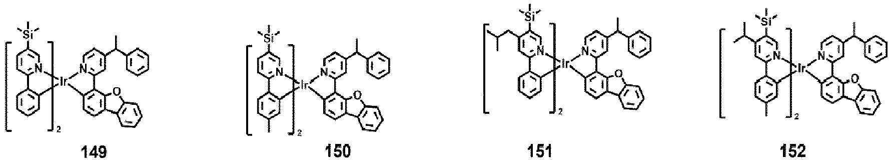

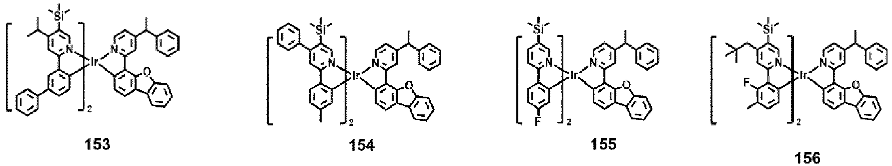

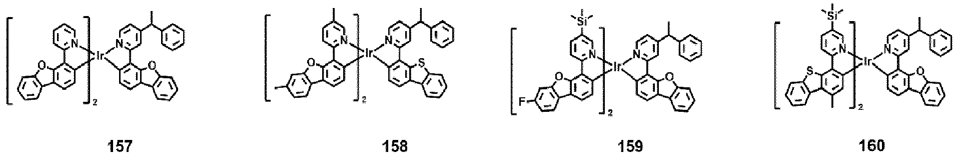

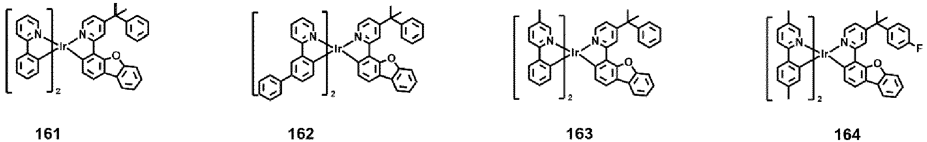

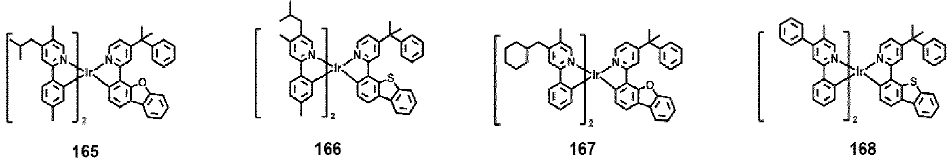

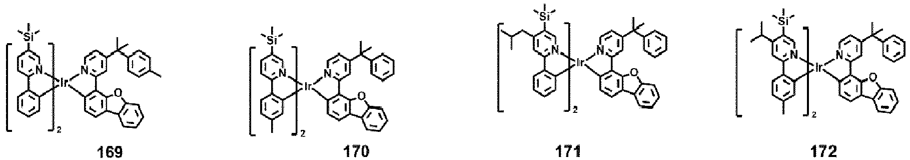

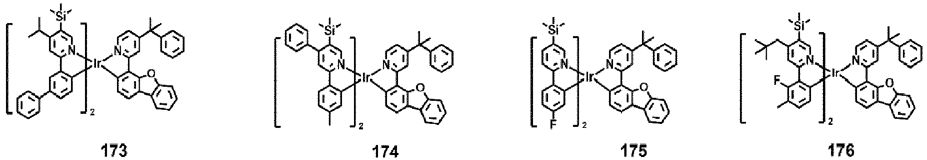

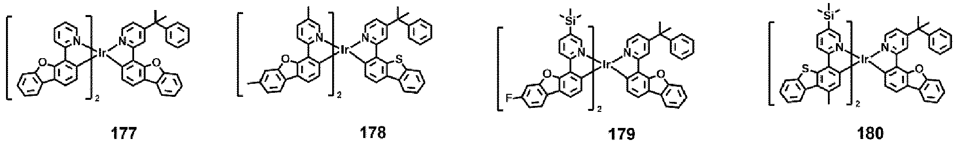

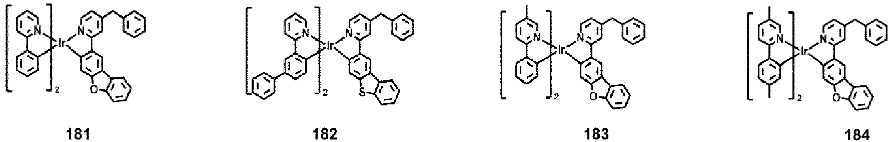

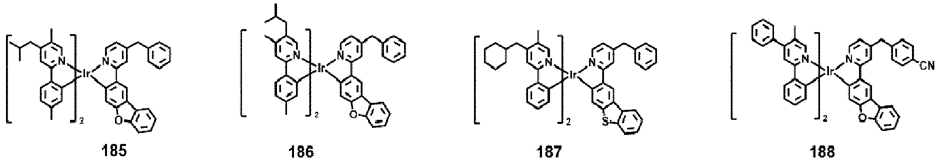

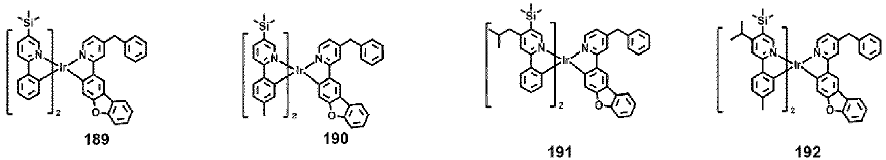

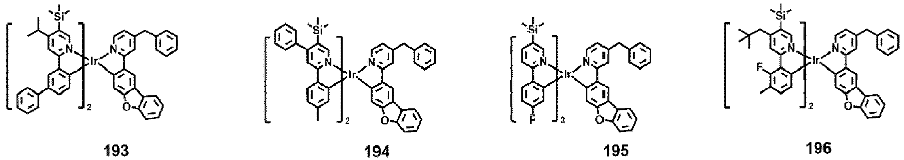

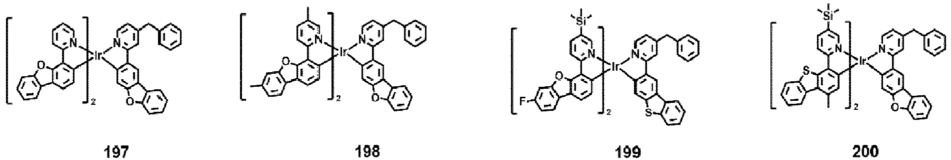

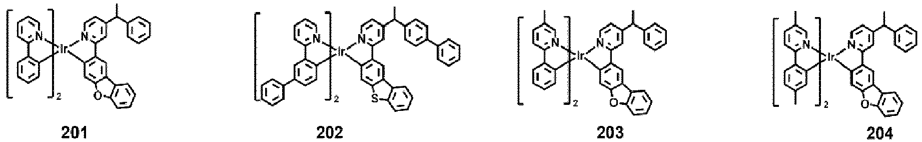

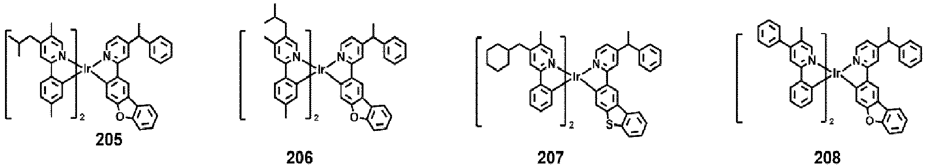

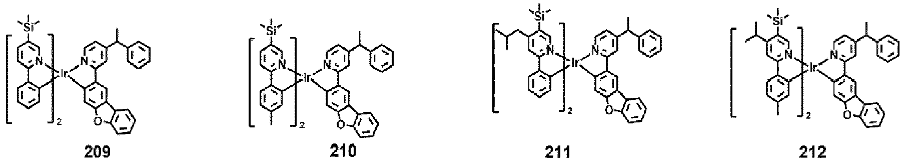

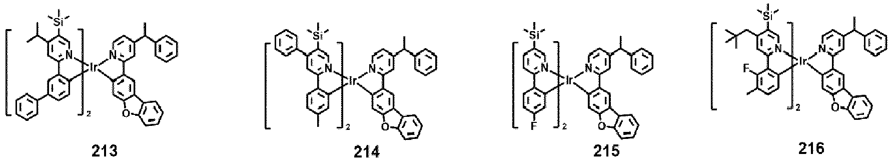

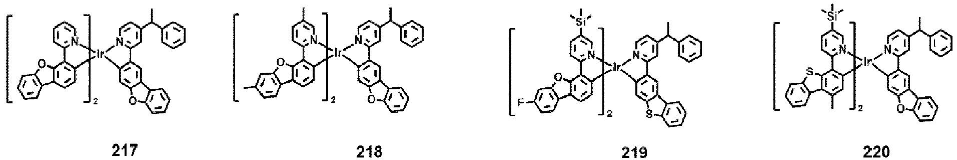

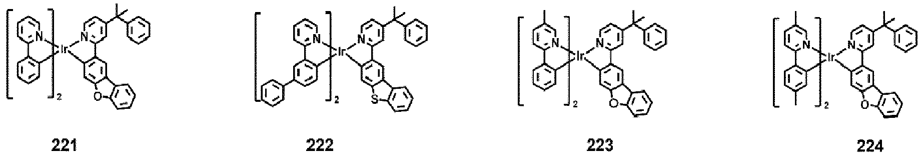

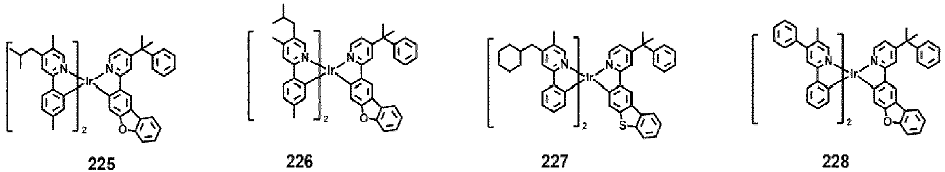

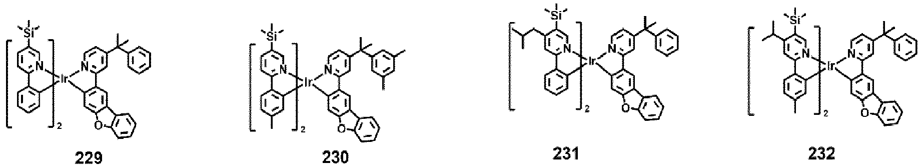

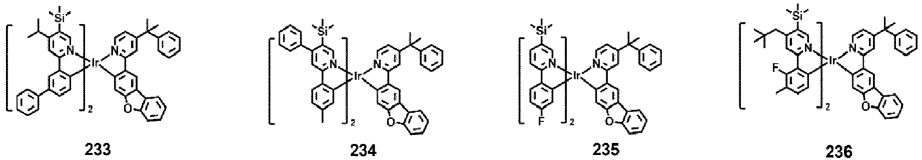

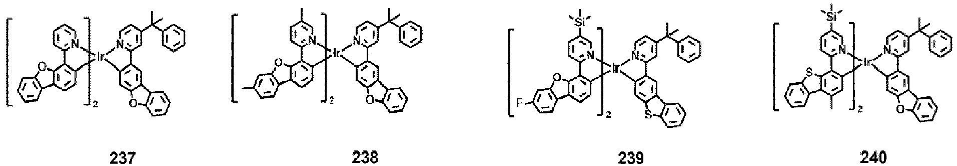

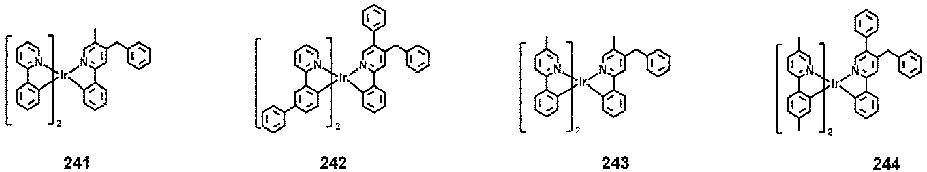

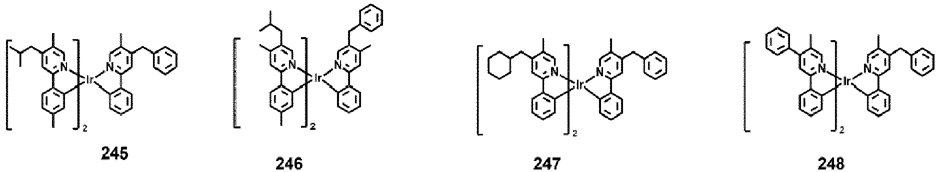

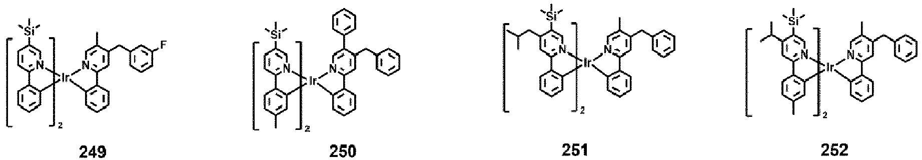

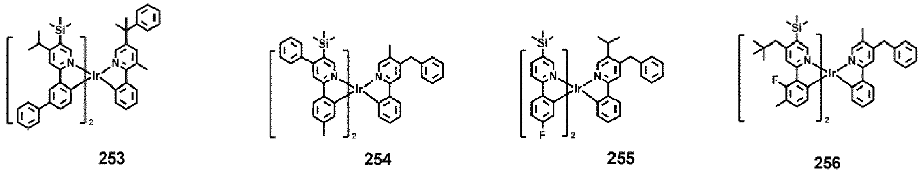

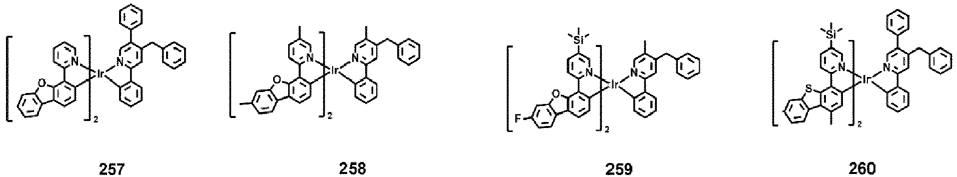

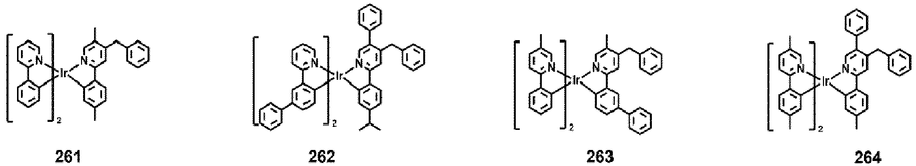

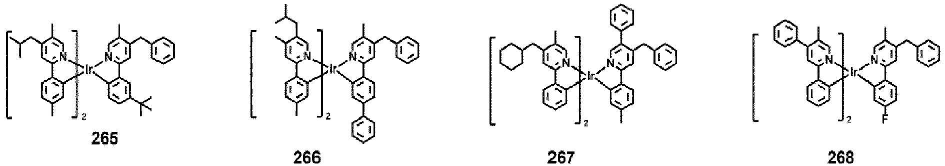

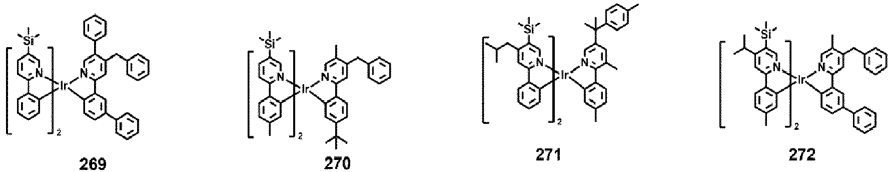

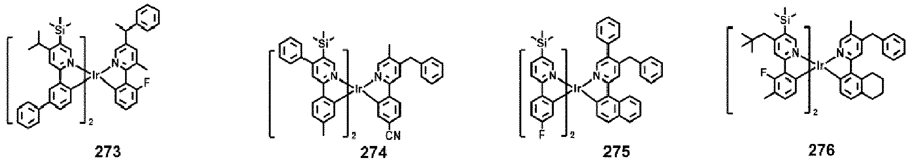

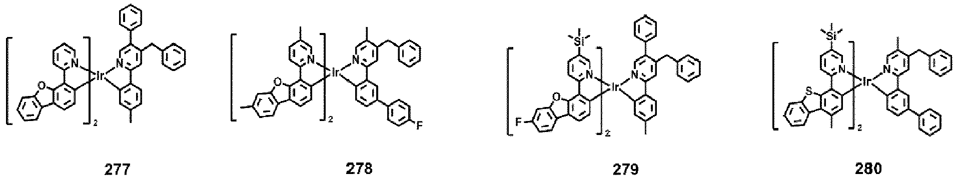

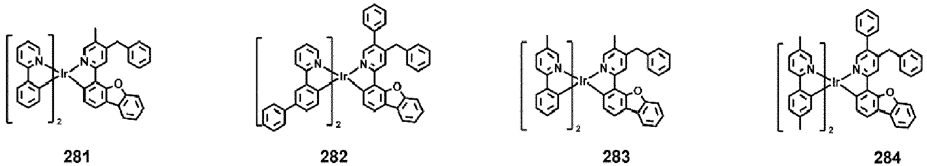

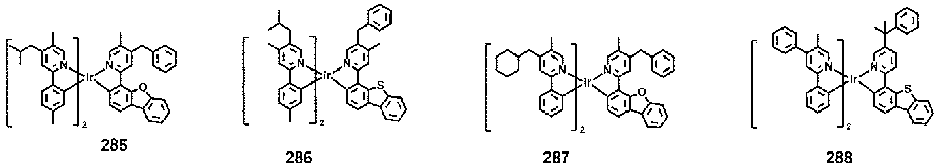

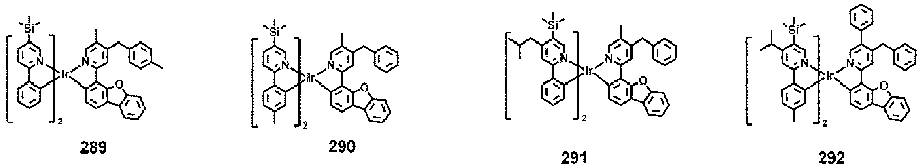

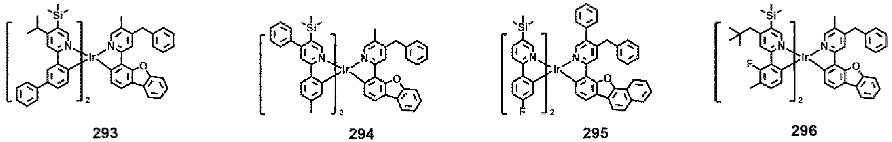

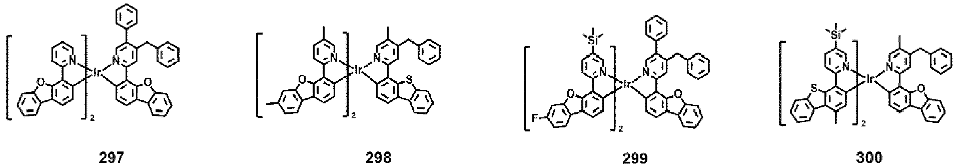

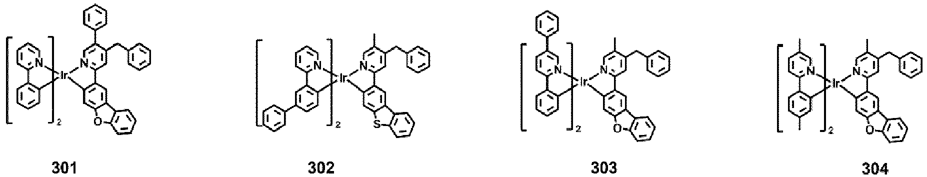

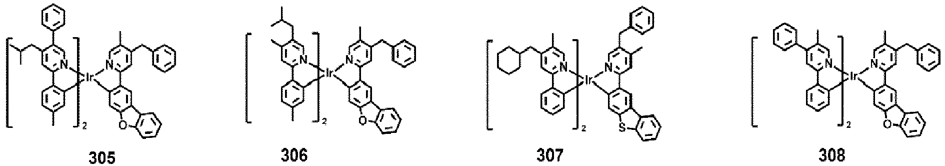

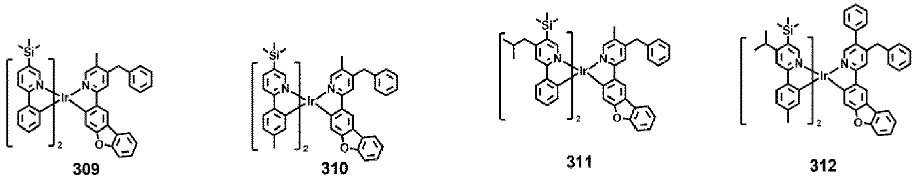

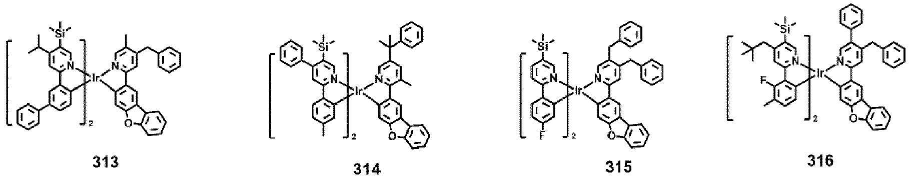

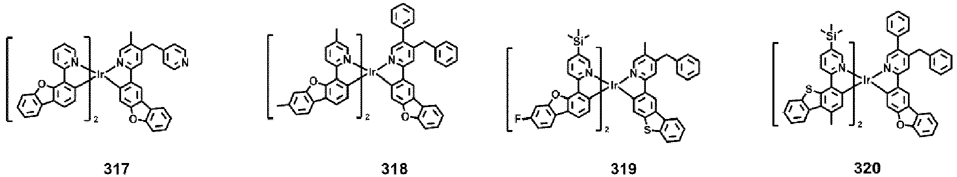

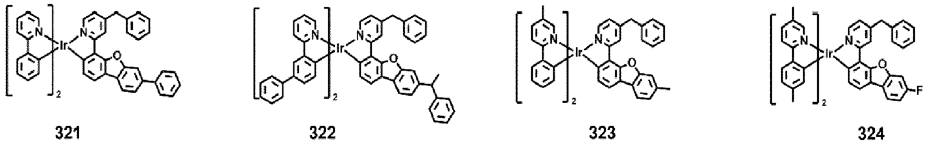

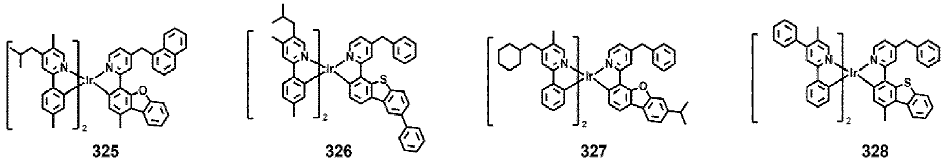

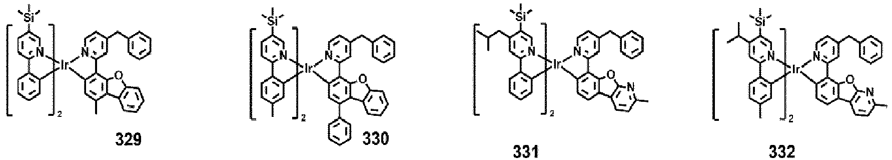

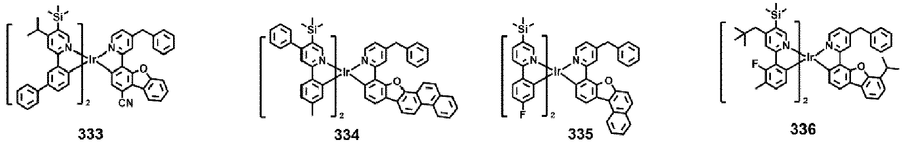

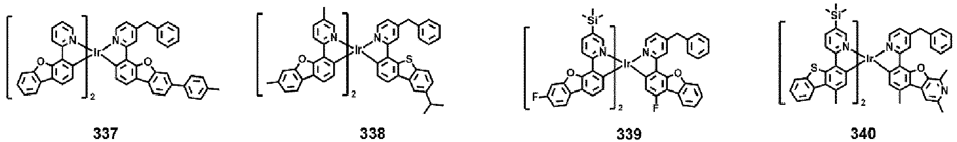

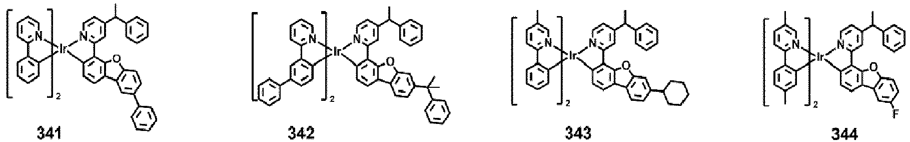

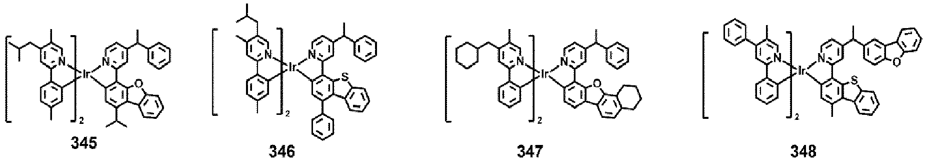

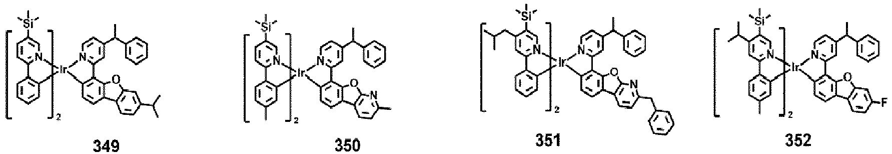

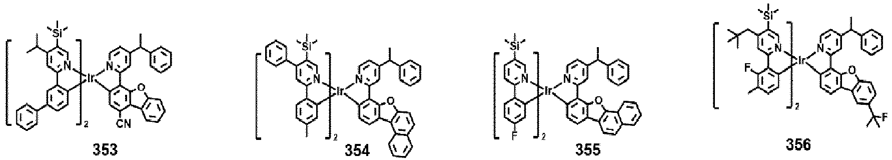

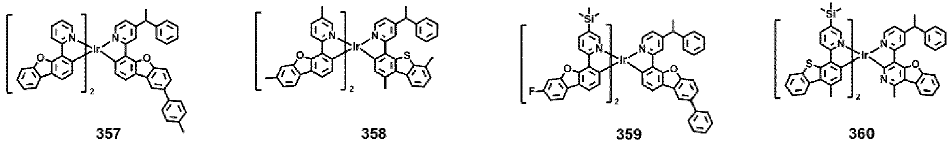

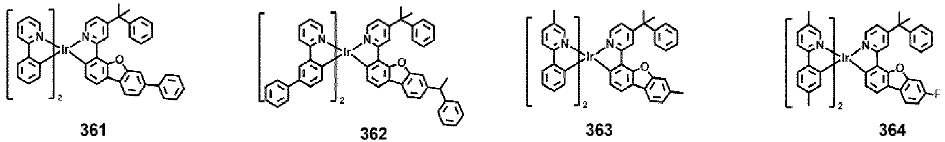

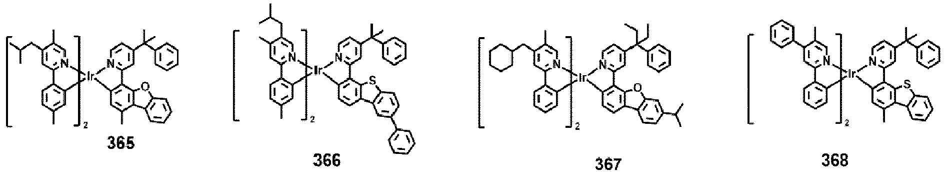

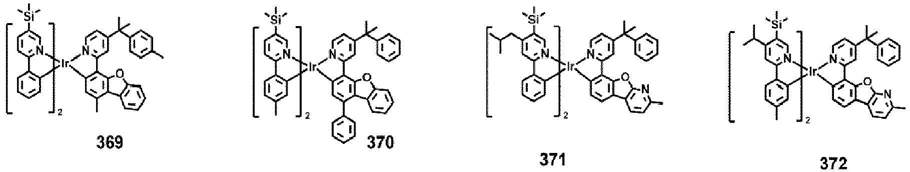

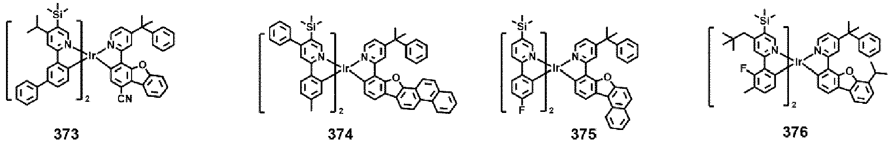

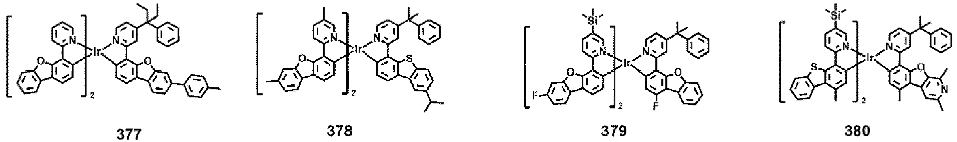

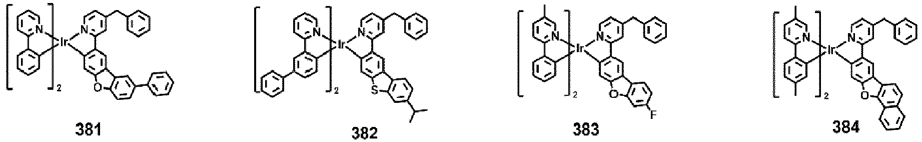

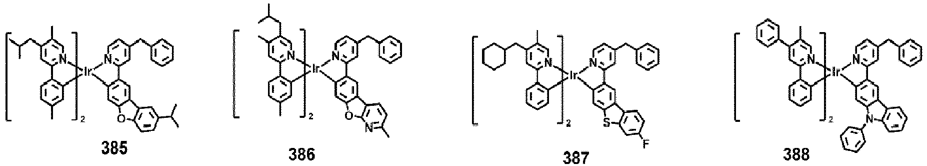

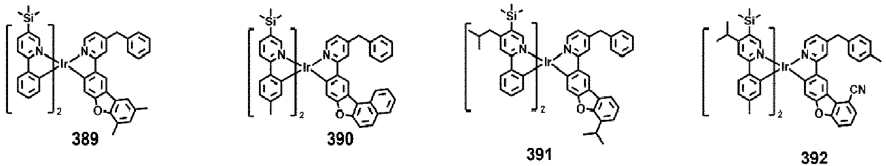

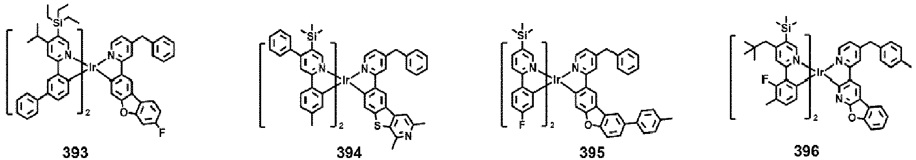

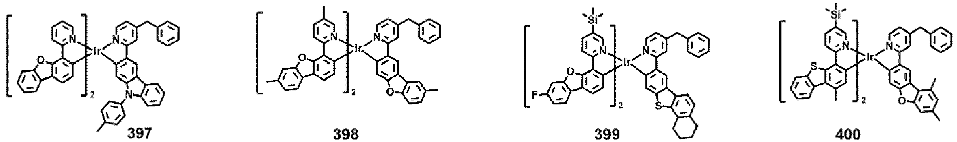

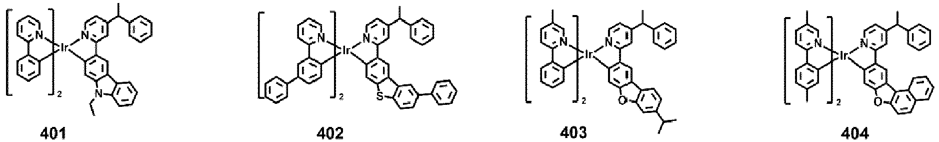

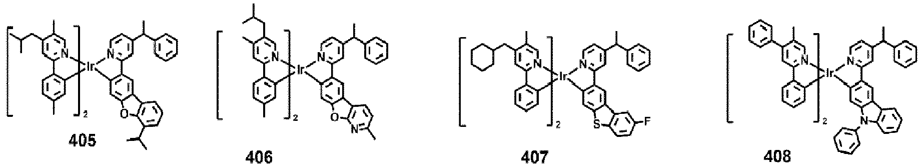

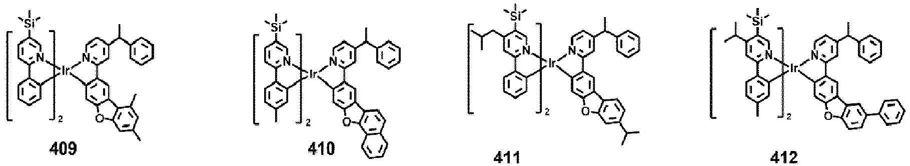

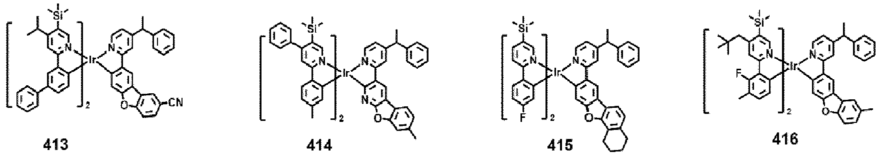

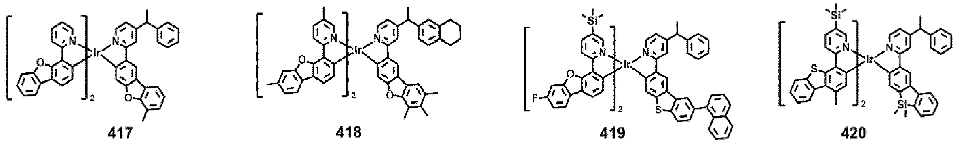

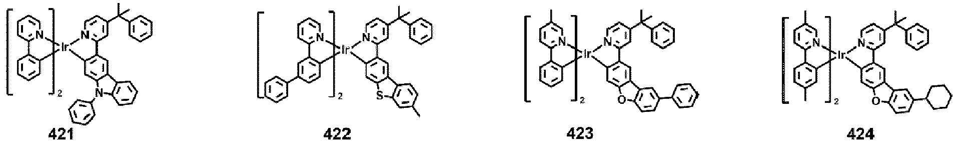

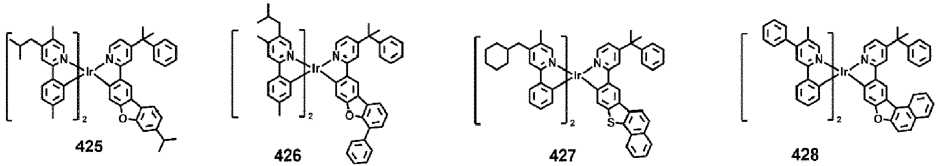

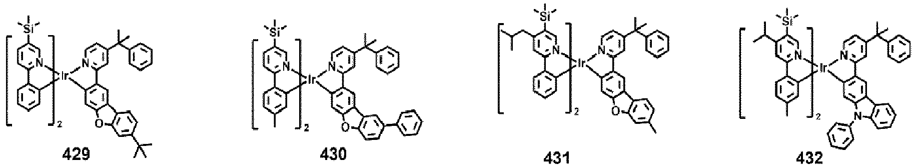

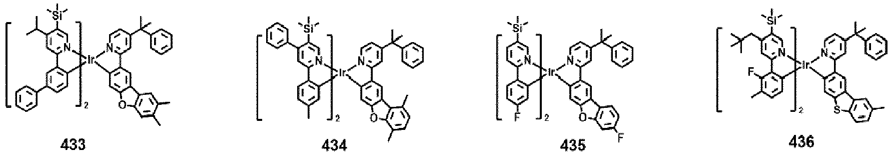

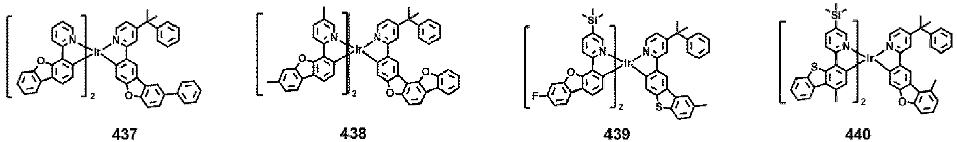

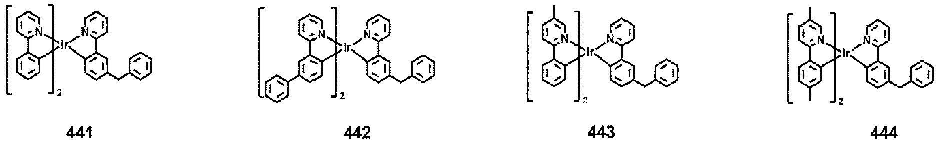

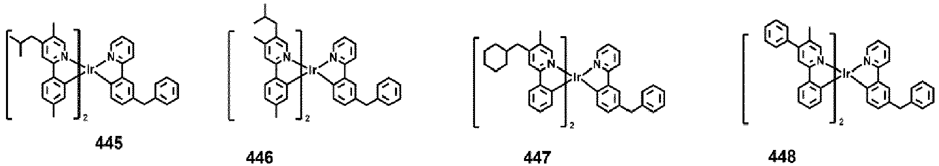

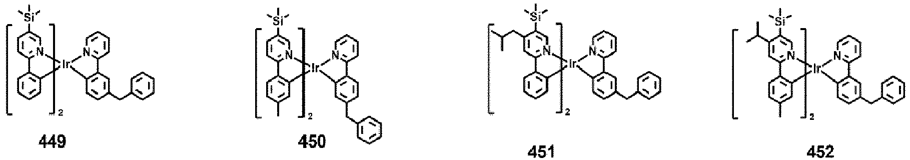

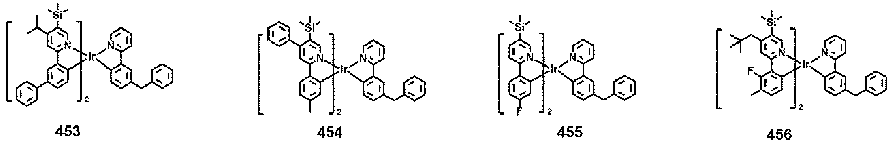

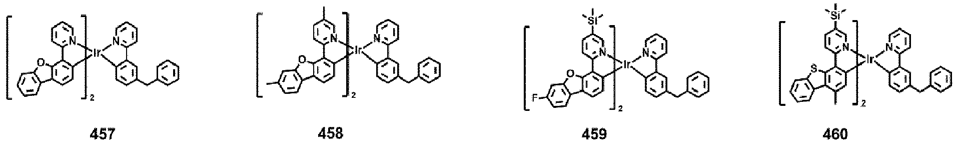

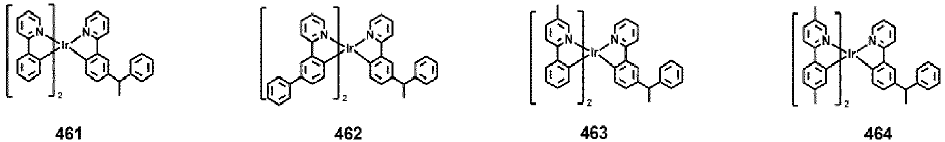

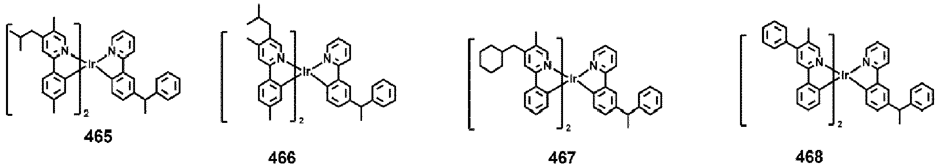

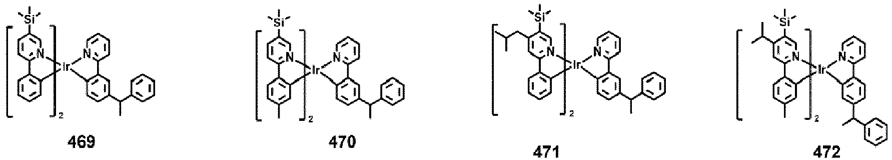

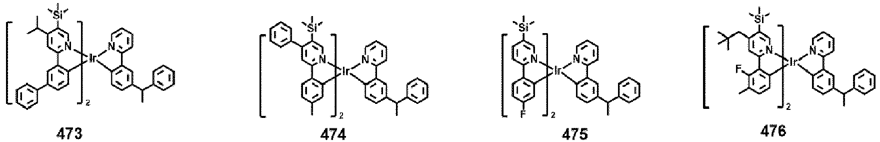

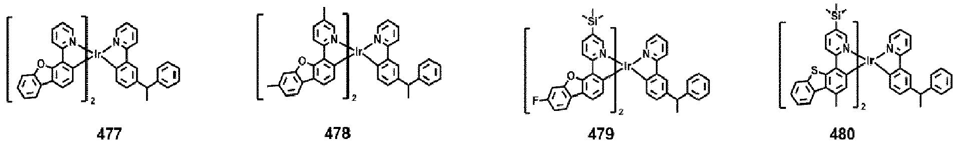

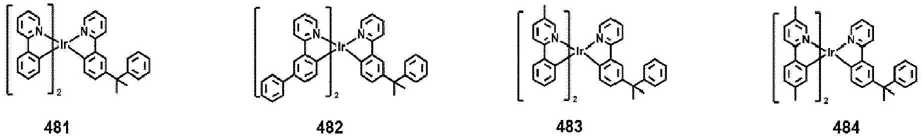

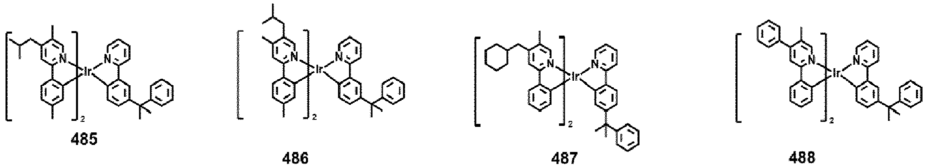

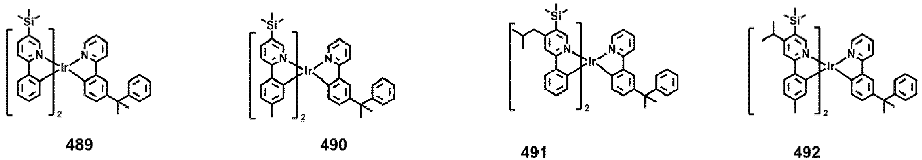

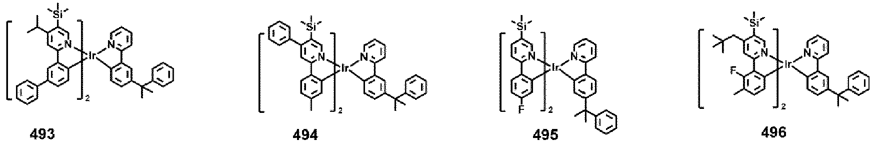

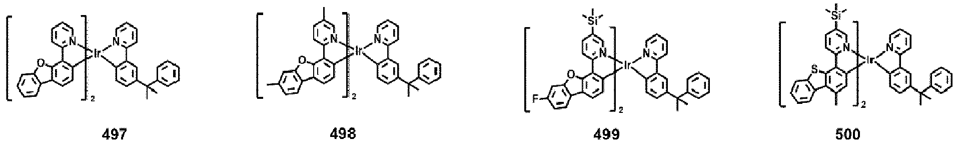

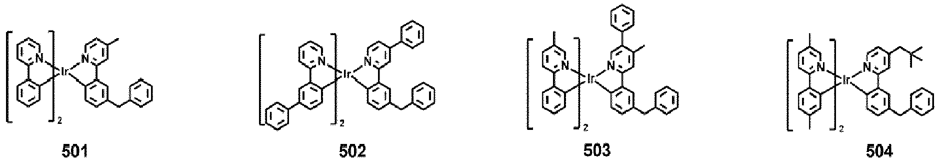

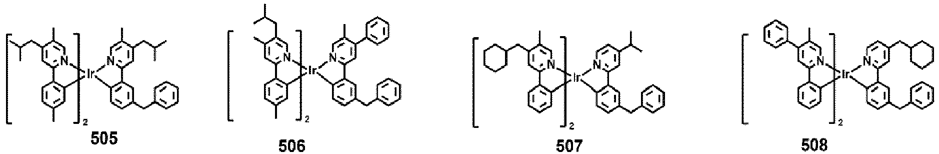

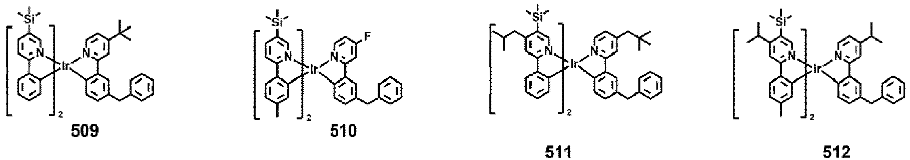

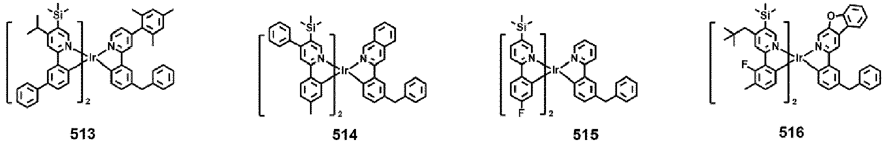

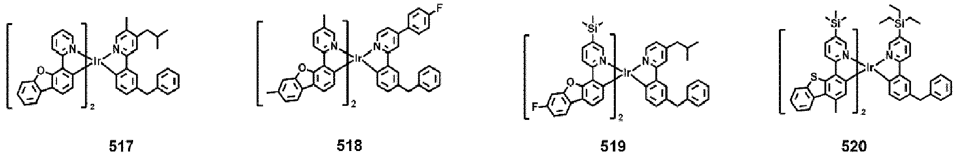

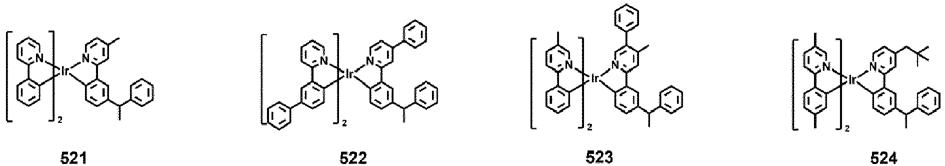

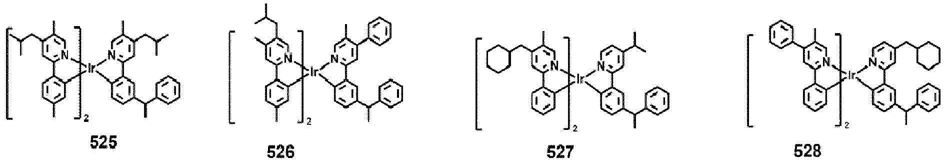

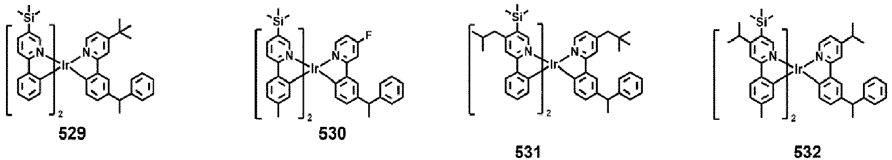

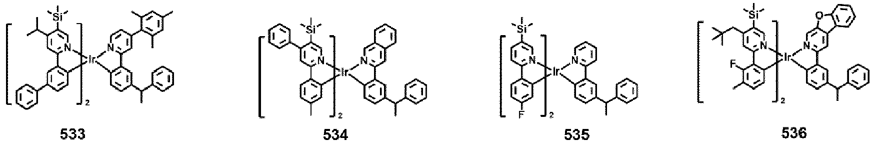

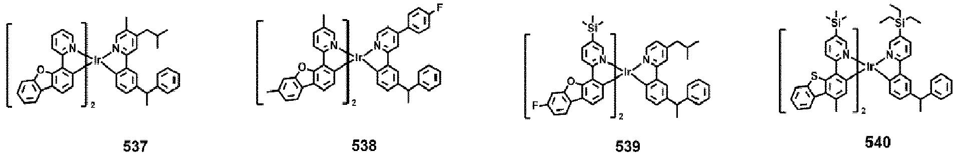

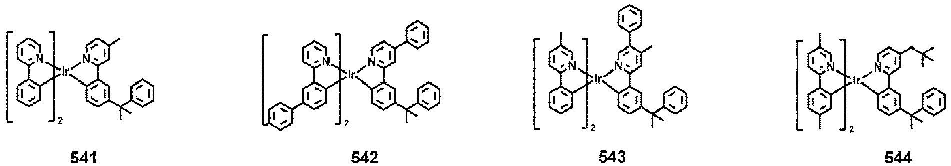

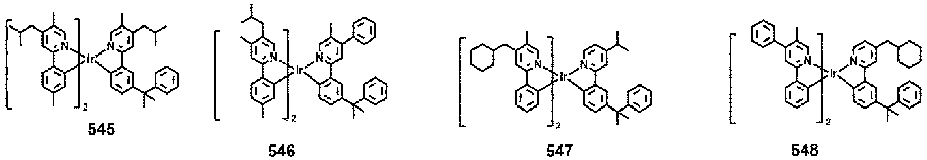

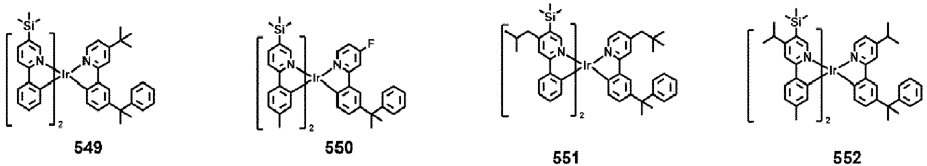

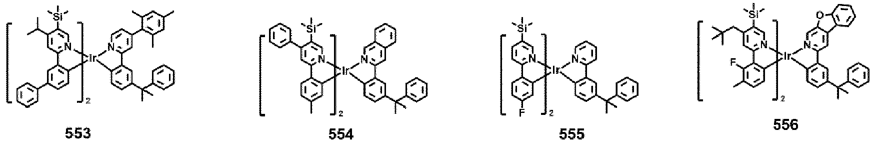

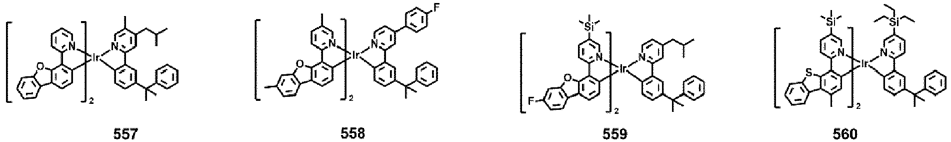

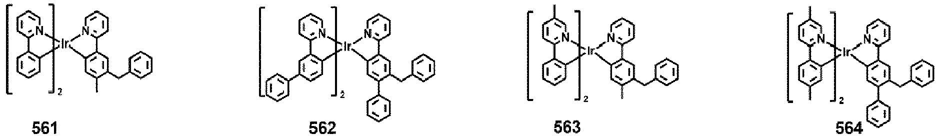

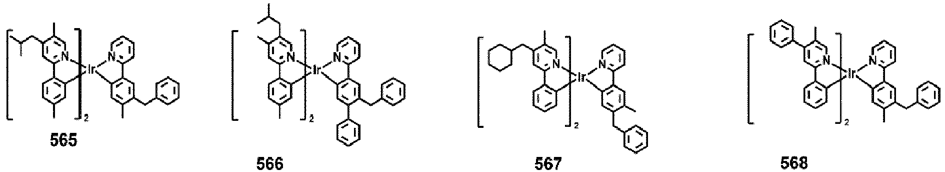

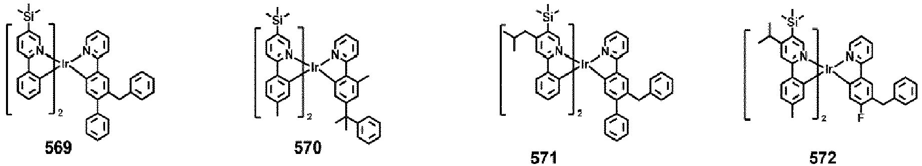

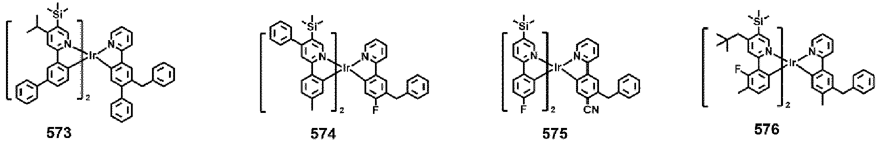

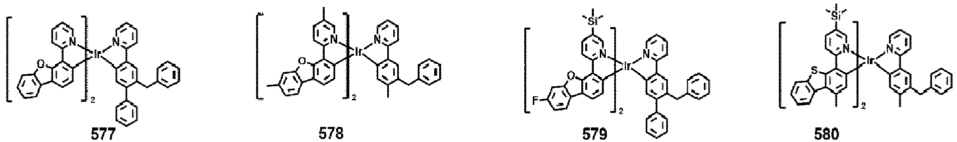

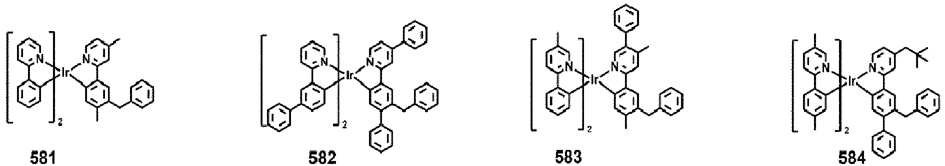

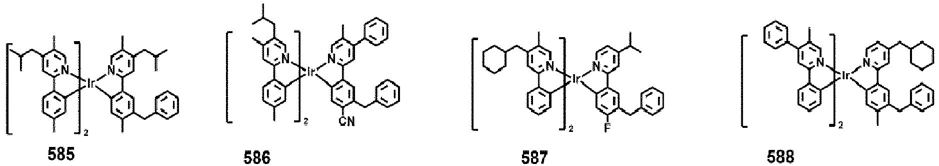

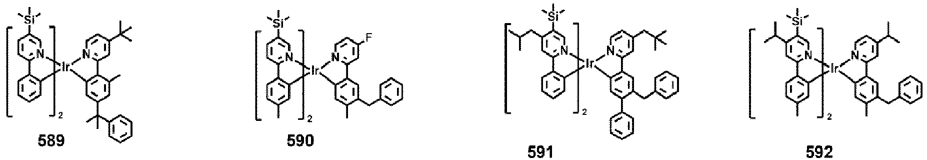

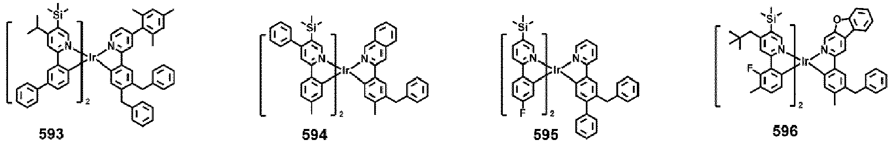

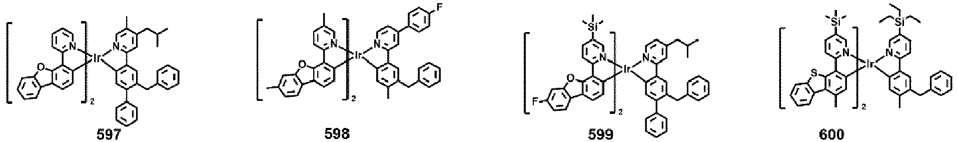

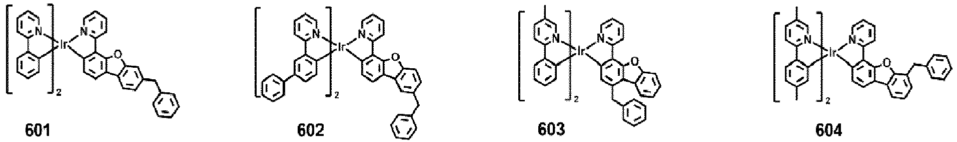

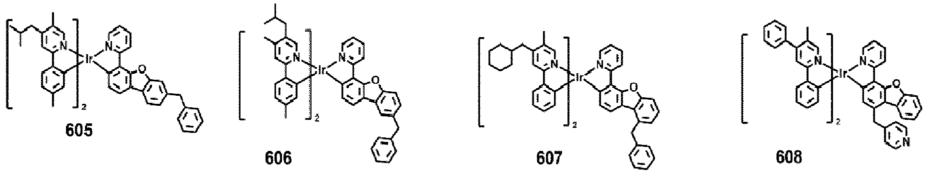

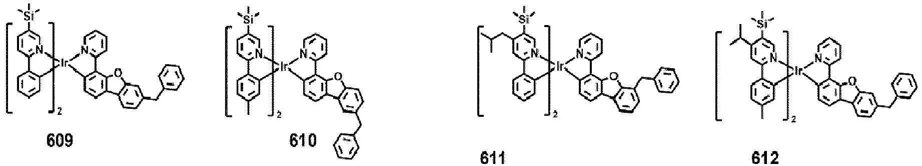

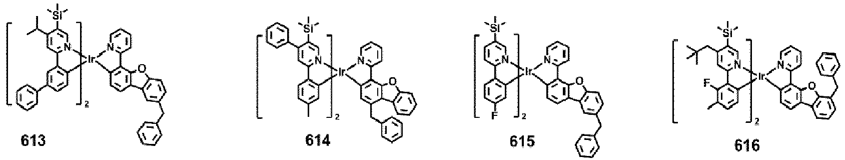

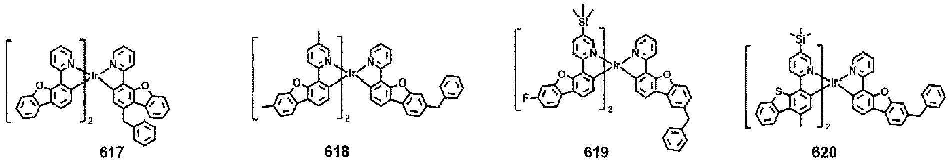

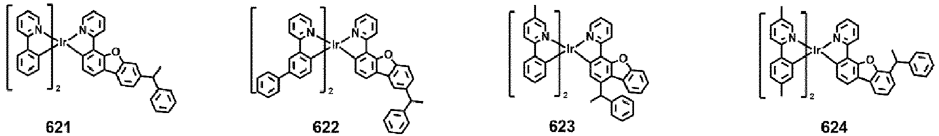

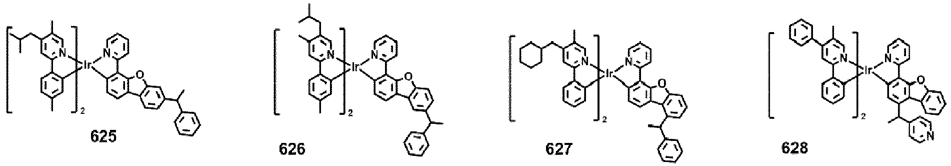

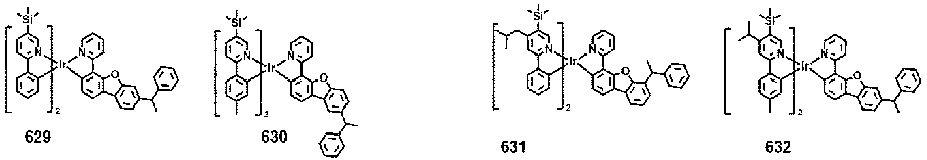

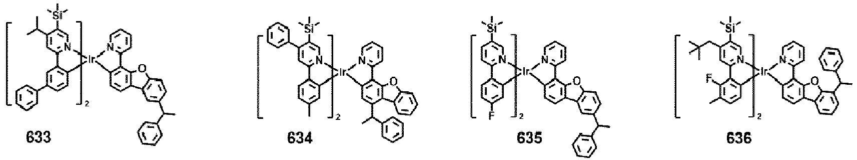

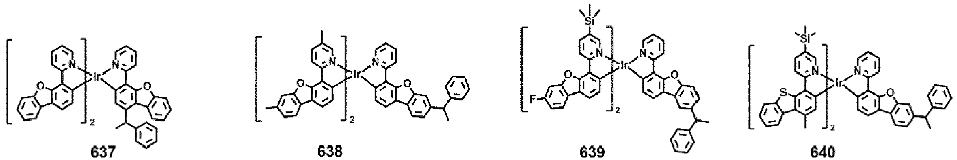

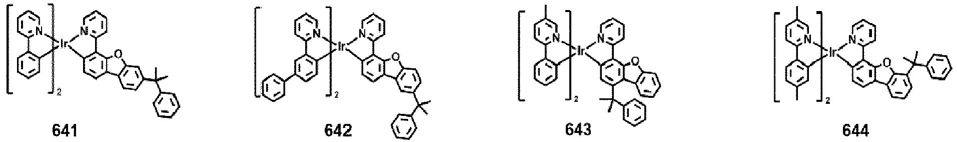

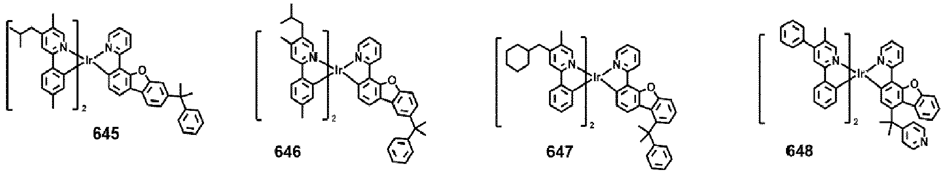

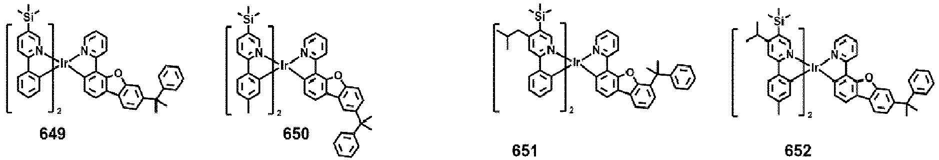

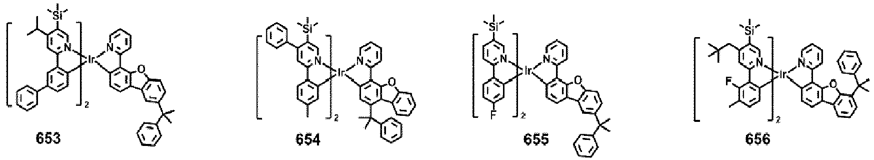

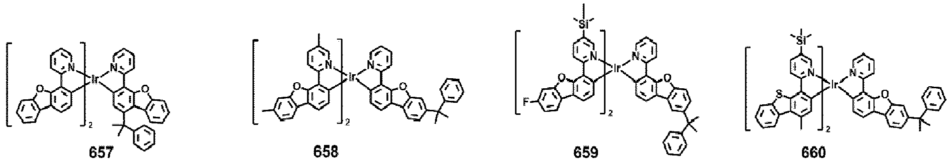

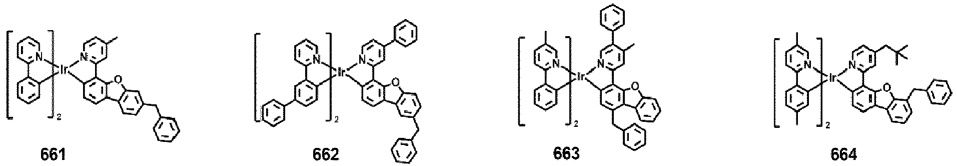

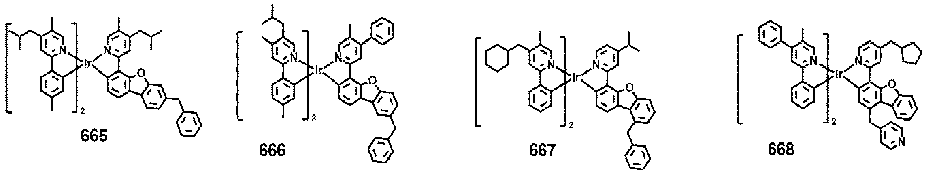

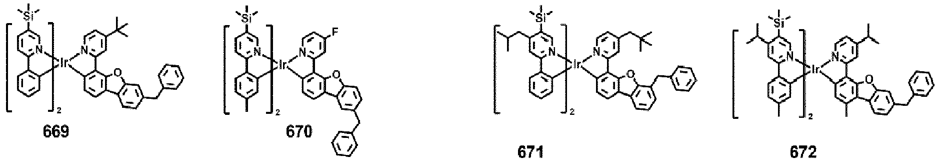

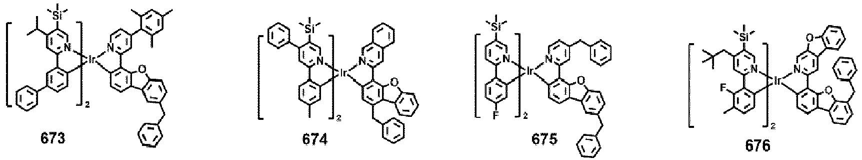

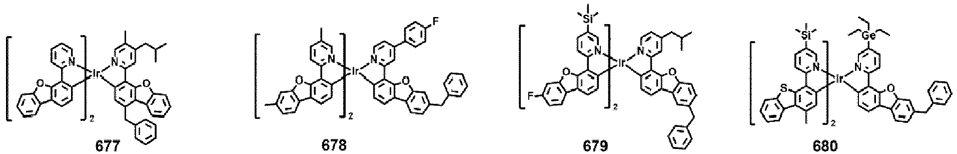

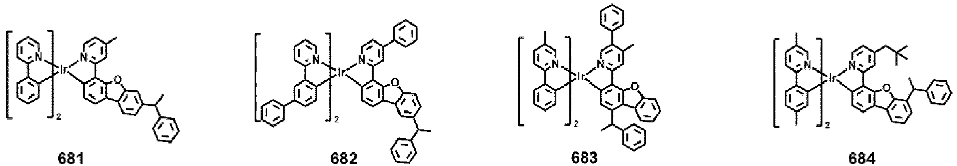

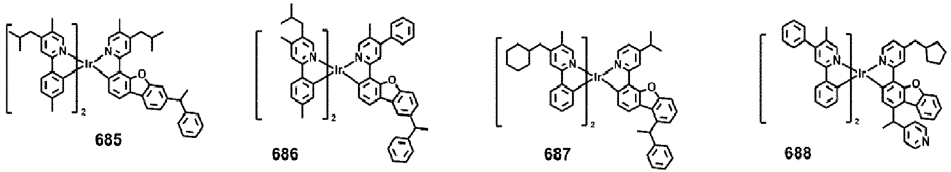

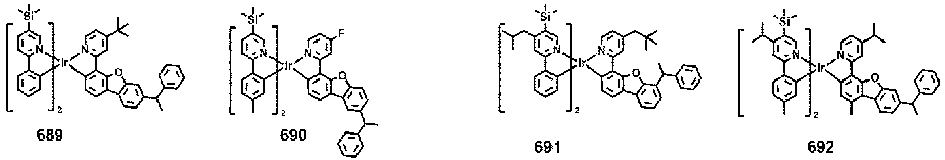

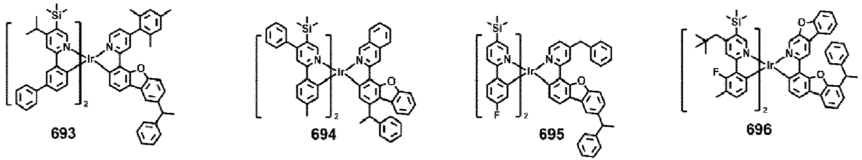

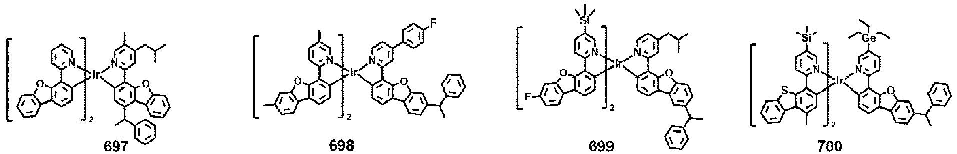

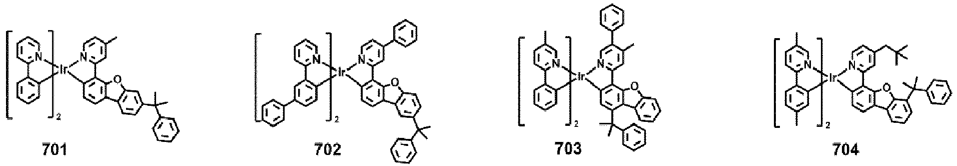

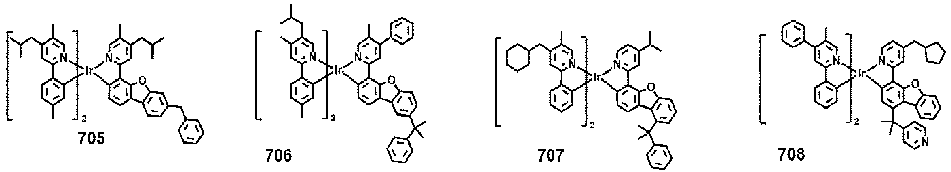

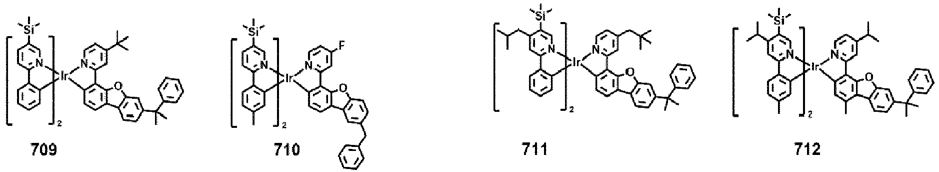

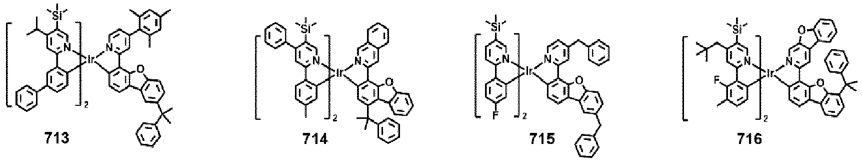

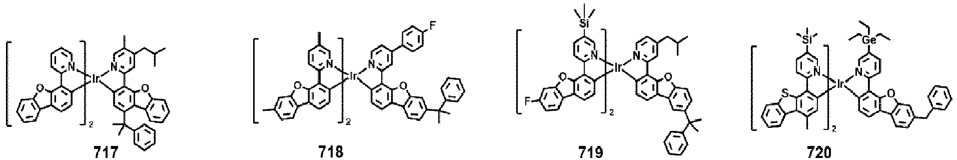

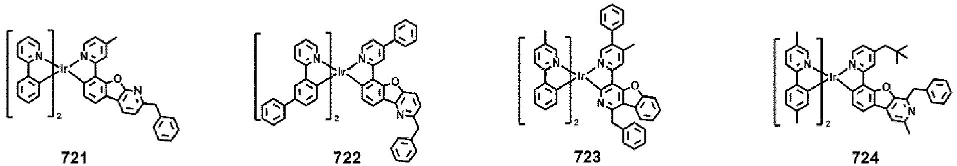

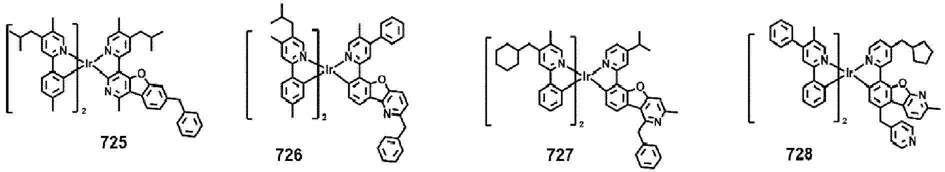

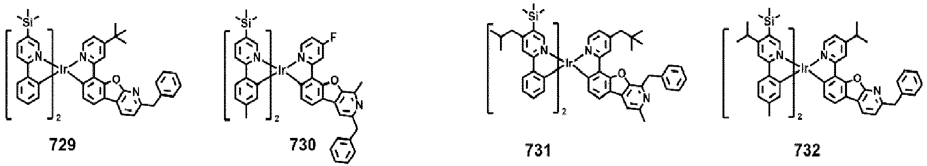

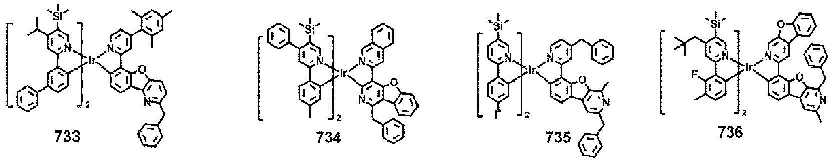

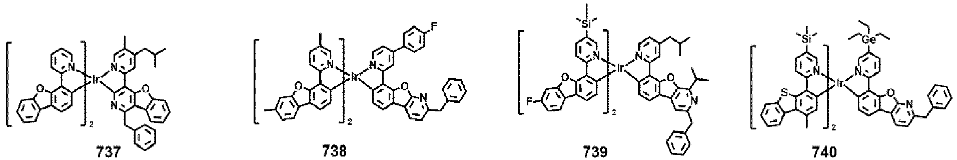

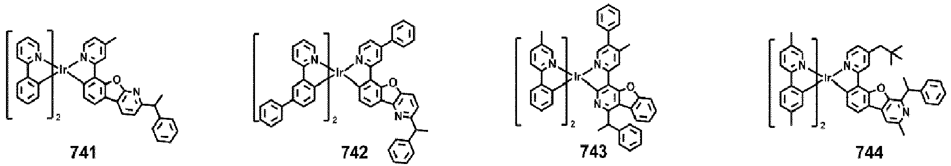

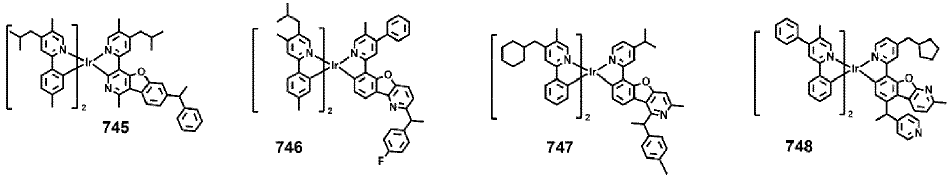

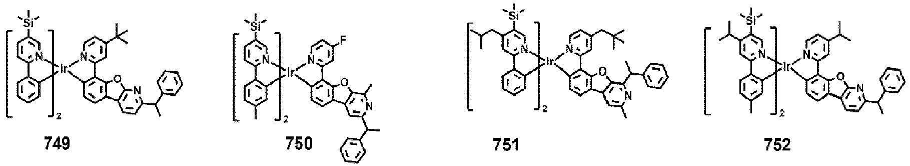

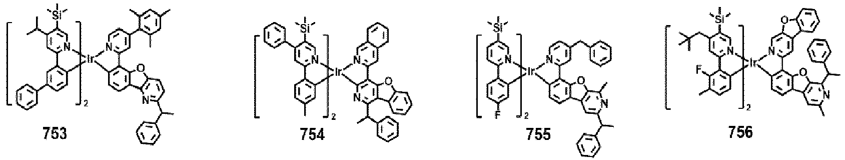

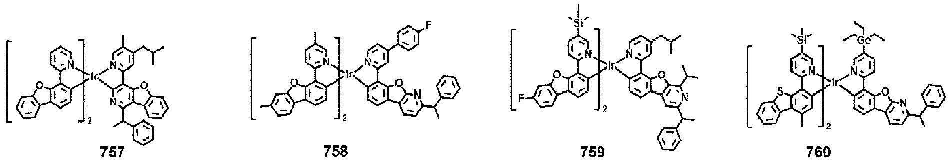

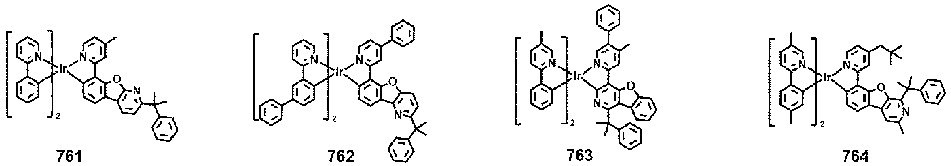

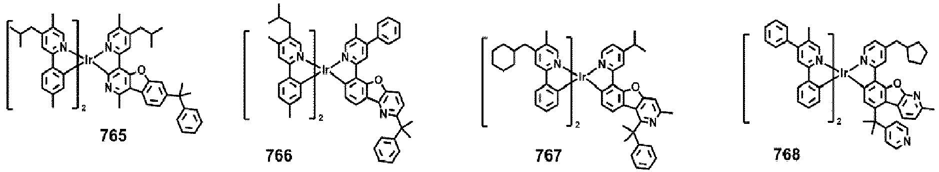

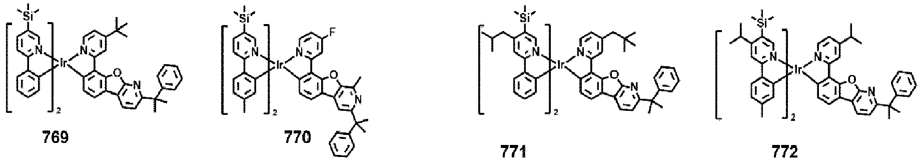

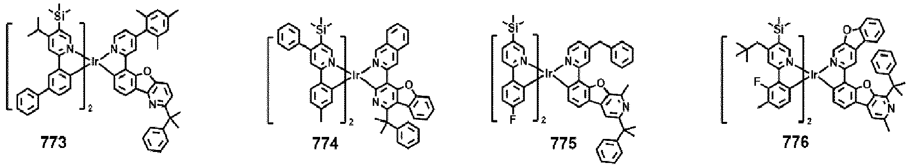

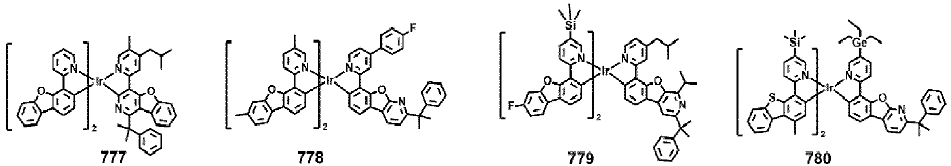

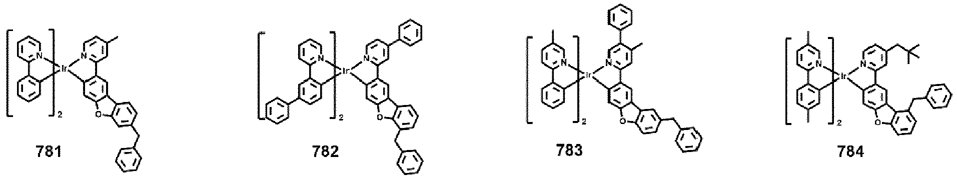

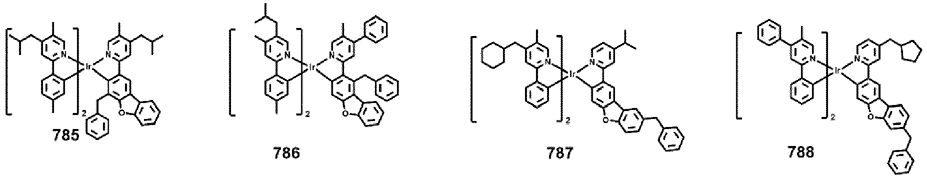

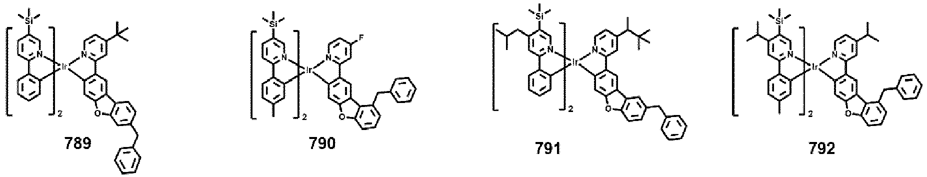

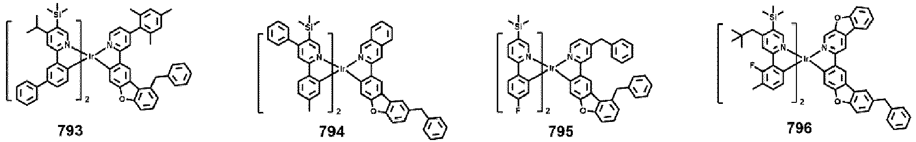

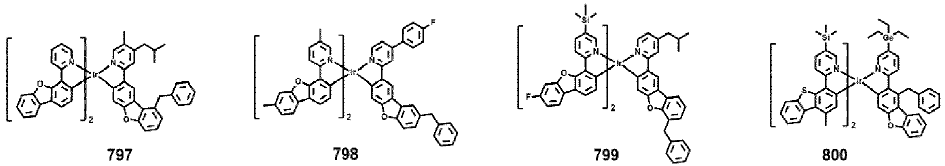

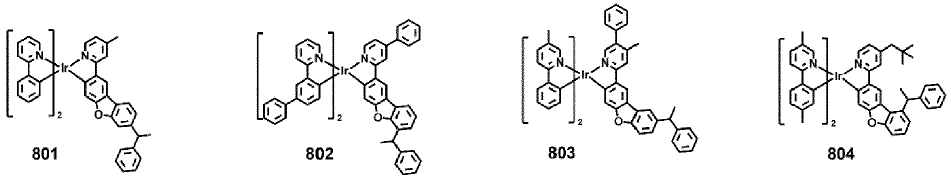

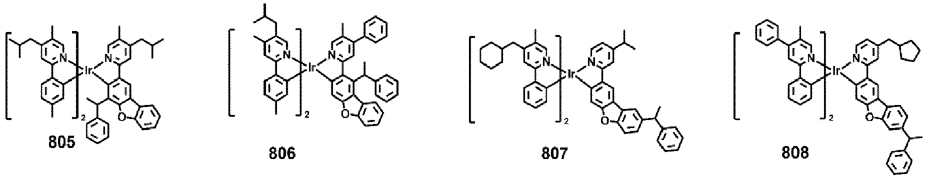

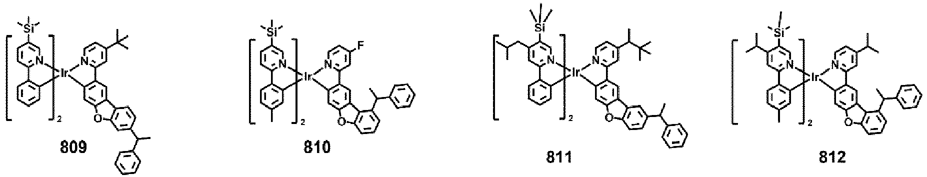

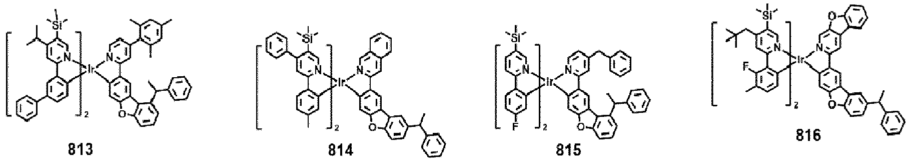

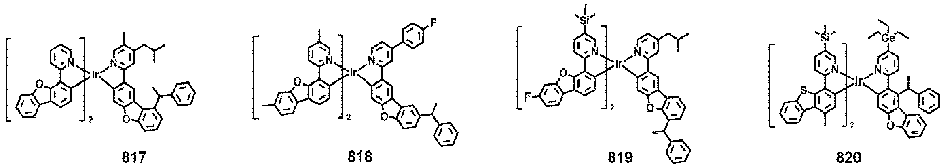

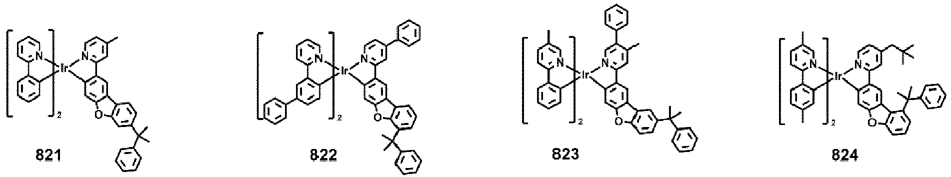

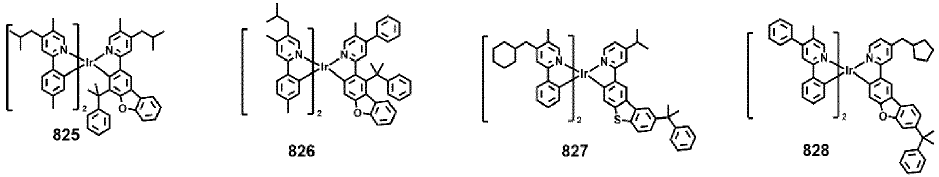

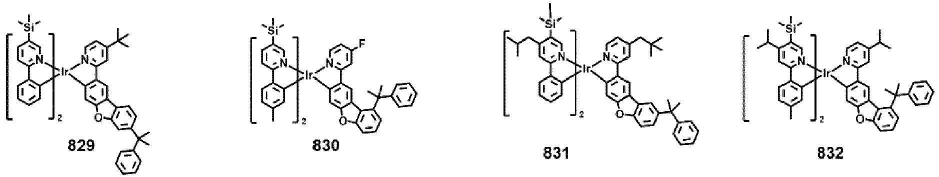

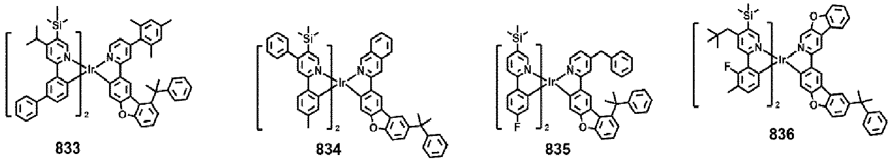

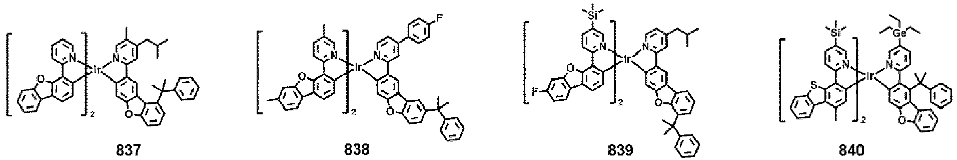

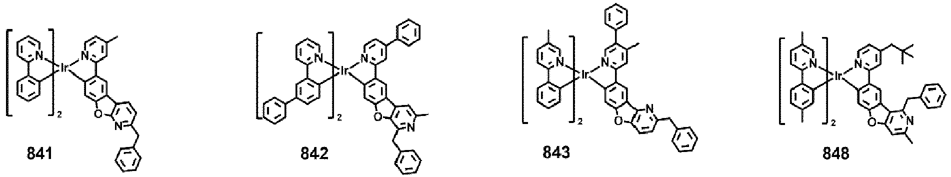

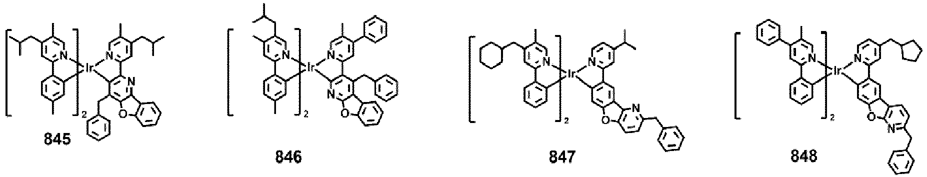

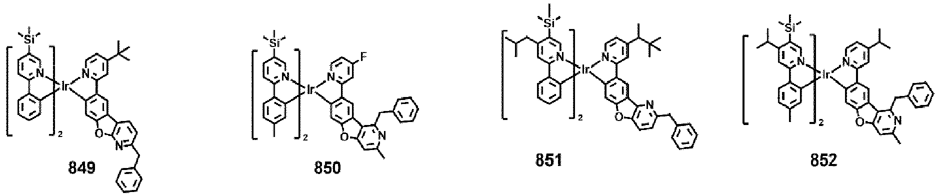

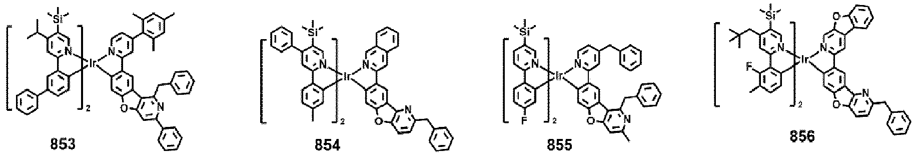

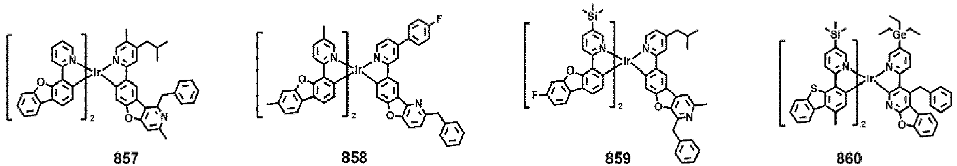

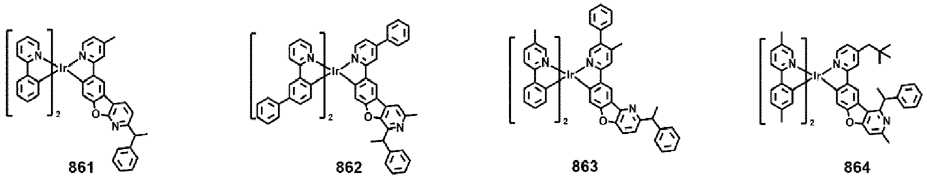

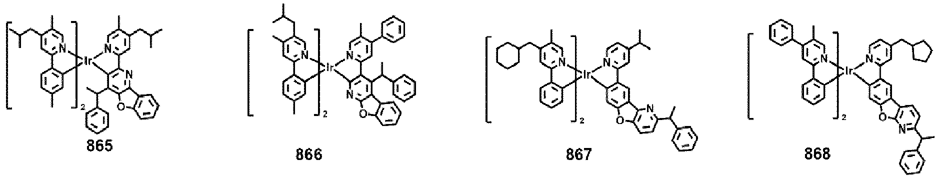

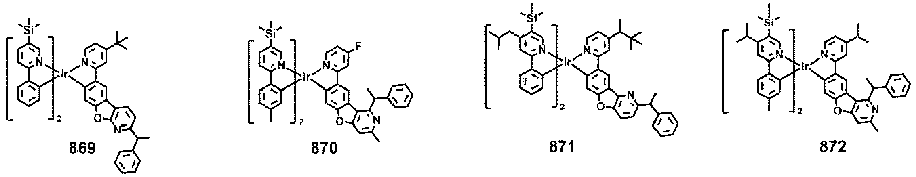

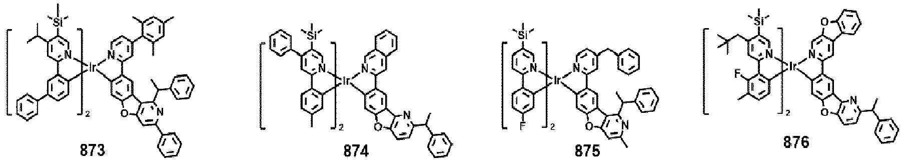

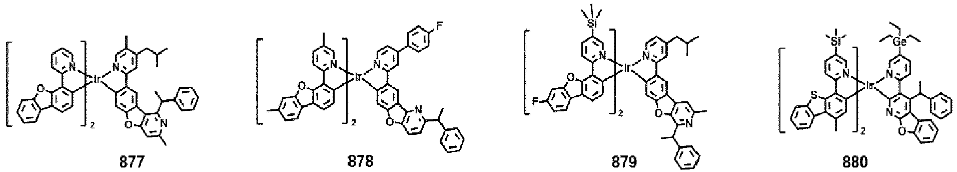

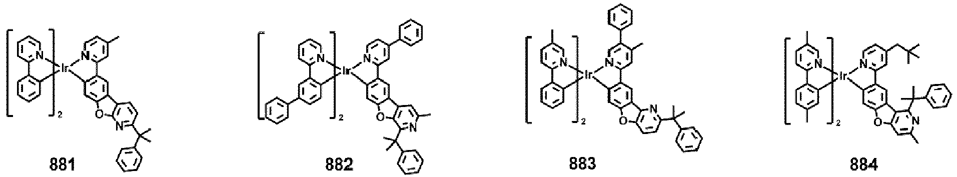

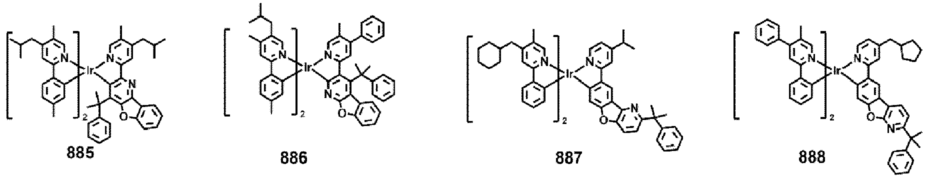

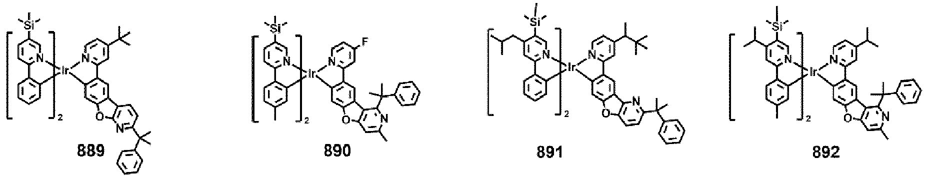

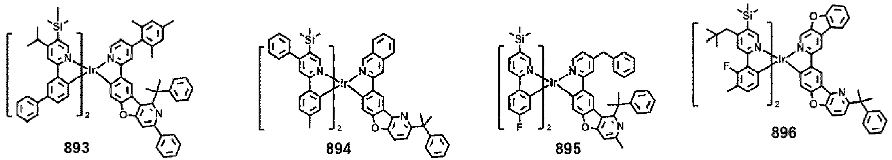

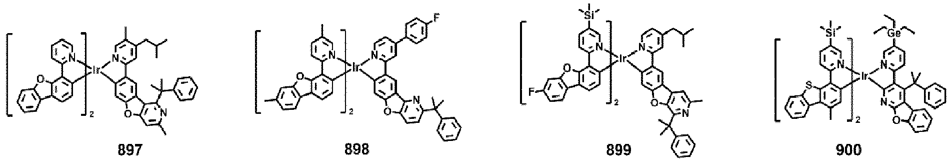

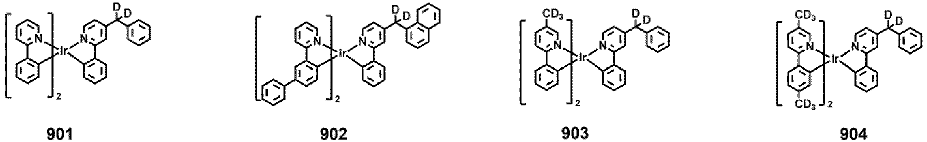

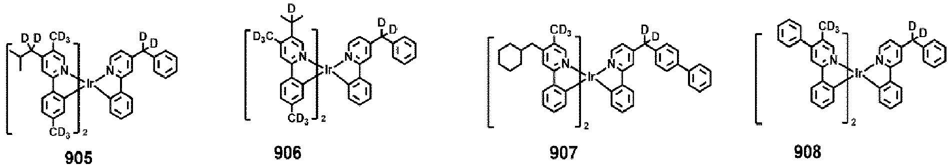

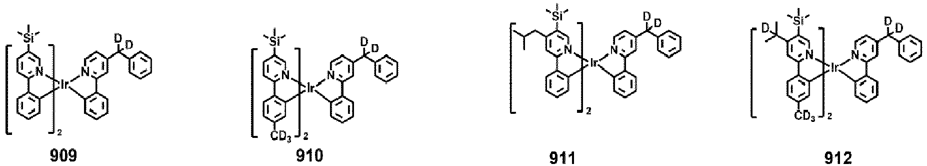

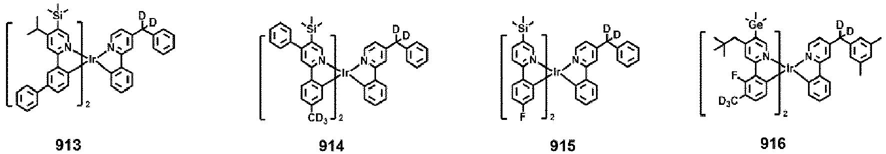

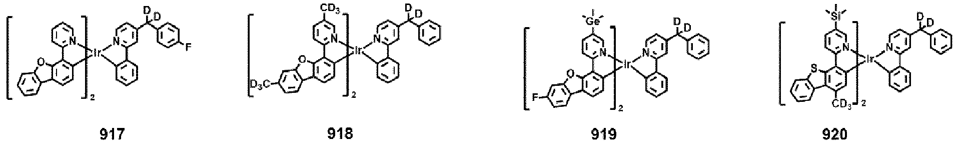

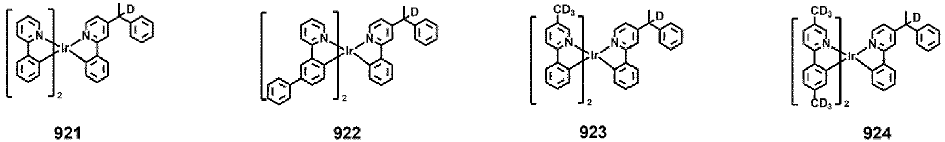

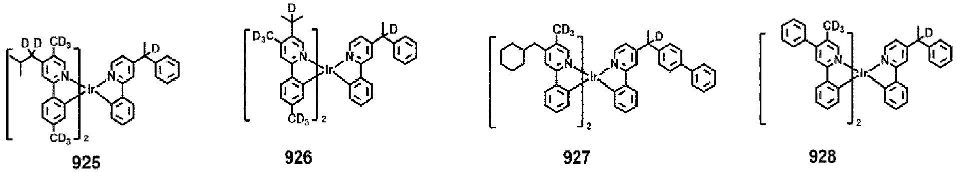

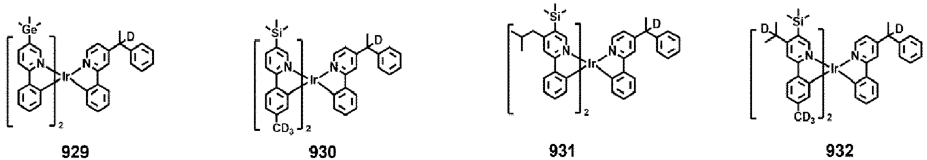

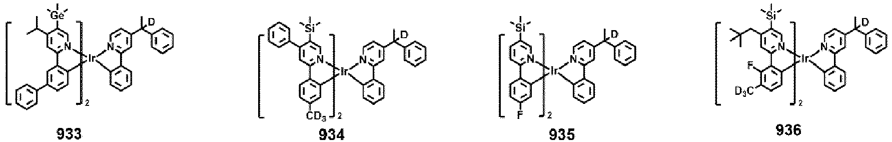

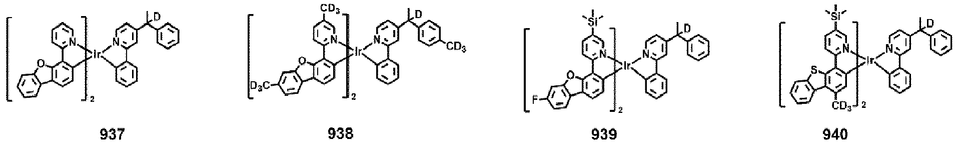

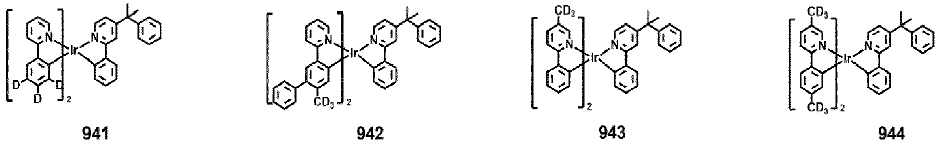

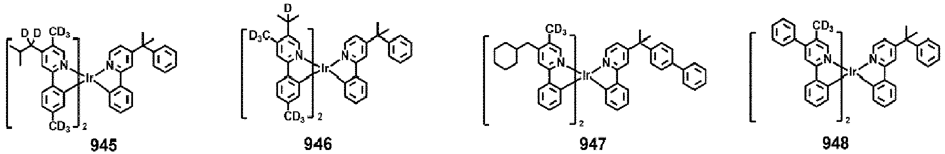

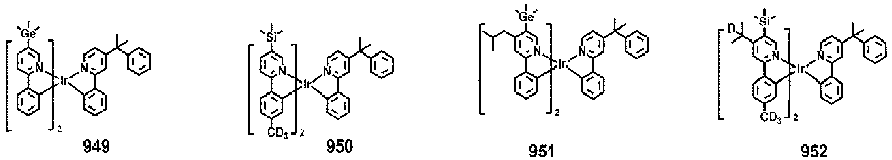

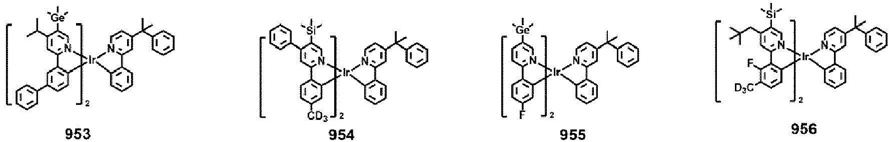

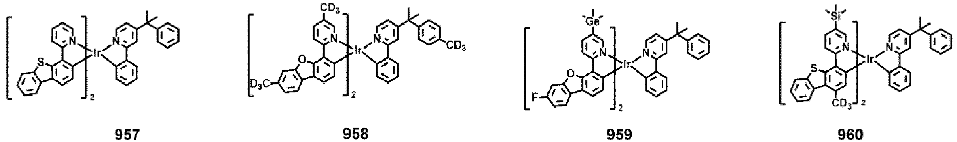

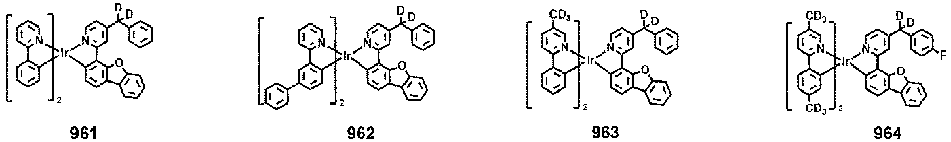

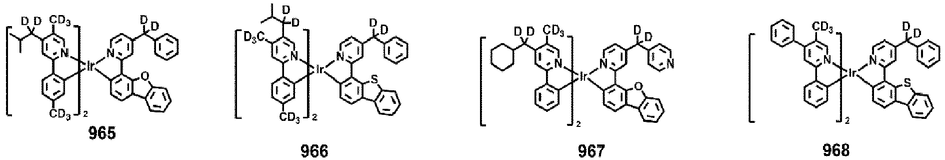

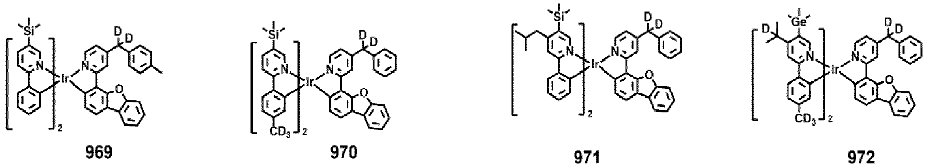

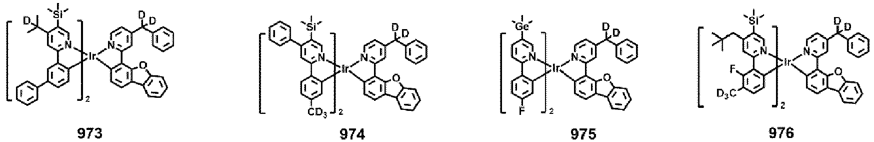

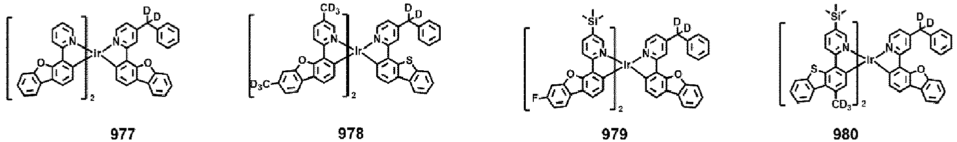

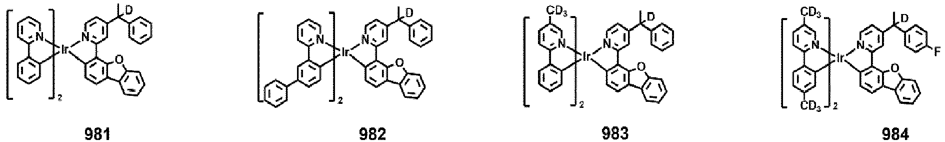

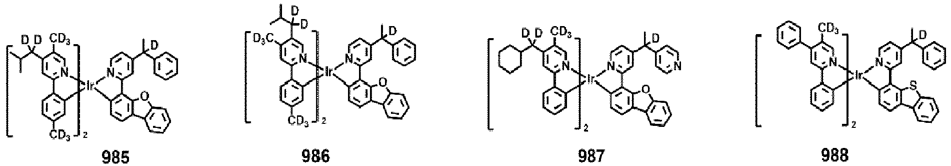

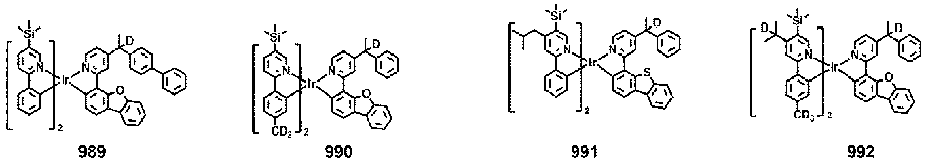

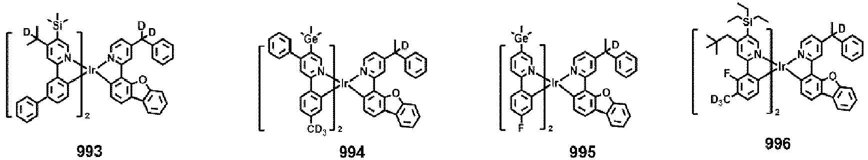

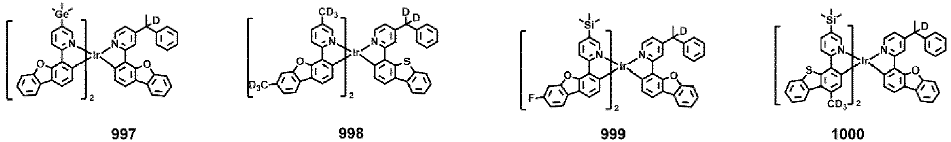

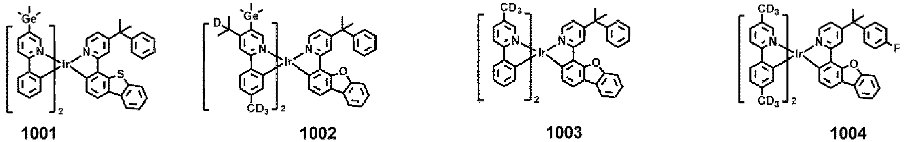

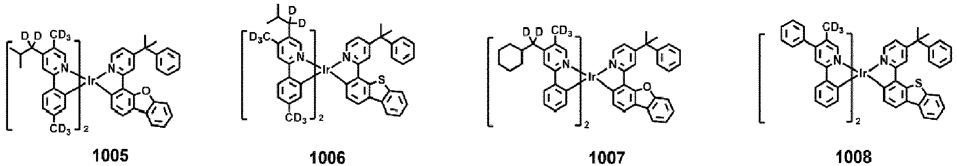

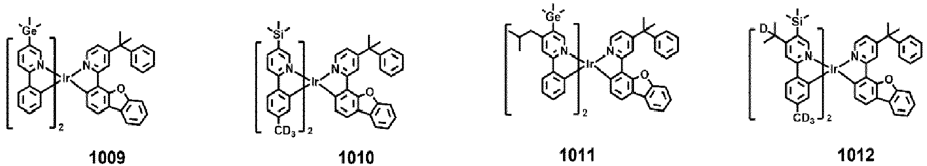

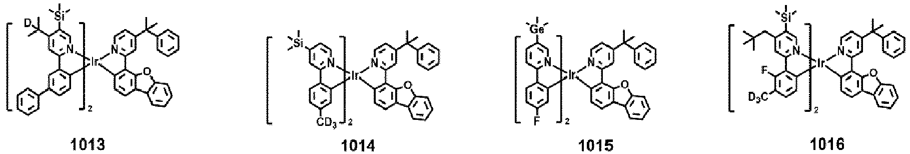

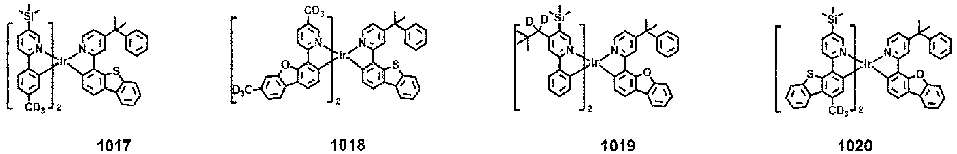

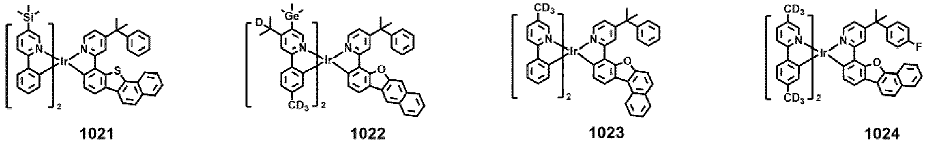

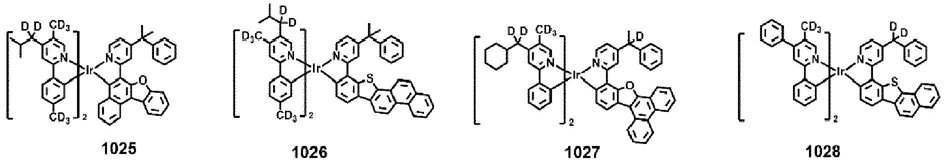

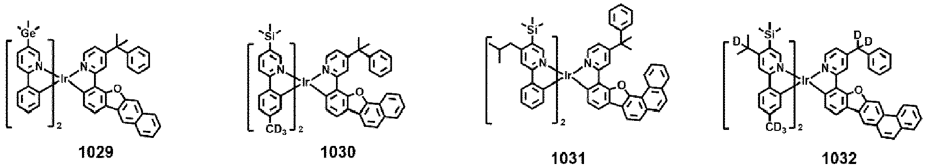

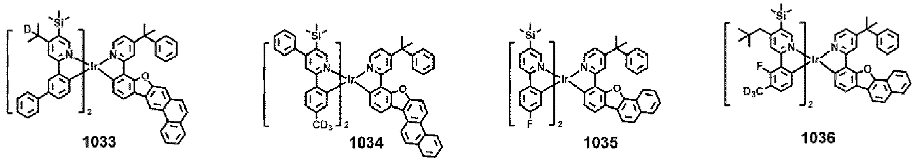

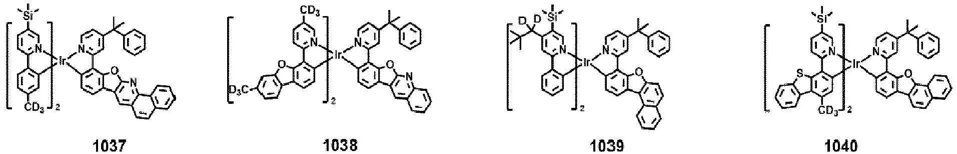

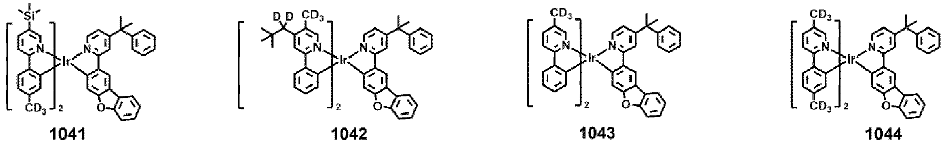

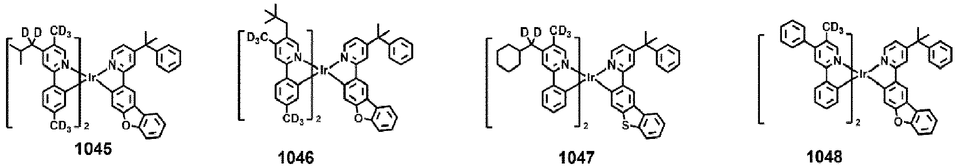

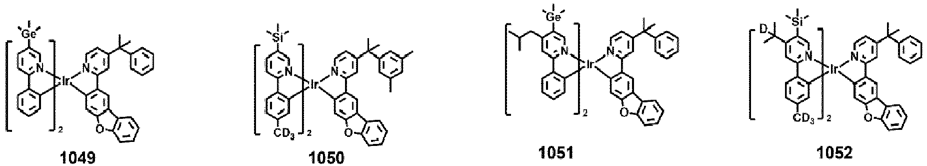

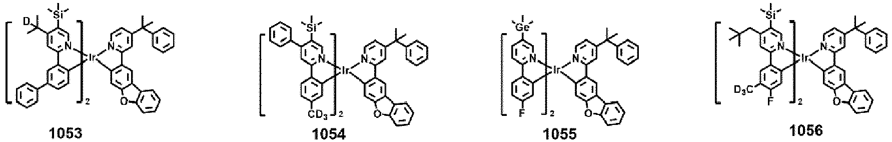

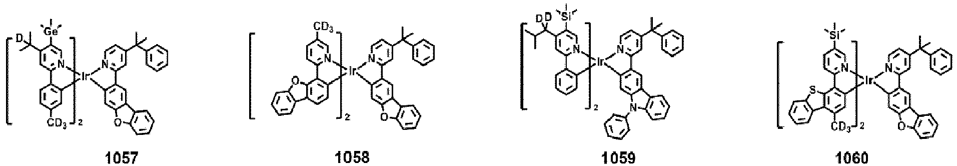

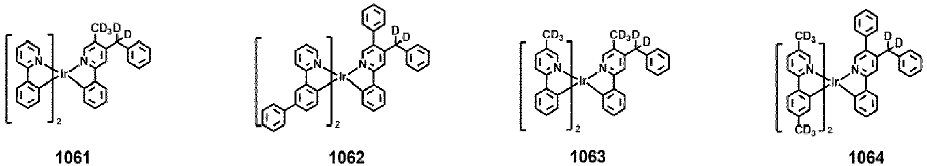

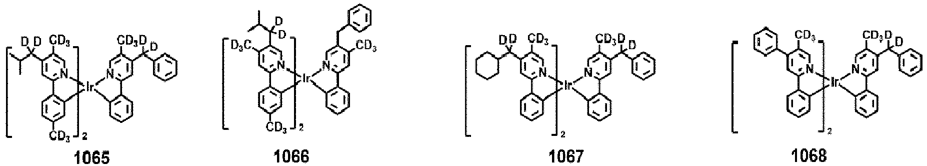

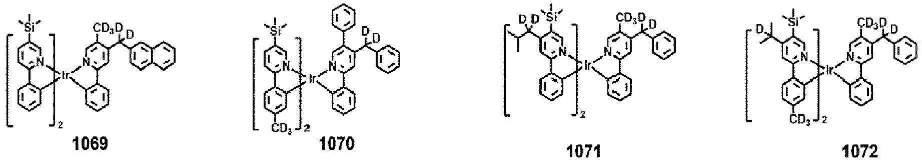

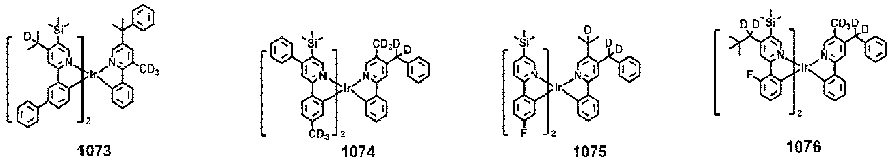

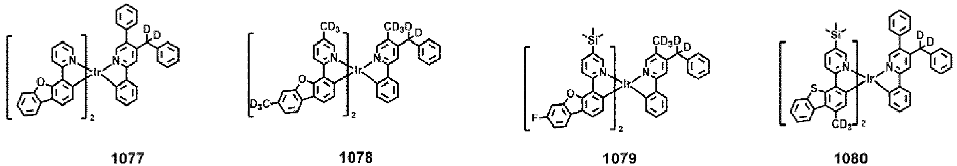

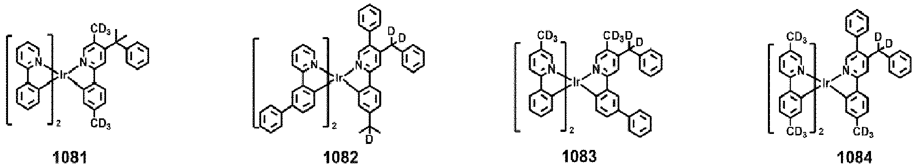

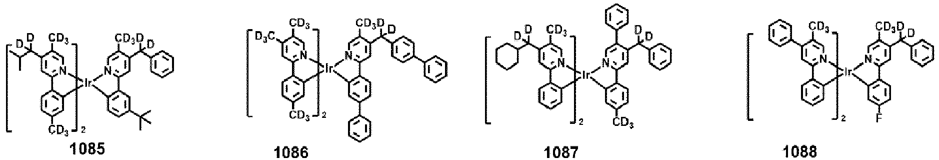

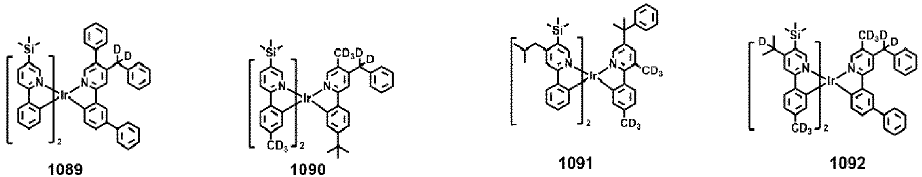

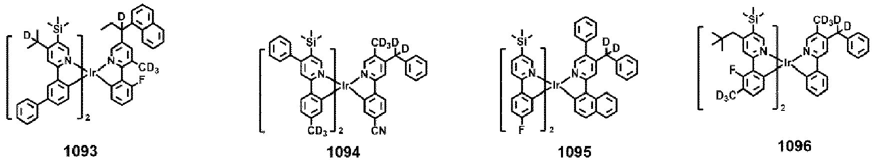

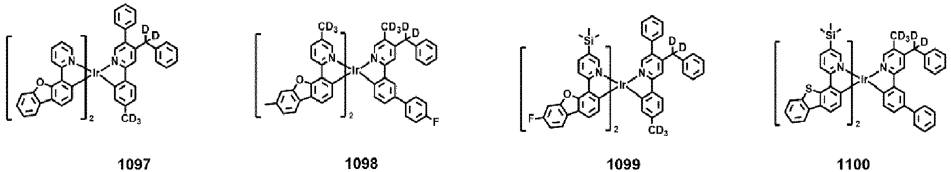

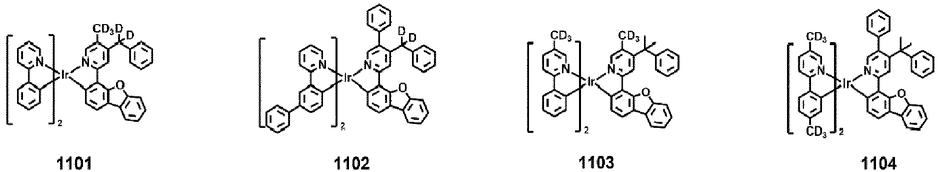

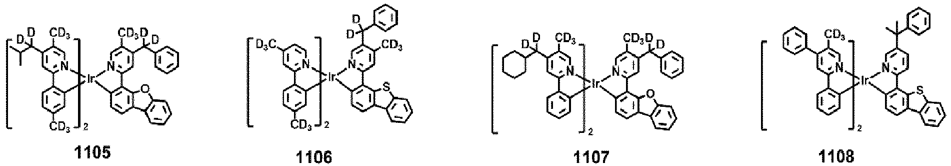

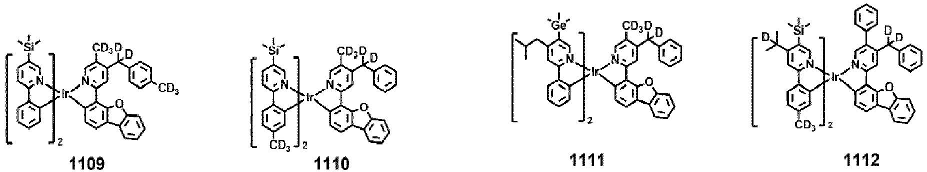

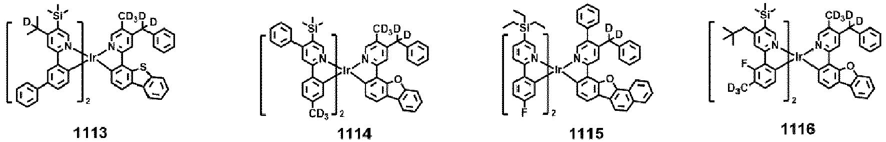

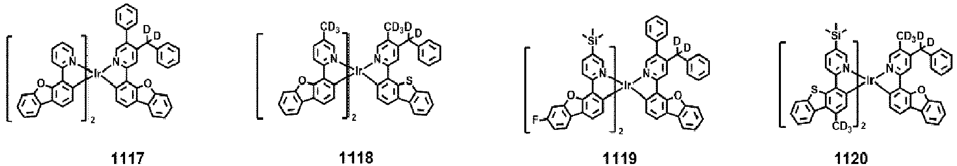

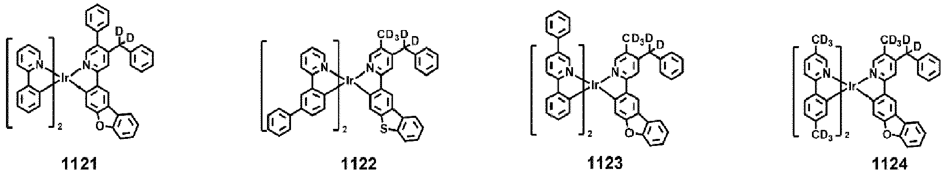

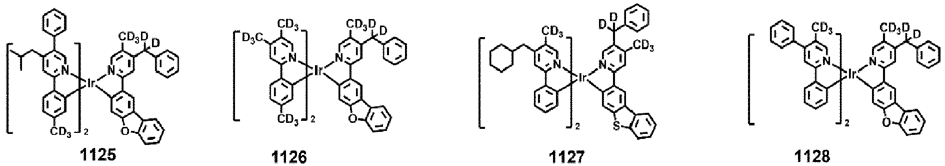

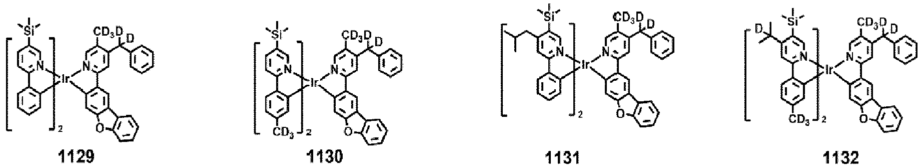

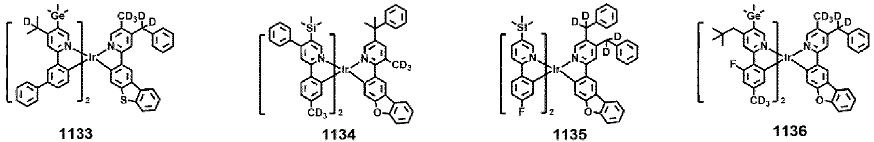

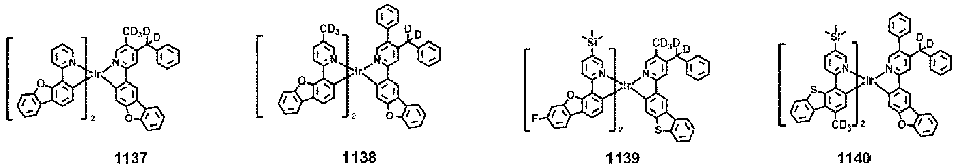

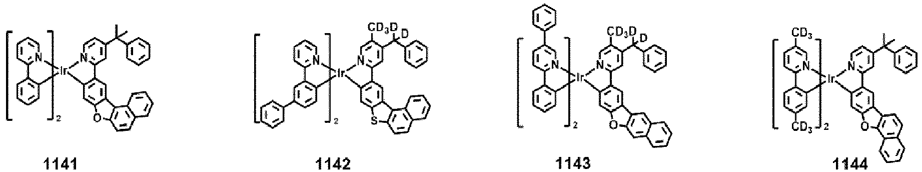

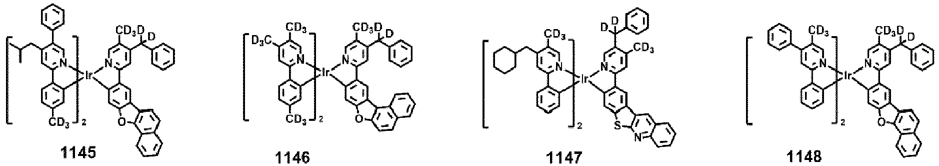

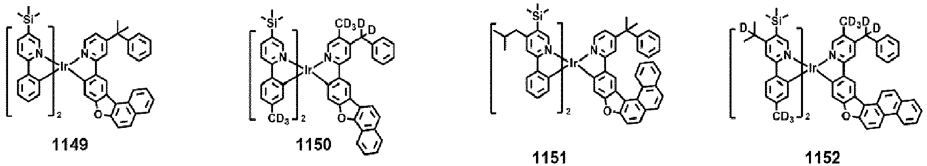

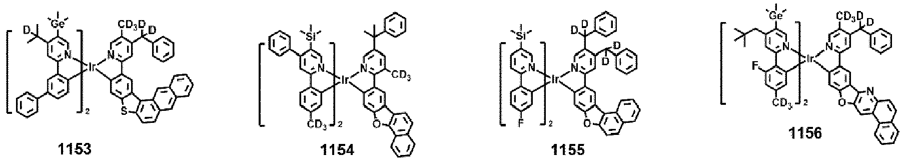

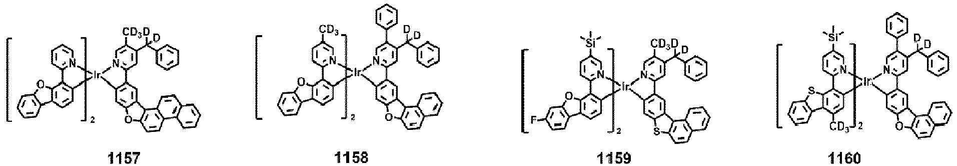

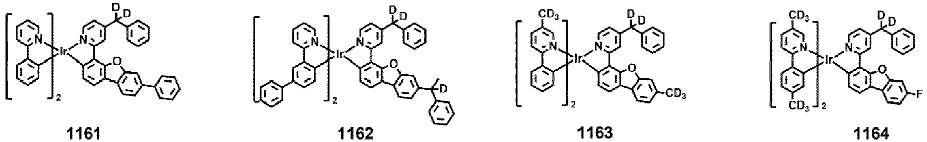

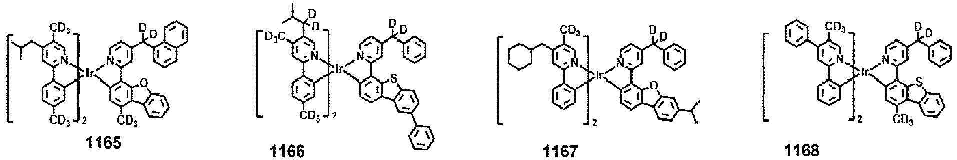

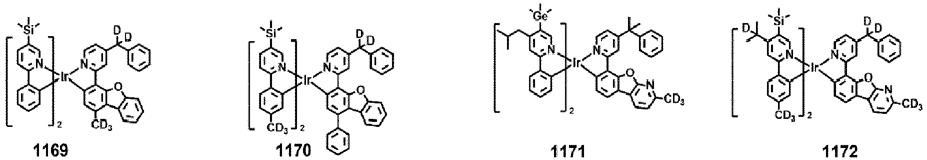

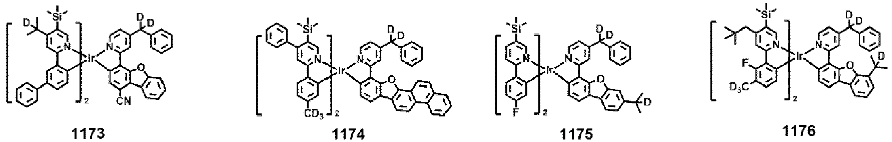

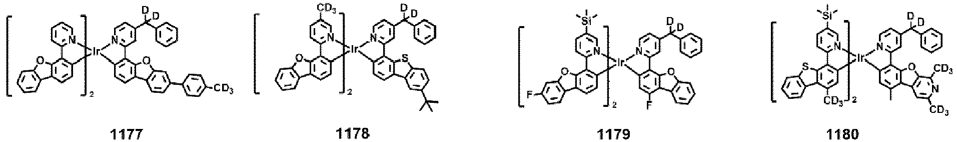

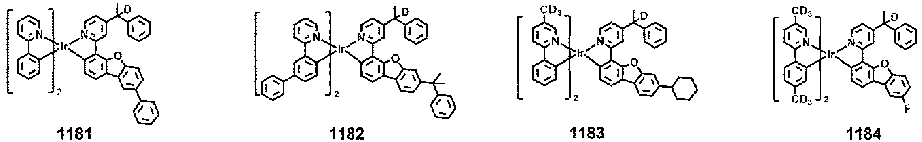

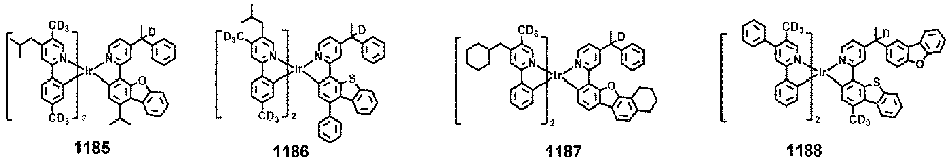

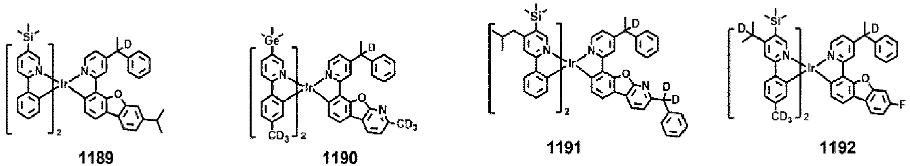

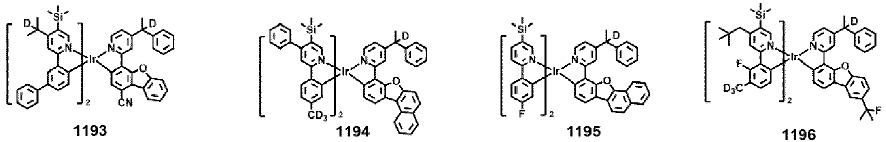

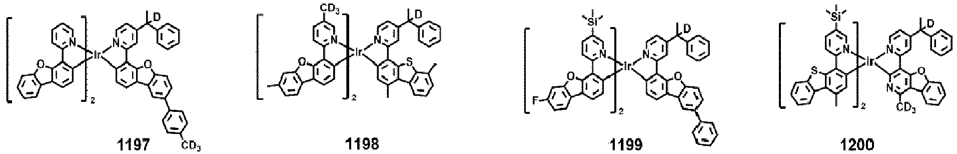

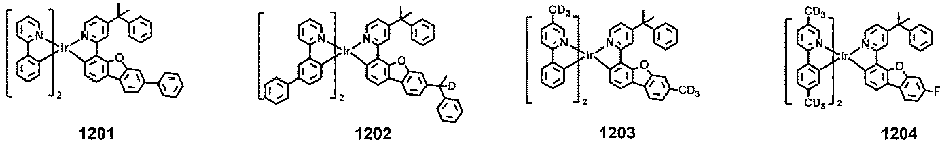

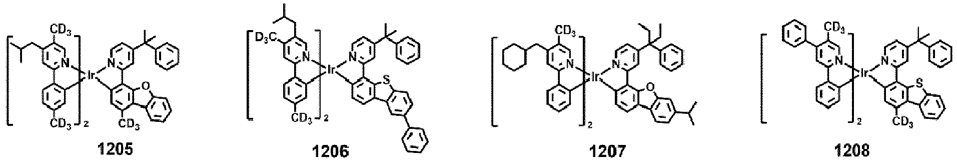

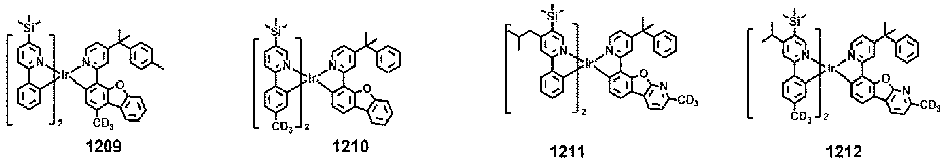

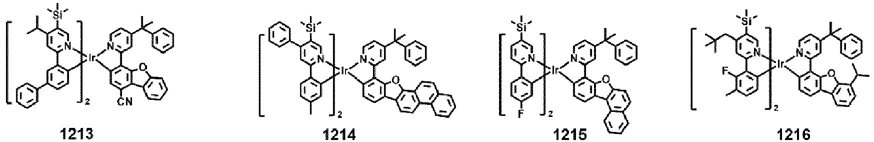

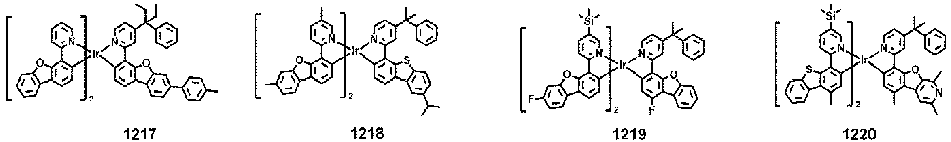

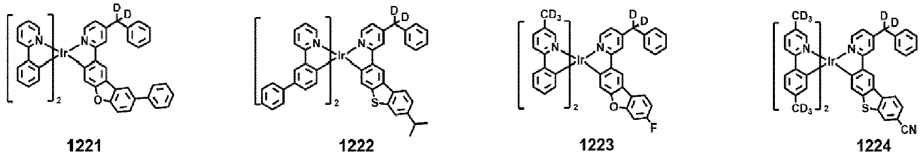

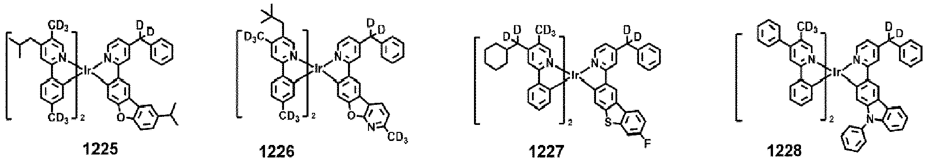

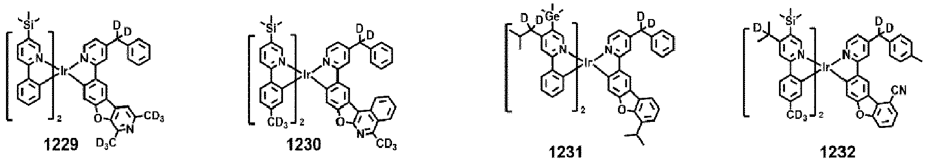

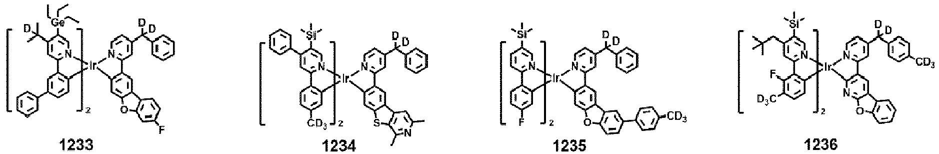

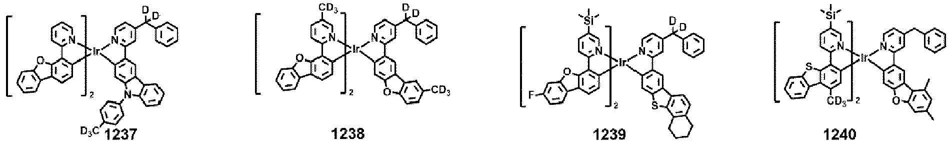

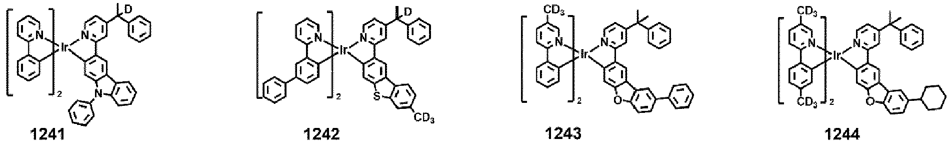

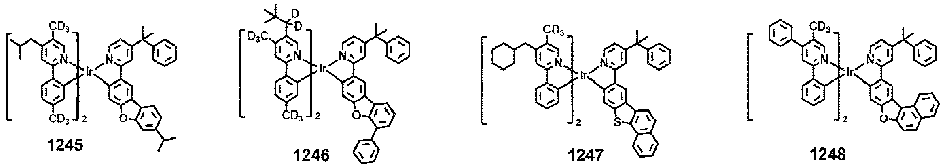

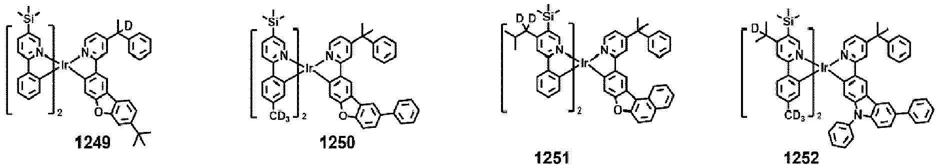

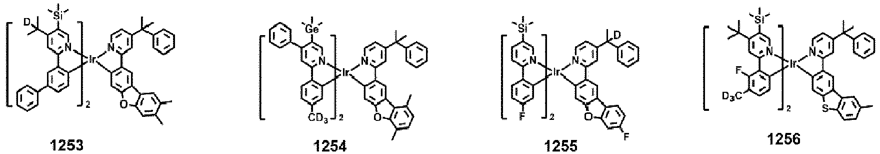

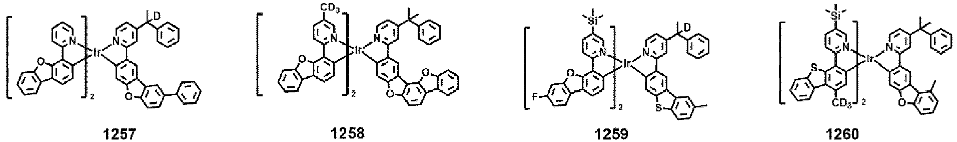

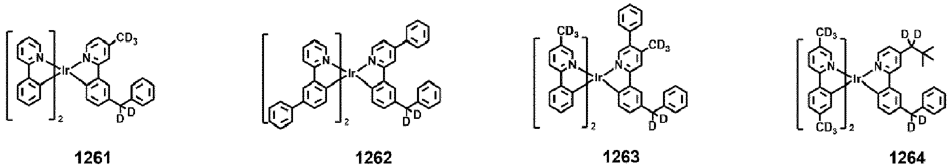

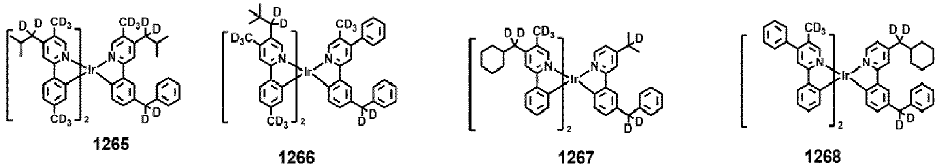

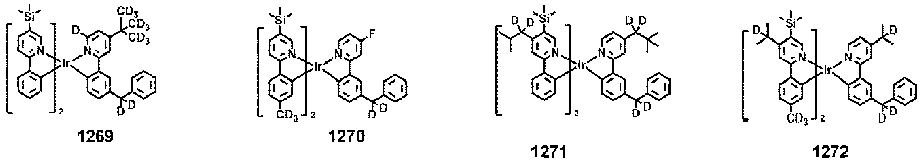

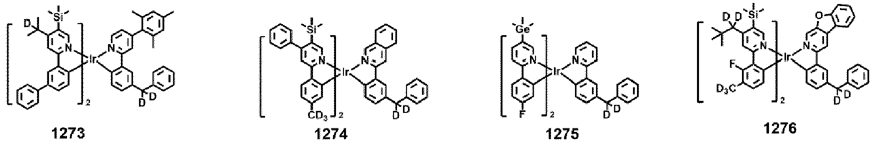

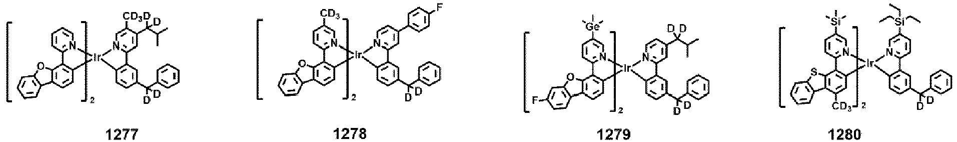

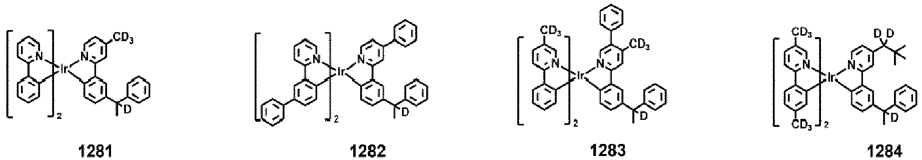

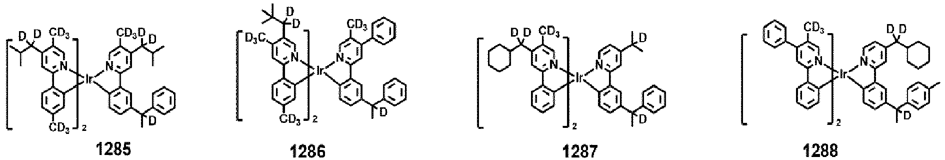

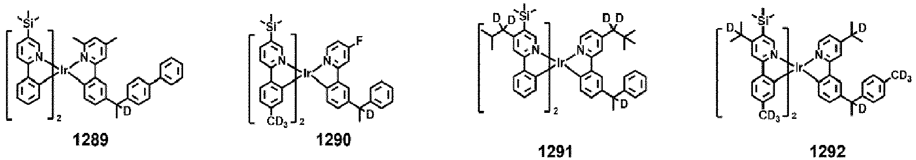

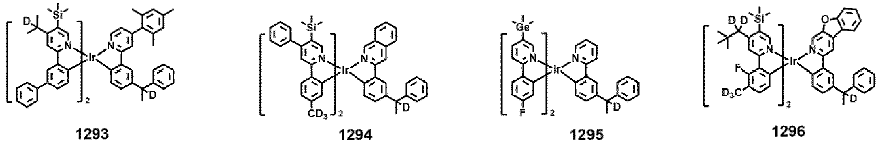

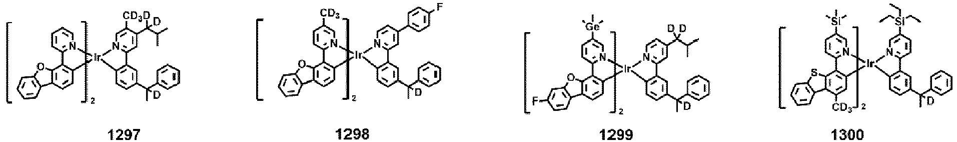

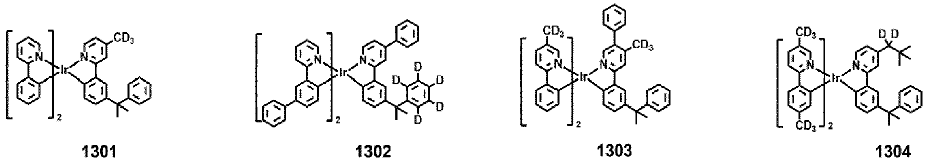

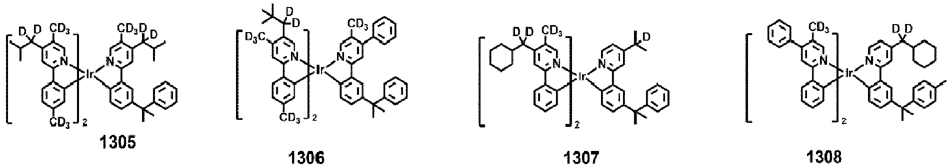

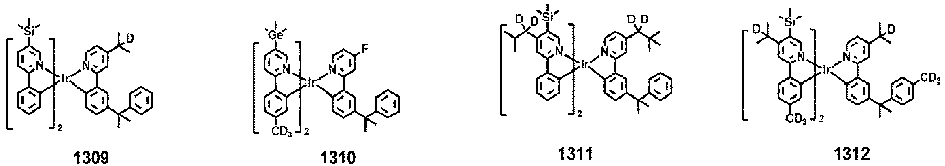

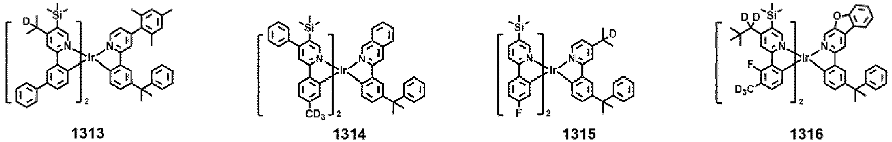

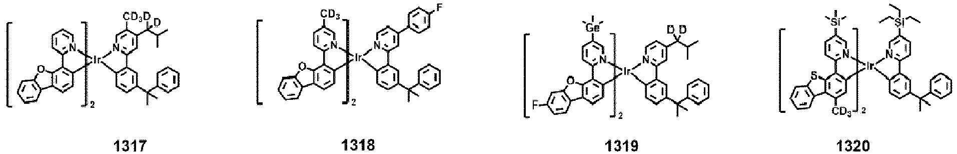

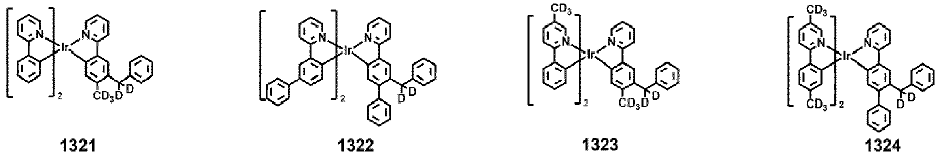

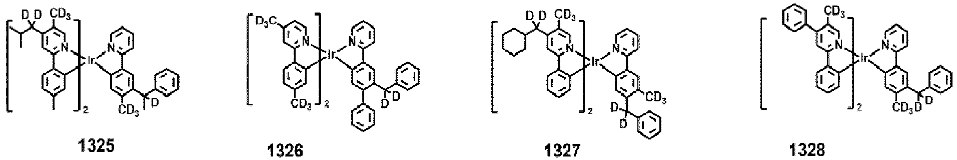

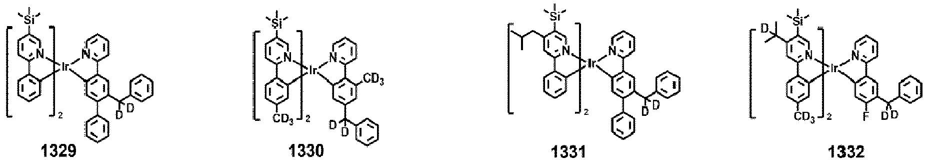

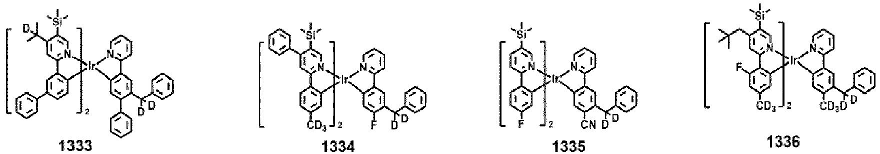

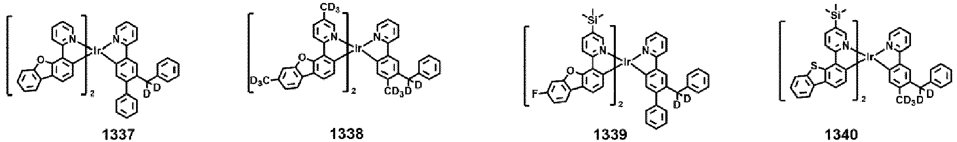

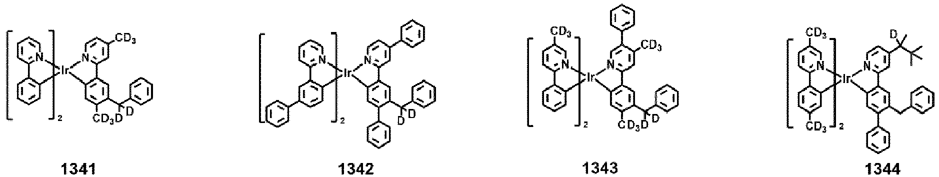

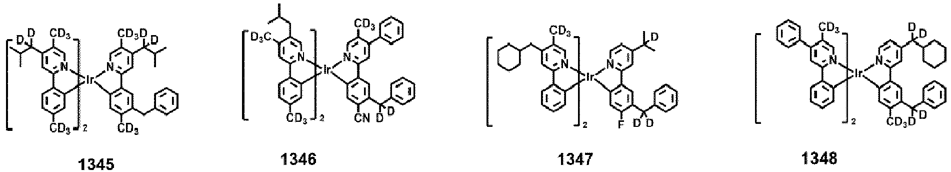

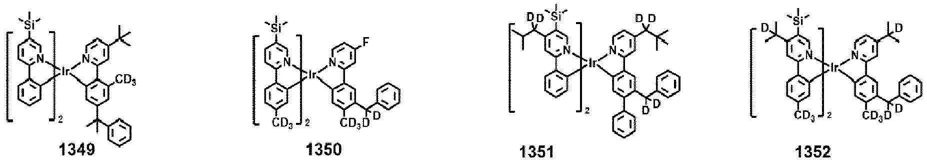

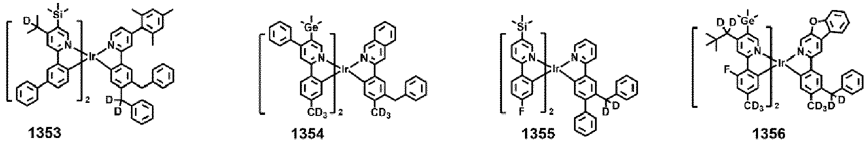

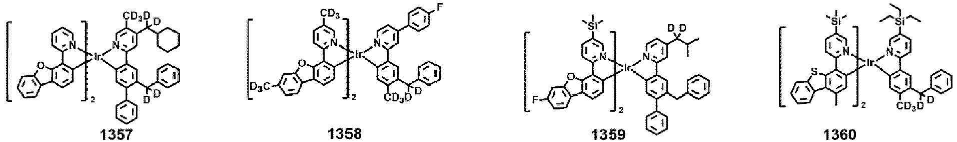

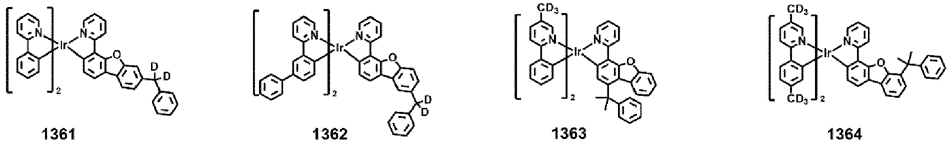

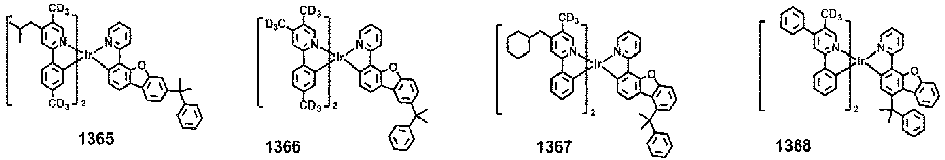

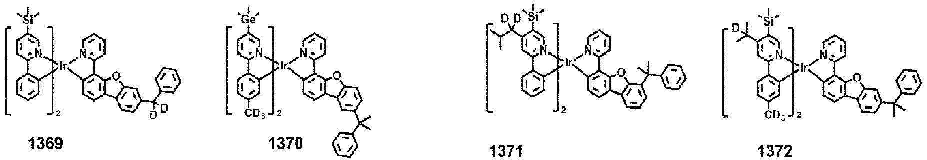

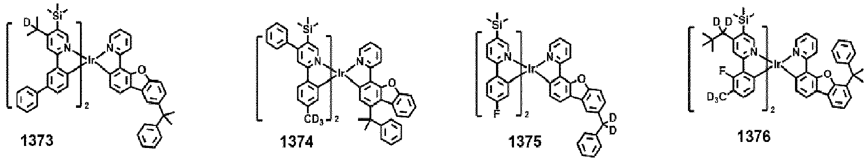

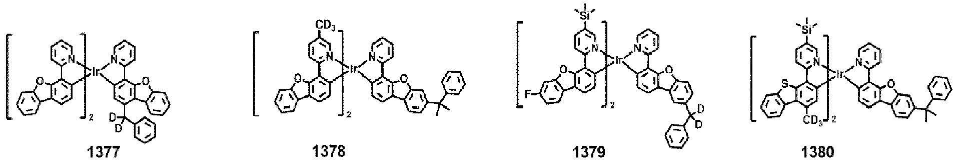

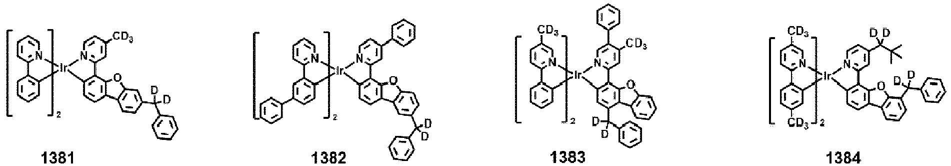

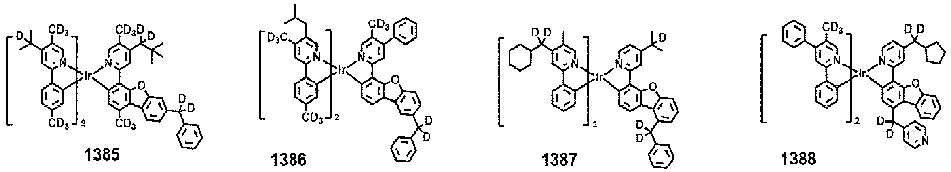

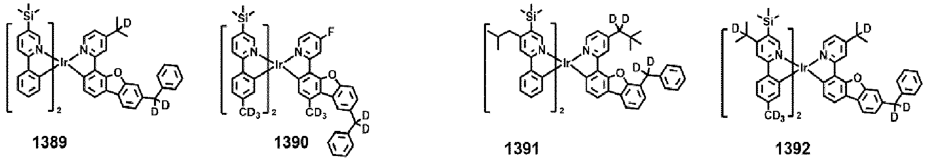

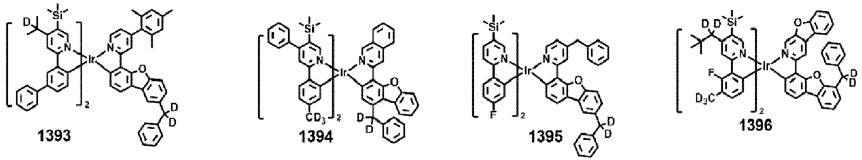

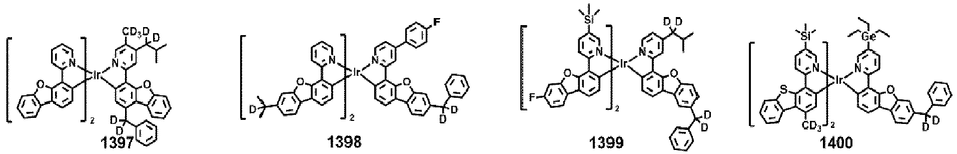

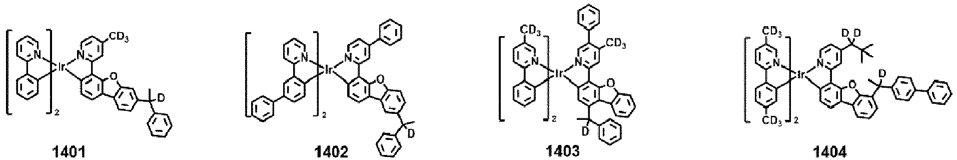

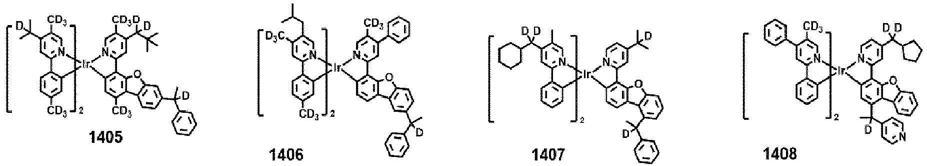

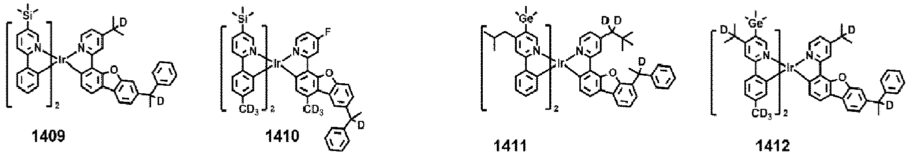

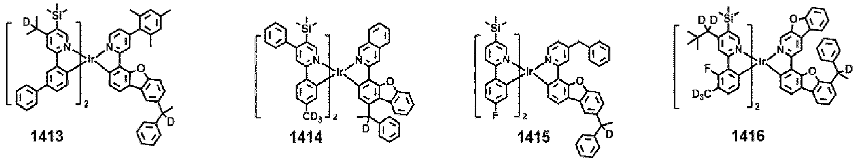

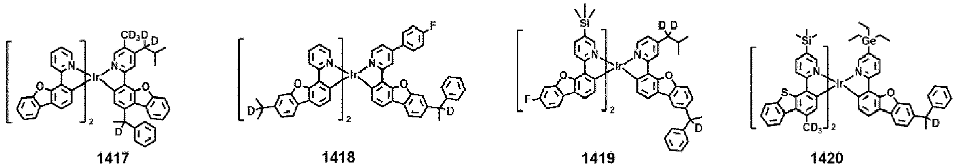

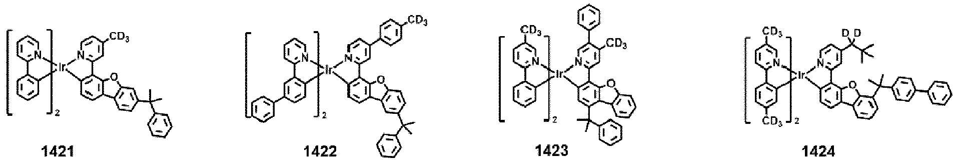

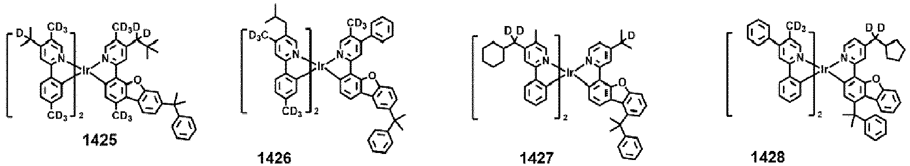

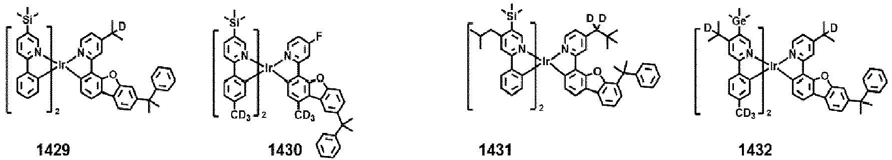

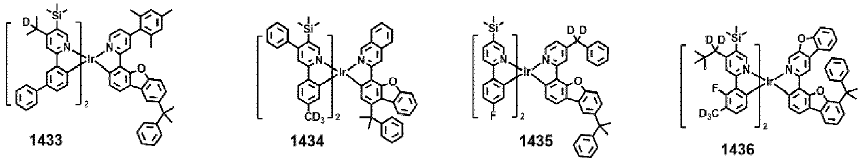

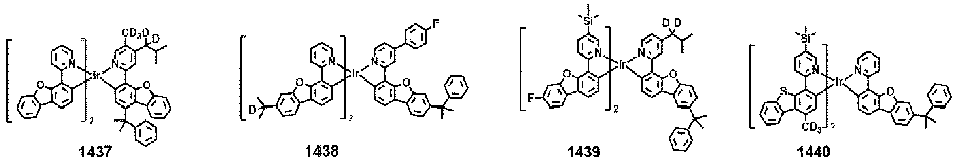

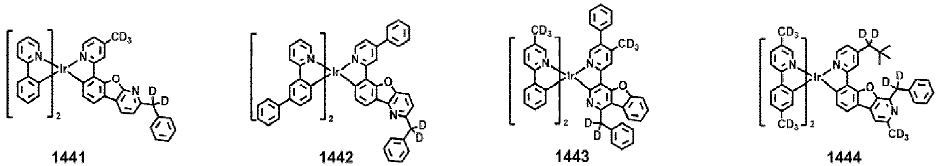

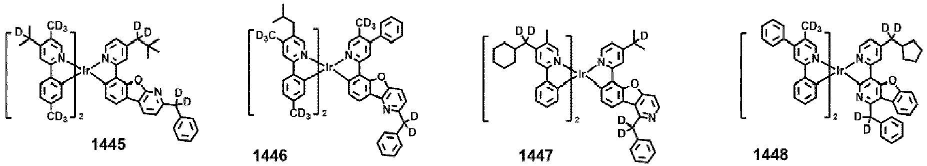

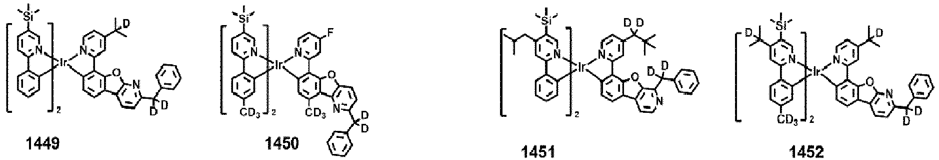

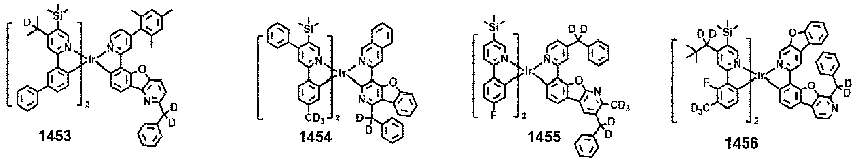

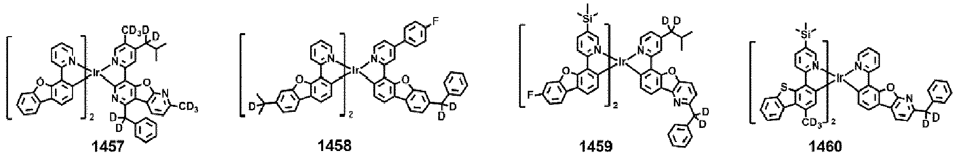

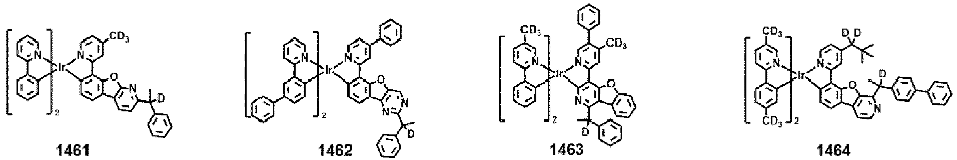

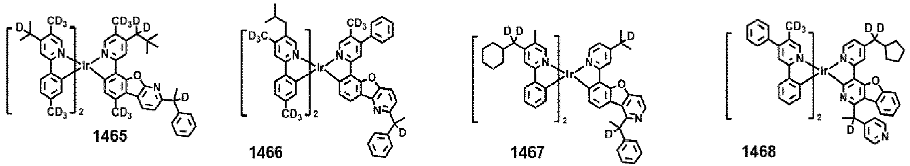

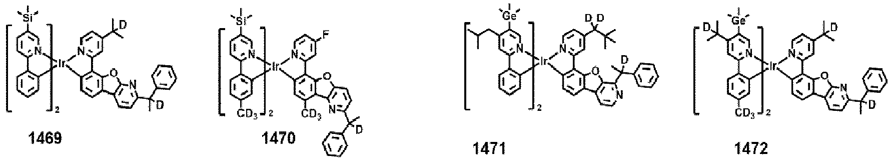

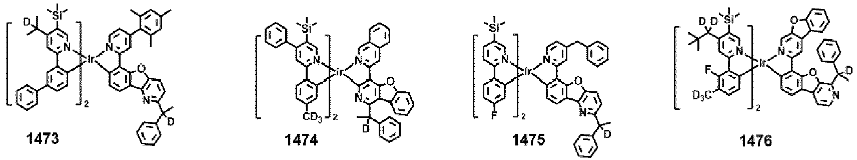

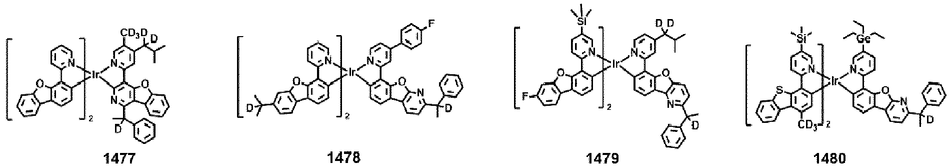

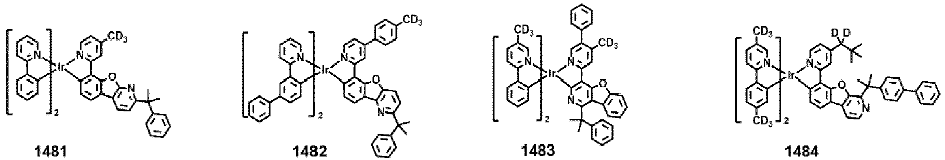

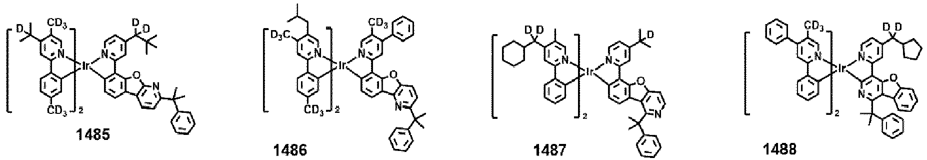

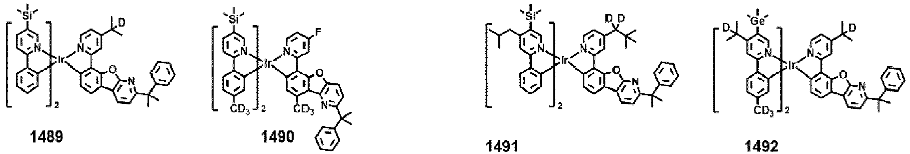

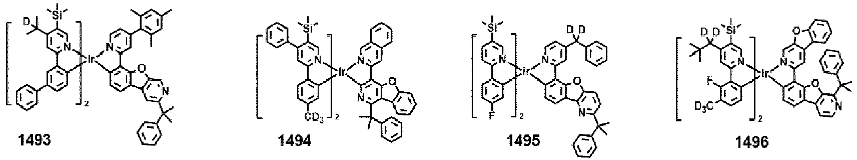

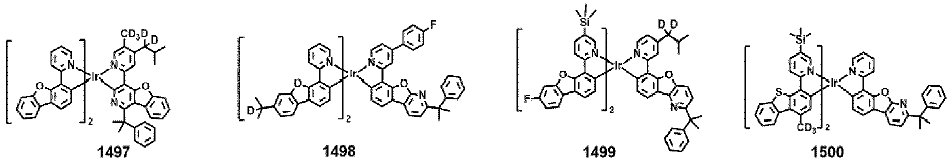

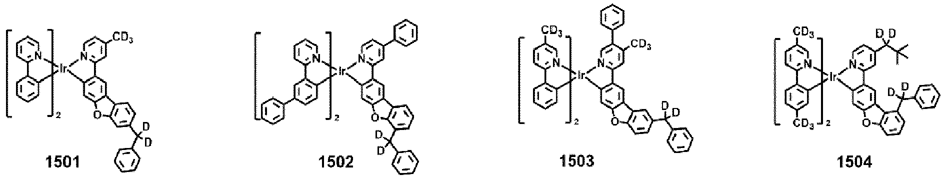

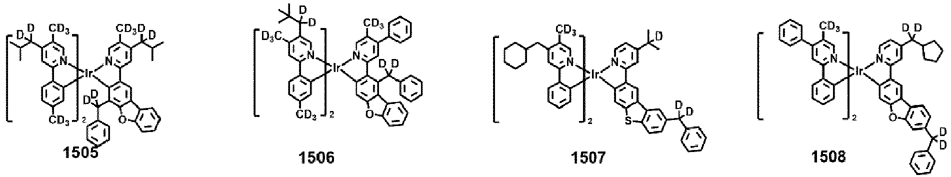

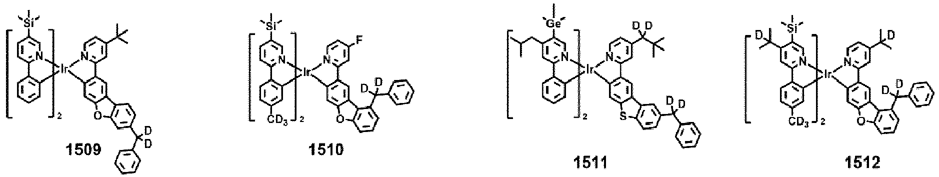

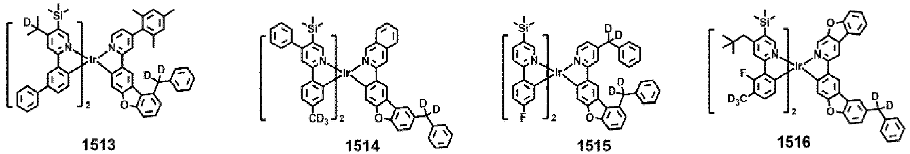

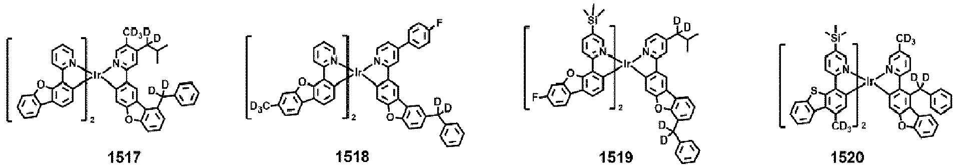

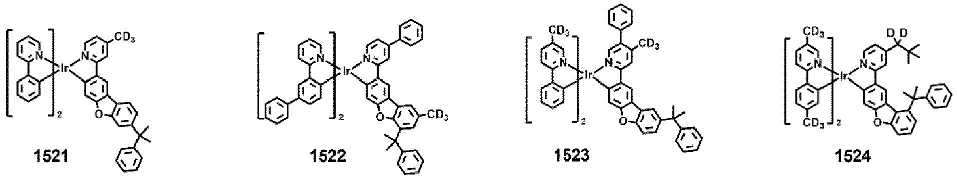

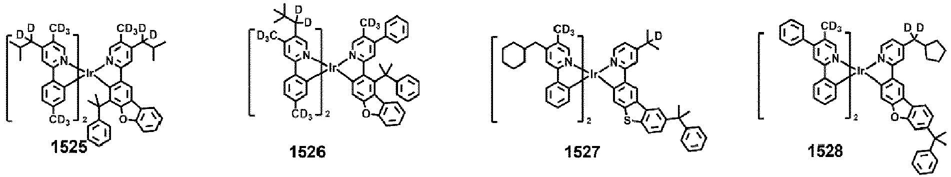

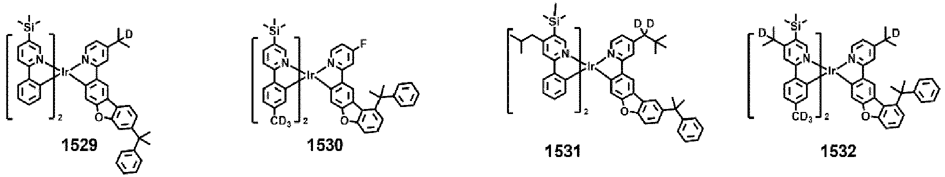

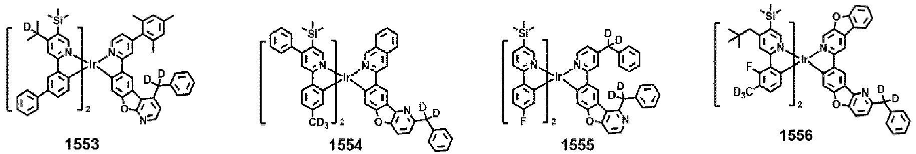

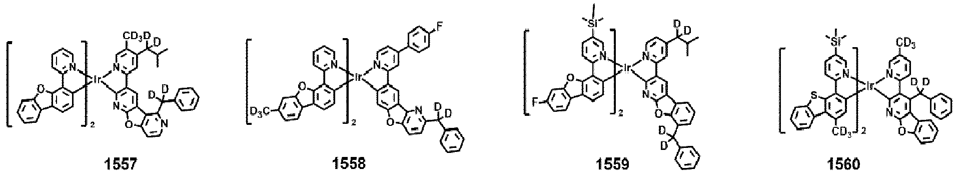

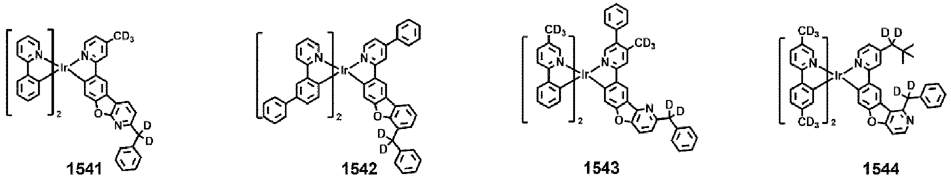

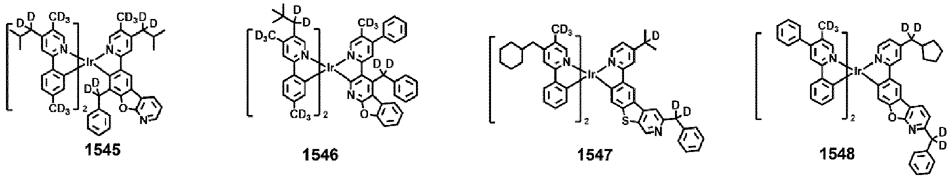

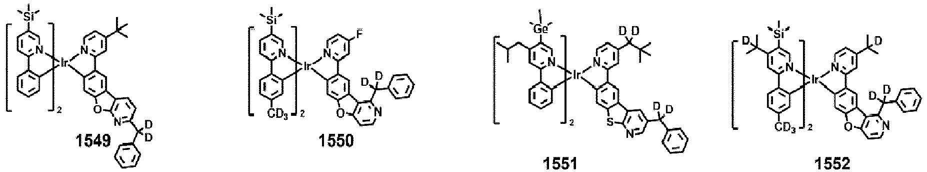

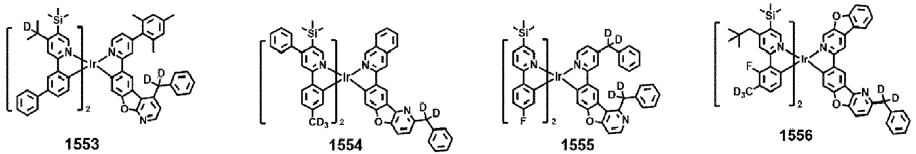

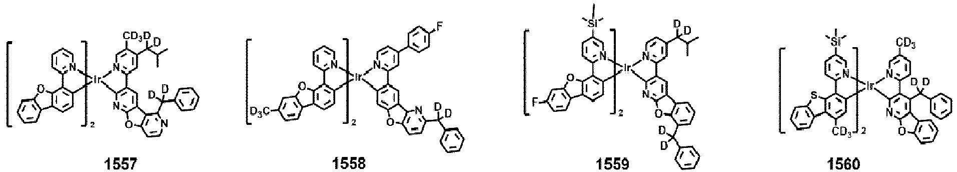

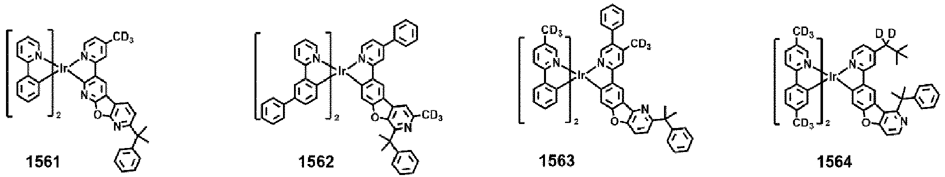

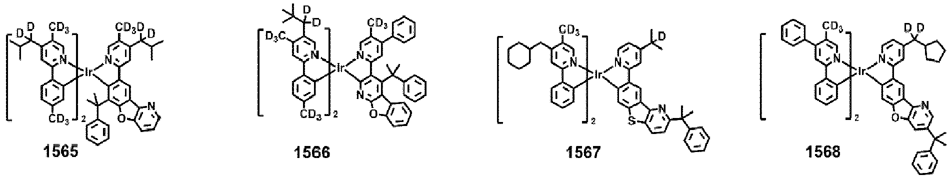

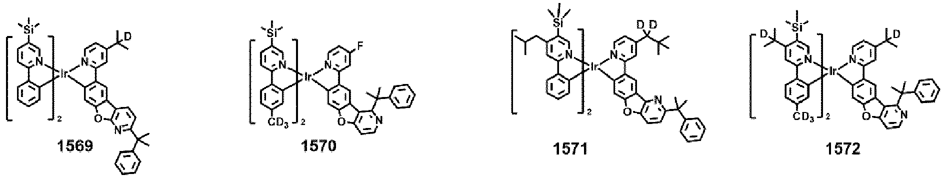

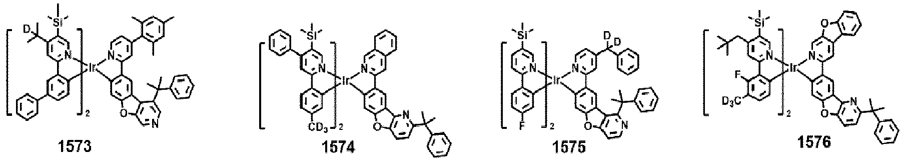

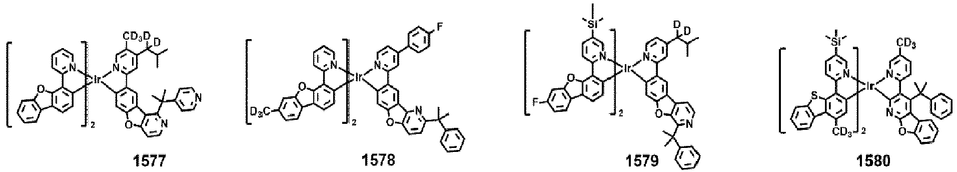

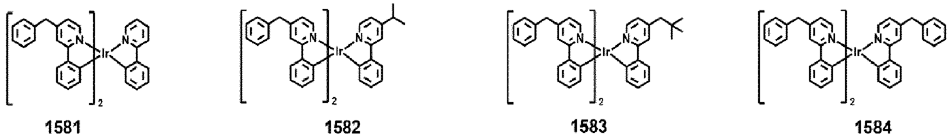

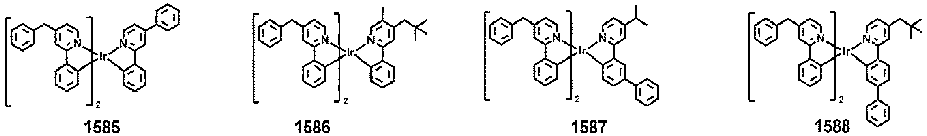

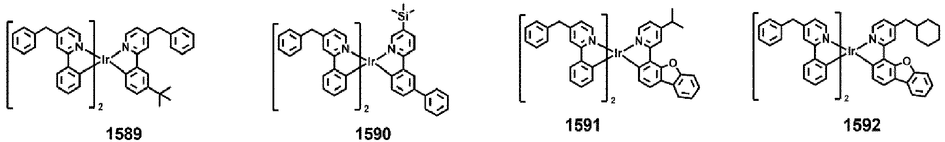

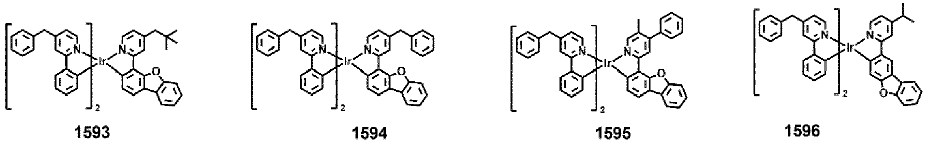

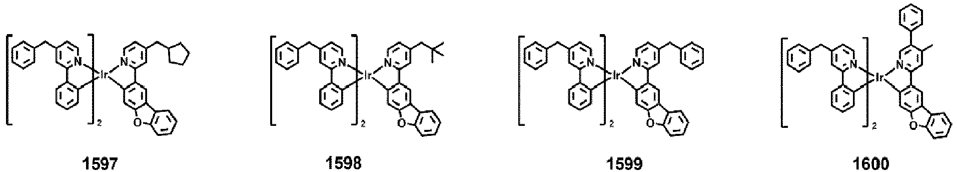

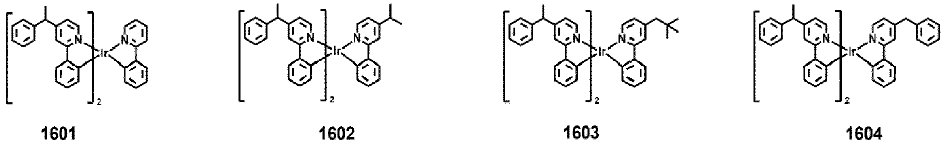

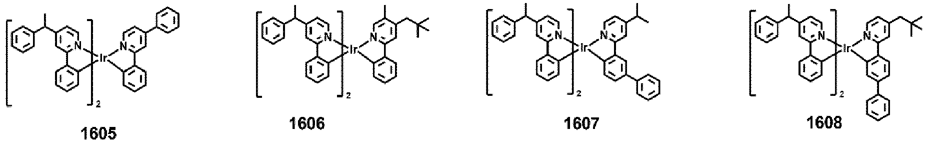

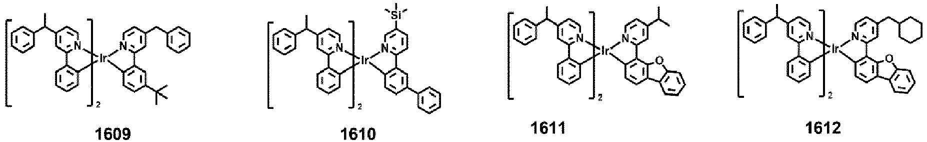

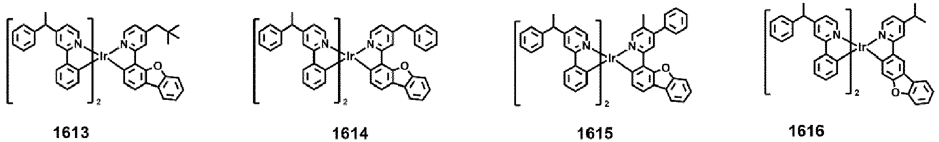

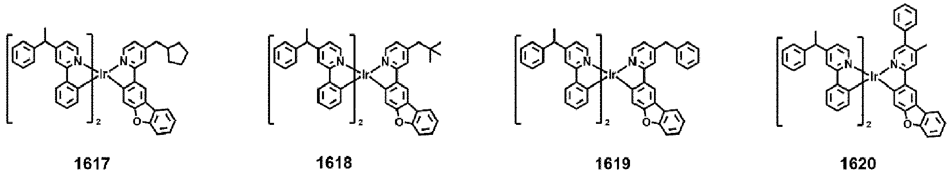

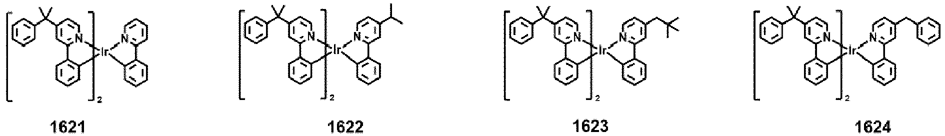

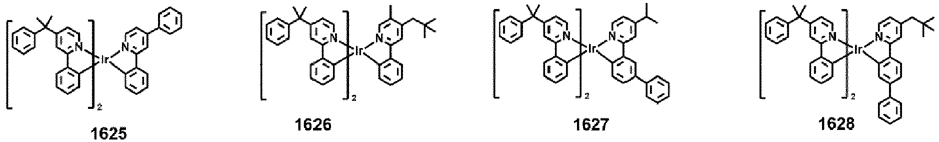

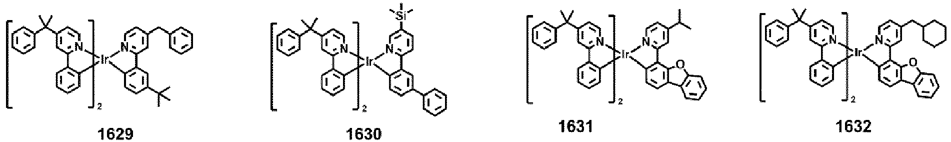

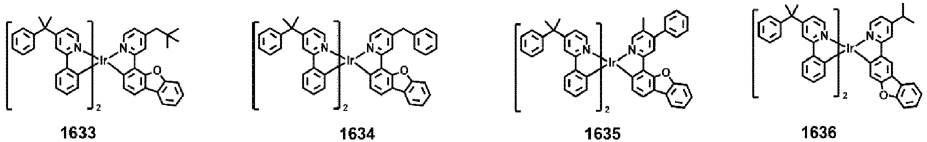

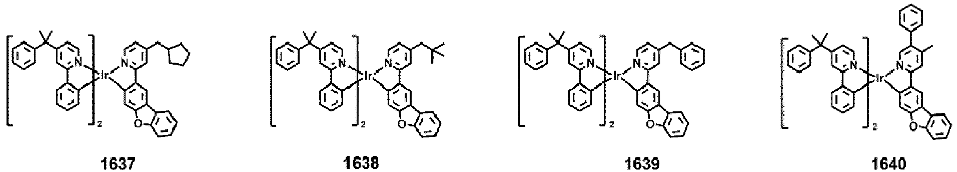

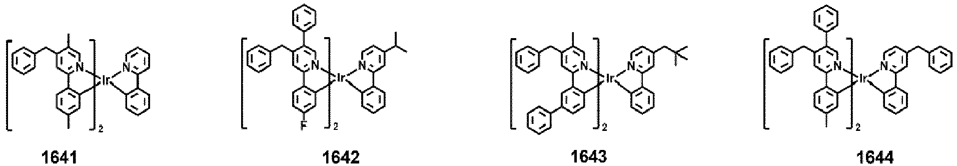

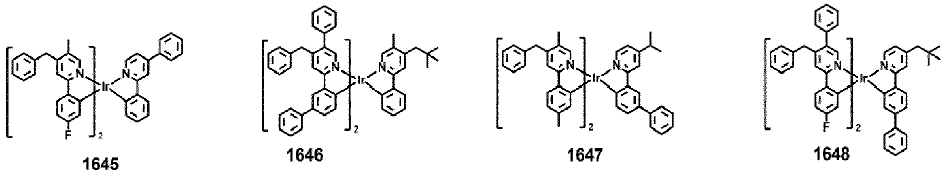

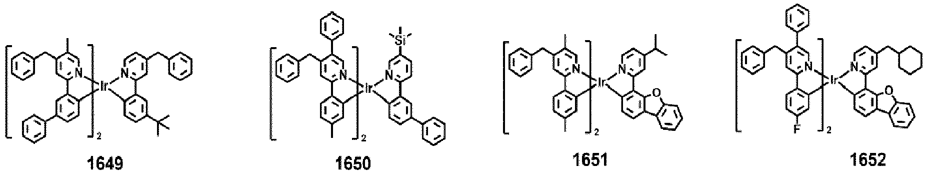

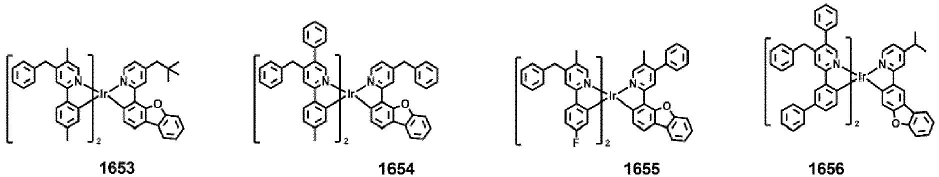

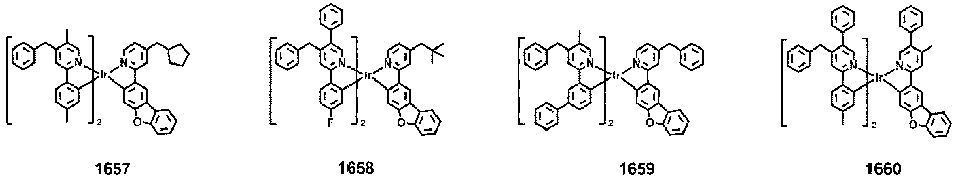

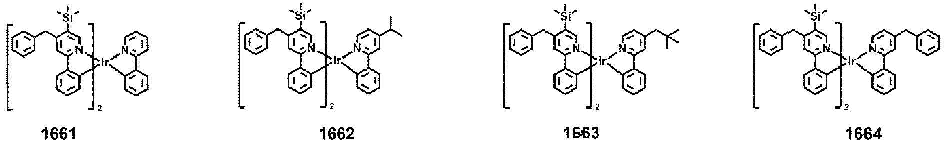

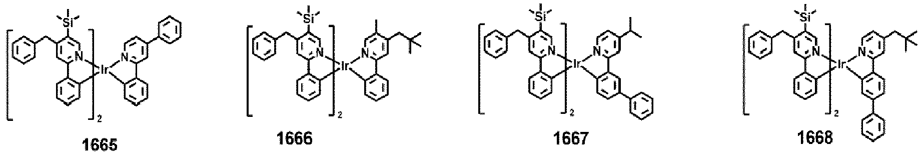

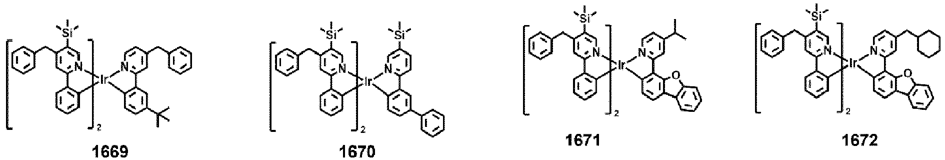

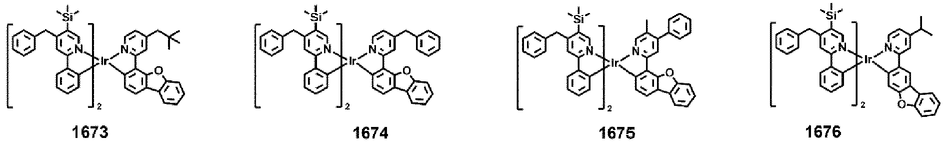

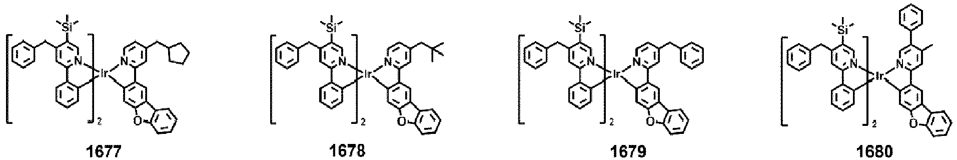

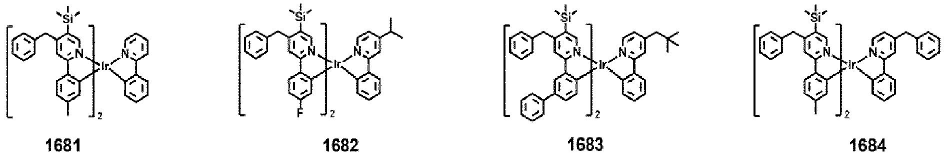

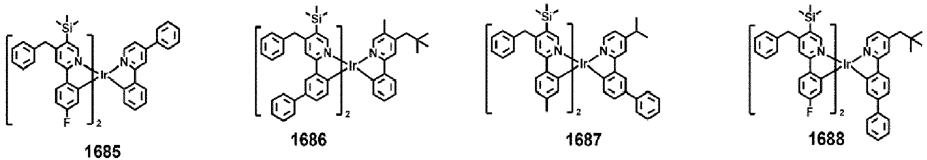

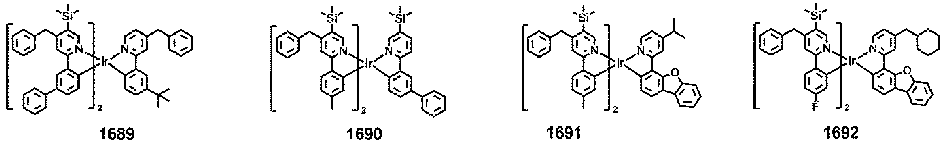

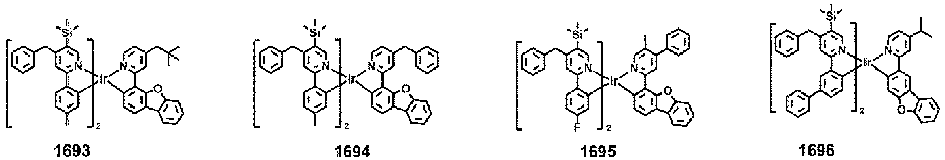

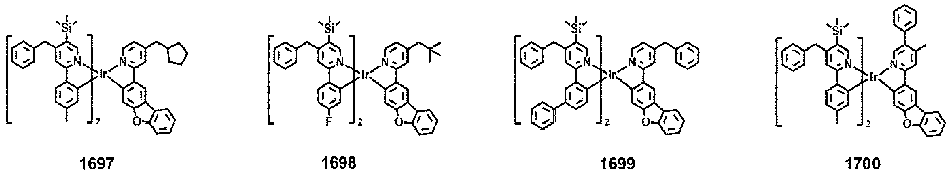

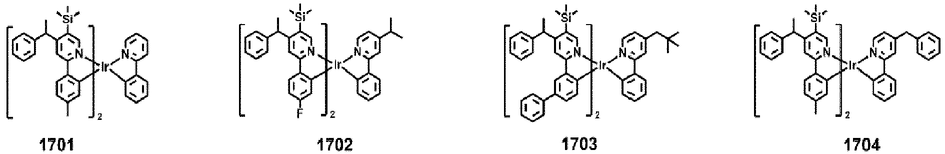

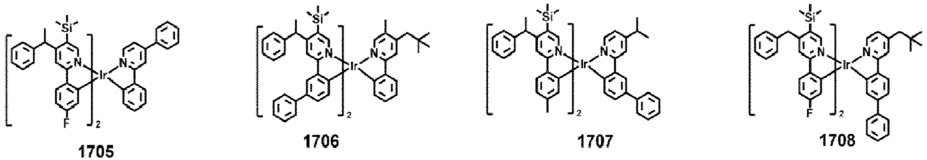

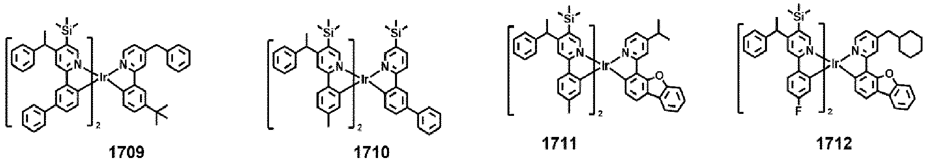

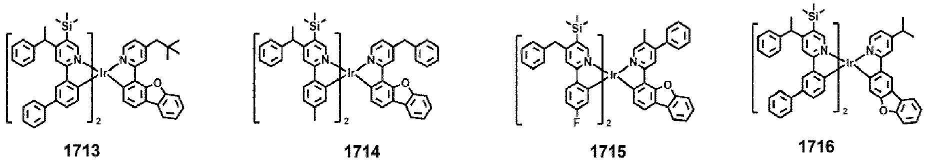

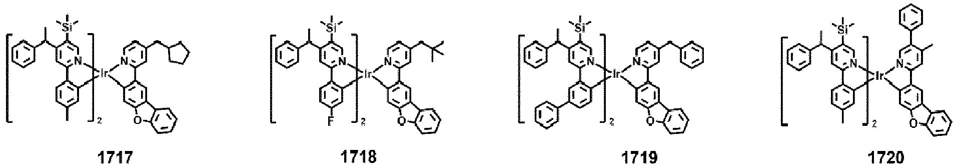

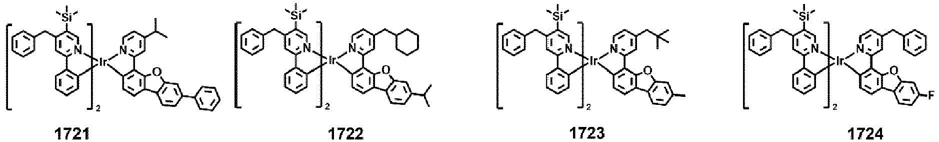

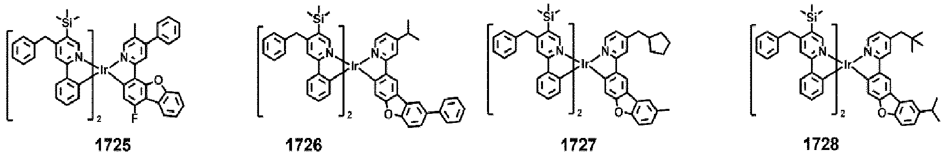

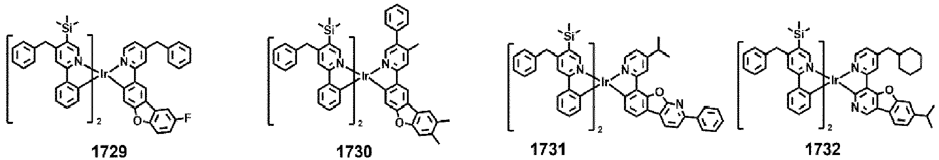

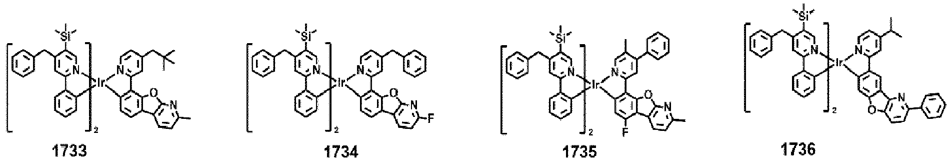

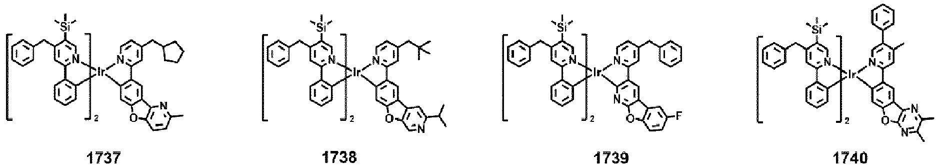

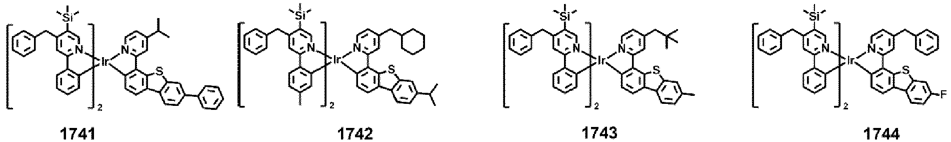

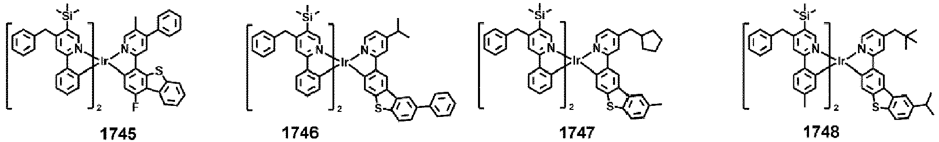

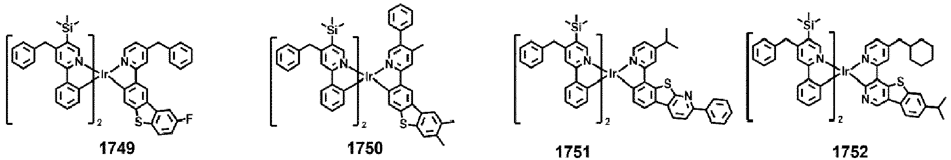

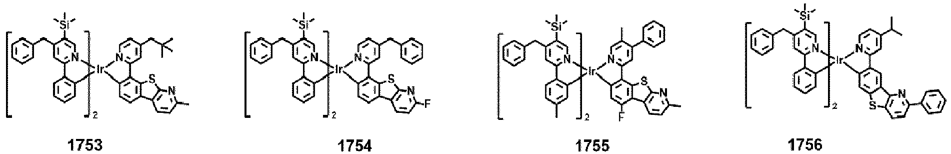

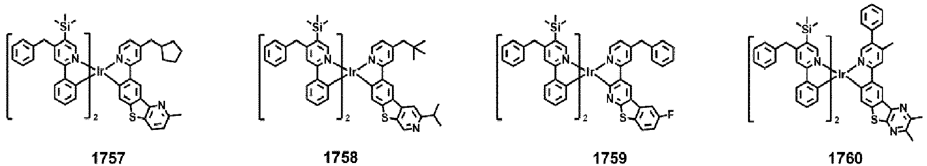

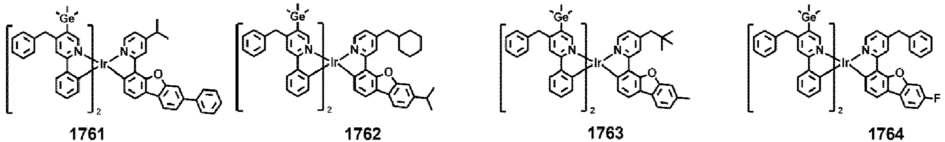

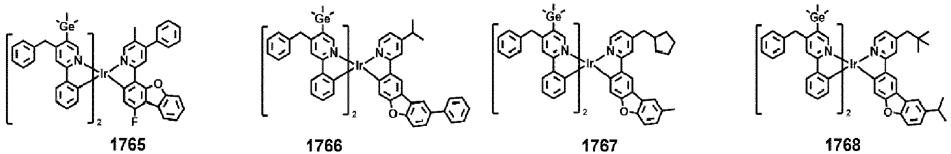

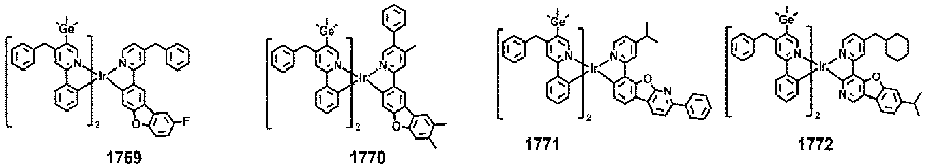

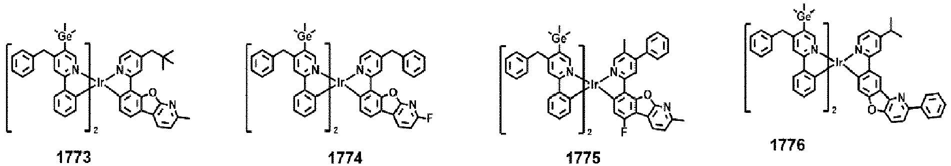

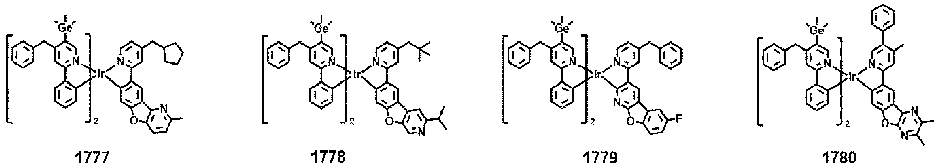

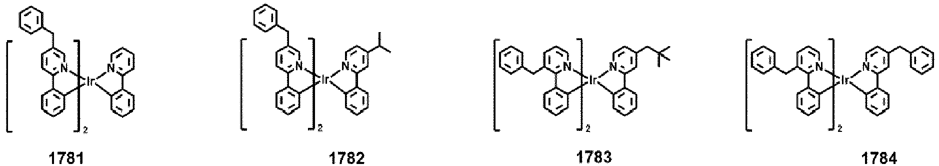

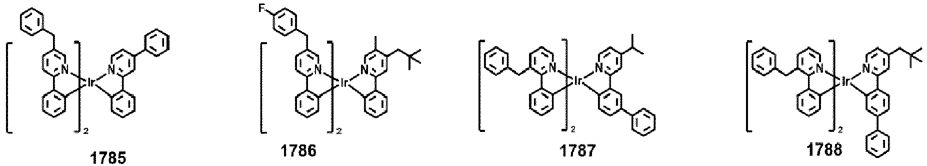

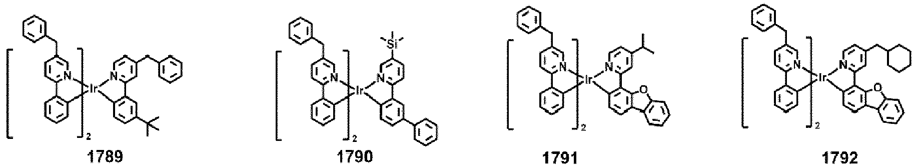

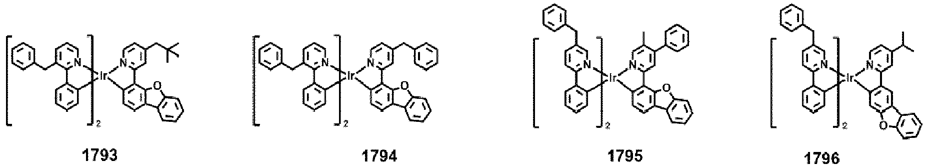

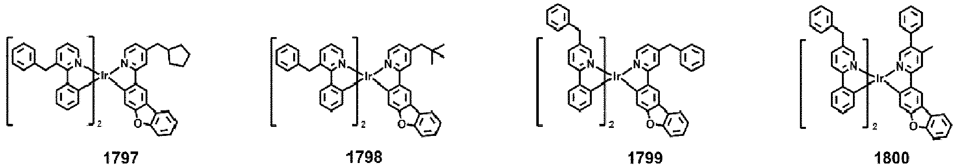

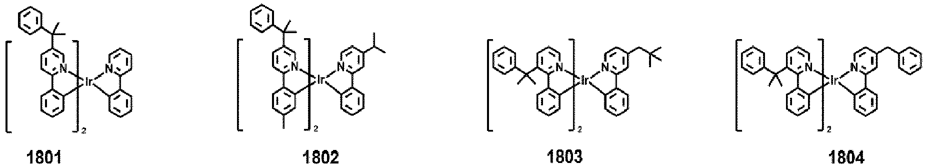

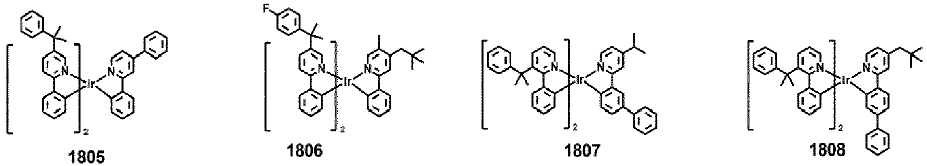

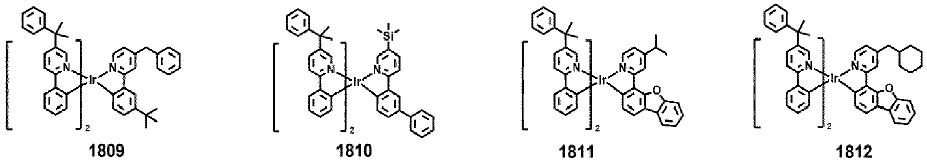

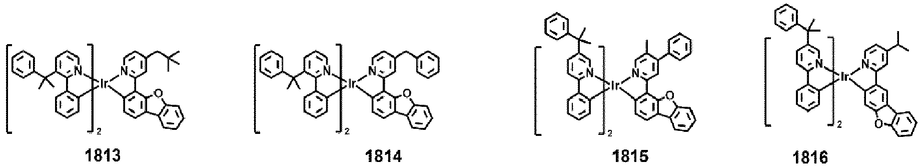

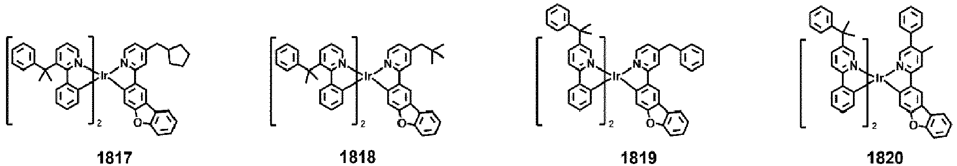

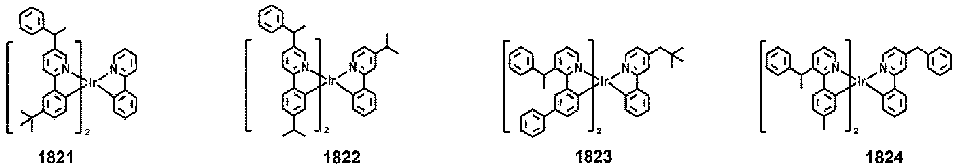

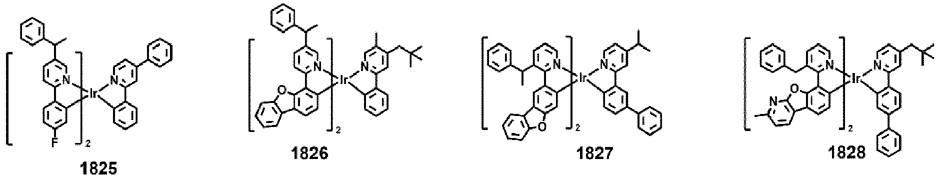

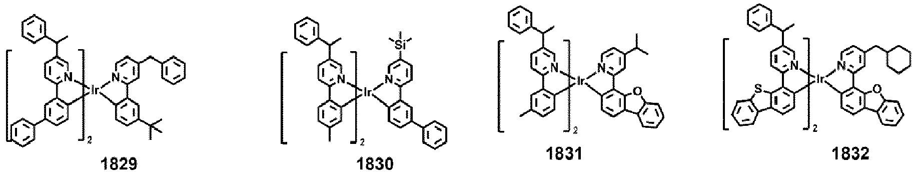

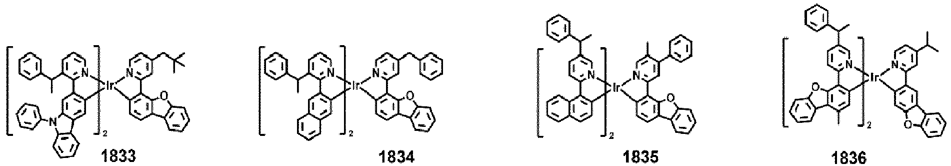

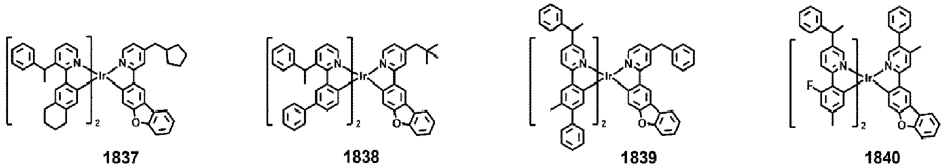

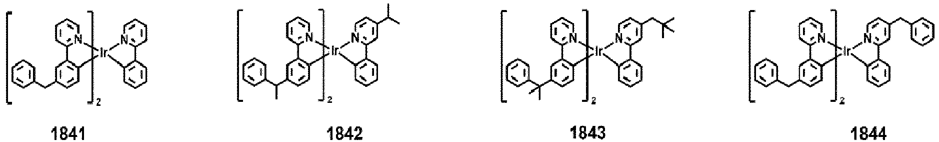

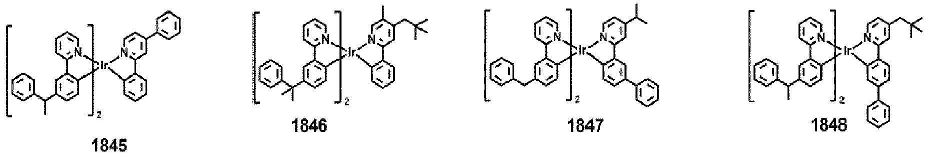

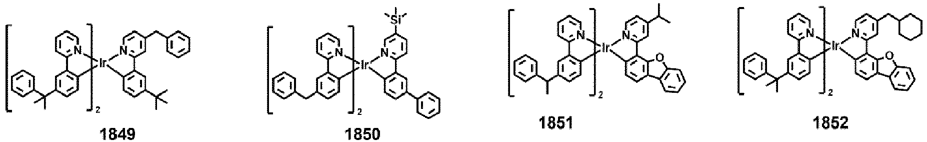

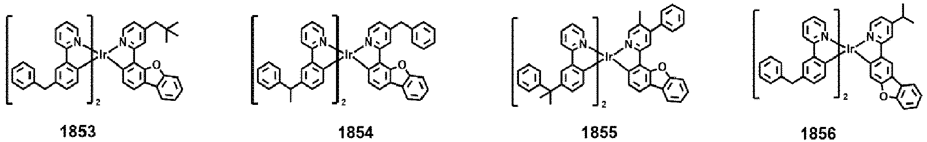

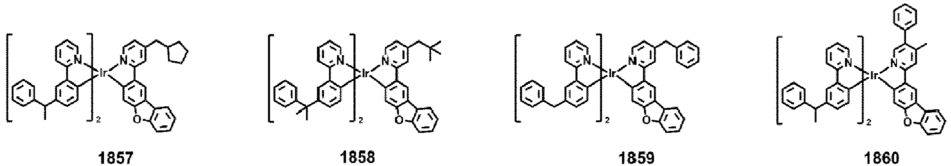

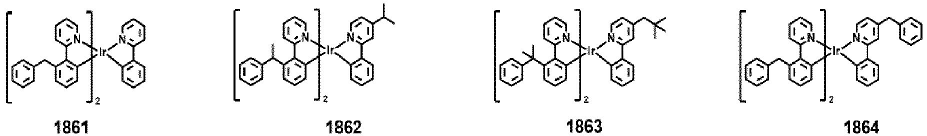

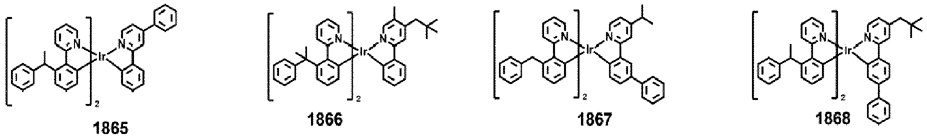

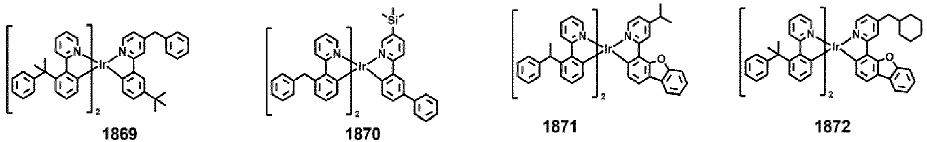

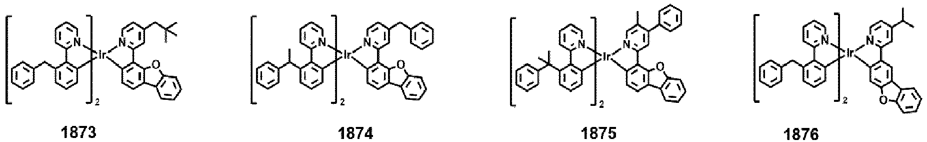

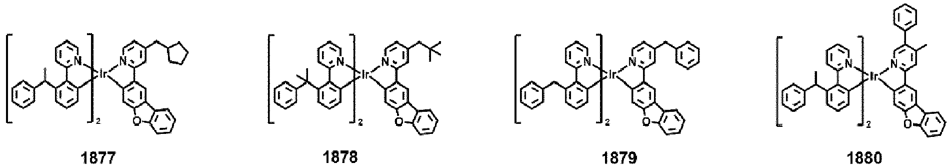

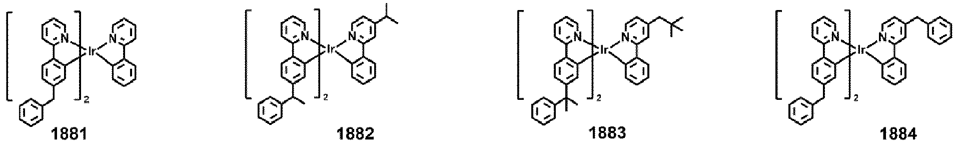

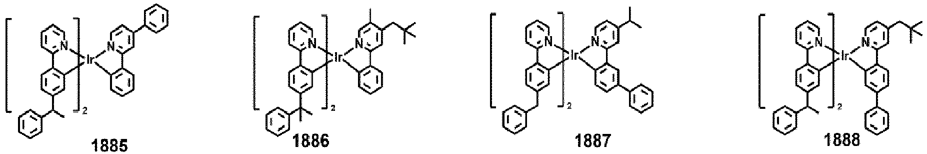

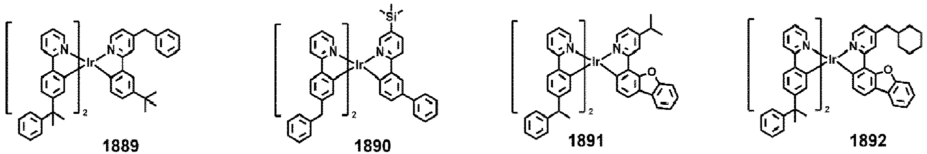

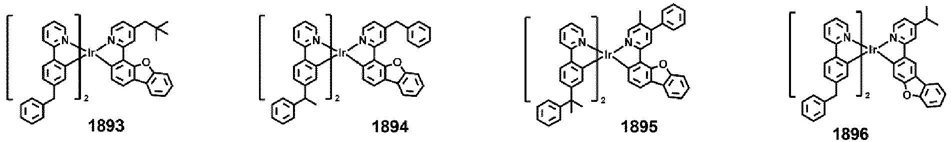

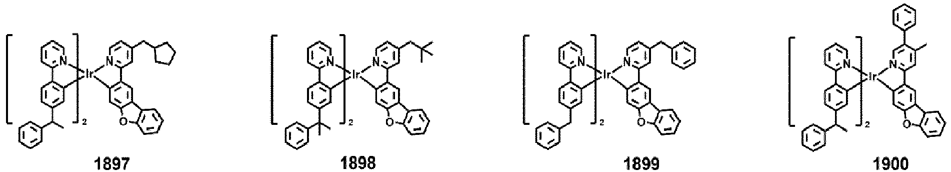

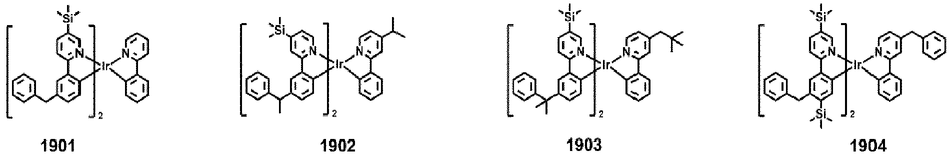

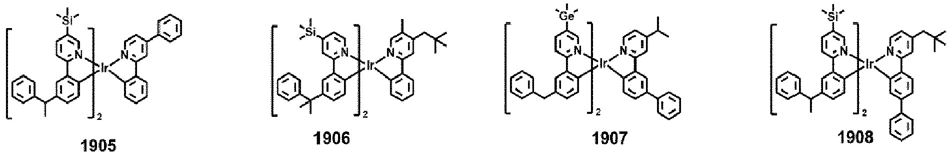

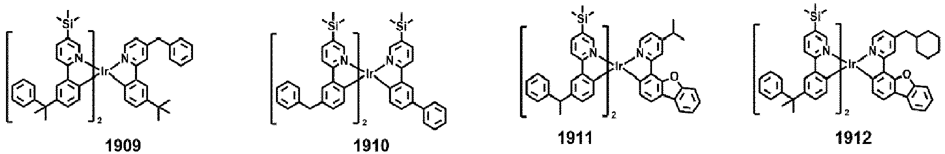

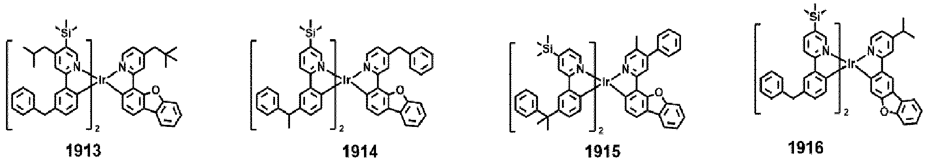

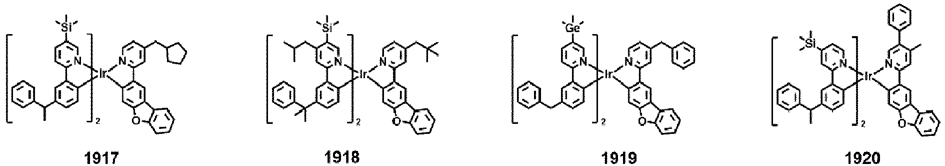

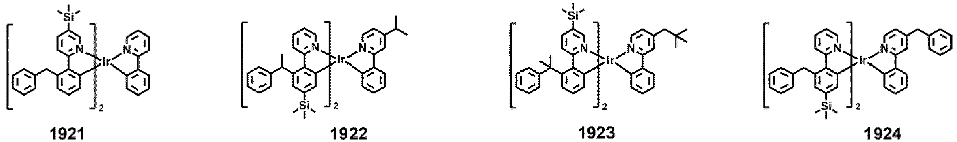

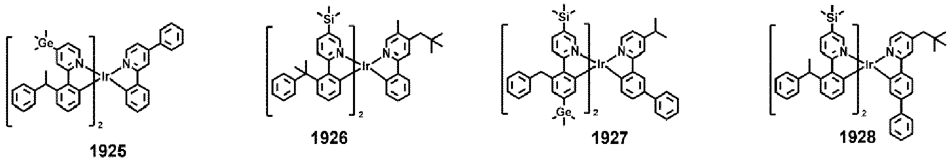

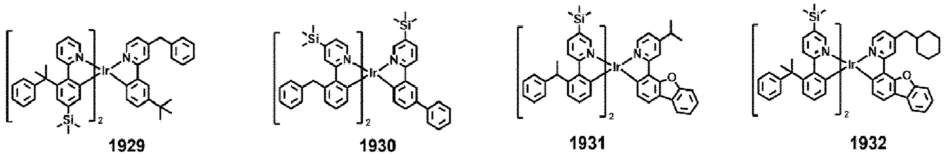

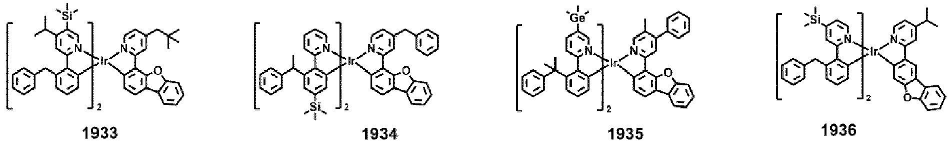

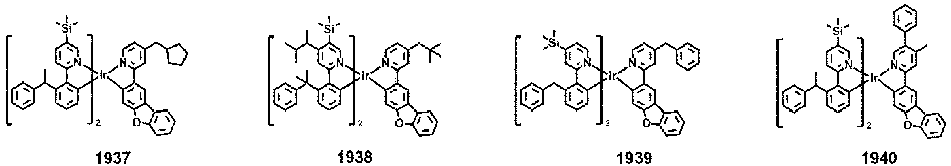

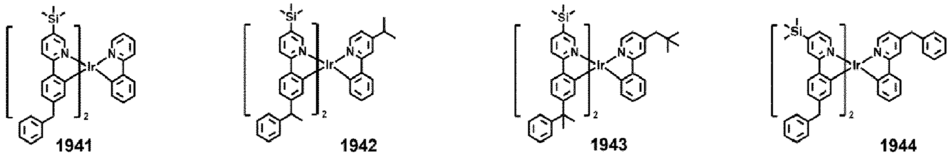

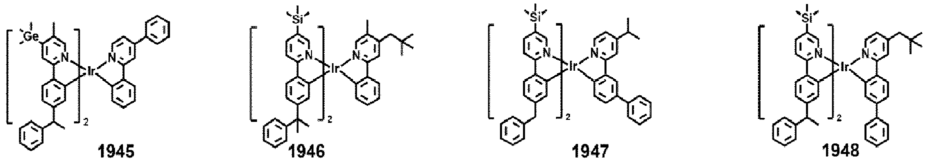

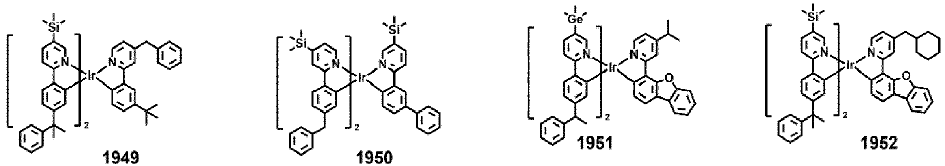

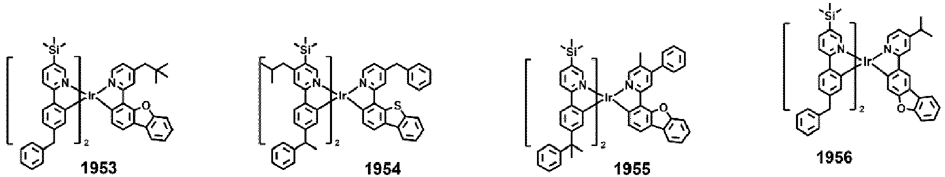

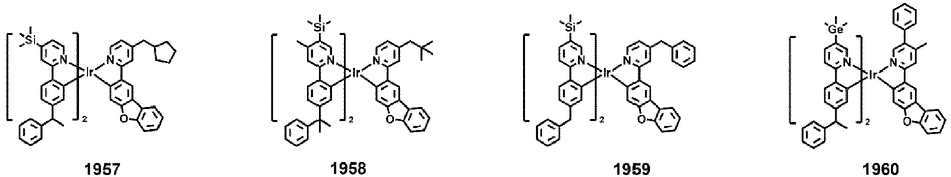

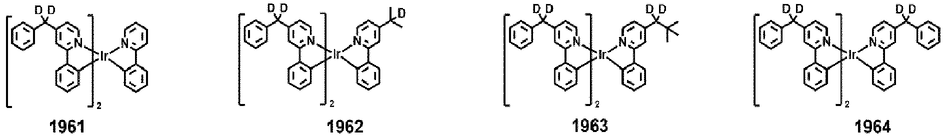

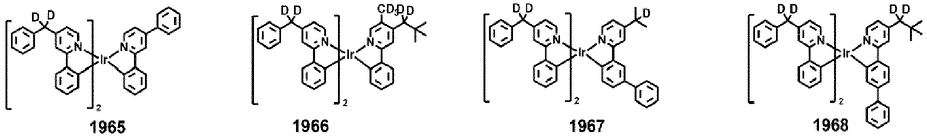

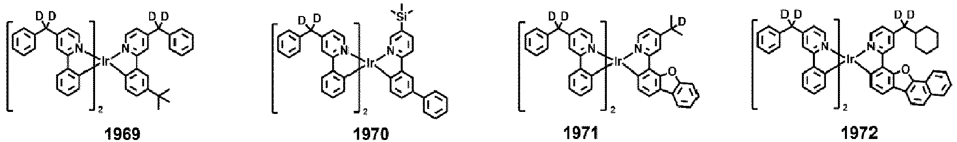

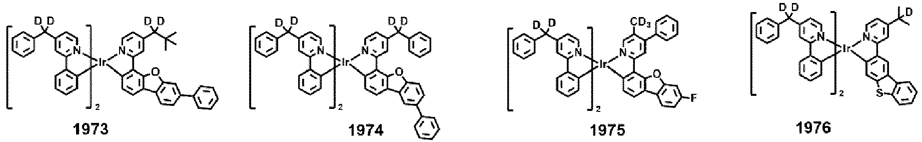

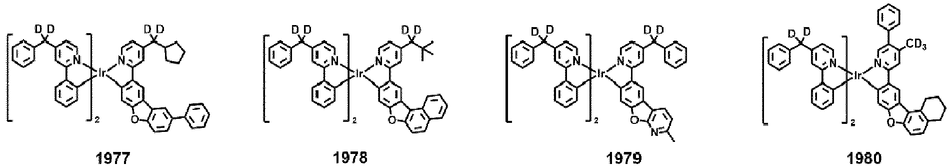

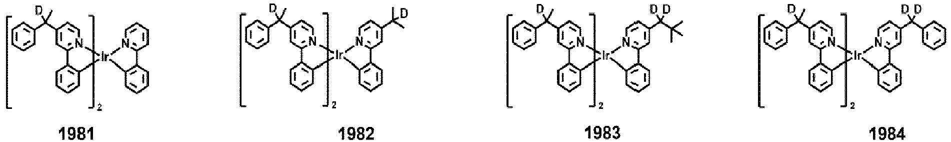

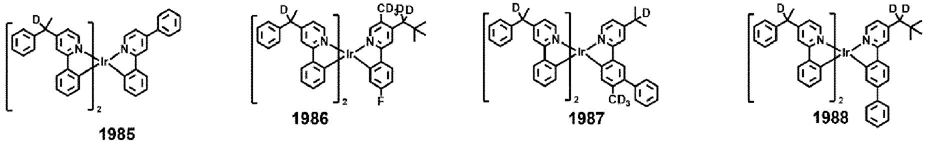

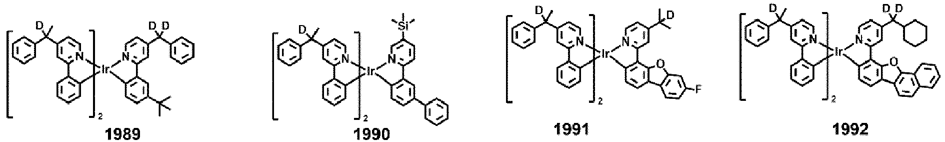

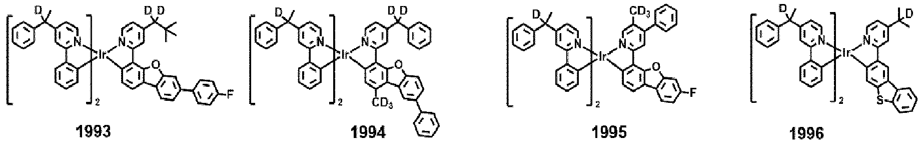

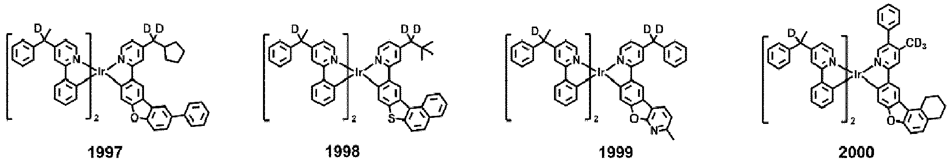

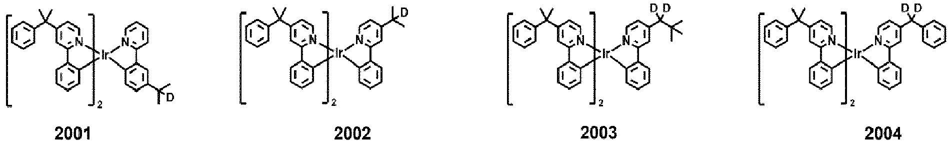

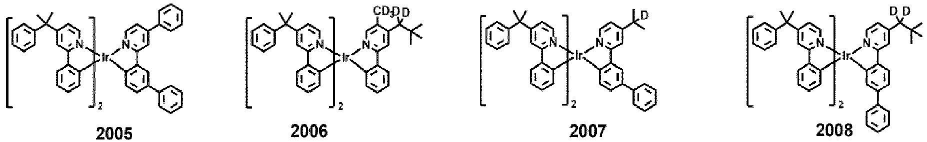

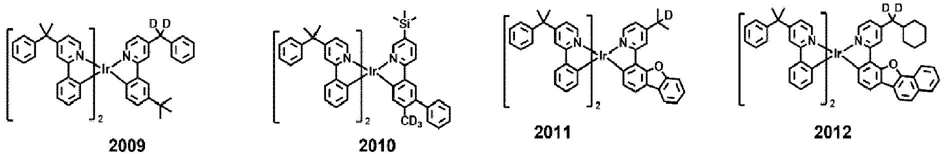

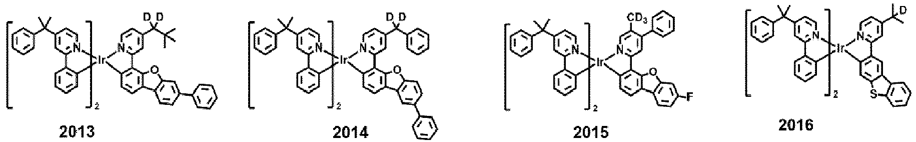

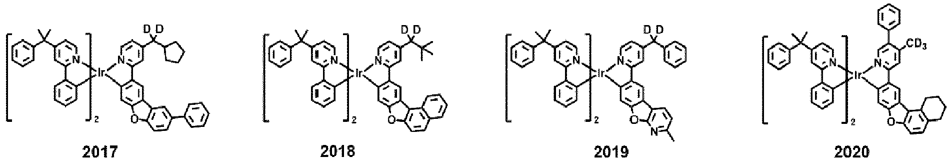

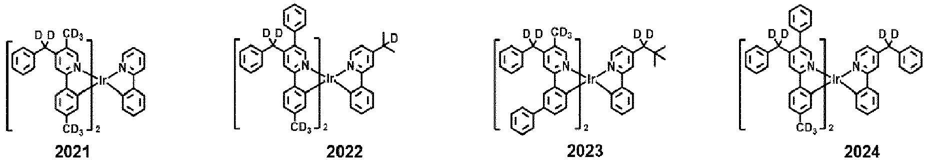

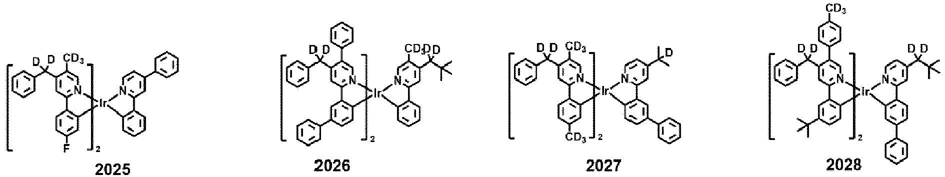

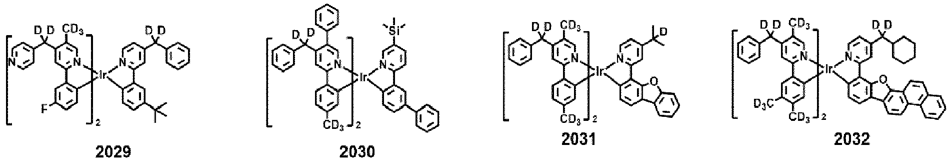

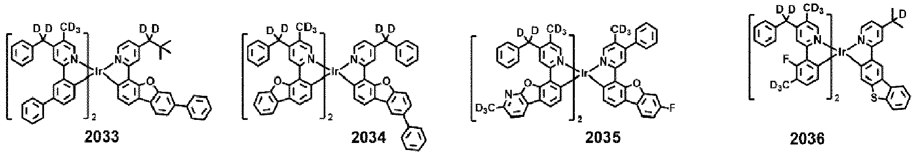

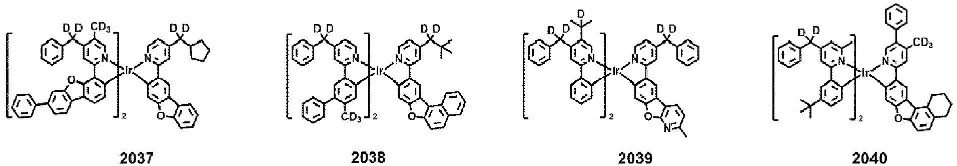

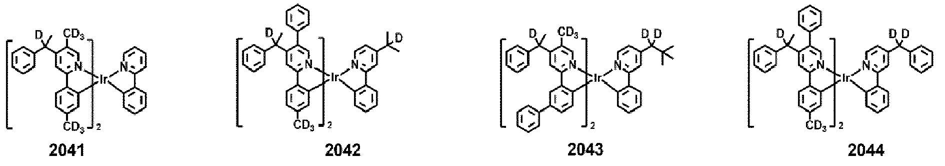

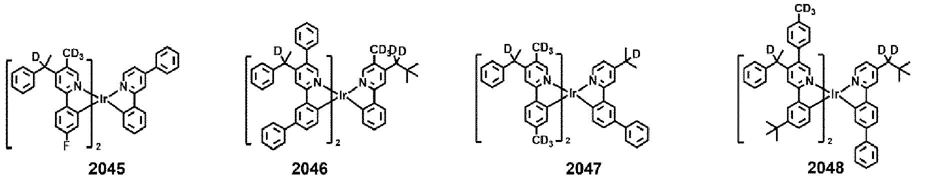

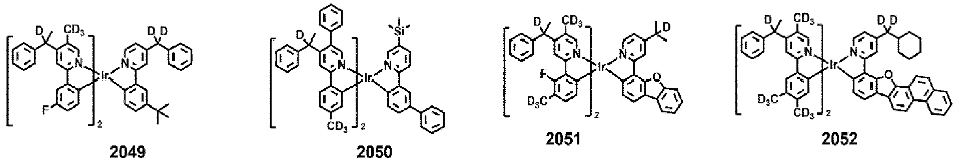

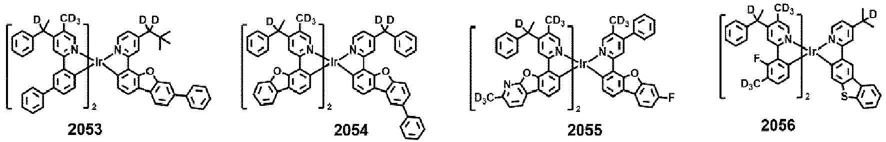

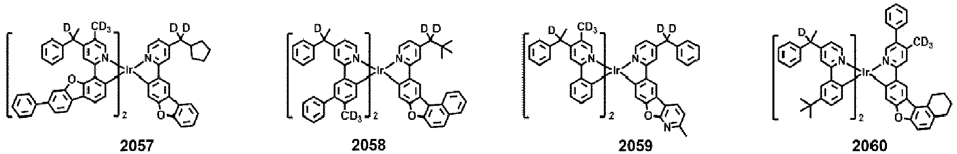

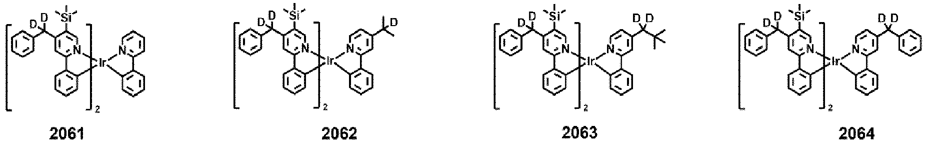

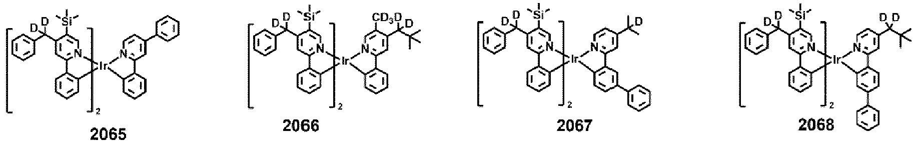

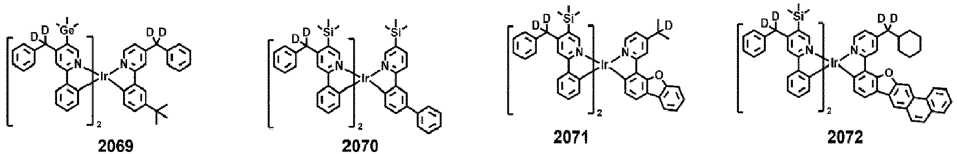

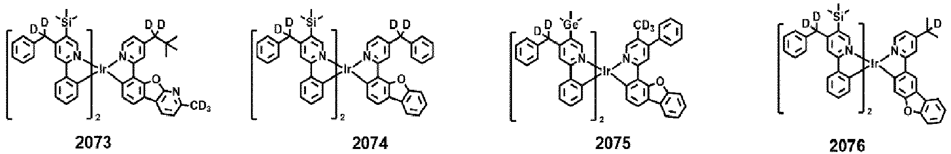

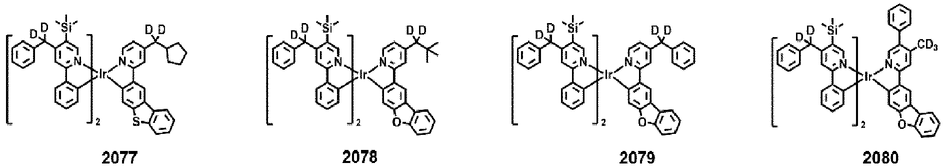

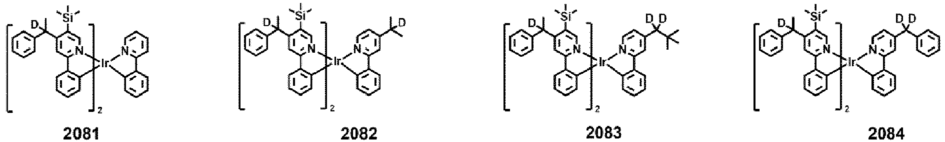

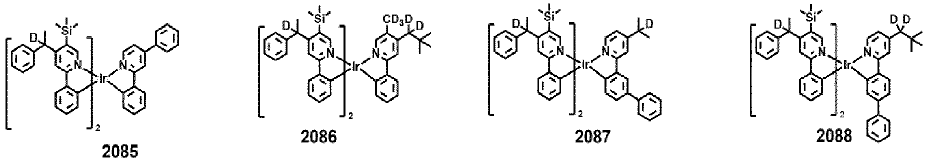

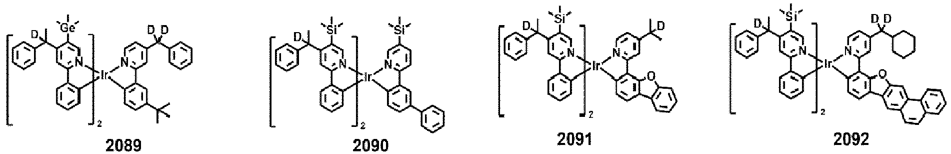

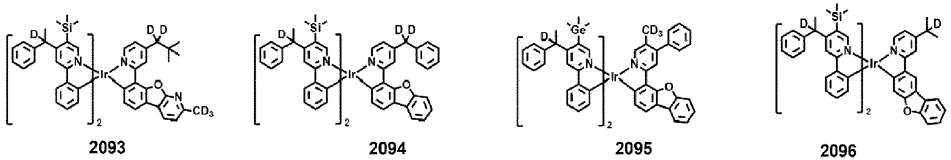

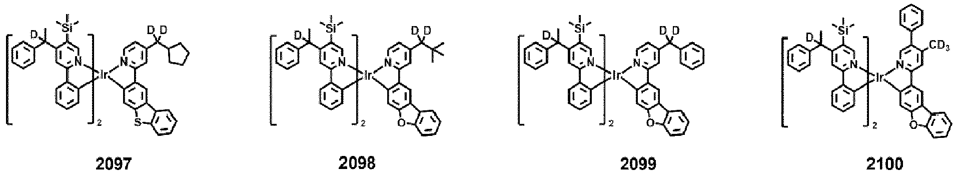

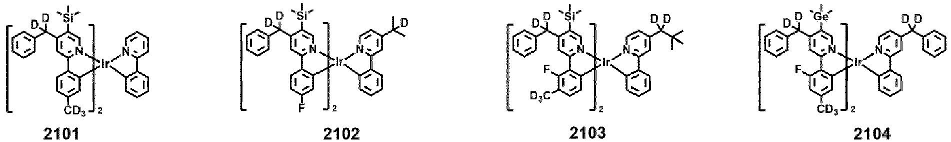

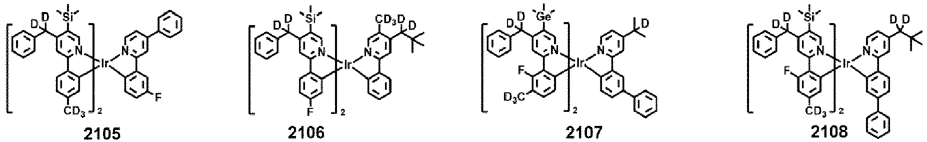

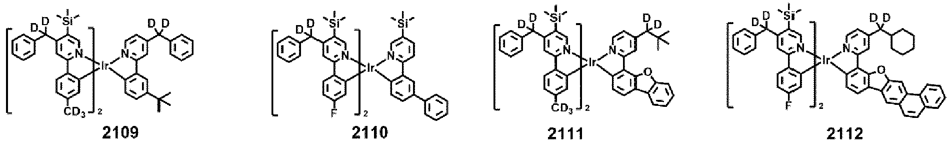

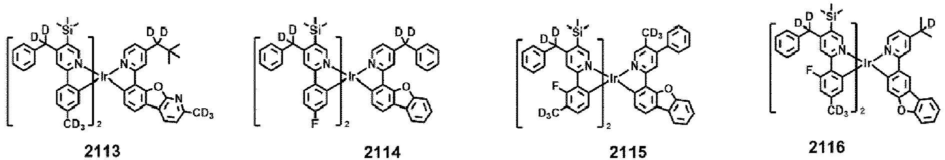

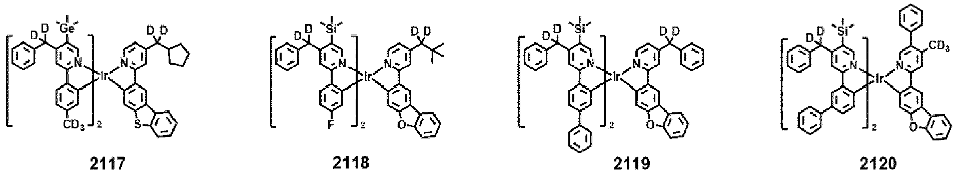

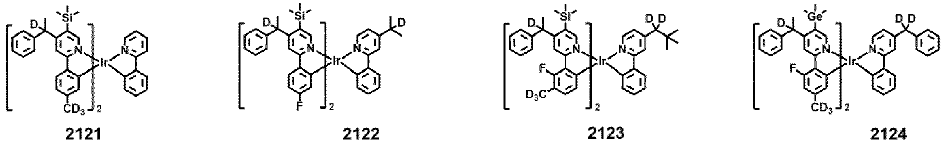

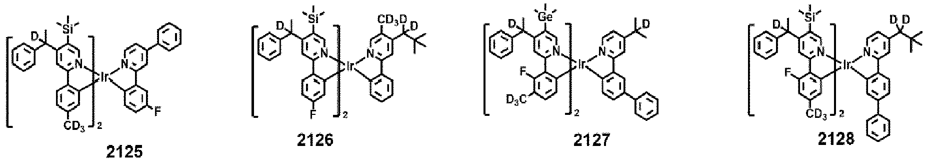

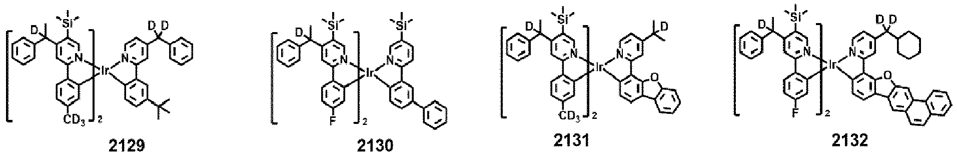

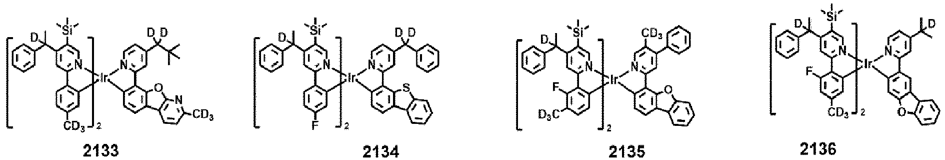

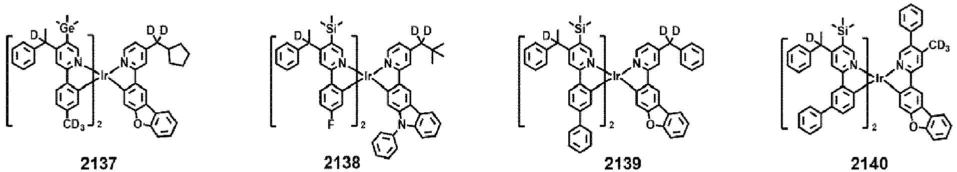

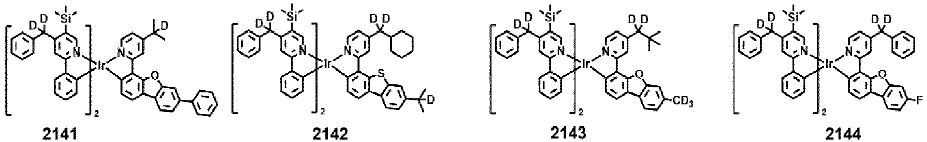

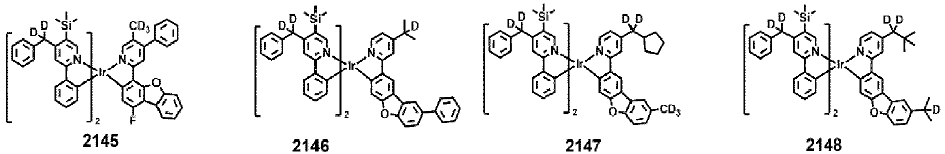

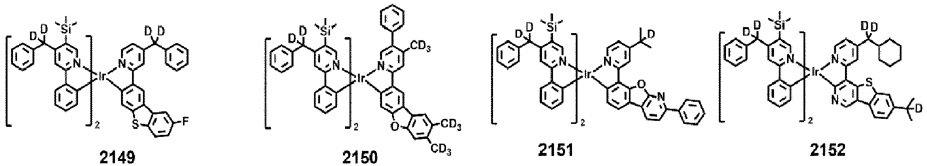

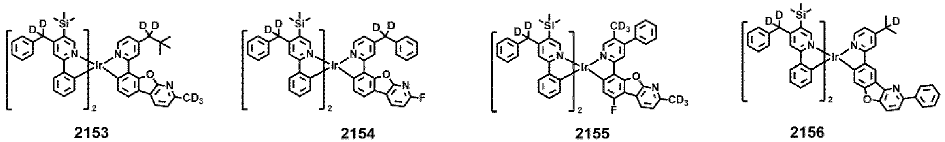

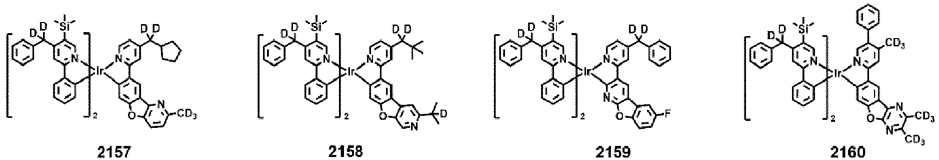

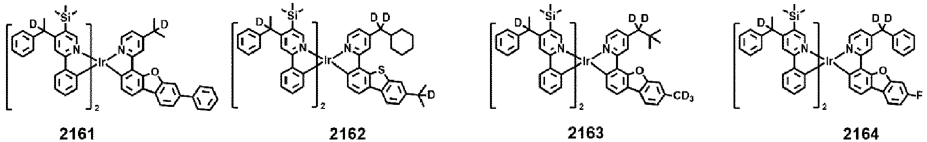

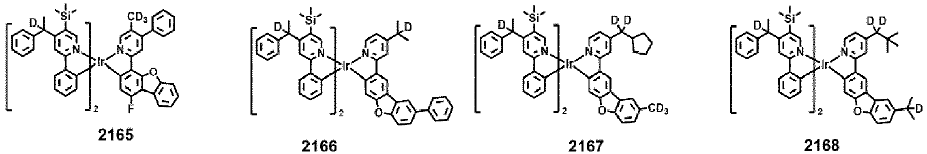

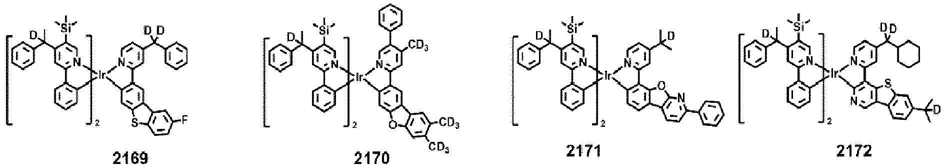

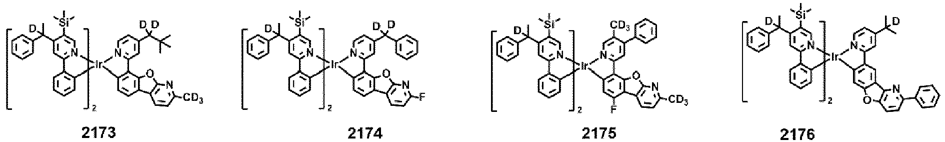

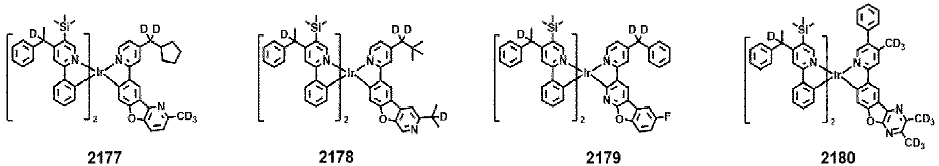

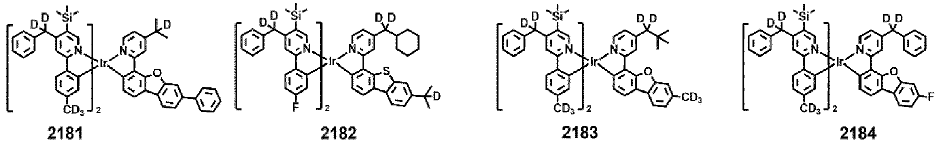

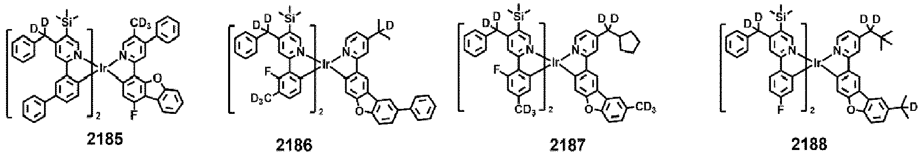

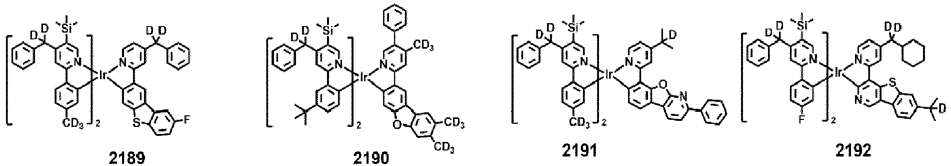

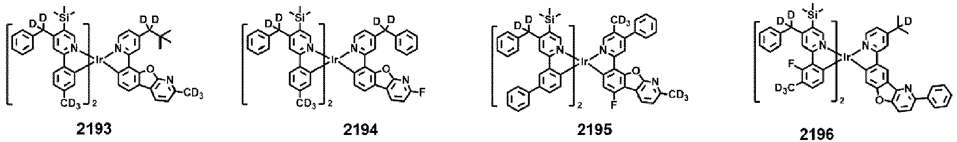

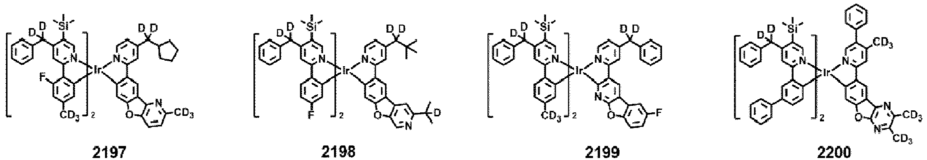

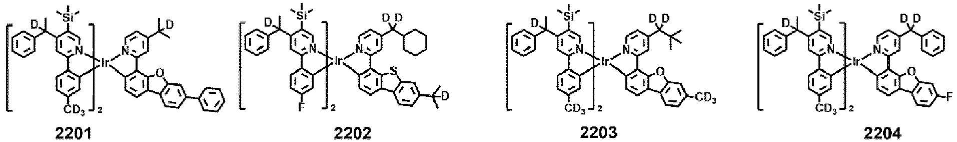

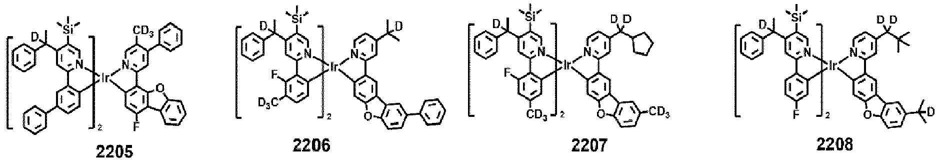

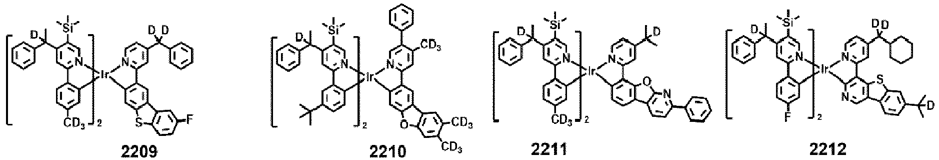

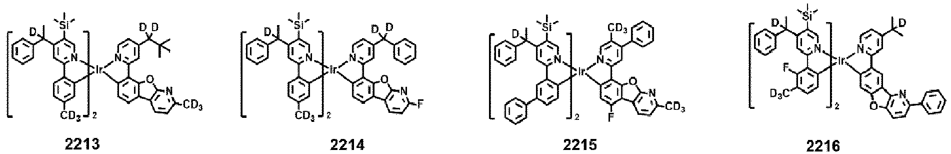

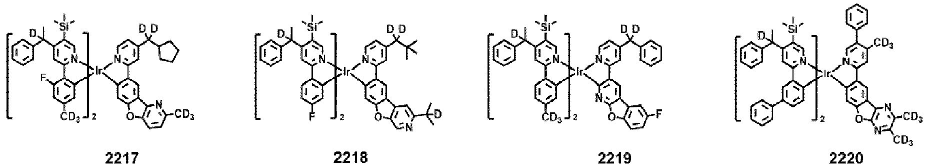

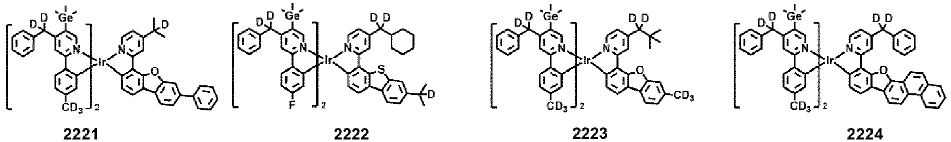

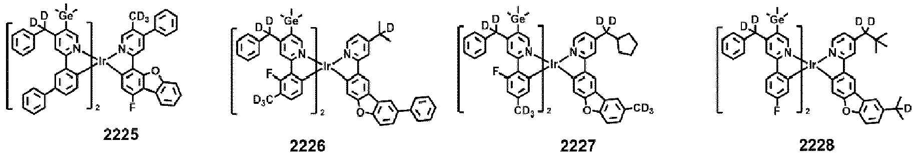

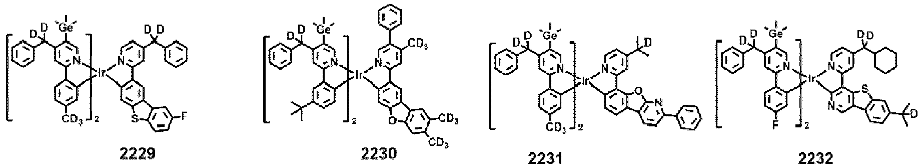

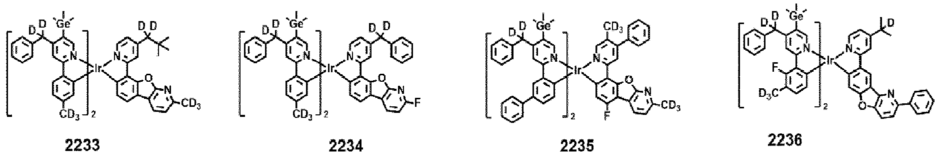

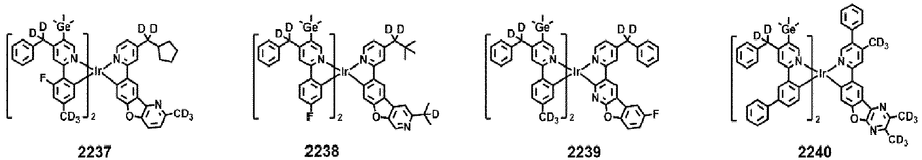

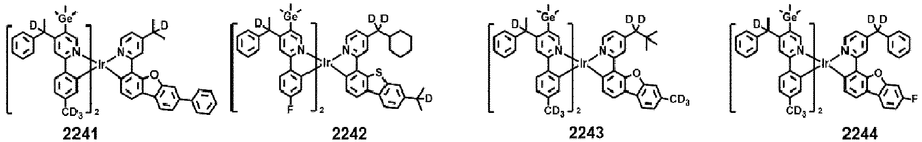

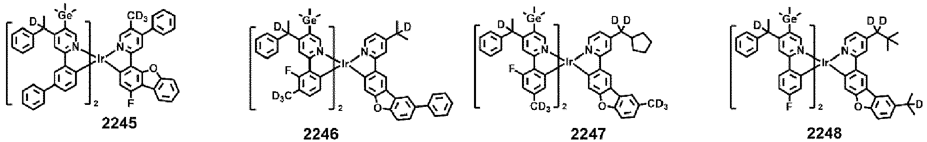

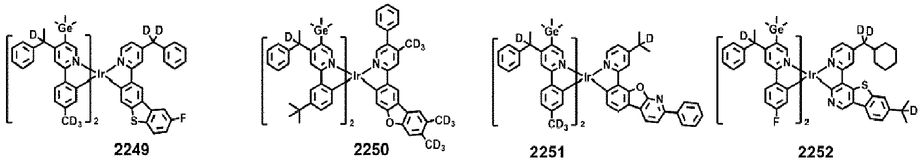

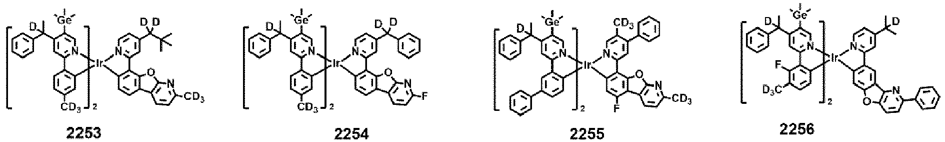

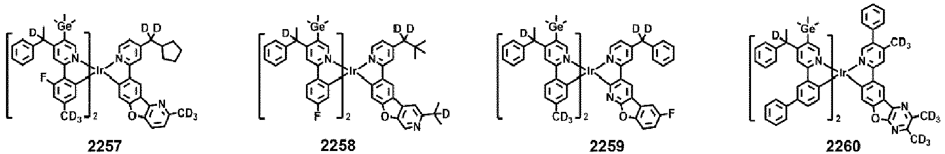

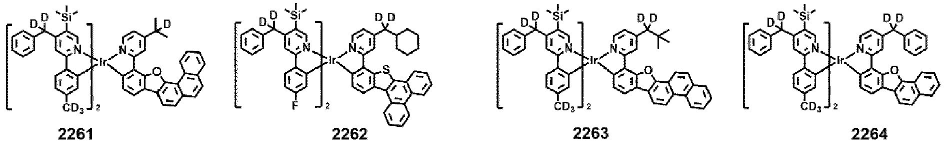

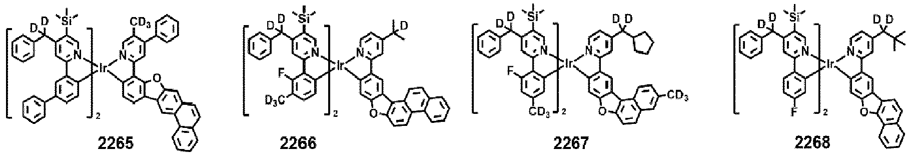

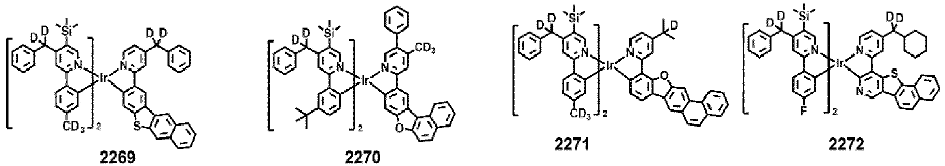

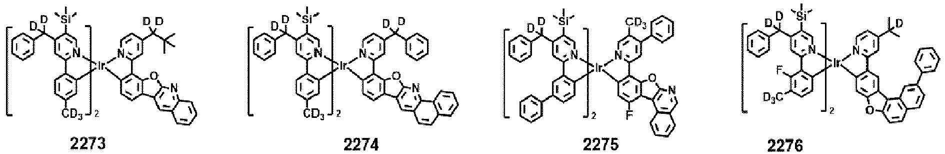

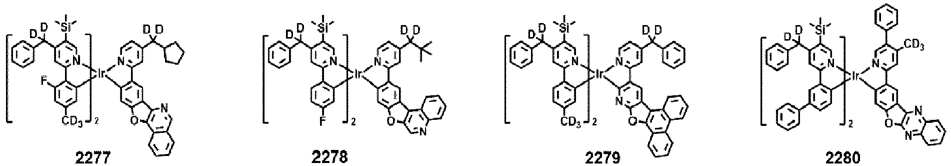

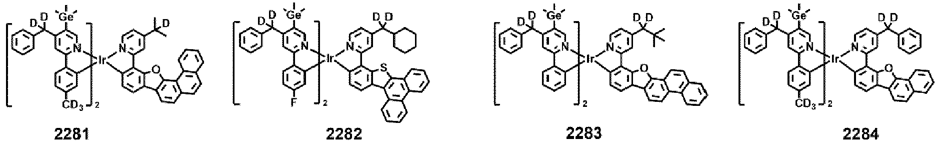

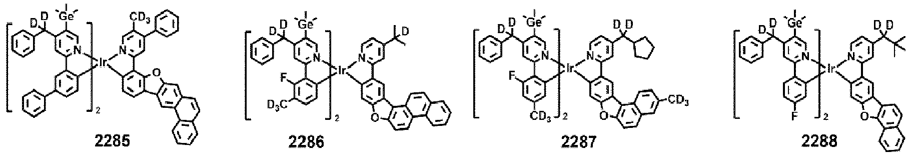

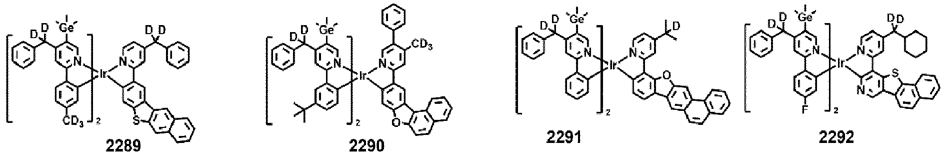

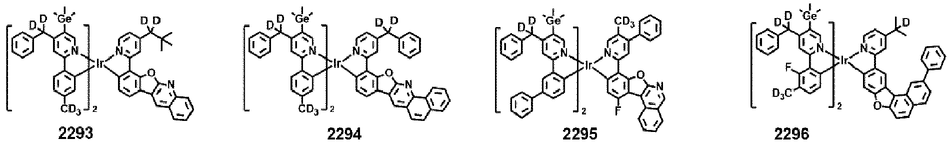

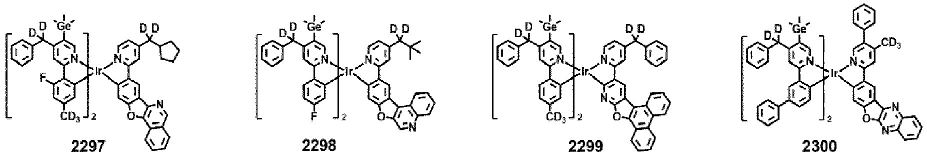

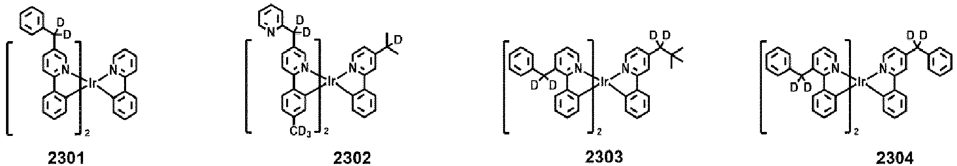

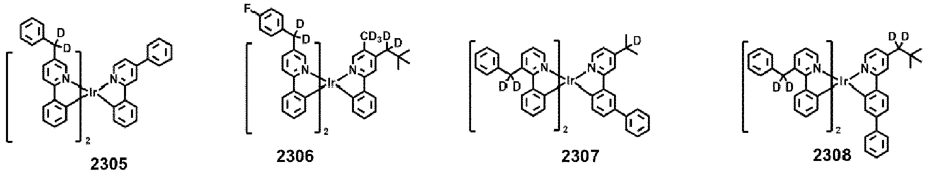

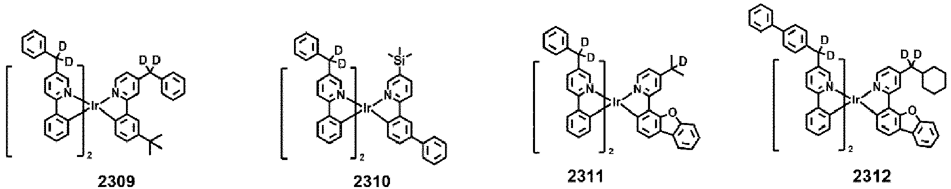

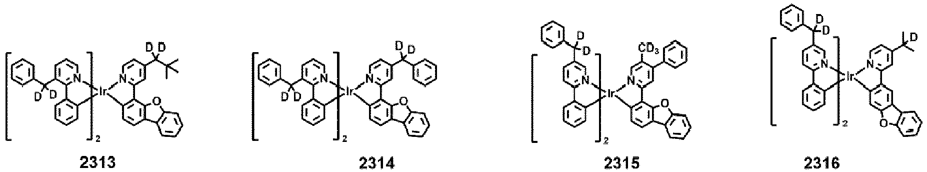

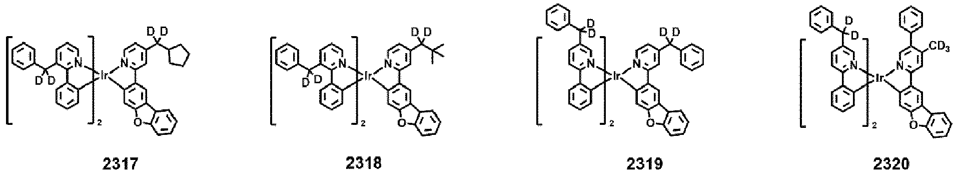

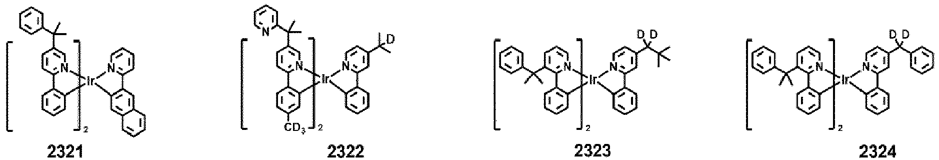

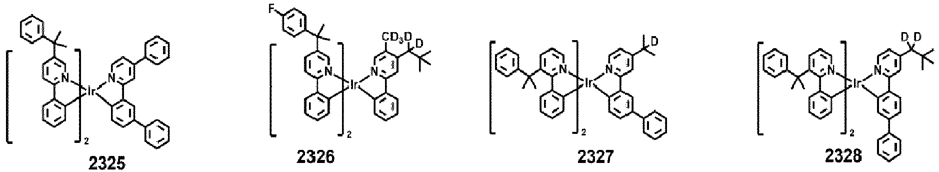

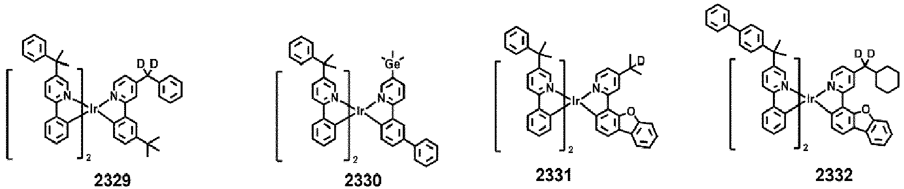

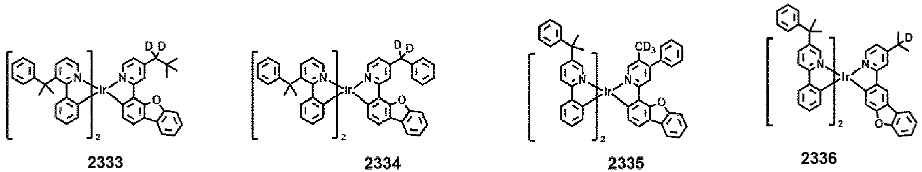

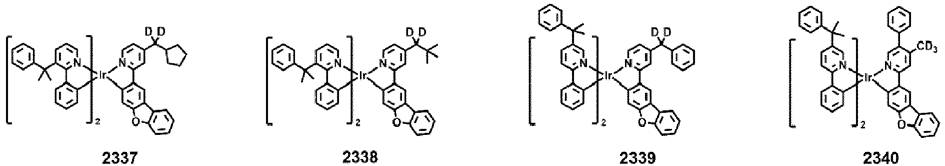

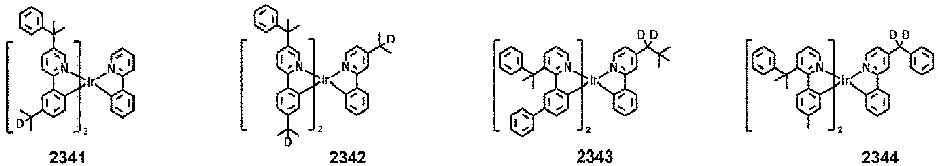

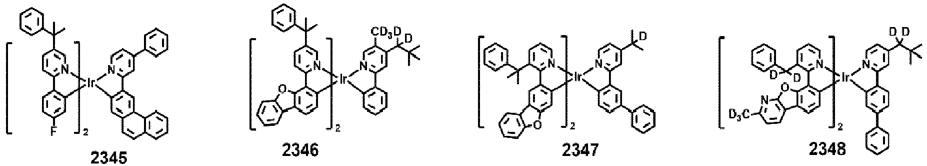

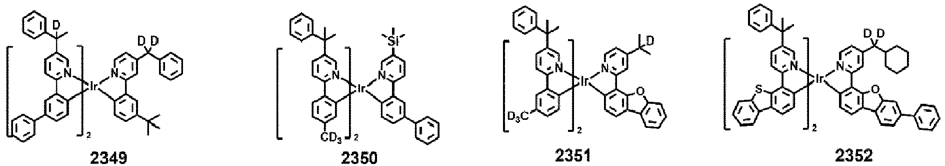

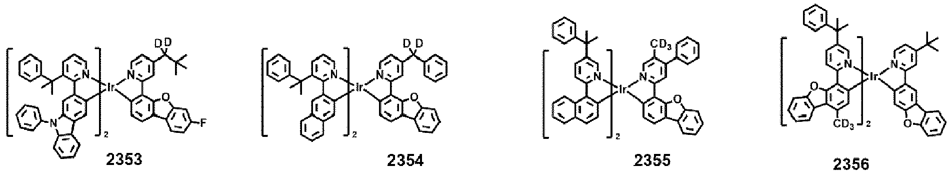

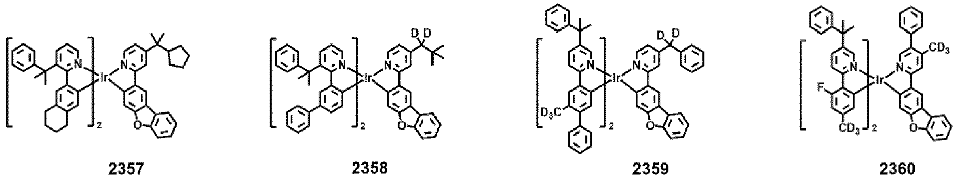

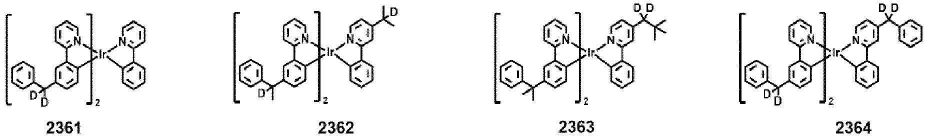

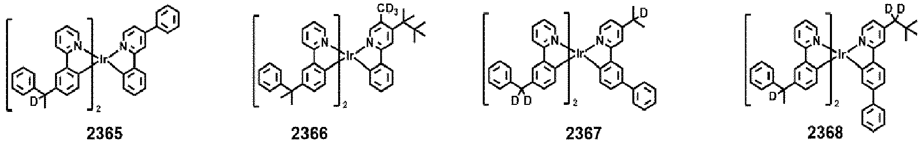

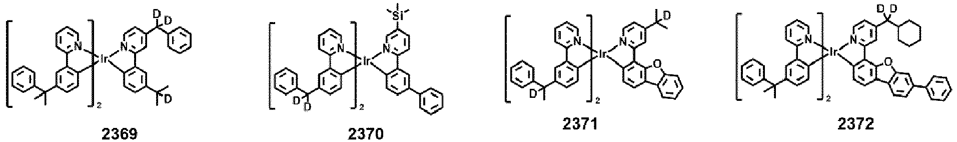

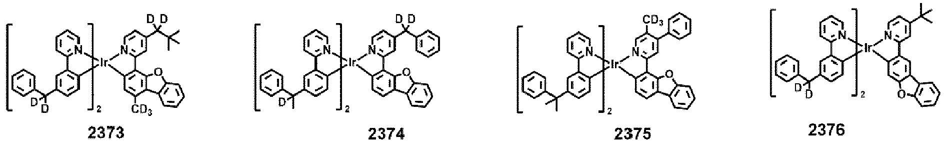

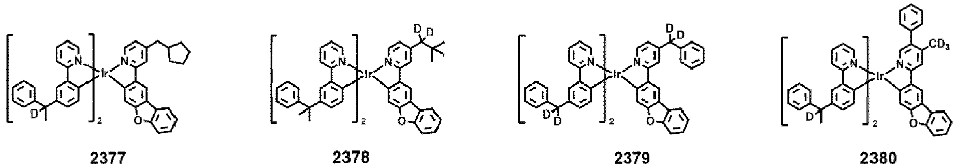

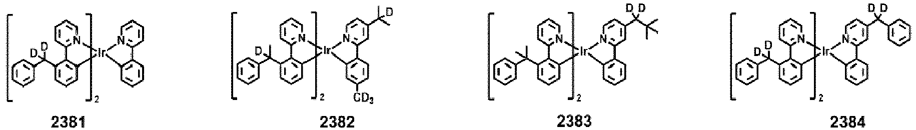

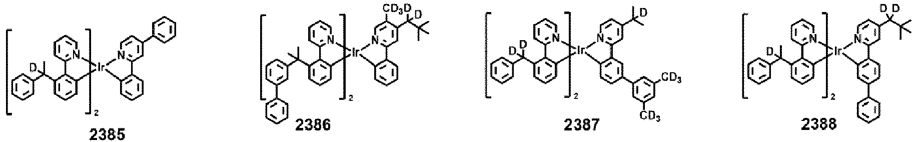

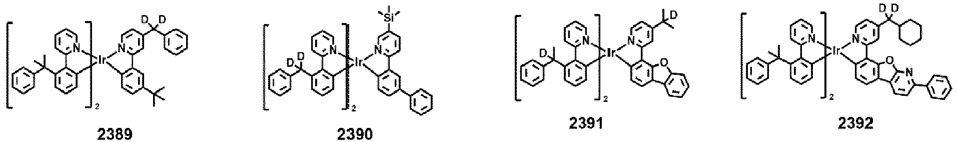

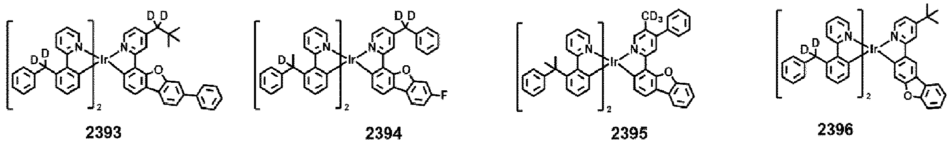

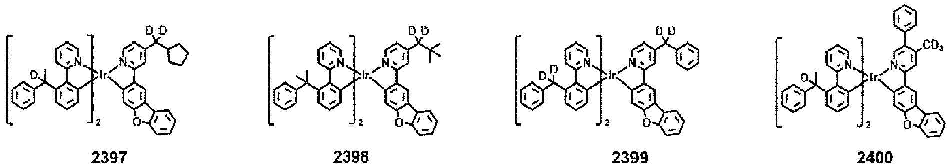

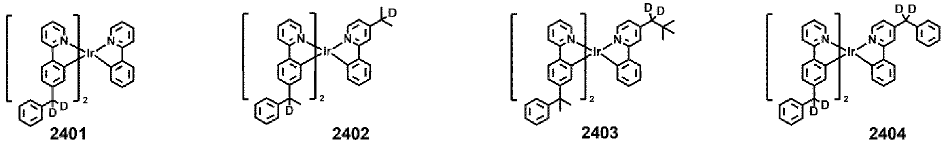

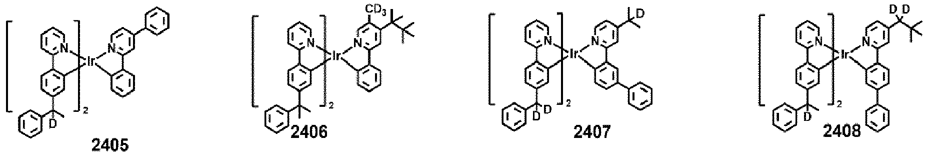

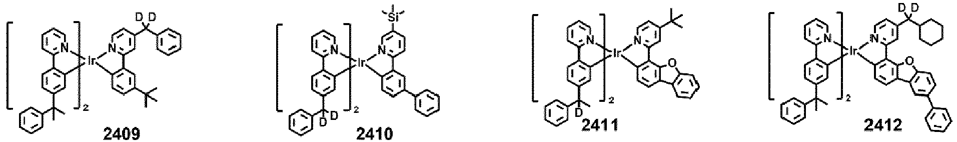

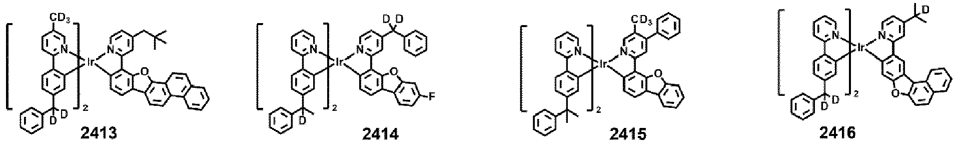

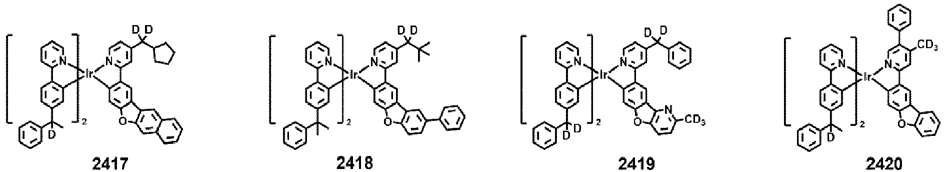

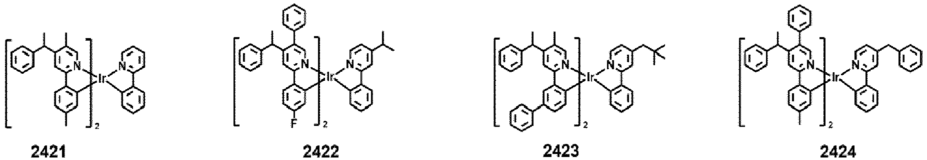

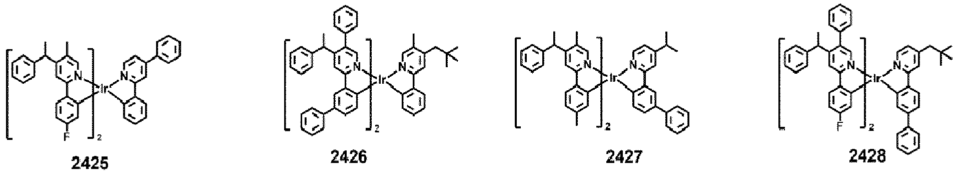

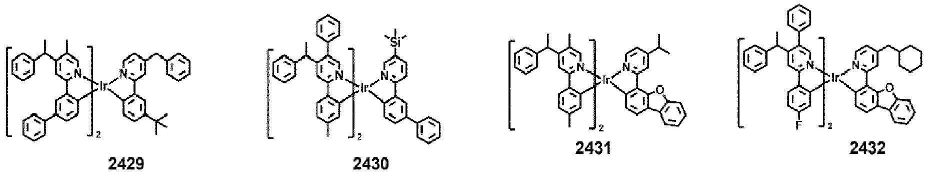

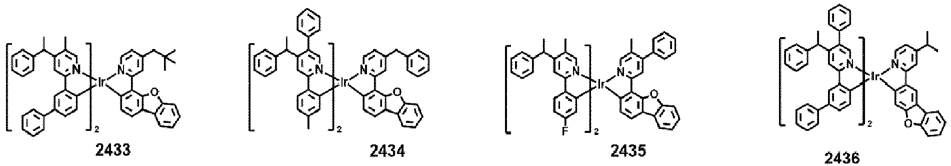

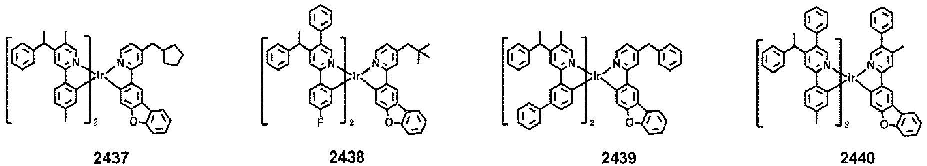

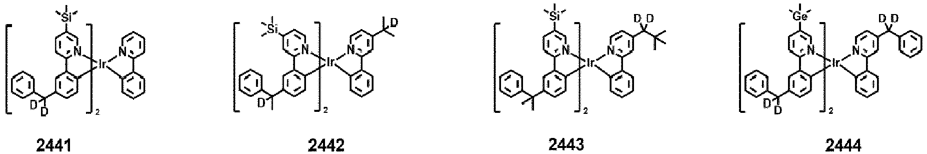

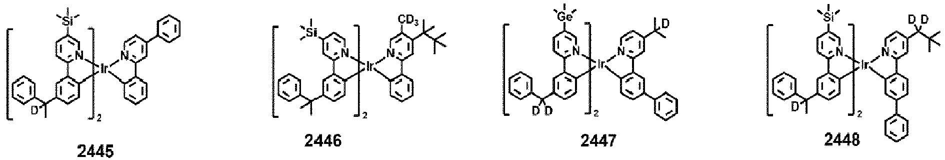

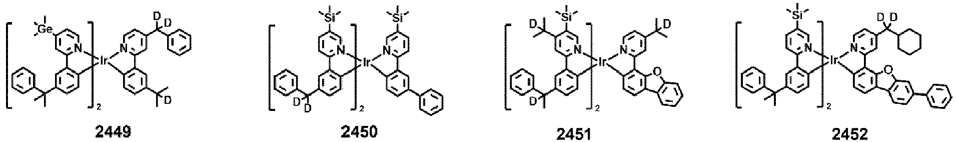

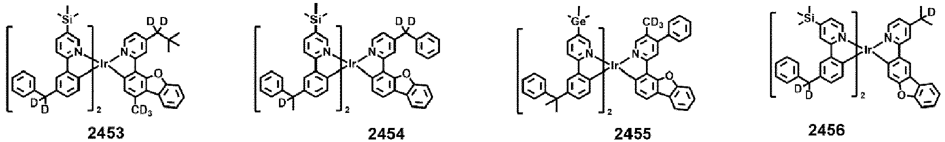

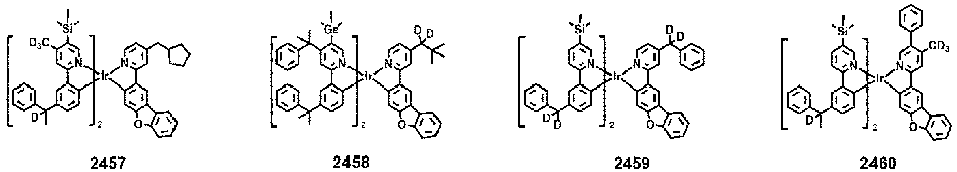

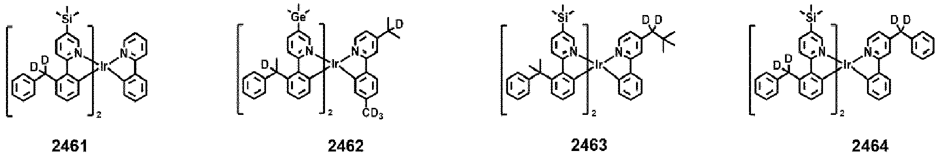

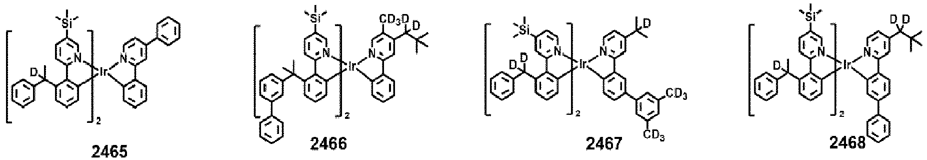

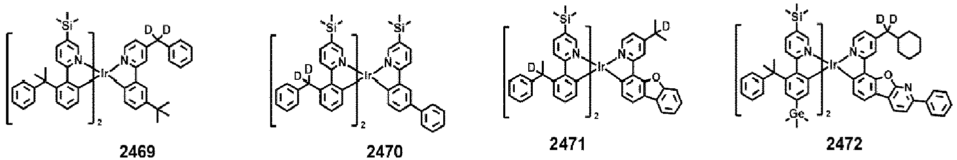

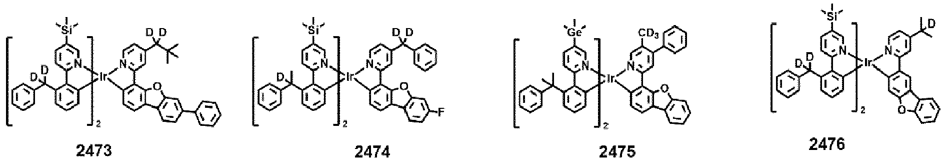

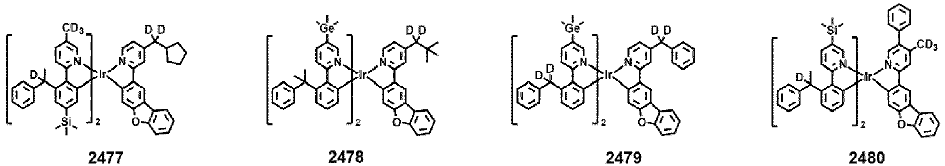

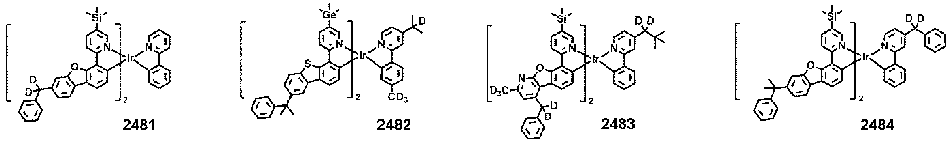

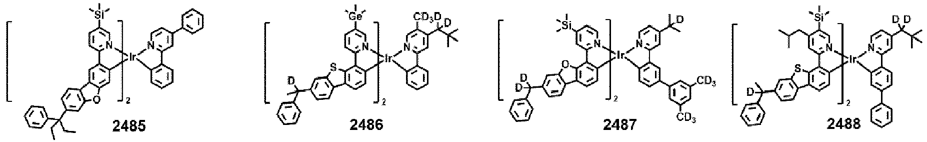

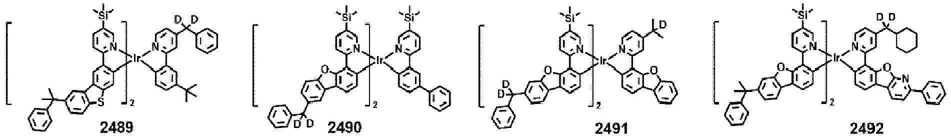

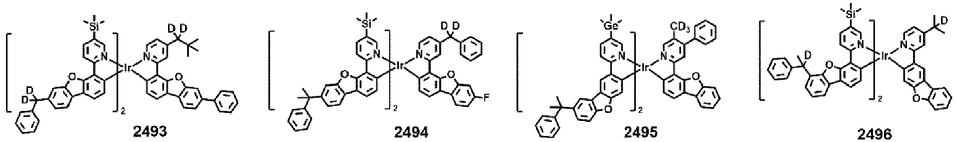

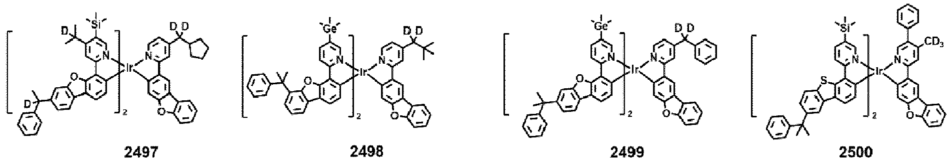

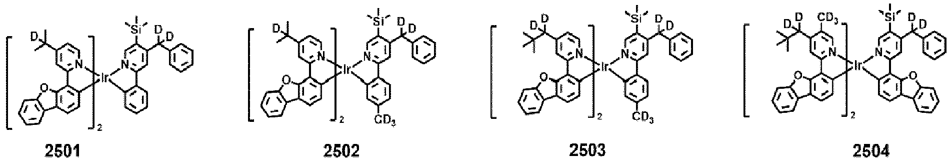

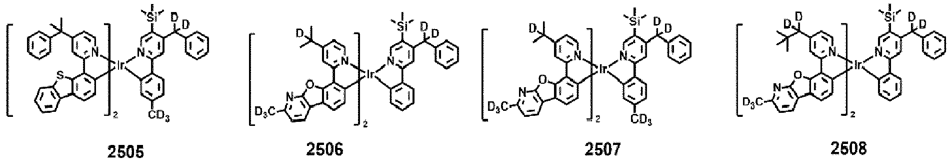

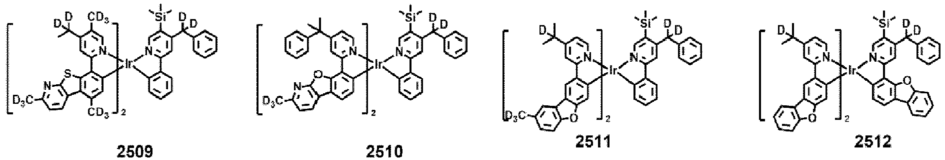

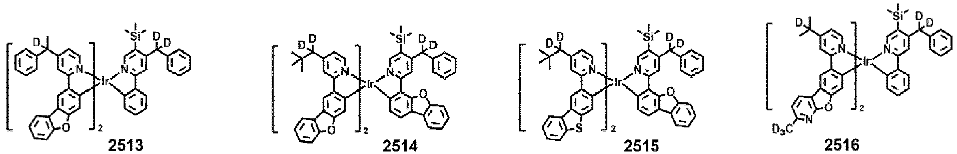

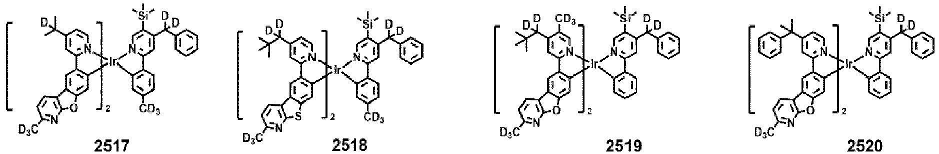

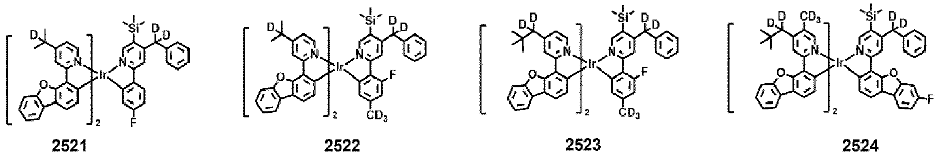

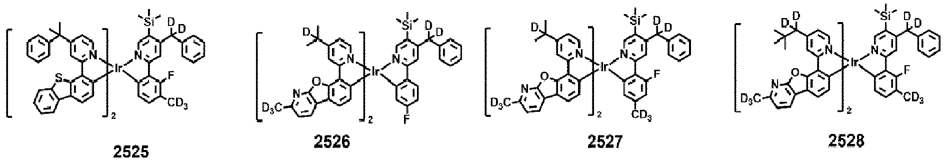

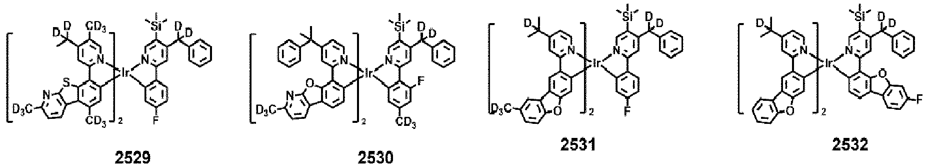

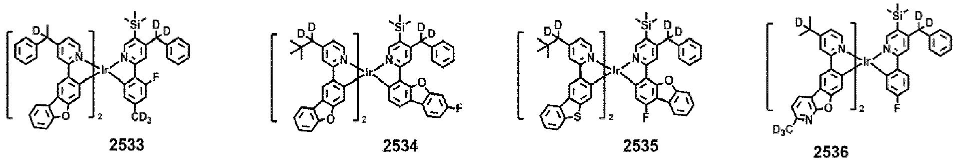

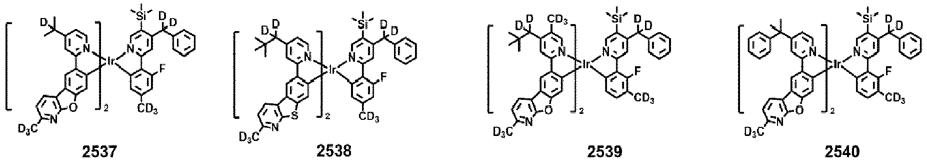

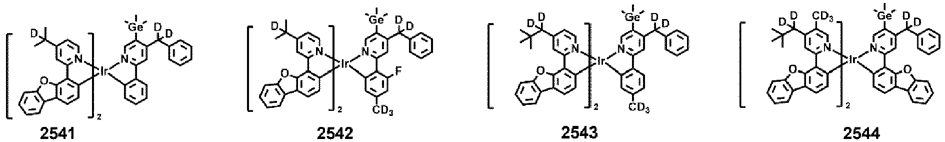

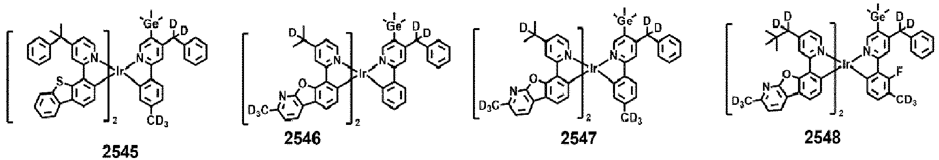

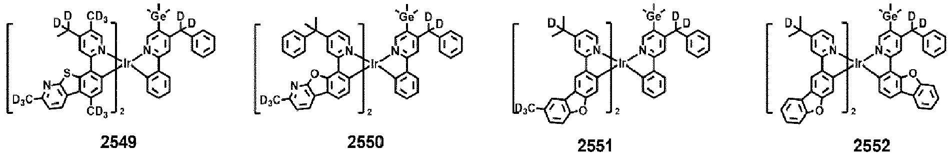

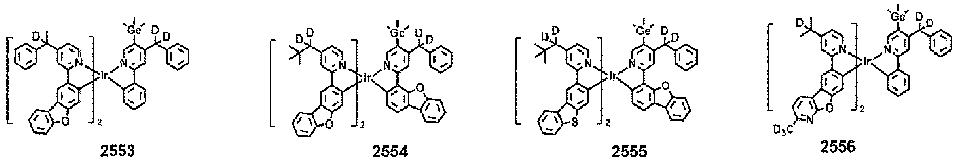

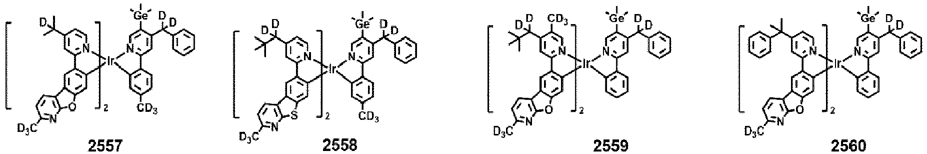

In Formula 1, L₁ may be a ligand represented by Formula 2, and n1 may be 1, 2, or 3, wherein, when n1 is 3, two or more of three L₁ groups may be different from each other. In addition, n2 which indicates the number of L₂ groups in Formula 1 may be 0, 1, 2, 3, or 4. Here, L₁ and L₂ may be different from each other. That is, the organometallic compound represented by Formula 1 may be a heteroleptic complex including at least one ligand represented by Formula 2.

Furthermore, Z₁ and Z₂ in Formula 2 may each be a group represented by Formula 3, Q₅₁ to Q₅₃ in Formula 3 may each be bonded to a carbon atom, Q₅₃ in Formula 3 may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and the sum of b1 and b2, which indicate the number of Z₁ groups and the number of Z₂ groups, respectively, may be 1 or more. That is, the ligand represented by Formula 2 may include at least one group represented by Formula 3.

Accordingly, the organometallic compound represented by Formula 1 may have excellent thermal and/or electrical stability, and improved orientation characteristics, so that an electronic device, such as an organic light-emitting device, including the organometallic compound represented by Formula 1 may have excellent luminescence efficiency and/or lifespan characteristics.

The highest occupied molecular orbital (HOMO) energy level, lowest unoccupied molecular orbital (LUMO) energy level, S₁ energy level, and T₁ energy level of some compounds of the organometallic compound represented by Formula 1 are evaluated using the Gaussian 09 program with the molecular structure optimization obtained by B3LYP-based density functional theory (DFT), and results thereof are shown in Table 1. The energy levels are in electron volts (eV).

**Table 1**

| Compound No. | HOMO (eV) | LUMO (eV) | S₁ (eV) | T₁ (eV) |
|---|---|---|---|---|
| 361 | -4.777 | -1.201 | 2.872 | 2.514 |
| 716 | -4.705 | -1.172 | 2.848 | 2.497 |
| 771 | -4.791 | -1.220 | 2.878 | 2.533 |
| 1653 | -4.664 | -1.078 | 2.861 | 2.519 |
| 1693 | -4.700 | -1.100 | 2.875 | 2.520 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 may be suitable for use as a material for forming an organic layer of an organic light-emitting device, for example, a dopant in an emission layer of an organic layer. Thus, another aspect of the present disclosure provides an organic light-emitting device including: a first electrode; a second electrode; and an organic layer arranged between the first electrode and the second electrode and including an emission layer, wherein the organic layer includes at least one organometallic compound represented by Formula 1.

The organic light-emitting device may have, due to the inclusion of an organic layer including the organometallic compound represented by Formula 1, high external quantum efficiency and long lifespan characteristics.

The organometallic compound of Formula 1 may be used between a pair of electrodes of the organic light-emitting device. For example, the organometallic compound represented by Formula 1 may be included in the emission layer. In this regard, the organometallic compound may function as a dopant, and the emission layer may further include a host (wherein, an amount of the organometallic compound represented by Formula 1 is smaller than that of the host). The emission layer may emit, for example, green light or blue light.

The expression "(an organic layer) includes at least one of organometallic compound" as used herein may include a case in which "(an organic layer) includes identical organometallic compounds represented by Formula 1" and a case in which "(an organic layer) includes two or more different organometallic compounds represented by Formula 1".

In one or more embodiments, the organic layer may include, as the organometallic compound, only Compound 1. In this embodiment, Compound 1 may be included in the emission layer of the organic light-emitting device. In one or more embodiments, the organic layer may include, as the organometallic compound, Compound 1, and Compound 2. In this embodiment, Compound 1 and Compound 2 may exist in an identical layer (for example, Compound 1 and Compound 2 all may exist in an emission layer).

In one or more embodiments, the first electrode may be an anode, which is a hole injection electrode, and the second electrode may be a cathode, which is an electron injection electrode. In one or more embodiments, the first electrode may be a cathode, which is an electron injection electrode, and the second electrode may be an anode, which is a hole injection electrode.

For example, in the organic light-emitting device, the first electrode may be an anode, and the second electrode may be a cathode, and the organic layer may further include a hole transport region disposed between the first electrode and the emission layer and an electron transport region disposed between the emission layer and the second electrode, wherein and the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

FIGURE is a schematic cross-sectional view of an organic light-emitting device 10 according to one or more embodiments. Hereinafter, a structure of an organic light-emitting device according to an embodiment of the present disclosure and a method of manufacturing an organic light-emitting device according to one or more embodiments of the present disclosure will be described in connection with the FIGURE. The organic light-emitting device 10 includes a first electrode 11, an organic layer 15, and a second electrode 19, which are sequentially stacked.

A substrate may be additionally arranged under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

The first electrode 11 may be, for example, formed by depositing or sputtering a material for forming the first electrode11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. In one or more embodiments, the material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is arranged on the first electrode 11.

The organic layer 15 may include: a hole transport region; an emission layer; and an electron transport region.

The hole transport region may be disposed between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. For example, the hole transport region may have a hole injection layer/hole transport layer structure or a hole injection layer/hole transport layer/electron blocking layer structure, wherein, for each structure, each layer is sequentially stacked on the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When the hole injection layer is formed by vacuum deposition, the deposition conditions may vary according to a material that is used to form the hole injection layer, and the structure and thermal characteristics of the hole injection layer. For example, the deposition conditions may include a deposition temperature in a range of about 100 °C to about 500 °C, a vacuum pressure in a range about 10⁻⁸ torr to about 10⁻³ torr, and a deposition rate in a range of about 0.01 Å/sec to about 100 Å/sec.

When the hole injection layer is formed using spin coating, the coating conditions may vary according to a material that is used to form the hole injection layer, and the structure and thermal characteristics of the hole injection layer. For example, the coating speed may be in a range of about 2,000 rpm to about 5,000 rpm, and the temperature at which a heat treatment is performed to remove a solvent after coating may be in a range of about 80 °C to about 200 °C.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof: 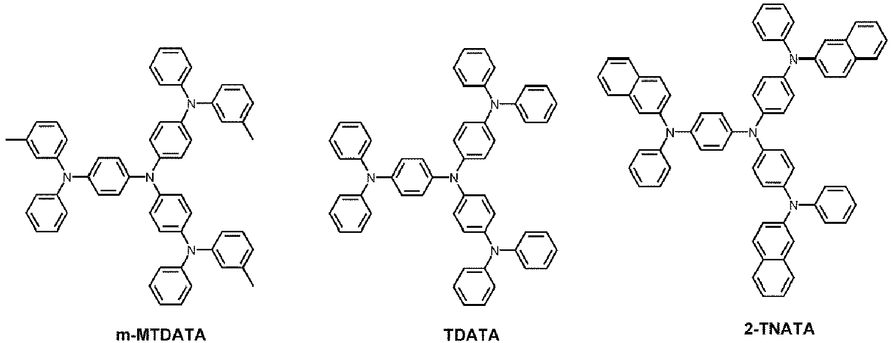 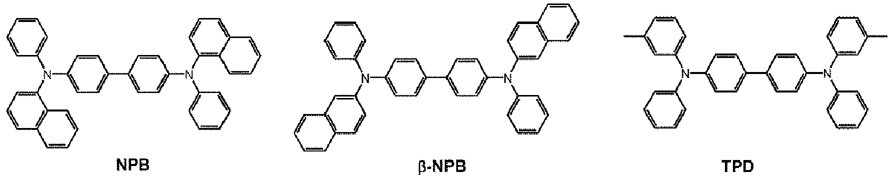 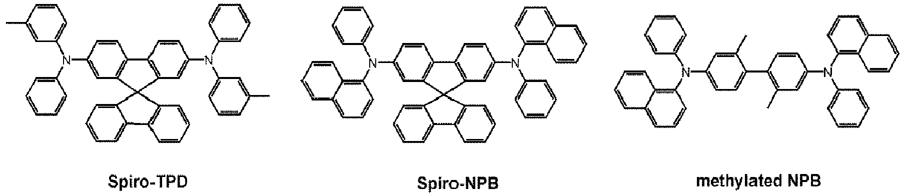 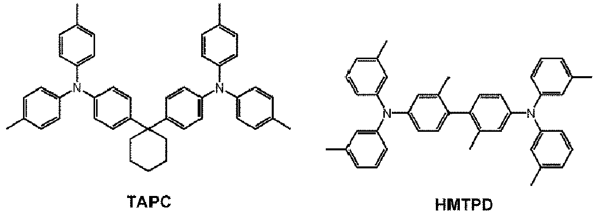 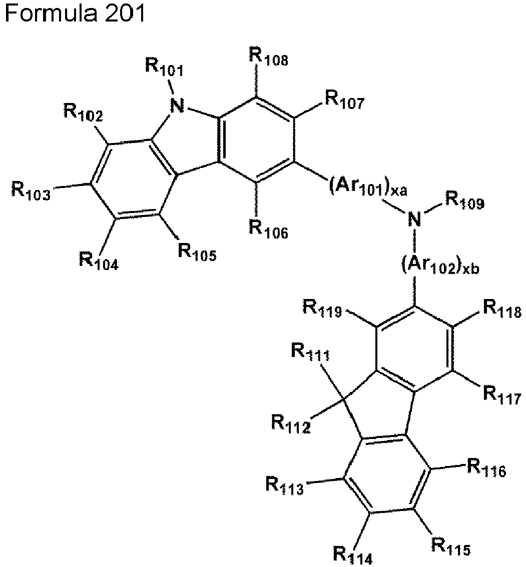 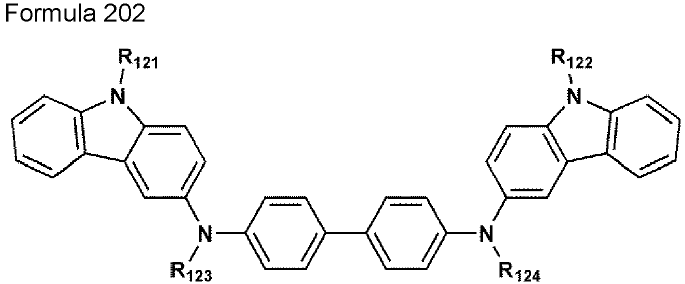 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or a combination thereof.

In Formula 201, xa and xb may each independently be an integer from 0 to 5, or 0, 1, or 2. For example, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or a combination thereof.

In one or more embodiments, the compound represented by Formula 201 may be represented by Formula 201A: 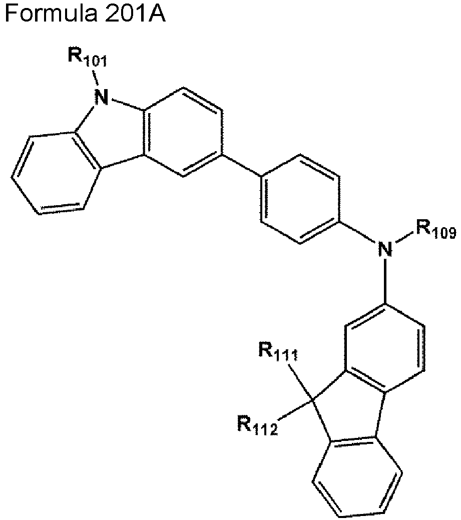 wherein R₁₀₁, R₁₁₁, R₁₁₂, and R₁₀₉ in Formula 201A may be understood by referring to the description provided herein.

For example, the hole transport region may include one of Compounds HT1 to HT20 or a combination thereof:

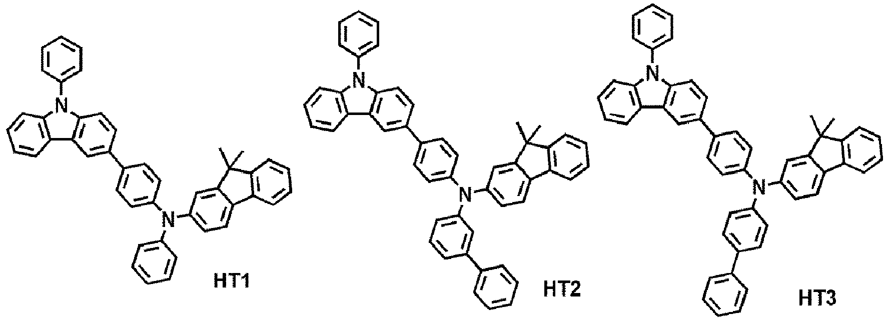

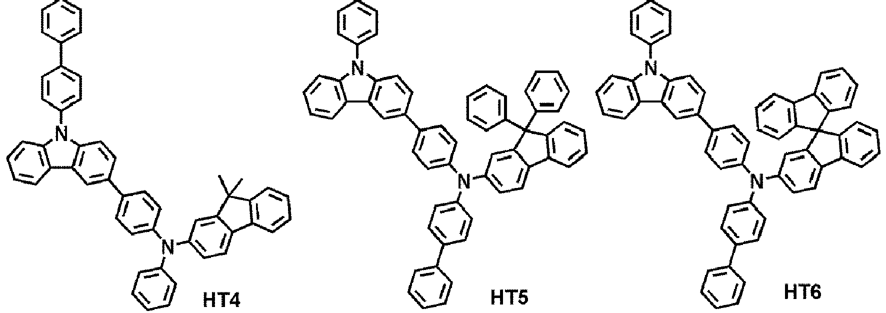

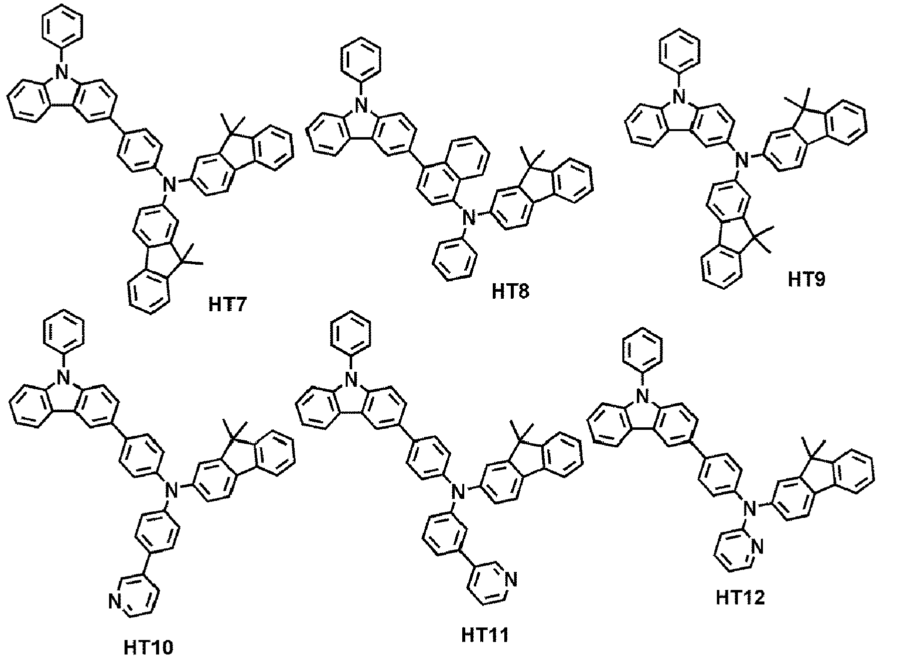

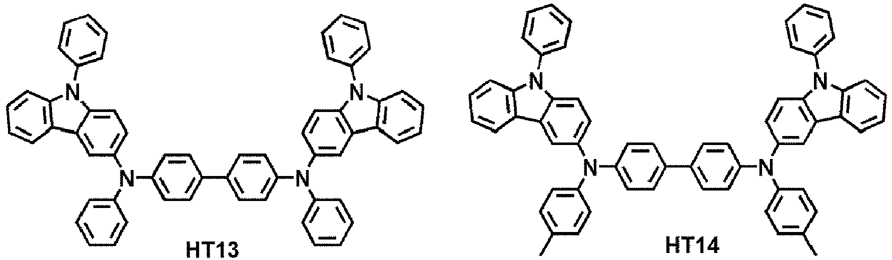

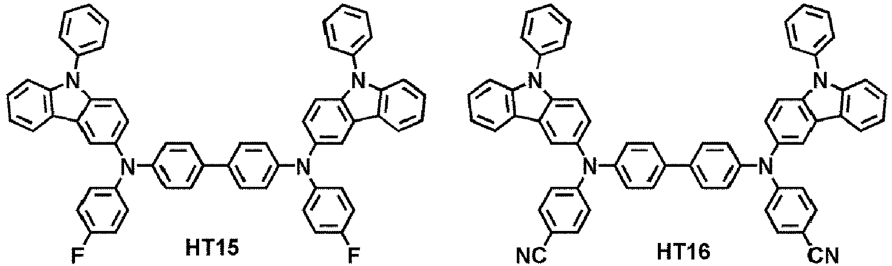

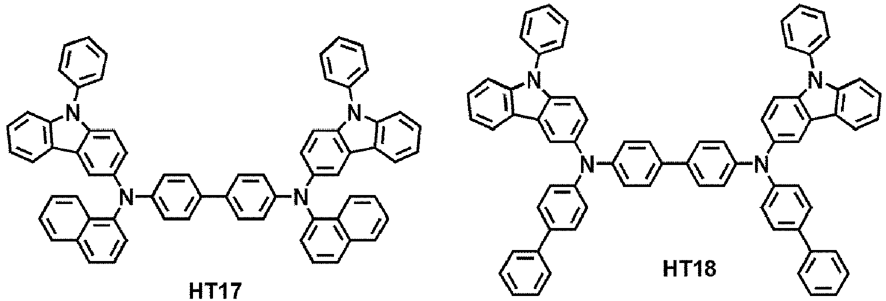

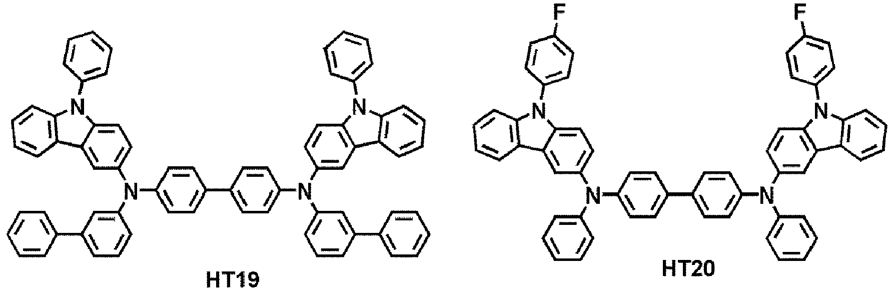

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof. For example, the p-dopant may be: a quinone derivative, such as tetracyanoquinodimethane (TCNQ), 2,3,5,6-tetrafluoro-tetracyano-1,4-benzoquinonedimethane (F4-TCNQ), or F6-TCNNQ; a metal oxide, such as tungsten oxide and molybdenum oxide; a cyano group-containing compound, such as Compound HT-D1; or a combination thereof.

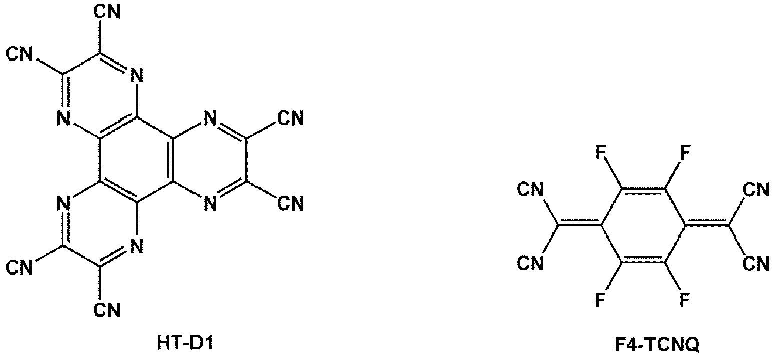

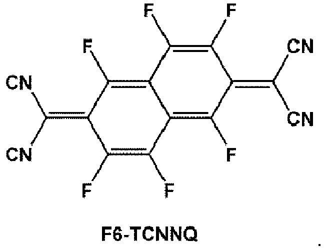

The hole transport region may further include a buffer layer.

The buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for forming the electron blocking layer may include a material that is used in the hole transport region as described above, a host material described below, or a combination thereof. For example, when the hole transport region includes an electron blocking layer, a material for forming the electron blocking layer may include mCP described below.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the hole transport layer.

The emission layer may include a host and a dopant, and the dopant may include the organometallic compound represented by Formula 1 as described herein.

The host may include TPBi, TBADN, ADN (also referred to as "DNA"), CBP, CDBP, TCP, mCP, Compound H50, Compound H51, Compound H52, or a combination thereof:

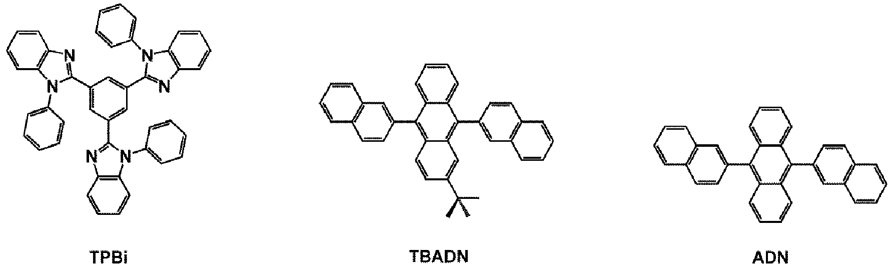

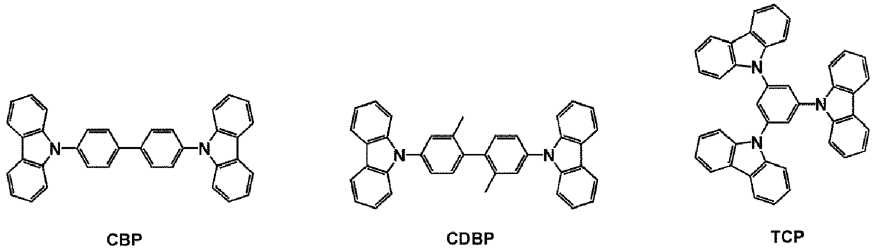

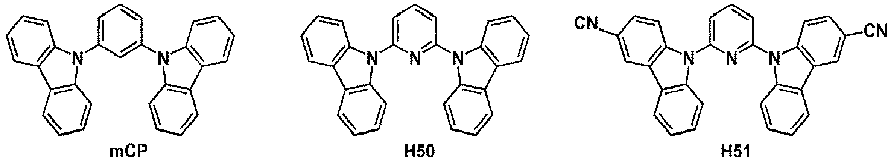

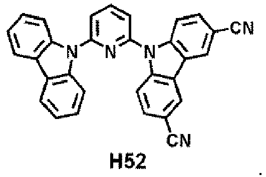

In one or more embodiments, an amount of the host in the emission layer may be greater than an amount of the at least one organometallic compound in the emission layer, based on weight.

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Then, an electron transport region is arranged on the emission layer.

The electron transport region may include a hole blocking layer, an electron transport layer, an electron injection layer, or a combination thereof.

For example, the electron transport region may have a hole blocking layer/electron transport layer/electron injection layer structure, or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAlq, or a combination thereof:

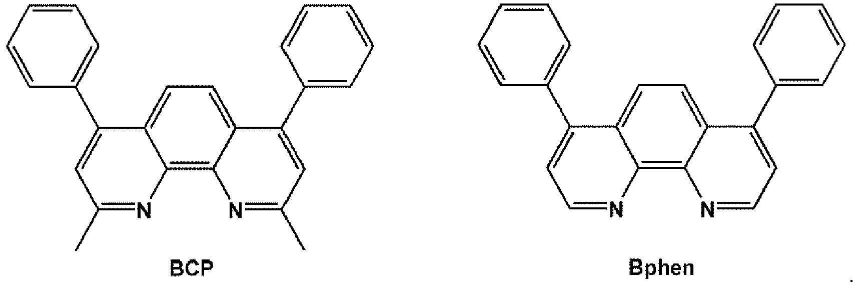

A thickness of the hole blocking layer may be in a range of about 20 Å to about 1,000 Å, for example, about 30 Å to about 600 Å. When a thickness of the hole blocking layer is within these ranges, excellent hole blocking characteristics may be obtained without a substantial increase in driving voltage.

In one or more embodiments, the electron transport layer may include BCP, Bphen, TPBi, Alq₃, BAlq, TAZ, NTAZ, or a combination thereof:

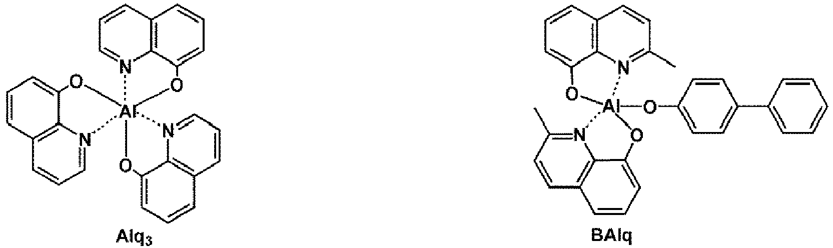

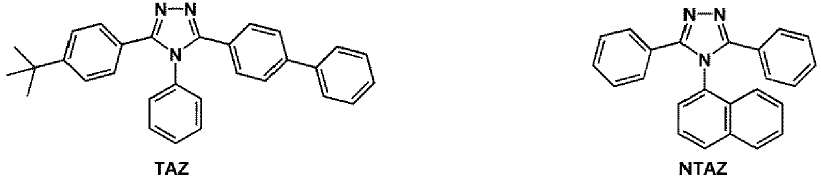

In one or more embodiments, the electron transport layer may include one of Compounds ET1 to ET25, or a combination thereof:

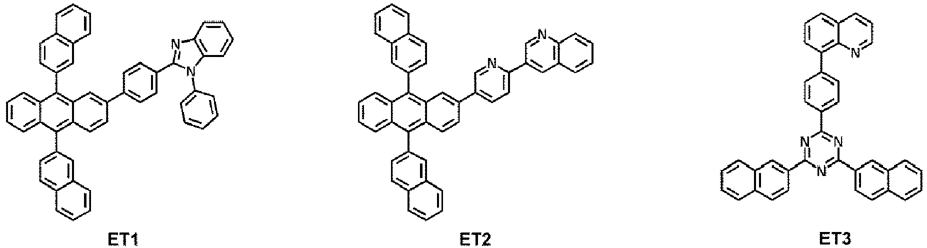

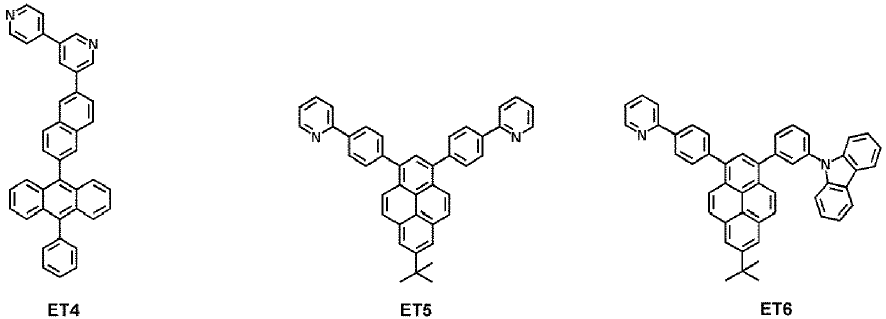

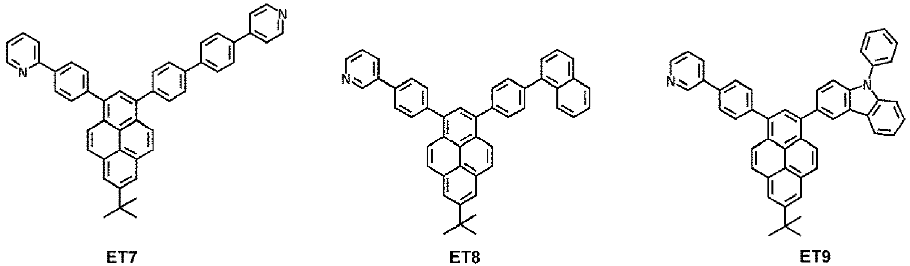

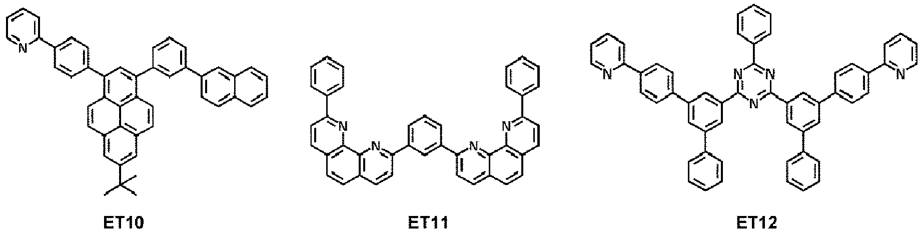

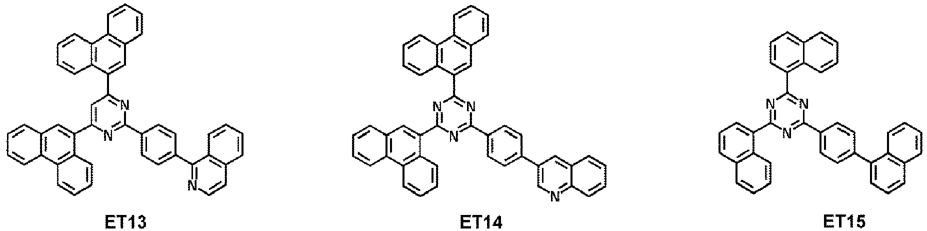

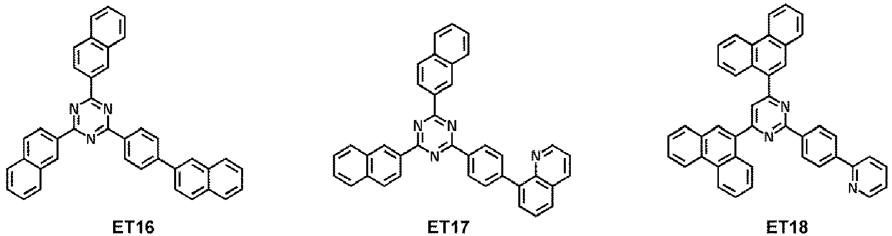

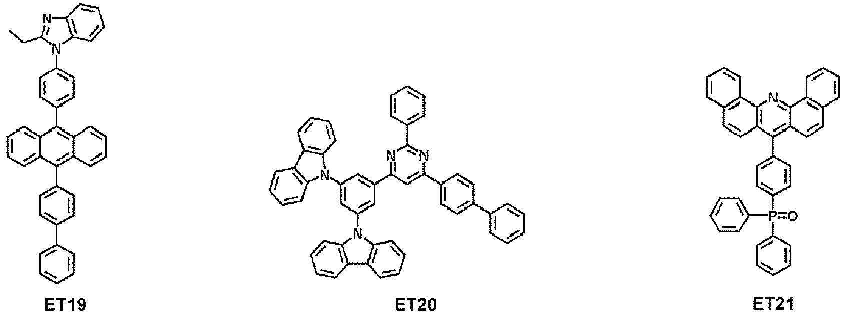

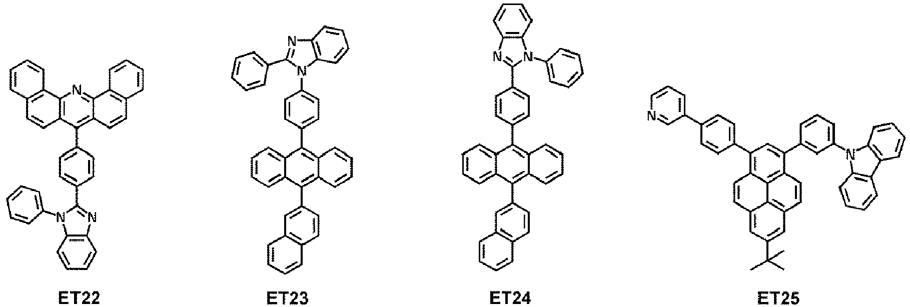

A thickness of the electron transport layer may be in a range of about 100 Å to about 1,000 Å, for example, about 150 Å to about 500 Å. When the thickness of the electron transport layer is within these ranges, satisfactory electron transport characteristics may be obtained without a substantial increase in driving voltage.

The electron transport layer may further include, in addition to the materials described above, a metal-containing material.

The metal-containing material may include a Li complex. The Li complex may include, for example, Compound ET-D1 or ET-D2:

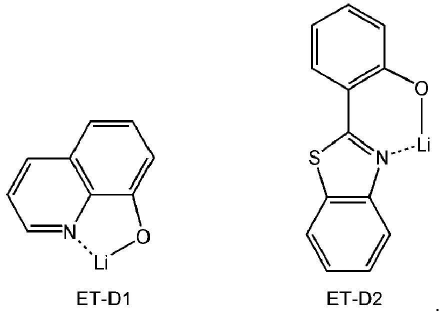

The electron transport region may include an electron injection layer that facilitates the flow of electrons from the second electrode 19 thereinto.

The electron injection layer may include LiF, NaCl, CsF, Li₂O, BaO, or a combination thereof.

A thickness of the electron injection layer may be in a range of about 1 Å to about 100 Å, and, for example, about 3 Å to about 90 Å. When the thickness of the electron injection layer is within these ranges, satisfactory electron injection characteristics may be obtained without a substantial increase in driving voltage.

The second electrode 19 is arranged on the organic layer 15. The second electrode 19 may be a cathode. A material for forming the second electrode 19 may include metal, an alloy, an electrically conductive compound, or a combination thereof, which have a relatively low work function. For example, the material for forming the second electrode 19 may include lithium (Li), magnesium (Mg), aluminum (Al), aluminum-lithium (Al-Li), calcium (Ca), magnesium-indium (Mg-In), or magnesium-silver (Mg-Ag). To manufacture a top-emission type light-emitting device, a transmissive electrode formed using ITO or IZO may be used as the second electrode 19.

Hereinbefore, one or more embodiments of the organic light-emitting device have been described with reference to the FIGURE, but embodiments of the present disclosure are not limited thereto.

According to another aspect, the organic light-emitting device may be included in an electronic apparatus. Thus, another aspect of the present disclosure provides an electronic apparatus including the organic light-emitting device. The electronic apparatus may include, for example, a display, an illumination, a sensor, a mobile phone, and the like.

Another aspect of the present disclosure provides a diagnostic composition including at least one organometallic compound represented by Formula 1.

The organometallic compound represented by Formula 1 may provide high luminescence efficiency. Accordingly, the diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, and a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof are an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the term C₃-C₁₀ cycloalkyl group are a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, and, a bicyclo[2.2.2]octyl group.

The term "C₁-C₁₀ heterocycloalkyl group" as used herein refers to a monocyclic group that includes at least one hetero atom selected from N, O, P, Si, S, Se, B, and Ge as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that has 3 to 10 carbon atoms and at least one carbon-carbon double bond in the ring thereof and no aromaticity, and examples thereof are a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, B, and Ge as a ring-forming atom, 1 to 10 carbon atoms, and at least one carbon-carbon double bond in its ring. Examples of the C₁-C₁₀ heterocycloalkenyl group are a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The term "C₇-C₆₀ alkylaryl group" as used herein refers to a C₆-C₆₀ aryl group substituted with at least one C₁-C₆₀ alkyl group.

The term "C₁-C₆₀ heteroaryl group" as used herein refers to a monovalent group having at least one hetero atom selected from N, O, P, Si, S, Se, B, and Ge as a ring-forming atom and a cyclic aromatic system having 1 to 60 carbon atoms, and the term "C₁-C₆₀ heteroarylene group" as used herein refers to a divalent group having at least one hetero atom selected from N, O, P, Si, S, Se, B, and Ge as a ring-forming atom and a carbocyclic aromatic system having 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the two or more rings may be fused to each other.

The term "C₂-C₆₀ alkylheteroaryl group" as used herein refers to a C₁-C₆₀ heteroaryl group substituted with at least one C₁-C₆₀ alkyl group.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates-SA₁₀₃ (wherein A₁₀₃ is the C₆-C₆₀ aryl group), and the term "C₁-C₆₀ alkylthio group" indicates -SA₁₀₄ (wherein A₁₀₄ is the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. An example of the monovalent non-aromatic condensed polycyclic group is a fluorenyl group. The term "divalent non-aromatic condensed polycyclic group" as used herein refers to a divalent group having the same structure as the monovalent non-aromatic condensed polycyclic group. The term "monovalent non-aromatic condensed heteropolycyclic group" as used herein refers to a monovalent group (for example, having 1 to 60 carbon atoms) having two or more rings condensed to each other, a heteroatom selected from N, O, P, Si, S, Se, B, and Ge, other than carbon atoms, as a ring-forming atom, and no aromaticity in its entire molecular structure. An example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

Examples of the "C₅-C₃₀ carbocyclic group (unsubstituted or substituted with at least one R₁₀ₐ)" are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group ,each unsubstituted or substituted with at least one R₁₀ₐ as defined herein.

The term "C₁-C₃₀ heterocyclic group" as used herein refers to a saturated or unsaturated cyclic group having, as a ring-forming atom, at least one heteroatom selected from N, O, P, Si, Se, Ge, B, and S other than 1 to 30 carbon atoms. The C₁-C₃₀ heterocyclic group may be a monocyclic group or a polycyclic group.

Examples of the "C₁-C₃₀ heterocyclic group (unsubstituted or substituted with at least one R₁₀ₐ)" are a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group, each unsubstituted or substituted with at least one R₁₀ₐ as disclosed herein.

Examples of the terms "C₅-C₃₀ carbocyclic group" and "C₁-C₃₀ heterocyclic group" as used herein may include i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the "fluorinated C₁ alkyl group (that is, the fluorinated methyl group)" may include -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein, in each group, all hydrogens included therein are each substituted with a fluoro group, or ii) a partially fluorinated C₁-C₆₀ alkyl group (or, a partially fluorinated C₁-C₂₀ alkyl group or the like), a partially fluorinated C₃-C₁₀ cycloalkyl group, a partially fluorinated C₁-C₁₀ heterocycloalkyl group, or a partially fluorinated phenyl group, wherein, in each group, all hydrogens included therein are not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include-CD₃, -CD₂H, and -CDH₂, and examples of the "deuterated C₃-C₁₀ cycloalkyl group" are Formula 10-501 and the like. The "deuterated C₁-C₆₀ alkyl group (or the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogens included therein are each substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogens included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group," in which, in each group, at least one carbon selected from ring-forming carbon atoms is substituted with a nitrogen atom.

Substituents of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or-P(Q38)(Q39); or
a combination thereof,

In the present specification, Q₁ to Q₉, Q₁₁ to Q₁₉, Q₂₁ to Q₂₉, and Q₃₁ to Q₃₉ may each independently be: hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, -F, a cyano group, a C₁-C₆₀ alkyl group, a C₆-C₆₀ aryl group, a deuterated C₆-C₆₀ aryl group, a fluorinated C₆-C₆₀ aryl group, or a combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group or a C₁-C₆₀ heteroaryl group, each unsubstituted or substituted with deuterium, -F, a cyano group, a C₁-C₆₀ alkyl group, a deuterated C₁-C₆₀ alkyl group, a fluorinated C₁-C₆₀ alkyl group, a C₆-C₆₀ aryl group, a deuterated C₆-C₆₀ aryl group, a fluorinated C₆-C₆₀ aryl group, or a combination thereof; a C₆-C₆₀ aryloxy group; a C₆-C₆₀ arylthio group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ may each ay each independently be:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with deuterium, a C₁-C₂₀ alkyl group, a phenyl group, or a combination thereof.

Hereinafter, a compound and an organic light-emitting device according to one or more embodiments are described in further detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example 1 (Compound 171)

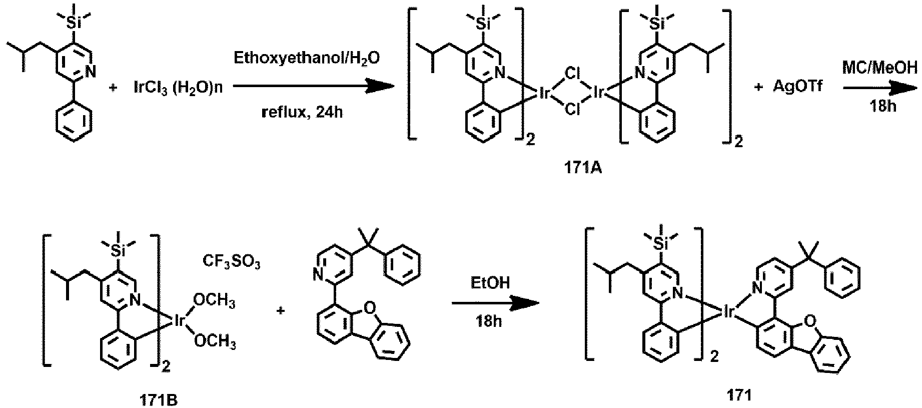

### Synthesis of Compound 171A

4-isobutyl-2-phenyl-5-(trimethylsilyl)pyridine) (7.9 grams (g), 27.8 millimoles (mmol)) and iridium chloride hydrate (IrCl₃·(H₂O)ₙ) (4.4 g, 12.6 mmol) were mixed with 120 mL of ethoxyethanol and 40 mL of deionized water, and the mixture was stirred at reflux for 24 hours. Then, the reaction temperature was reduced to room temperature. The resulting solid produced therefrom was separated by filtration, sufficiently washed with water/methanol/hexane in the stated order, and dried in a vacuum oven, so as to obtain 7.6 g (yield of 76 %) of Compound 171A.

### Synthesis of Compound 171B

Compound 171A (3.3 g, 2.1 mmol) was mixed with 90 mL of methylene chloride, and a mixture containing AgOTf (silver triflate) (1.1 g, 4.1 mmol) and 30 mL of methanol was added thereto. Afterwards, the resultant mixture was stirred at room temperature for 18 hours while blocking the light with aluminum foil. The resultant was filtered using Celite to remove a solid formed therefrom and filtered under reduced pressure to thereby obtain a solid (Compound 171B). The solid was used in the next reaction without further purification.

### Synthesis of Compound 171

Compound 171B (4.0 g, 4.1 mmol) and 2-(dibenzo[b,d]furan-4-yl)-4-(2-phenylpropan-2-yl)pyridine (1.6 g, 4.5 mmol) were mixed with 40 mL of ethanol, and the mixture was stirred at reflux for 18 hours. Then, the reaction temperature was lowered. Solvent was removed from the resultant mixture thus obtained under reduced pressure and subjected to column chromatography (eluent: methylene chloride (MC) and hexane), so as to obtain 1.5 g (yield of 33 %) of Compound 171. The compound was identified by Mass and HPLC.

High resolution mass spectrometry - (Matrix Assisted Laser Desorption Ionization) (HRMS(MALDI)) calcd. for C₆₂H₆₈IrN₃OSi₂: m/z 1119.4530 Found: 1119.4523.

### Synthesis Example 2 (Compound 1032)

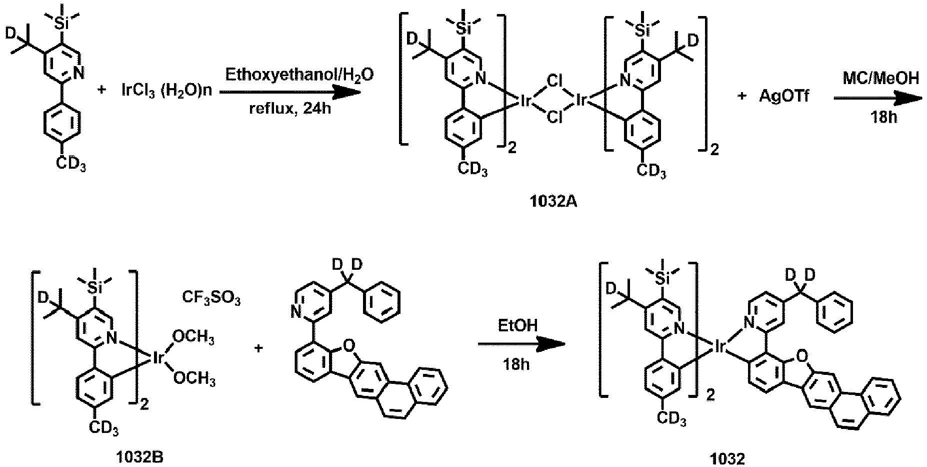

### Synthesis of Compound 1032A

6.9 g (yield of 69 %) of Compound 1032A was obtained in the same manner as used to obtain Compound 171A of Synthesis Example 1, except that 2-(4-(methyl-d3)phenyl)-4-(propan-2-yl-2-d)-5-(trimethylsilyl)pyridine was used instead of 4-isobutyl-2-phenyl-5-(trimethylsilyl)pyridine.

### Synthesis of Compound 1032B

Compound 1032B was obtained in the same manner as used to obtain Compound 171B of Synthesis Example 1, except that Compound 1032A was used instead of Compound 171A. Compound 1032B thus obtained was used in the next reaction without further purification.

### Synthesis of Compound 1032

0.9 g (yield of 27 %) of Compound 1032 was obtained in the same manner as used to obtain Compound 171 of Synthesis Example 1, except that Compound 1032B was used instead of Compound 171B and that 2-(phenanthro[3,2-b]benzofuran-11-yl)-4-(phenylmethyl-d2)pyridine was used instead of 2-(dibenzo[b,d]furan-4-yl)-4-(2-phenylpropan-2-yl)pyridine. The compound was identified by mass spectrometry (MS) and high-pressure liquid chromatography (HPLC).

HRMS(MALDI) calcd for C₆₈H₅₈D₁₀IrN₃OSi₂: m/z 1201.5158 Found: 1201.5164.

### Synthesis Example 3 (Compound 1485)

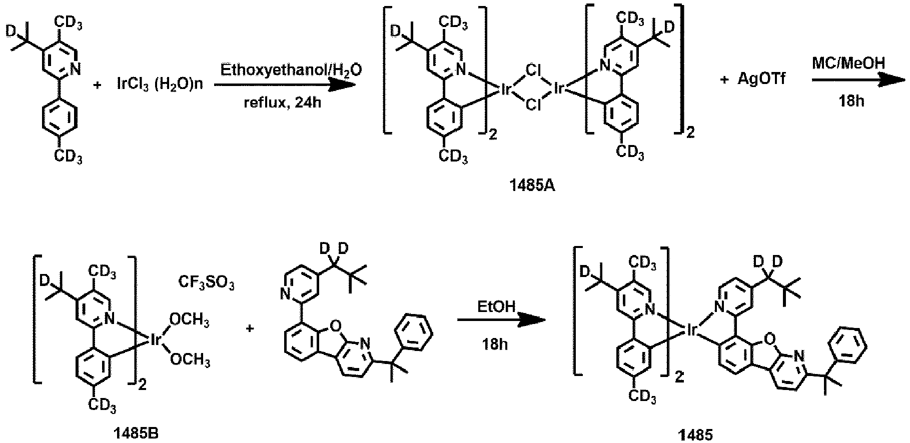

### Synthesis of Compound 1485A

8.1 g (yield of 81 %) of Compound 1485A was obtained in the same manner as used to obtain Compound 171A of Synthesis Example 1, except that 5-(methyl-d3)-2-(4-(methyl-d3)phenyl)-4-(propan-2-yl-2-d)pyridine was used instead of 4-isobutyl-2-phenyl-5-(trimethylsilyl)pyridine.

### Synthesis of Compound 1485B

Compound 1485B was obtained in the same manner as used to obtain Compound 171B of Synthesis Example 1, except that Compound 1485A was used instead of Compound 171A. Compound 1485B thus obtained was used in the next reaction without further purification.

### Synthesis of Compound 1485

1.2 g (yield of 36 %) of Compound 1485 was obtained in the same manner as used to obtain Compound 171 of Synthesis Example 1, except that Compound 1485B was used instead of Compound 171B and that 8-(4-(2,2-dimethylpropyl-1,1-d2)pyridin-2-yl)-2-(2-phenylpropan-2-yl)benzofuro[2,3-b]pyridine was used instead of 2-(dibenzo[b,d]furan-4-yl)-4-(2-phenylpropan-2-yl)pyridine. The compound was identified by MS and HPLC.

HRMS(MALDI) calcd for C₆₂H₄₉D₁₆IrN₄O. m/z 1090.5792 Found: 1090.5788.

### Synthesis Example 4 (Compound 2051)

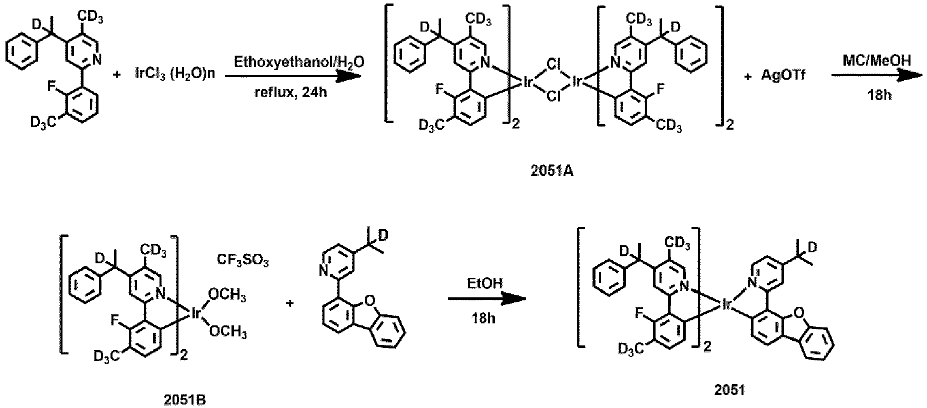

### Synthesis of Compound 2051A

6.6 g (yield of 66 %) of Compound 2051A was obtained in the same manner as used to obtain Compound 171A of Synthesis Example 1, except that 2-(2-fluoro-3-(methyl-d3)phenyl)-5-(methyl-d3)-4-(1-phenylethyl-1-d)pyridine was used instead of 4-isobutyl-2-phenyl-5-(trimethylsilyl)pyridine.

### Synthesis of Compound 2051B

Compound 2051B was obtained in the same manner as used to obtain Compound 171B of Synthesis Example 1, except that Compound 2051A was used instead of Compound 171A. Compound 2051B thus obtained was used in the next reaction without further purification.

### Synthesis of Compound 2051

1.3 g (yield of 29 %) of Compound 2051 was obtained in the same manner as used to obtain Compound 171 of Synthesis Example 1, except that Compound 2051B was used instead of Compound 171B and that 2-(dibenzo[b,d]furan-4-yl)-4-(propan-2-yl-2-d)pyridine was used instead of 2-(dibenzo[b,d]furan-4-yl)-4-(2-phenylpropan-2-yl)pyridine. The compound was identified by Mass and HPLC.

HRMS(MALDI) calcd for C₆₂H₃₉D₁₅F₂IrN₃O: m/z 1102.4806 Found: 1102.4801.

### Synthesis Example 5 (Compound 2111)

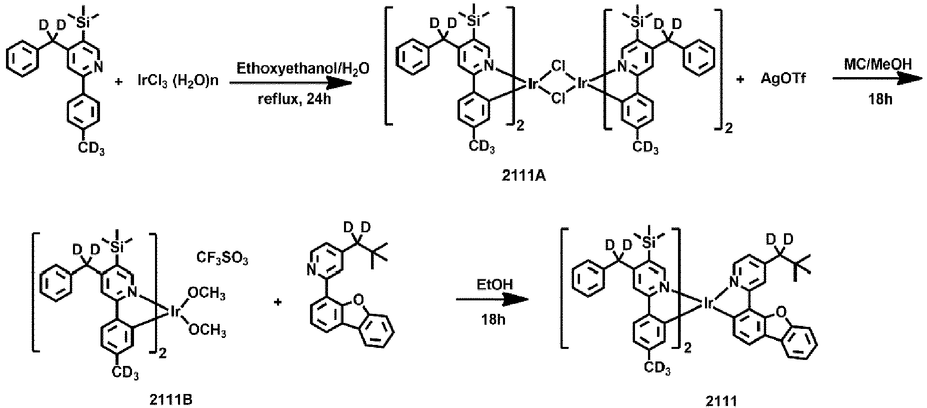

### Synthesis of Compound 2111A

7.9 g (yield of 79 %) of Compound 2111A was obtained in the same manner as used to obtain Compound 171A of Synthesis Example 1, except that 2-(4-(methyl-d3)phenyl)-4-(phenylmethyl-d2)-5-(trimethylsilyl)pyridine was used instead of 4-isobutyl-2-phenyl-5-(trimethylsilyl)pyridine.

### Synthesis of Compound 2111B

Compound 2111B was obtained in the same manner as used to obtain Compound 171B of Synthesis Example 1, except that Compound 2111A was used instead of Compound 171A. Compound 2111B thus obtained was used in the next reaction without further purification.

### Synthesis of Compound 2111

1.5 g (yield of 40 %) of Compound 2111 was obtained in the same manner as used to obtain Compound 171 of Synthesis Example 1, except that Compound 2111B was used instead of Compound 171B and that 2-(dibenzo[b,d]furan-4-yl)-4-(2,2-dimethylpropyl-1,1-d2)pyridine was used instead of 2-(dibenzo[b,d]furan-4-yl)-4-(2-phenylpropan-2-yl)pyridine. The compound was identified by Mass and HPLC.

HRMS(MALDI) calcd for C₆₆H₅₆D₁₂IrN₃OSi₂: m/z 1179.5283 Found: 1179.5288.

### Synthesis Example 6 (Compound 2543)

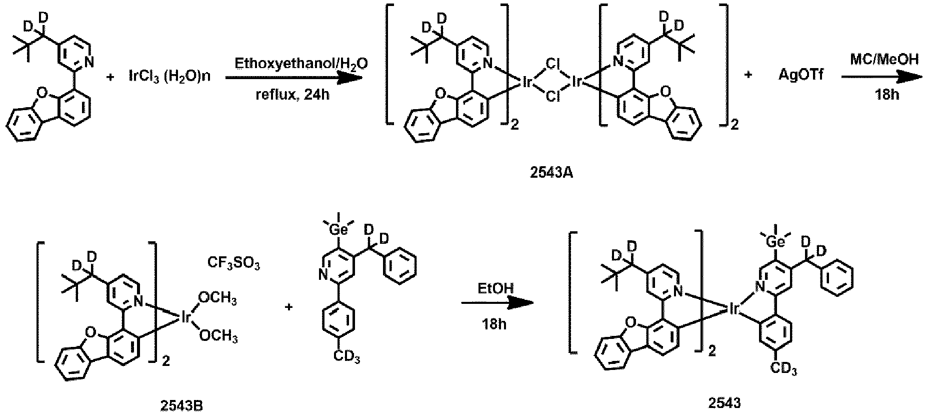

### Synthesis of Compound 2543A

5.4 g (yield of 54 %) of Compound 2543A was obtained in the same manner as used to obtain Compound 171A of Synthesis Example 1, except that 2-(dibenzo[b,d]furan-4-yl)-4-(2,2-dimethylpropyl-1,1-d2)pyridine was used instead of 4-isobutyl-2-phenyl-5-(trimethylsilyl)pyridine.

### Synthesis of Compound 2543B

Compound 2543B was obtained in the same manner as used to obtain Compound 171B of Synthesis Example 1, except that Compound 2543A was used instead of Compound 171A. Compound 2543B thus obtained was used in the next reaction without further purification.

### Synthesis of Compound 2543

0.9 g (yield of 23 %) of Compound 2543 was obtained in the same manner as used to obtain Compound 171 of Synthesis Example 1, except that Compound 2543B was used instead of Compound 171B and that 2-(4-(methyl-d3)phenyl)-4-(phenylmethyl-d2)-5-(trimethylgermyl)pyridine was used instead of 2-(dibenzo[b,d]furan-4-yl)-4-(2-phenylpropan-2-yl)pyridine. The compound was identified by Mass and HPLC.

HRMS(MALDI) calcd for C₆₆H₅₅D₉GeIrN₃O₂: m/z 1206.4404 Found: 1206.4414.

### Example 1

A glass substrate with ITO/Ag/ITO as an anode deposited thereon to a thickness of 70 Å/1,000 Å/70 Å was cut to a size of 50 millimeters (mm) x 50 mm x 0.5 mm, sonicated with isopropyl alcohol and pure water each for 5 minutes, and then cleaned by exposure to ultraviolet rays and ozone for 30 minutes. Then, the resultant glass substrate was loaded onto a vacuum deposition apparatus.

2-TNATA was vacuum-deposited on the anode to form a hole injection layer having a thickness of 600 Å, and 4,4'-bis[N-(1-naphthyl)-N-phenylamino] biphenyl (hereinafter referred to as NPB) was vacuum-deposited on the hole injection layer to form a hole transport layer having a thickness of 1,350 Å.

Subsequently, CBP (host) and Compound 171 (dopant) were co-deposited at a weight ratio of 98:2 on the hole transport layer to form an emission layer having a thickness of 400 Å.

Afterwards, BCP was vacuum-deposited on the emission layer to form a hole blocking layer having a thickness of 50 Å, Alq₃ was vacuum-deposited on the hole blocking layer to form an electron transport layer having a thickness of 350 Å, LiF was vacuum-deposited on the electron transport layer to form an electron injection layer having a thickness of 10 Å, and Mg and Ag were co-deposited at a weight ratio of 90:10 on the electron injection layer to form a cathode having a thickness of 120 Å, thereby completing an organic light-emitting device.

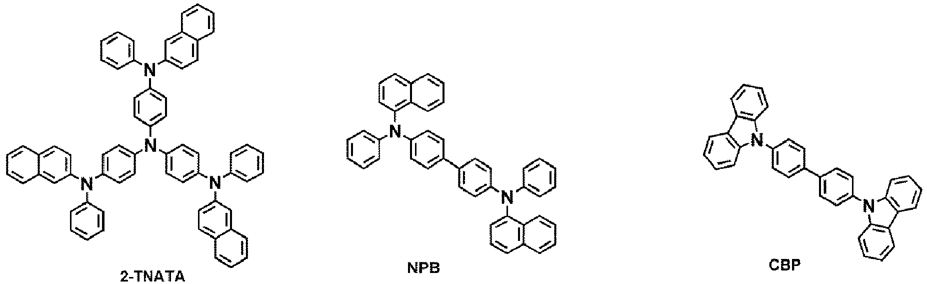

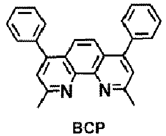

### Examples 2 to 6 and Comparative Examples A to C

Organic light-emitting devices were manufactured in the same manner as in Example 1, except that compounds shown in Table 2 were each used instead of Compound 171 as a dopant in forming an emission layer.

### Evaluation Example 1: Characterization of organic light-emitting device

Regarding each of the organic light-emitting devices of Examples 1 to 6 and Comparative Examples A to C, the driving voltage, maximum value (%) of external quantum efficiency (EQE), and lifespan (LT₉₇)(hr.) were evaluated, and results thereof are shown in Table 2. This evaluation was performed using a current-voltage meter (Keithley 2400) and a luminance meter (Minolta Cs-1000A), and the lifespan (LT₉₇)(at 16,000 candela per square meter (cd/m²) was evaluated by measuring, as a relative value (%), the amount of time that elapsed until luminance was reduced to 97 % of the initial luminance of 100 %. The compounds were provided as a dopant in an emission layer.

**Table 2**

| | Compound No. | Max EQE (%) | LT₉₇ (%) (at 16,000 cd/m²) |
|---|---|---|---|
| Example 1 | 171 | 25.9 | 100 |
| Example 2 | 1032 | 27.4 | 207 |
| Example 3 | 1485 | 26.8 | 113 |
| Example 4 | 2051 | 26.2 | 108 |
| Example 5 | 2111 | 26.5 | 154 |
| Example 6 | 2543 | 27.1 | 193 |
| Comparative Example A | A | 23.4 | 19 |
| Comparative Example B | B | 22.8 | 35 |
| Comparative Example C | C | 21.6 | 23 |

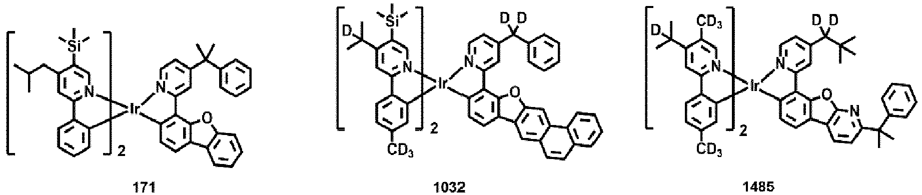

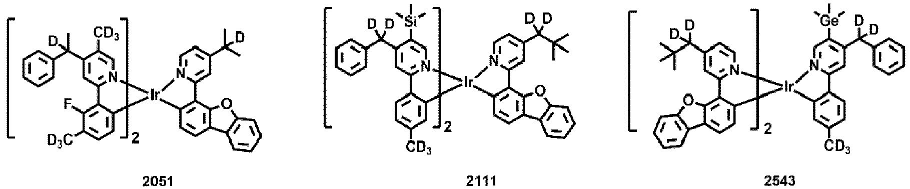

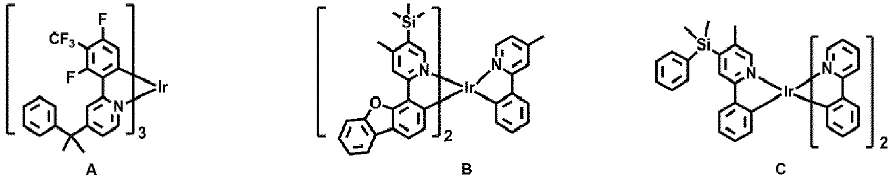

Referring to Table 2, it was confirmed that the organic light-emitting devices of Example 1 to 6 had improved EQE and improved lifespan characteristics compared to the organic light-emitting devices of Comparative Examples A to C.

According to the one or more embodiments, an organometallic compound may have excellent electrical characteristics and heat resistance, so that an electronic device, such as an organic light-emitting device, including the organometallic compound may have excellent EQE and excellent lifespan characteristics. Therefore, the use of the organometallic compound may enable the embodiment of a high-quality organic light-emitting device and an electron device including the same.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2,
n1 is 1, 2, or 3, wherein, when n1 is 2, two L₁ groups are identical to or different from each other, and when n1 is 3, two or more of three L₁ groups are different from each other,
L₂ is a monodentate ligand, a bidentate ligand, a tridentate ligand, or a tetradentate ligand,
n2 is 0, 1, 2, 3, or 4, wherein, when n2 is 2 or greater, two or more L₂ groups are identical to or different from each other, and
L₁ and L₂ are different from each other, 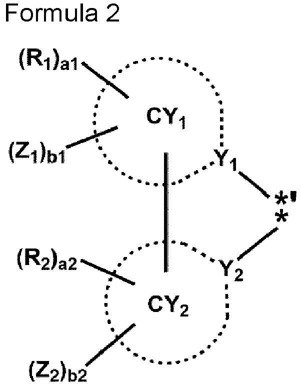 wherein, in Formula 2,
Y₁ and Y₂ are each independently C or N,
ring CY₁ and ring CY₂ are each independently a C₅-C₃₀ carbocyclic group or a C1-C30 heterocyclic group,
R₁ and R₂ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),-Ge(Q₃)(Q₄)(Q₅), -B(Q₆)(Q₇), -P(=O)(Q₆)(Q₉), or -P(Q₈)(Q₉),
a1 and a2 are each independently an integer from 0 to 20,
b1 and b2 are each independently an integer from 0 to 20, wherein the sum of b1 and b2 is 1 or greater,
Z₁ and Z₂ are each independently a group represented by Formula 3, 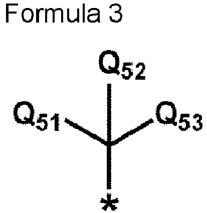 wherein, in Formula 3,
Q₅₁ and Q₅₂ are each independently hydrogen, deuterium, -F, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
Q₅₃ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
two or more of a plurality of R₁ groups are optionally linked together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of R₂ groups are optionally linked together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is the same as described in connection with R₁,
* and *' in Formula 2 each indicate a binding site to M in Formula 1,
* in Formula 3 indicates a binding site to a neighboring atom,
in Formula 2 and Formula 3,
substituents of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group are each independently:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C1-C10 heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉),-P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₆)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₆)(Q₃₉), or -P(Q₃₆)(Q₃₉); or
a combination thereof, and
Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, -F, a cyano group, a C₁-C₆₀ alkyl group, a C₆-C₆₀ aryl group, a deuterated C₆-C₆₀ aryl group, a fluorinated C₆-C₆₀ aryl group, or a combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group or a C₁-C₆₀ heteroaryl group, each unsubstituted or substituted with deuterium, -F, a cyano group, a C₁-C₆₀ alkyl group, a deuterated C₁-C₆₀ alkyl group, a fluorinated C₁-C₆₀ alkyl group, a C₆-C₆₀ aryl group, a deuterated C₆-C₆₀ aryl group, a fluorinated C₆-C₆₀ aryl group, or a combination thereof; a C₆-C₆₀ aryloxy group; a C₆-C₆₀ arylthio group; a monovalent non-aromatic condensed polycyclic group; or a monovalent non-aromatic condensed heteropolycyclic group.

2. The organometallic compound of claim 1, wherein
ring CY₁ in Formula 2 is a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a 5,6,7,8-tetrahydroisoquinoline group, a 5,6,7,8-tetrahydroquinoline group, an azafluorene group, an azacarbazole group, an azadibenzofuran group, an azadibenzothiophene group, or an azadibenzosilole group; and/or
wherein ring CY₂ in Formula 2 is a benzene group, a naphthalene group, an anthracene group, a phenanthrene group, a triphenylene group, a pyrene group, a chrysene group, a 1,2,3,4-tetrahydronaphthalene group, or a group represented by Formula 2B: 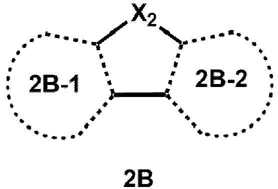 wherein, in Formula 2B,
X₂ is O, S, Se, or a moiety comprising N, C, or Si,
ring 2B-1 and ring 2B-2 are each independently a benzene group, a naphthalene group, an anthracene group, a phenanthrene group, a triphenylene group, a pyrene group, a chrysene group, a 1,2,3,4-tetrahydronaphthalene group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a 5,6,7,8-tetrahydroisoquinoline group, a 5,6,7,8-tetrahydroquinoline group, an indene group, an indole group, a benzofuran group, a benzothiophene group, a benzosilole group, a fluorene group, a carbazole group, a dibenzofuran group, a dibenzothiophene group, a dibenzosilole group, an azaindene group, an azaindole group, an azabenzofuran group, an azabenzothiophene group, an azabenzosilole group, an azafluorene group, an azacarbazole group, an azadibenzofuran group, an azadibenzothiophene group, or an azadibenzosilole group.

3. The organometallic compound of claims 1 or 2, wherein
R₁ and R₂ in Formula 2 are each independently:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, or a combination thereof;
a C₃-C₁₀ cycloalkyl group, a C₁-C₁₀ heterocycloalkyl group, a phenyl group, a biphenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)Ci-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a naphthyl group, a deuterated naphthyl group, a fluorinated naphthyl group, a (C₁-C₂₀ alkyl)naphthyl group, a pyridinyl group, a deuterated pyridinyl group, a fluorinated pyridinyl group, a (C₁-C₂₀ alkyl)pyridinyl group, or a combination thereof; or
-Si(Q₃)(Q₄)(Q₆) or -Ge(Q₃)(Q₄)(Q₅),
wherein,
Q₃ to Q₅ are each independently:
deuterium;
a C₁-C₆₀ alkyl group unsubstituted or substituted with deuterium, -F, a cyano group, a C₁-C₆₀ alkyl group, a C₆-C₆₀ aryl group, a deuterated C₆-C₆₀ aryl group, a fluorinated C₆-C₆₀ aryl group, or a combination thereof; or
a C₆-C₆₀ aryl group or a C₁-C₆₀ heteroaryl group, each unsubstituted or substituted with deuterium, -F, a cyano group, a C₁-C₆₀ alkyl group, a deuterated C₁-C₆₀ alkyl group, a fluorinated C₁-C₆₀ alkyl group, a C₆-C₆₀ aryl group, a deuterated C₆-C₆₀ aryl group, a fluorinated C₆-C₆₀ aryl group, or a combination thereof.

4. The organometallic compound of any of claims 1-3, wherein
at least one R₁ in the number of a1 in Formula 2 is: deuterium; -F; a C₁-C₂₀ alkyl group or a C₃-C₁₀ cycloalkyl group, each unsubstituted or substituted with deuterium, -F, C₁-C₁₀ alkyl group, or a combination thereof; a group represented by-Si(Q₃)(Q₄)(Q₅); or a group represented by -Ge(Q₃)(Q₄)(Q₅).

5. The organometallic compound of any of claims 1-4, wherein
i) b1 is 1 or 2, and b2 is 0;
ii) b1 is 0, and b2 is 1 or 2; or
iii) b1 and b2 are each 1.

6. The organometallic compound of any of claims 1-5, wherein
at least one of Q₅₁ and Q₅₂ in Formula 3 is each independently deuterium, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

7. The organometallic compound of any of claims 1-6, wherein
at least one of Q₅₁ and Q₅₂ in Formula 3 is each independently:
deuterium; or
a C₁-C₂₀ alkyl group unsubstituted or substituted with deuterium, -F, or a combination thereof.

8. The organometallic compound of any of claims 1-7, wherein
Q₅₃ in Formula 3 is a C₃-C₁₀ cycloalkyl group, a C₁-C₁₀ heterocycloalkyl group, a phenyl group, a biphenyl group, a naphthyl group, or a pyridinyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a naphthyl group, a deuterated naphthyl group, a fluorinated naphthyl group, a (C₁-C₂₀ alkyl)naphthyl group, a pyridinyl group, a deuterated pyridinyl group, a fluorinated pyridinyl group, a (C₁-C₂₀ alkyl)pyridinyl group, or a combination thereof; and/or
wherein in Formula 2,
a group represented by 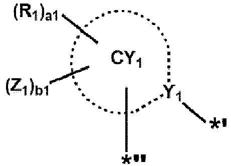 is a group represented by one of Formulae CY1(1) to CY1(16) and CY1(1)Z to CY₁ (38)Z: 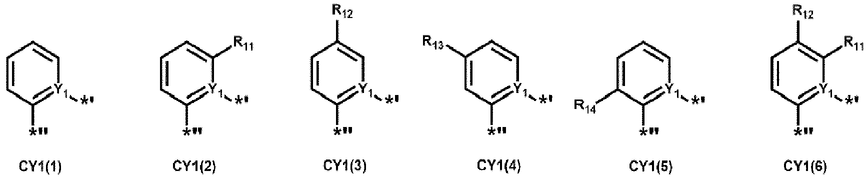 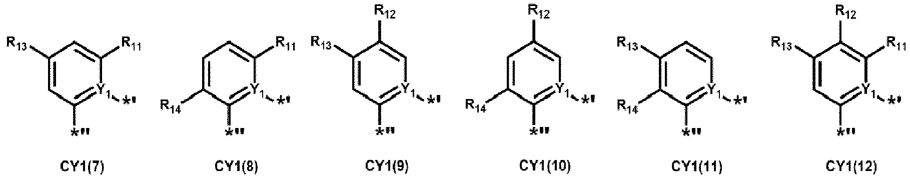 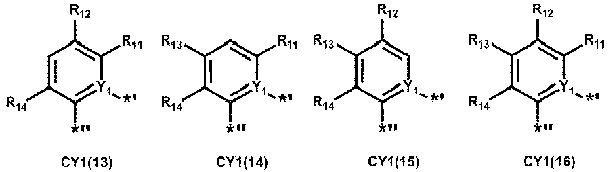 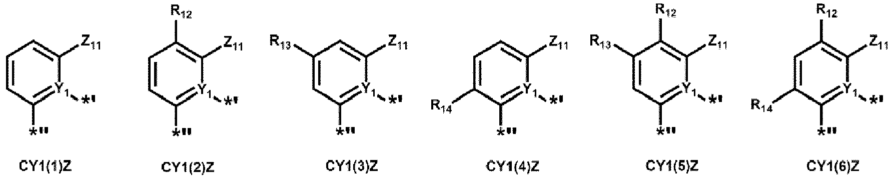 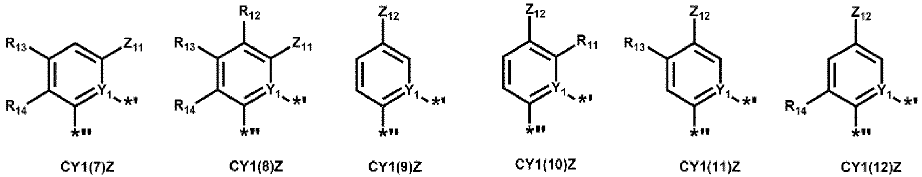 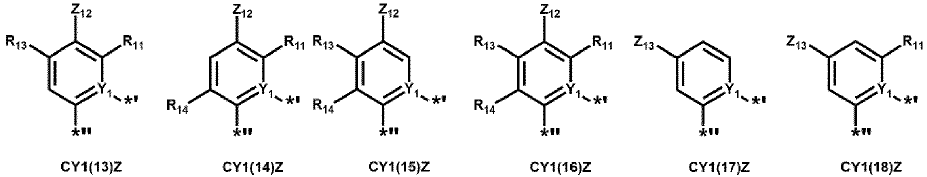 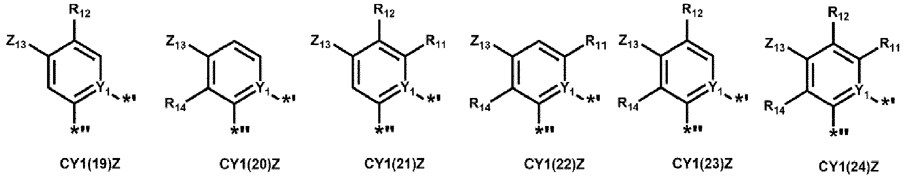 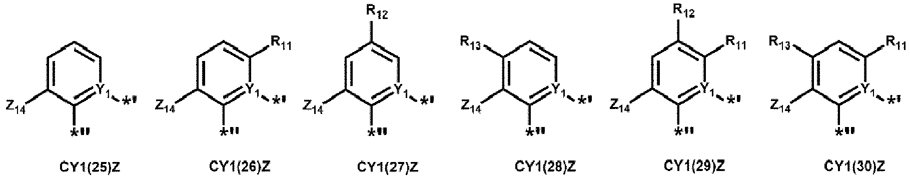 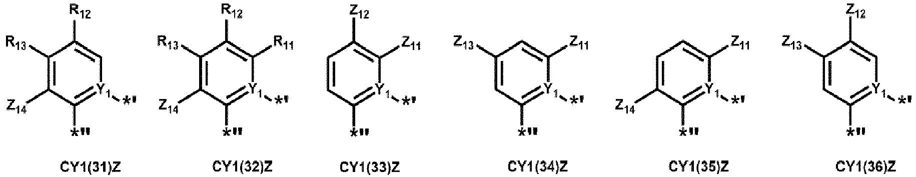 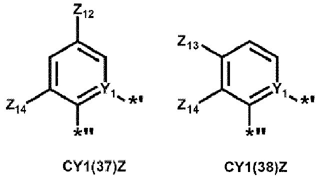 wherein, in Formulae CY1(1) to CY1(16) and CY1(1)Z to CY1(38)Z,
Y₁ is the same as described in claim 1,
R₁₁ to R₁₄ are each the same as described in connection with R₁ in claim 1, provided that each of R₁₁ to R₁₄ is not hydrogen,
Z₁₁ to Z₁₄ are each the same as described in connection with Z₁ in claim 1,
*' indicates a binding site to M in Formula 1, and
*" indicates a binding site to ring CY₂ in Formula 2.

9. The organometallic compound of any of claims 1-8, wherein in Formula 2,
a group represented by 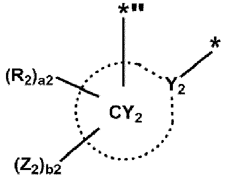 is a group represented by one of Formulae CY2(1) to CY2(96) and CY2(1)Z to CY2(54)Z: 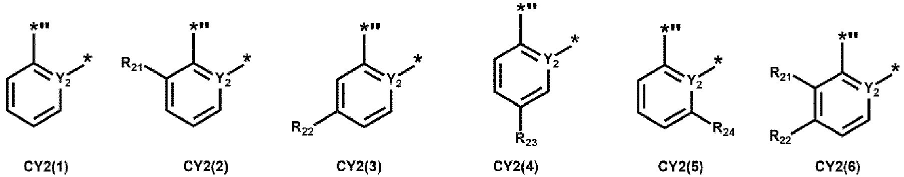 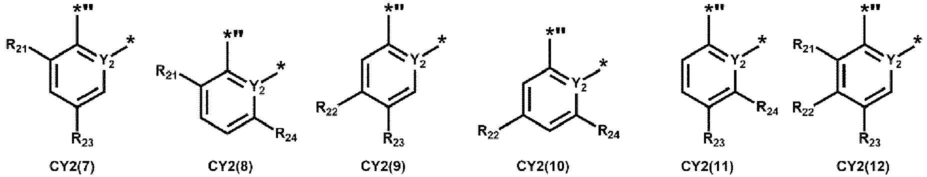 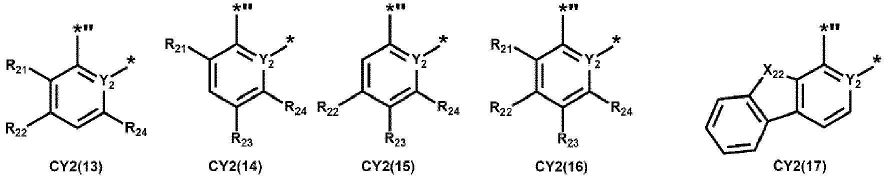 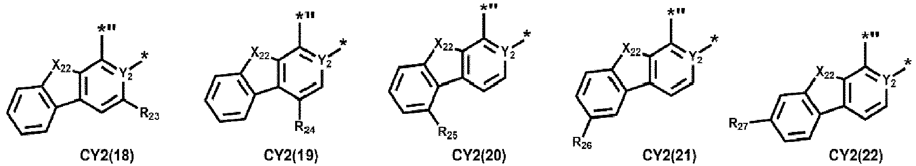 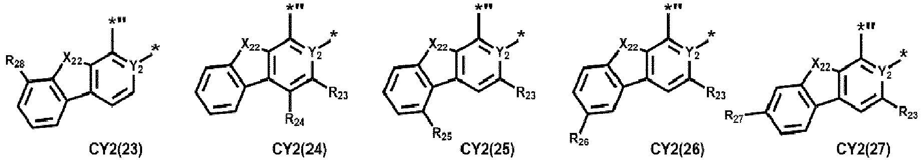 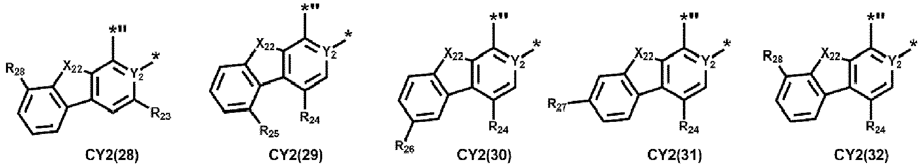 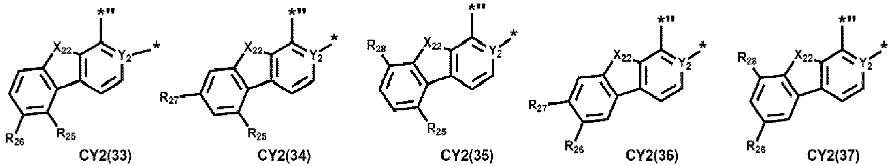 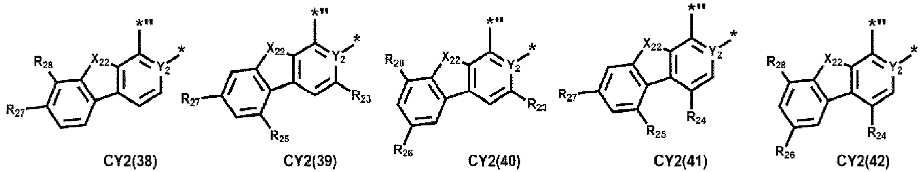 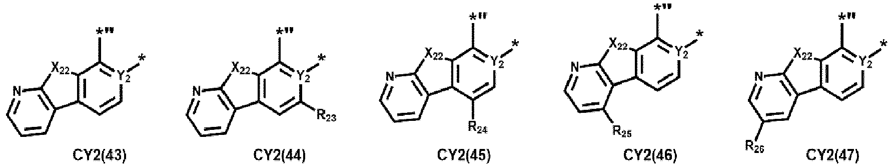 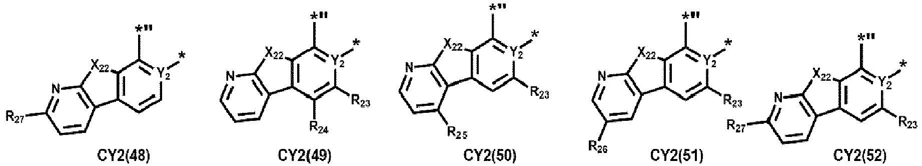 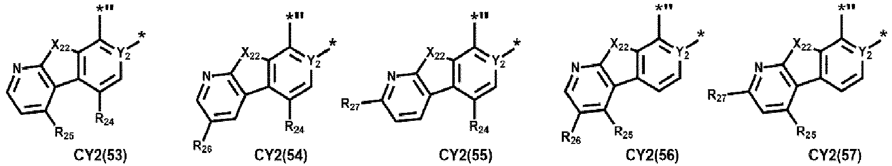 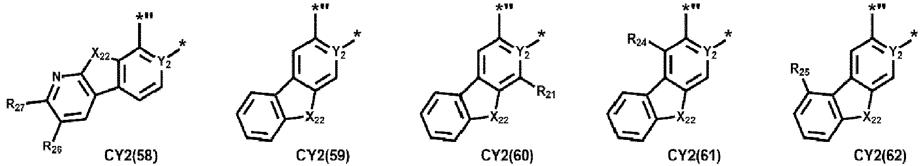 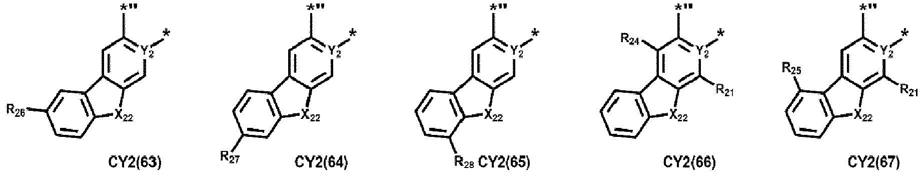 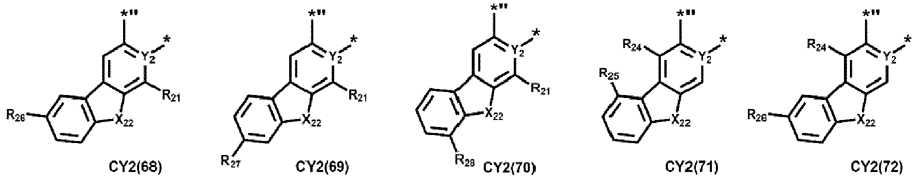 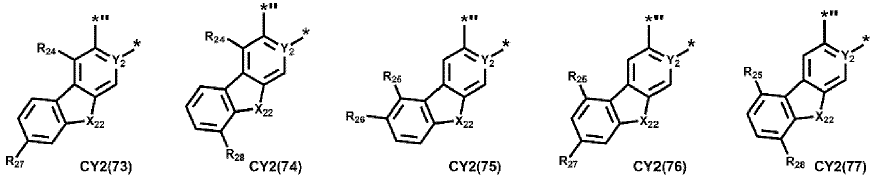 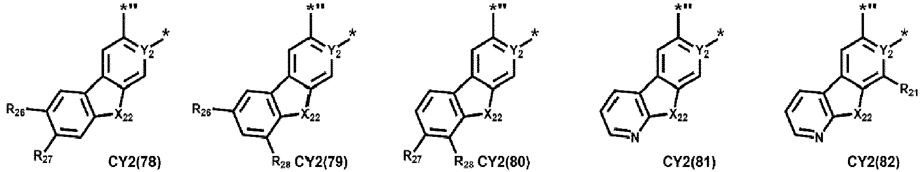 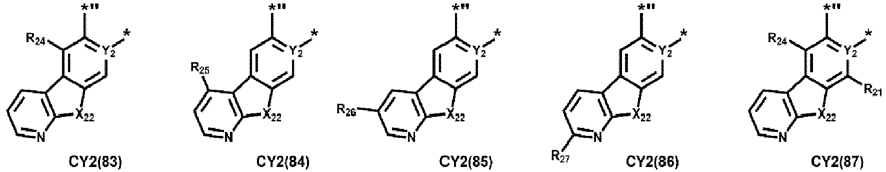 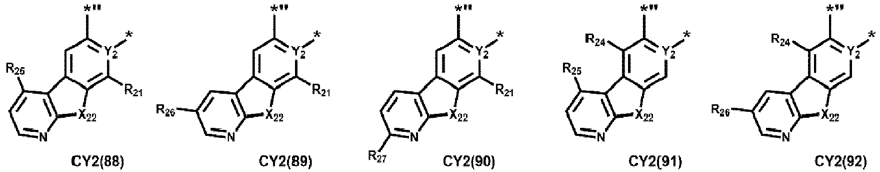 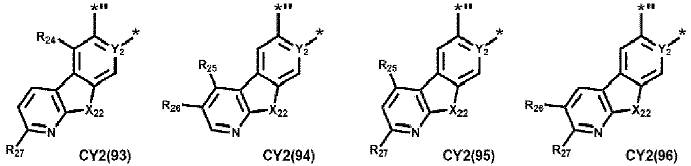 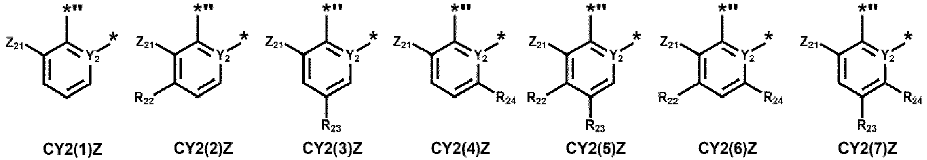 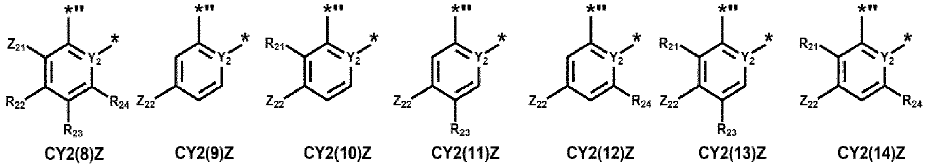 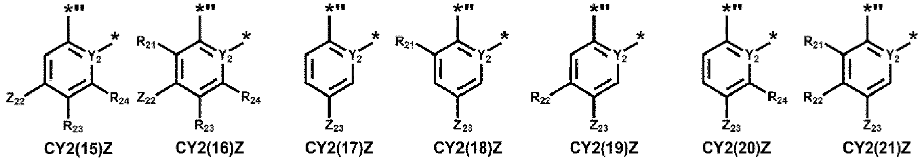 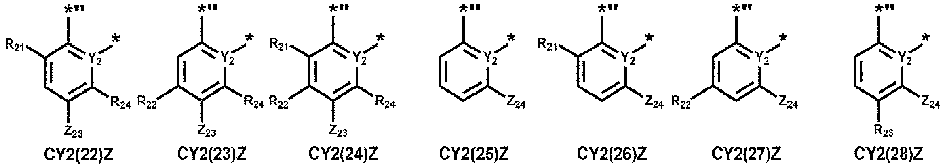 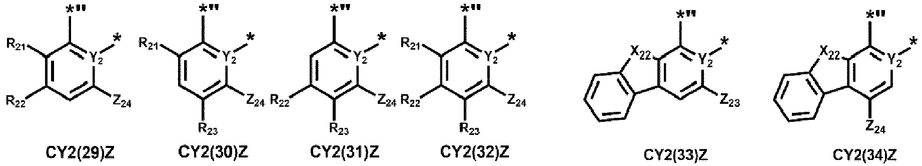 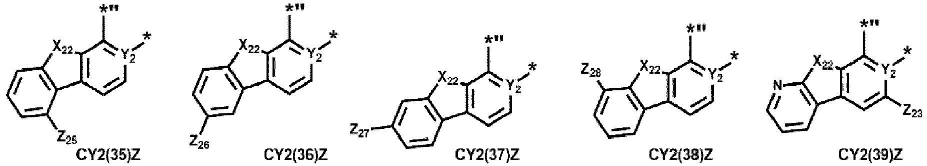 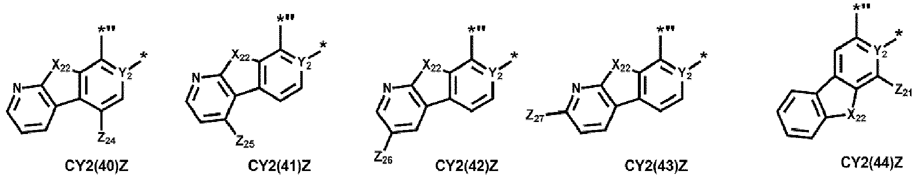 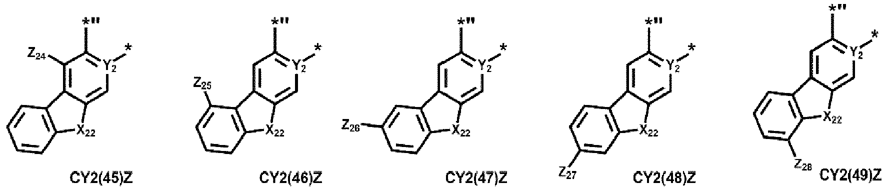 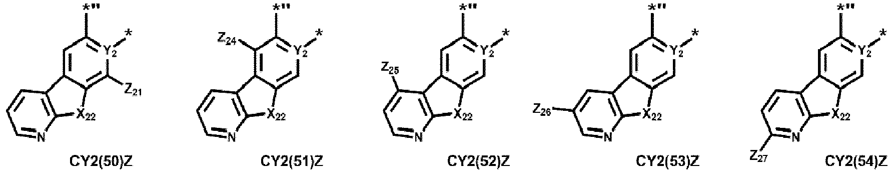 wherein, in Formulae CY2(1) to CY2(96) and CY2(1)Z to CY2(54)Z,
Y₂ is the same as described in claim 1,
X₂₂ is C(R₂₉ₐ)(R_{29b}), N(R₂₉ₐ), O, S, Se, or Si(R₂₉ₐ)(R_{29b}),
R₂₁ to R₂₈, R₂₉ₐ, and R_{29b} are each the same as described in connection with R₂ in claim 1, provided that each of R₂₁ to R₂₈ is not hydrogen,
Z₂₁ to Z₂₈ are each the same as described in connection with Z₂ in claim 1,
* indicates a binding site to M in Formula 1, and
*" indicates a binding site to ring CY₁ in Formula 2.

10. The organometallic compound of any of claims 1-9, wherein in Formula 1,
L₂ is a group represented by one of Formulae 4A to 4F: 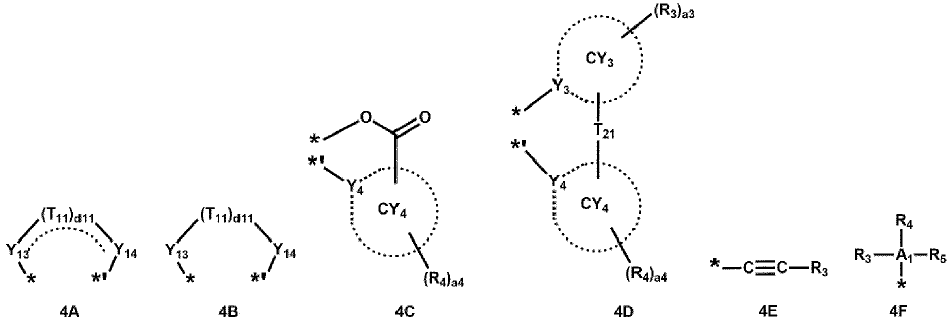 wherein, in Formulae 4A to 4F,
Y₁₃ is O, N, N(R₃), P(R₃)(R₄), or As(R₃)(R₄),
Y₁₄ is O, N, N(R₅), P(R₅)(R₆), or As(R₅)(R₆),
T₁₁ is a single bond, a double bond, *-C(R₃₁)(R₃₂)-*', *-C(R₃₁)=C(R₃₂)-*', *=C(R₃₁)-*', *-C(R₃₁)=*', *=C(R₃₁)-C(R₃₂)=C(R₃₃)-*', *-C(R₃₁)=C(R₃₂)-C(R₃₃)=", *-N(R₃₁)-*', or a C₅-C₃₀ carbocyclic group unsubstituted or substituted with at least one R₃₁,
d11 is an integer from 1 to 10, wherein, when d11 is 2 or greater, two or more T₁₁ groups are identical to or different from each other,
Y₃ and Y₄ are each independently C or N,
T₂₁ is a single bond, a double bond, O, S, Se, C(R₅)(R₆), Si(R₅)(R₆), or N(R₅),
ring CY₃ and ring CY₄ are each independently a C₅-C₃₀ carbocyclic group or a C₁-C₃₀ heterocyclic group,
A₁ is P or As,
R₃ to R₆ and R₃₁ to R₃₃ are each the same as described in connection with R₁ in claim 1,
a3 and a4 are each independently an integer from 0 to 20, and
* and *' each indicate a binding site to M in Formula 1;
preferably wherein in Formula 4D,
a group represented by 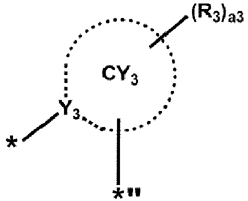 is a group represented by one of Formulae CY3(1) to CY3(16): 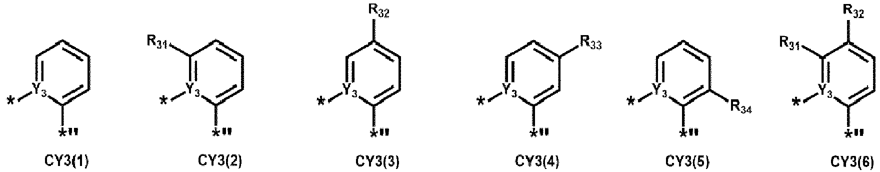 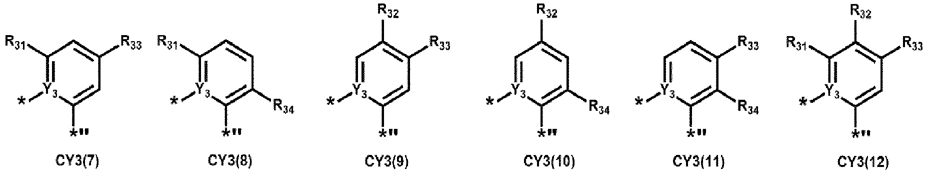 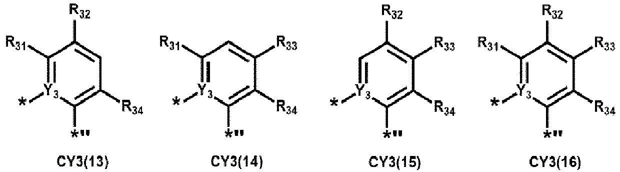 wherein, in Formulae CY3(1) to CY3(16),
Y₃ is the same as described in claim 10,
R₃₁ to R₃₄ are each the same as described in connection with R₃ in claim 10, provided that each of R₃₁ to R₃₄ is not hydrogen,
* indicates a binding site to M in Formula 1, and
*" indicates a binding site to T₂₁ in Formula 4D.

11. The organometallic compound of claim 10, wherein in Formulae 4C and 4D,
a group represented by 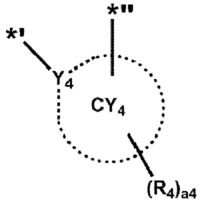 is a group represented by one of Formulae CY4(1) to CY4(96): 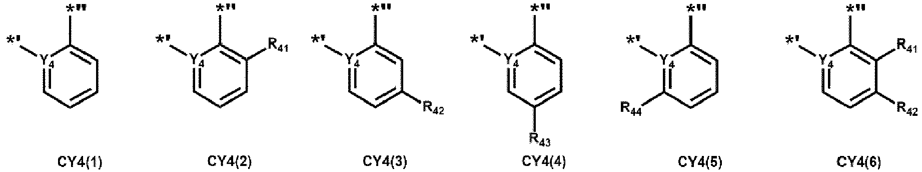 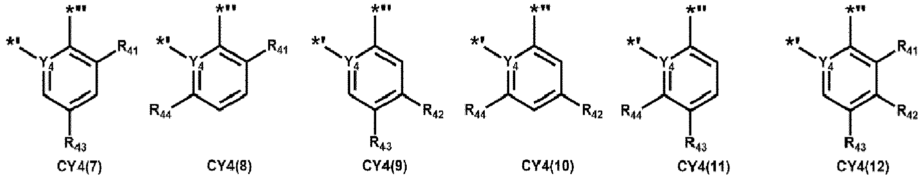 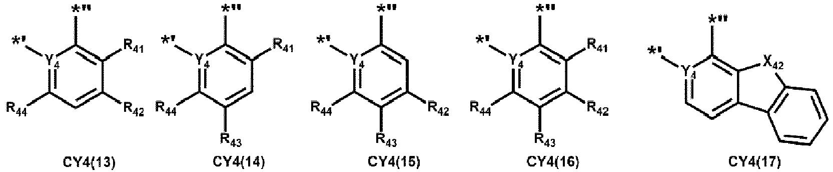 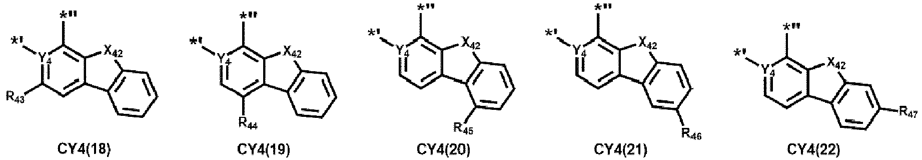 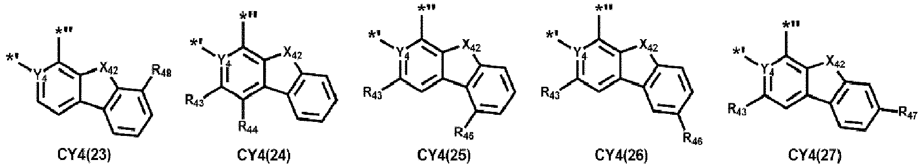 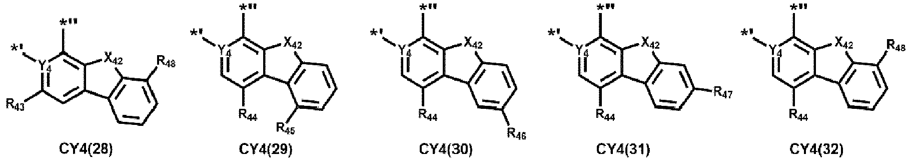 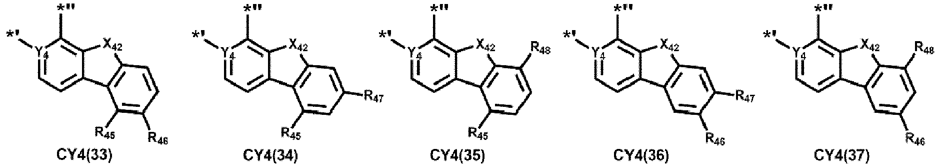 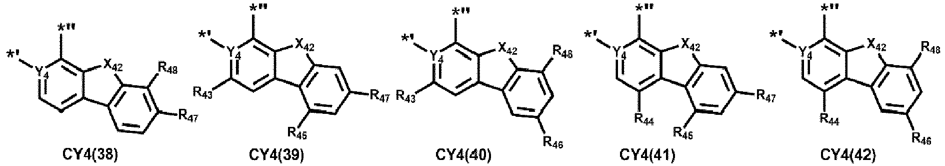 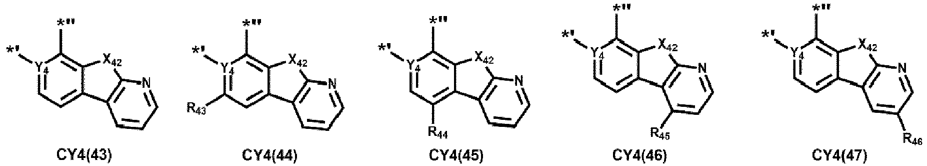 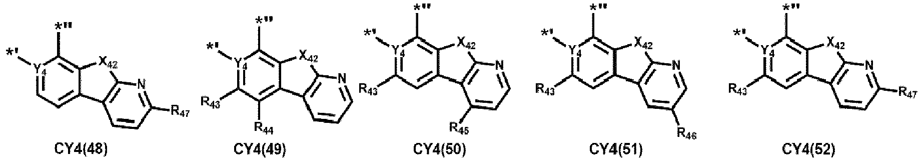 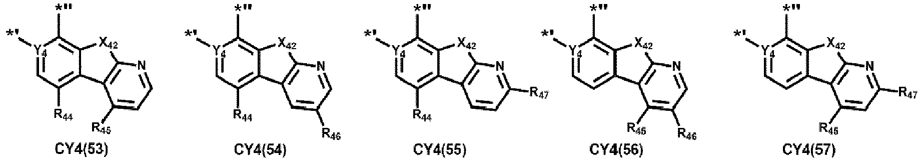 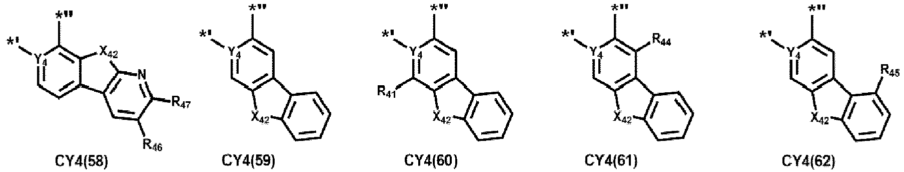 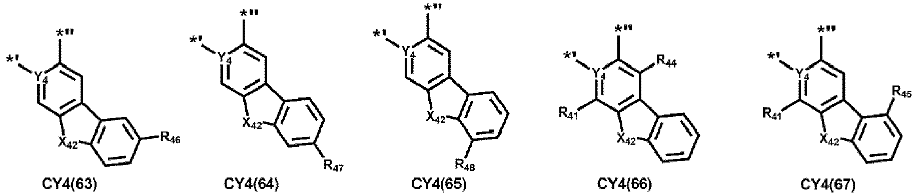 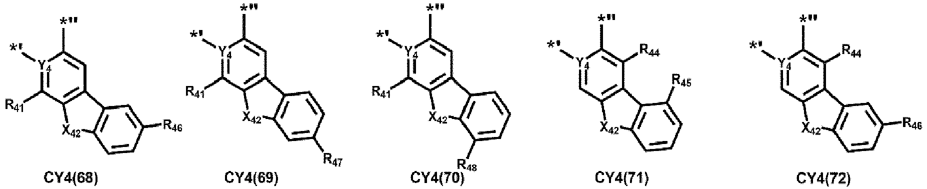 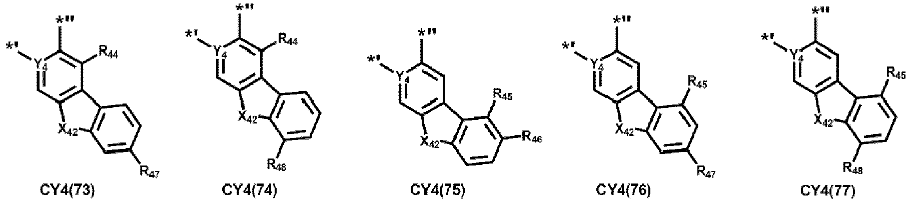 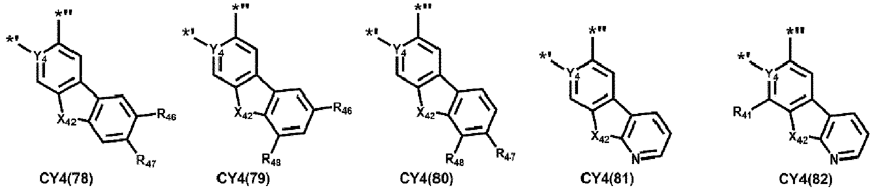 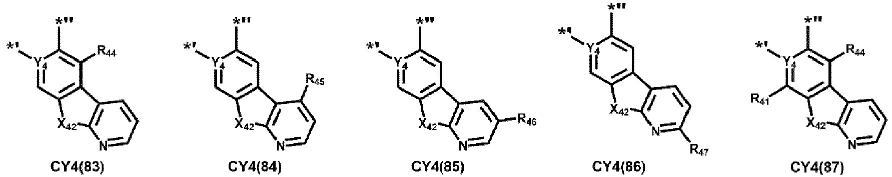 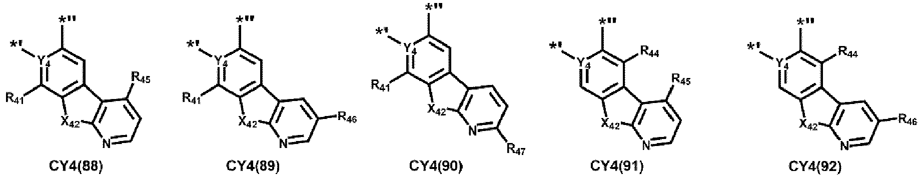 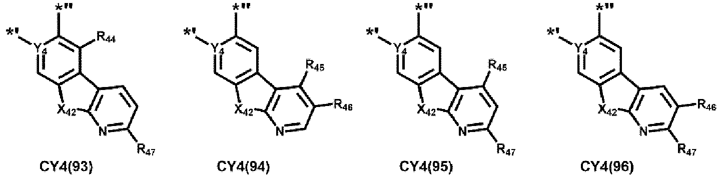 wherein, in Formulae CY4(1) to CY4(96),
Y₄ is the same as described in claim 10,
X₄₂ is C(R₄₉ₐ)(R_{49b}), N(R₄₉ₐ), O, S, Se, or Si(R₄₉ₐ)(R_{49b}),
R₄₁ to R₄₈, R₄₉ₐ, and R_{49b} are each the same as described in connection with R₄ in claim 10, provided that each of R₄₁ to R₄₈ is not hydrogen,
*' indicates a binding site to M in Formula 1, and
*" indicates a binding site to a neighboring atom in Formula 4C or a binding site to T₂₁ in Formula 4D.

12. An organic light-emitting device, comprising:
a first electrode;
a second electrode; and
an organic layer disposed between the first electrode and the second electrode and comprising an emission layer,
wherein the organic layer comprises at least one organometallic compound of any of claims 1-11;
preferably wherein
the first electrode is an anode,
the second electrode is a cathode,
the organic layer further comprises a hole transport region disposed between the first electrode and the emission layer, and an electron transport region disposed between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

13. The organic light-emitting device of claim 12, wherein
the emission layer comprises the at least one organometallic compound.

14. The organic light-emitting device of claim 13, wherein the at least one organometallic compound emits green light; and/or
wherein the emission layer further comprises a host, and an amount of the host in the emission layer is greater than an amount of the at least one organometallic compound in the emission layer, based on weight.

15. An electronic apparatus, comprising the organic light-emitting device of any of claims 12-14.
